(19) Europäisches Patentamt
European Patent Office
Office européen des brevets

(11) EP 3 991 988 B1

(12) **EUROPEAN PATENT SPECIFICATION**

(45) Date of publication and mention of the grant of the patent:
**05.11.2025 Bulletin 2025/45**

(21) Application number: **20832088.7**

(22) Date of filing: **26.06.2020**

(51) International Patent Classification (IPC):
***B41C 1/10*** (2006.01) ***G03F 7/00*** (2006.01)
***G03F 7/004*** (2006.01) ***G03F 7/027*** (2006.01)
***G03F 7/029*** (2006.01) ***G03F 7/031*** (2006.01)
***G03F 7/038*** (2006.01) ***G03F 7/09*** (2006.01)
***G03F 7/11*** (2006.01) *G03F 7/032* (2006.01)
*G03F 7/033* (2006.01) *G03F 7/105* (2006.01)
*G03F 7/30* (2006.01)

(52) Cooperative Patent Classification (CPC):
**B41C 1/1016;** B41C 2201/02; B41C 2201/12; B41C 2201/14; B41C 2210/04; B41C 2210/08; B41C 2210/22; B41C 2210/24; G03F 7/027; G03F 7/0295; G03F 7/032; G03F 7/033; G03F 7/0388; G03F 7/105; G03F 7/3035

(86) International application number:
**PCT/JP2020/025416**

(87) International publication number:
**WO 2020/262694 (30.12.2020 Gazette 2020/53)**

(54) **LITHOGRAPHIC PRINTING PLATE PRECURSOR, METHOD FOR PREPARING A LITHOGRAPHIC PRINTING PLATE, AND LITHOGRAPHIC PRINTING METHOD**

FLACHDRUCKPLATTENVORLÄUFER, VERFAHREN ZUR HERSTELLUNG EINER FLACHDRUCKPLATTE UND FLACHDRUCKVERFAHREN

PRÉCURSEUR DE PLAQUE D'IMPRESSION LITHOGRAPHIQUE, PROCÉDÉ DE PRODUCTION DE PLAQUE D'IMPRESSION LITHOGRAPHIQUE ET PROCÉDÉ D'IMPRESSION LITHOGRAPHIQUE

(84) Designated Contracting States:
**AL AT BE BG CH CY CZ DE DK EE ES FI FR GB GR HR HU IE IS IT LI LT LU LV MC MK MT NL NO PL PT RO RS SE SI SK SM TR**

(30) Priority: **28.06.2019 JP 2019122478**
**30.08.2019 JP 2019158814**
**18.09.2019 JP 2019169810**

(43) Date of publication of application:
**04.05.2022 Bulletin 2022/18**

(73) Proprietor: **FUJIFILM Corporation**
**Tokyo 106-8620 (JP)**

(72) Inventors:
- **ENOMOTO, Kazuaki**
  **Shizuoka 421-0396 (JP)**
- **ISHIJI, Yohei**
  **Shizuoka 421-0396 (JP)**
- **YANAGI, Shunsuke**
  **Shizuoka 421-0396 (JP)**

(74) Representative: **HGF**
**HGF Limited**
**1 City Walk**
**Leeds LS11 9DX (GB)**

(56) References cited:
**EP-A1- 1 203 660** **EP-A1- 2 236 291**
**EP-A1- 2 363 748** **EP-A1- 2 554 381**
**EP-A1- 3 476 616** **EP-A2- 1 470 914**
**EP-A2- 1 674 928** **EP-A2- 2 383 118**
**EP-A2- 2 471 654** **WO-A1-2012/124177**
**WO-A1-2017/141882** **WO-A1-2018/159640**
**WO-A1-2018/230412** **WO-A1-2019/004471**
**WO-A1-2019/013268** **WO-A1-2020/045586**

Note: Within nine months of the publication of the mention of the grant of the European patent in the European Patent Bulletin, any person may give notice to the European Patent Office of opposition to that patent, in accordance with the Implementing Regulations. Notice of opposition shall not be deemed to have been filed until the opposition fee has been paid. (Art. 99(1) European Patent Convention).

WO-A1-2020/045587
JP-A- 2011 227 311
JP-A- S63 137 226
JP-B1- 6 461 447
JP-A- 2004 341 500
JP-A- 2012 501 878
JP-A- S63 202 497
US-A1- 2009 269 699

## Description

## BACKGROUND OF THE INVENTION

1. Field of the Invention

The present invention relates to a lithographic printing plate precursor, a method for preparing a lithographic printing plate, and a lithographic printing method.

2. Description of the Related Art

Generally, a lithographic printing plate consists of a lipophilic image area that receives ink in a printing process and a hydrophilic non-image area that receives dampening water. Lithographic printing is a method exploiting the mutual repulsion of water and oil-based ink, in which the lipophilic image area and the hydrophilic non-image area of a lithographic printing plate are used as an ink-receiving portion and a dampening water-receiving portion (that is, non-ink-receiving portion) respectively, the adhesiveness of ink is varied within the surface of the lithographic printing plate so that only the image area receives the ink, and then printing is performed by the transfer of the ink to a printing substrate such as paper.

In the related art, in order to prepare this lithographic printing plate, a lithographic printing plate precursor (also called "PS plate") has been widely used which is obtained by providing a lipophilic photosensitive resin layer (also called "image-recording layer") on a hydrophilic support. Generally, a lithographic printing plate is obtained by a plate making method of exposing a lithographic printing plate precursor through an original picture such as a lith film, then keeping a portion of an image-recording layer that will be an image area while removing other unnecessary portions of the image-recording layer by dissolving such portions in an alkaline developer or an organic solvent, and forming a non-image area by exposing the hydrophilic surface of a support.

In response to the intensifying interest in the global environment, an environmental issue of waste liquid generated by wet treatments such as a development treatment has gathered more attention.

Regarding the environmental issue described above, an attempt is made to simplify development or plate making, to remove treatments, and the like. As one of simple preparation methods, a method called "on-press development" is being carried out. That is, in this method, after being exposed, a lithographic printing plate precursor is immediately mounted on a printer without being developed as in the related art, and an unnecessary portion of the image-recording layer is removed at an early stage of the ordinary printing step.

As an on-press development type lithographic printing plate precursor, for example, WO2018-159710A describes a lithographic printing plate precursor having an image-recording layer on a support, in which the image-recording layer contains a specific infrared absorber and thermoplastic polymer particles and does not contain a binder polymer.

As another lithographic printing plate precursor, JP2005-297305A discloses a lithographic printing plate precursor having a photosensitive-thermosensitive layer which is on a support and on which images can be recorded by exposure to an infrared laser, the lithographic printing plate precursor making it possible to perform printing by being mounted on a printer without going through a development treatment step after image recording or by performing image recording after being mounted on a printer. JP2005-297305A also discloses a photosensitive-thermosensitive layer containing microcapsules encapsulating a compound having an ethylenically unsaturated group.

EP 1470914 A2 discloses a method for forming an image on a planographic printing plate precursor comprising a substrate and an image recording layer disposed thereon, the image recording layer comprising a hydrophobic precursor and a light-to-heat converting agent, wherein the method comprises: exposing the planographic printing plate precursor to infrared radiation to form an image on the image recording layer of the planographic printing plate precursor; and post-heating the planographic printing plate precursor to a predetermined heating temperature.

EP 2236291 A1 discloses a lithographic printing plate precursor comprising: an aluminum support subjected to a roughening treatment; and an image-recording layer comprising an infrared absorbing agent, a radical polymerization initiator, a radical polymerizable monomer, a compound having two or more mercapto group-containing groups per molecule and a polymer particle containing a polyalkylene oxide segment.

WO 2012/124177 A1 discloses a lithographic printing plate precursor comprising a hydrophilic support and an image-recording layer containing (A) a polymer fine particle, (B) a radical polymerizable compound and (C) an infrared absorbing dye, wherein the polymer fine particle is a polymer fine particle obtained by a reaction between a polyvalent isocyanate compound which is an adduct of a polyhydric phenol compound having two or more hydroxyl groups in a molecule thereof and isophorone diisocyanate and a compound having an active hydrogen atom.

EP 2471654 A2 discloses a lithographic printing plate precursor comprising: an image-recording layer containing a thermoplastic polymer fine particle, an infrared absorbing agent and a polymer compound; and a support having a hydrophilic surface, wherein the polymer compound has a star-like shape in which a main chain is branched to three or more branches and the branched main chain have a hydrophilic group in a side chain of the branched main chain.

WO 2018/230412 discloses a lithographic printing plate precursor having an image-recording layer on a hydrophilic support, in which the image-recording layer includes an organic polymer particle, and the organic polymer particle is a reaction product obtained by at least reacting an aromatic polyvalent isocyanate compound having a structure represented by Formula PO and water.

EP 3 476 616 discloses a lithographic printing plate precursor including an aluminum support and an image recording layer, the aluminum support includes an aluminum plate and an anodized film of aluminum formed on the aluminum plate, the anodized film is positioned closer to the image recording layer than the aluminum plate is, the anodized film has micropores extending in a depth direction of the anodized film from a surface of the anodized film on the image recording layer, the micropores have an average diameter of more than 10 nm but not more than 100 nm at the surface of the anodized film, and the surface of the anodized film on the image recording layer side has a lightness L* of 70 to 100 in a L*a*b* color system.

## SUMMARY OF THE INVENTION

An object to be achieved by an embodiment of the present invention is to provide a lithographic printing plate precursor making it possible to obtain a lithographic printing plate in which plate missing is unlikely to occur.

Furthermore, an object to be achieved by another embodiment of the present invention is to provide a method for preparing a lithographic printing plate or a lithographic printing method in which plate missing is unlikely to occur.

Here, the term "plate missing" refers to the following phenomenon. That is, in a case where solids such as fibers of paper or threads of the worker's clothing adhere to the surface of an image area in a lithographic printing plate, and the lithographic printing plate is used for printing as it is, the pressure applied to the image area locally increases at the site to which the solids have adhered, a part of the image area is damaged and removed accordingly, and ink does not stick to some parts, which is a phenomenon called plate missing. The number of sheets printed from the lithographic printing plate until "plate missing" occurs is an indicator showing "plate missing is unlikely to occur".

The invention is as defined in the appended claim set.

According to an embodiment of the present invention, a lithographic printing plate precursor can be provided which makes it possible to obtain a lithographic printing plate in which plate missing is unlikely to occur.

Furthermore, according to another embodiment of the present invention, it is possible to provide a method for preparing a lithographic printing plate or a lithographic printing method in which plate missing is unlikely to occur.

## BRIEF DESCRIPTION OF THE DRAWINGS

Fig. 1 is a schematic cross-sectional view of an embodiment of an aluminum support.

Fig. 2 is a schematic cross-sectional view of another embodiment of the aluminum support.

Fig. 3 is an example of a waveform graph of alternating current used for an electrochemical roughening treatment in a method for manufacturing an aluminum support.

Fig. 4 is a lateral view showing an example of a radial cell in an electrochemical roughening treatment using alternating current in a method for manufacturing an aluminum support.

Fig. 5 is a schematic view of an anodic oxidation treatment device used for an anodic oxidation treatment in a method for manufacturing an aluminum support having an anodic oxide film.

## DESCRIPTION OF THE PREFERRED EMBODIMENTS

Hereinafter, the contents of the present invention will be specifically described. The following constituents will be described on the basis of typical embodiments of the present invention, but the present invention is not limited to such embodiments.

Herein, a numerical range expressed using "to" includes numerical values listed before and after "to" as the lower limit and the upper limit.

Regarding the numerical ranges described in stages in the present specification, the upper or lower limit of a numerical range may be replaced with the upper or lower limit of another numerical range described in stages. Furthermore, regarding the numerical ranges described in the present specification, the upper or lower limit of a numerical range may be replaced with values described in examples.

Furthermore, herein, in a case where there is no description regarding whether a group (atomic group) is substituted or unsubstituted, such a group includes both a group having no substituent and a group having a substituent. For example, "alkyl group" includes not only an alkyl group having no substituent (unsubstituted alkyl group) but also an alkyl group having a substituent (substituted alkyl group).

Herein, "(meth)acryl" is a term used to explain a concept including both the acryl and methacryl, and "(meth) acryloyl" is a term used to explain a concept including both the acryloyl and methacryloyl.

In addition, the term "step" means not only an independent step but also a step that cannot be clearly differentiated from other steps as long as the intended goal of the step is achieved.

Herein, "% by mass" has the same definition as "% by weight", and "part by mass" has the same definition as "part by weight".

Herein, unless otherwise specified, as each component contained in a composition or each constitutional unit contained in a polymer, one kind of component or one kind of constitutional unit may be used alone, or two or more kinds of components or two or more kinds of constitutional units may be used in combination.

Furthermore, in a case where there is a plurality of substances corresponding to each component in a composition, or in a case where there is a plurality of constitutional units corresponding to each constitutional unit in a polymer, unless otherwise specified, the amount of each component in the composition or the amount of each constitutional unit in the polymer means the total amount of the plurality of corresponding substances present in the composition or the total amount of the plurality of corresponding constitutional units present in the polymer.

Herein, a combination of two or more preferred aspects is a more preferred aspect.

In addition, in the present specification, unless otherwise specified, each of the weight-average molecular weight (Mw) and number-average molecular weight (Mn) is a molecular weight that is detected using a gel permeation chromatography (GPC) analysis device using TSKgel GMHxL, TSKgel G4000HxL, and TSKgel G2000HxL (trade names, manufactured by Tosoh Corporation) as columns, tetrahydrofuran (THF) as a solvent, and a differential refractometer, and expressed in terms of polystyrene as a standard substance.

Herein, unless otherwise specified, the median diameter of resin particles refers to a value measured by a light scattering method, at which the number of large-diameter particles is the same as the number of small-diameter particles in a case where powder is divided into two groups based on a certain particle diameter. The measurement of median diameter of resin particles by the light scattering method is performed using LA-920 (manufactured by HORIBA, Ltd.) according to the manual of the instrument.

Herein, the term "lithographic printing plate precursor" refers not only to a lithographic printing plate precursor but also to a key plate precursor. In addition, the term "lithographic printing plate" refers not only to a lithographic printing plate prepared by performing operations such as exposure and development as necessary on a lithographic printing plate precursor but also to a key plate. The key plate precursor is not necessarily subjected to the operations such as exposure and development. The key plate refers to a lithographic printing plate precursor to be mounted on a plate cylinder that is not used, in a case where monochromatic or dichromatic printing is carried out on a part of paper during, for example, color newspaper printing.

Herein, "*" in a chemical structural formula represents a binding position with other structures.

Hereinafter, the present invention will be specifically described.

<Lithographic printing plate precursor>

The lithographic printing plate precursor according to the present invention is a lithographic printing plate precursor having an aluminum support and an image-recording layer formed on the aluminum support, in which the image-recording layer contains resin particles A having an ethylenically unsaturated group and a compound B having an ethylenically unsaturated group other than the resin particles A and has an ethylenically unsaturated bond valence of 1.5 mmol/g or more.

Herein, the resin particles A having an ethylenically unsaturated group are also called "polymerizable resin particles A", and the compound B having an ethylenically unsaturated group other than the resin particles A is also called "polymerizable compound B"

The lithographic printing plate precursor is a negative tone lithographic printing plate precursor.

The lithographic printing plate precursor can be suitably used as an on-press development type lithographic printing plate precursor. Herein, the on-press development type lithographic printing plate precursor means a lithographic printing plate precursor that can be developed by the on-press development method which will be described later.

The inventors of the present invention have found that the lithographic printing plate precursor in the related art, such as the lithographic printing plate precursor described in WO2018/159710A or JP2005-297305A described above, cannot fully suppress the occurrence of plate missing in a lithographic printing plate obtained from the precursor.

As a result of intensive studies, the inventors of the present invention have found that a lithographic printing plate in which plate missing is unlikely to occur is obtained from the lithographic printing plate precursor having the above constitution.

The detailed mechanism that brings about the aforementioned effect is unclear, but is assumed to be as below.

The lithographic printing plate precursor according to the present invention has an image-recording layer having a high ethylenically unsaturated bond valence (specifically, 1.5 mmol/g or more). In the image-recording layer having an

ethylenically unsaturated bond valence of 1.5 mmol/g or more, the density of ethylenically unsaturated groups is high. Presumably, accordingly, a polymerization reaction by the ethylenically unsaturated groups may be facilitated, and an image area having a high film hardness may be formed. Presumably, as a result, from the lithographic printing plate precursor according to the present invention, a lithographic printing plate in which plate missing is unlikely to occur may be obtained.

Furthermore, presumably, for the same reason as described above, from the lithographic printing plate precursor according to the present invention, a lithographic printing plate which can print a number of sheets (a lithographic printing plate which is excellent in so-called printing durability) may be obtained.

In other words, in the image-recording layer that contains the polymerizable resin particles A and the polymerizable compound B and has a high ethylenically unsaturated bond valence, due to the high ethylenically unsaturated bond valence, the content of polymer compounds such as a binder polymer tends to be reduced. Presumably, as a result, the image-recording layer is composed of components having a relatively low molecular weight, which may lead to high developability.

In recent years, as a printing ink, an ink that is cured by the irradiation with ultraviolet rays (UV) (hereinafter, also called "ultraviolet-curable ink") has been used in some cases.

Being able to dry instantly, the ultraviolet-curable ink has high productivity. Furthermore, because the ultraviolet-curable ink contains a small amount of solvents or contains no solvent, environmental pollution is likely to be reduced. In addition, the ultraviolet-curable ink makes it possible to form an image without performing heat drying or by reducing the time of heat drying. Therefore, the ultraviolet-curable ink has advantages such as being applicable to printing on a wide variety of objects.

Therefore, it is considered that the lithographic printing plate precursor providing a lithographic printing plate in which plate missing (hereinafter, also called "UV plate missing") is unlikely to occur in a case where an ultraviolet-curable ink is used is extremely useful in industry.

Furthermore, it is considered that the lithographic printing plate precursor providing a lithographic printing plate exhibiting excellent printing durability (hereinafter, also called "UV printing durability") in a case where an ultraviolet-curable ink is used is extremely useful.

As described above, because the lithographic printing plate precursor according to the present invention has an image-recording layer having a high ethylenically unsaturated bond valence, an image area having high film hardness is formed. Presumably, as a result, a lithographic printing plate in which UV plate missing is unlikely to occur and which has excellent UV printing durability may be obtained.

[Image-recording layer]

The lithographic printing plate precursor according to the present invention has an image-recording layer containing the polymerizable resin particles A and the polymerizable compound B.

The image-recording layer is a negative tone image-recording layer in which a cured portion (corresponding to an exposed portion) is formed by a polymerization reaction between the polymerizable resin particles A and the polymerizable compound B.

From the viewpoint of on-press developability, it is preferable that a non-cured portion (corresponding to a non-exposed portion) in the image-recording layer can be removed with at least one material selected from the group consisting of dampening water and a printing ink.

[Ethylenically unsaturated bond valence]

In the present invention, the ethylenically unsaturated bond valence in the image-recording layer refers to the amount [mmol] of ethylenically unsaturated groups per 1 g of the image-recording layer.

The image-recording layer in the present invention has an ethylenically unsaturated bond valence of 1.5 mmol/g or more. From the viewpoint of suppressing the occurrence of plate missing and improving printing durability, the ethylenically unsaturated bond valence is preferably 1.8 mmol/g or more, more preferably 2.1 mmol/g or more, and particularly preferably 2.5 mmol/g or more.

The upper limit of the ethylenically unsaturated bond valence of the image-recording layer is not particularly limited, but is preferably 10.0 mmol/g or less, for example.

The ethylenically unsaturated bond valence in the image-recording layer can be determined by the following method.

First, for a printing plate of a predetermined sample amount (for example, 200 $cm^2$ as the surface area of the image-recording layer), for example, the image-recording layer is subjected to solvent extraction, and the components contained in the sample are isolated using centrifugation, preparative gel permeation chromatography (preparative GPC), and preparative liquid chromatography (preparative HPLC). Then, by using pyrolysis gas chromatography mass spectrometry (pyrolysis GC/MS), liquid chromatography mass spectrometry (LC-MS), nuclear magnetic resonance spectroscopy (NMR), Fourier transform infrared spectroscopy (FT-IR), and the like, the structures and compositions of the components contained in the sample are identified, and the total amount [mmol] of ethylenically unsaturated groups is determined. The determined total amount [mmol] of ethylenically unsaturated groups is divided by the mass (g) of the image-recording layer used for measurement, thereby calculating the ethylenically unsaturated bond valence in the image-recording layer.

The above operation is performed for any three points of the image-recording layer, and the average thereof is taken as the ethylenically unsaturated bond valence in the image-recording layer.

From the viewpoint of printing durability and photosensitivity, the image-recording layer preferably contains a polymerization initiator, an infrared absorber, and the like, in addition to the polymerizable resin particles A and the polymerizable compound B. The image-recording layer may further contain other components.

Hereinafter, each of the components contained in the image-recording layer will be specifically described.

[Polymerizable resin particles A]

The polymerizable resin particles A in the present invention are preferably particles containing a resin having an ethylenically unsaturated group (hereinafter, also called polymerizable resin RA).

From the viewpoint of suppressing the occurrence of plate missing, the content of the polymerizable resin RA in the polymerizable resin particles A with respect to the total mass of the polymerizable resin particles A is preferably 80% by mass or more, more preferably 90% by mass or more, even more preferably 95% by mass or more, and particularly preferably 100% by mass. That is, the polymerizable resin particles A are particularly preferably particles consisting of the polymerizable resin RA (that is, polymerizable resin particles A in which the content of the polymerizable resin RA is 100% by mass with respect to the total mass of the particles).

The upper limit of the content of the polymerizable resin RA is not particularly limited, and may be 100% by mass or less.

(Ethylenically unsaturated bond valence)

The ethylenically unsaturated bond valence in the polymerizable resin particles A is not particularly limited. From the viewpoint of suppressing the occurrence of plate missing, the ethylenically unsaturated bond valence is preferably 0.01 mmol/g or more, more preferably 0.05 mmol/g or more, and even more preferably 0.09 mmol/g or more.

The ethylenically unsaturated bond valence in the polymerizable resin particles A refers to the amount [mmol] of ethylenically unsaturated groups per 1 g of the polymerizable resin particles A.

The upper limit of the ethylenically unsaturated bond valence in the polymerizable resin particles A is, for example, 10.0 mmol/g.

The ethylenically unsaturated bond valence in the polymerizable resin particles A can be determined by the following method.

First, for the polymerizable resin particles A of a predetermined sample amount (for example, 0.2 g), the structures and compositions of the components contained in the sample are identified, for example, using pyrolysis GC/MS, FT-IR, NMR, time-of-flight secondary ion mass spectrometry (TOF-SIMS), and the like, and the total amount [mmol] of ethylenically unsaturated groups is determined. The determined total amount [mmol]of ethylenically unsaturated groups is divided by the sample amount [g] of the polymerizable resin particles A, thereby calculating the ethylenically unsaturated bond valence in the polymerizable resin particles A.

(Polymerizable resin RA)

The polymerizable resin RA contained in the polymerizable resin particles A is not particularly limited as long as it is a resin having an ethylenically unsaturated group in the molecule. The polymerizable resin RA may be an addition polymerization-type resin, a polycondensation-type resin, or a polyaddition-type resin. From the viewpoint of suppressing plate missing, the polymerizable resin RA is preferably an addition polymerization-type resin.

From the viewpoint of ease of manufacturing, the addition polymerization-type resin as the polymerizable resin RA is preferably a resin obtained by polymerizing an ethylenically unsaturated compound, and more preferably a resin obtained by copolymerizing a polyfunctional ethylenically unsaturated compound and a monofunctional ethylenically unsaturated compound.

The polymerizable resin RA has at least an ethylenically unsaturated group.

From the viewpoint of achieving the ethylenically unsaturated bond valence in the polymerizable resin particles A described above, the polymerizable resin RA is preferably a resin having an ethylenically unsaturated group-containing constitutional unit.

The ethylenically unsaturated group contained in the polymerizable resin RA is not particularly limited, and

examples thereof include a (meth)acryloyl group, an allyl group, a vinyl phenyl group, a vinyl ether group, a vinyl ester group, and the like. Particularly, as the ethylenically unsaturated group, from the viewpoint of reactivity, a (meth)acryloyl group is preferable. More specifically, a (meth)acryloxy group and a (meth)acrylamide group are preferable, and a (meth) acryloxy group is most preferable.

The polymerizable resin RA may have only one kind of ethylenically unsaturated group or two or more kinds of ethylenically unsaturated groups.

-Polymerizable resin RA1 as addition polymerization-type resin-

Hereinafter, first, the polymerizable resin RA1 which is an addition polymerization-type resin (hereinafter, also called "polymerizable resin RA1") will be described.

The method for introducing an ethylenically unsaturated group into the polymerizable resin RA1 is not particularly limited. Examples thereof include a method (1) of using a polyfunctional monomer having two or more ethylenically unsaturated groups at the time of synthesizing the resin so that the ethylenically unsaturated groups remain in the synthesized resin and a method (2) of introducing an ethylenically unsaturated group into the synthesized resin by a polymer reaction. The latter method (2) is preferable.

In the case of the method (2), the resin into which an ethylenically unsaturated group is to be introduced may be a resin which does not have an ethylenically unsaturated group or a resin in which the content of an ethylenically unsaturated group is lower than the intended amount.

The polymerizable resin RA1 having an ethylenically unsaturated group-containing constitutional unit is obtained by the above method.

(Ethylenically unsaturated group-containing constitutional unit)

The ethylenically unsaturated group-containing constitutional unit in the polymerizable resin RA1 is not particularly limited. Examples thereof include a constitutional unit represented by Formula D1.

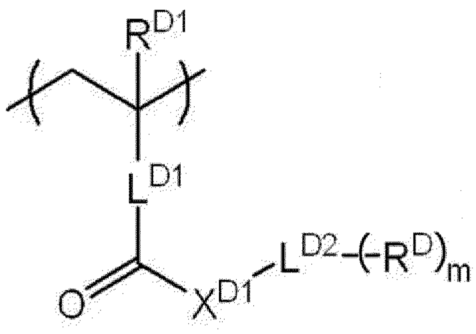

Formula D1

In Formula D1, $L^{D1}$ represents a single bond or a divalent linking group, $L^{D2}$ represents an (m + 1)-valent linking group, $X^{D1}$ represents -O- or -$NR^N$-, $R^N$ represents a hydrogen atom or an alkyl group, $R^{D1}$ represents a hydrogen atom or a methyl group, $R^D$ represents an ethylenically unsaturated group, and m represents an integer of 1 or more.

In a case where $L^{D1}$ in Formula D1 represents a divalent linking group, an alkylene group, an arylene group, or a divalent group in which two or more of these are bonded is preferable, and an alkylene group having 2 to 10 carbon atoms or a phenylene group is more preferable.

$L^{D1}$ is preferably a single bond.

In Formula D1, the (m + 1)-valent linking group represented by $L^{D2}$ is preferably a linking group having a group represented by any of Formula D2 to Formula D6, and is more preferably a group represented by any of Formula D2 to Formula D6 or a linking group in which a group represented by any of Formula D2 to Formula D6 is bonded to one or more groups selected from the group consisting of an ester bond, an alkylene group, and an alkyleneoxy group.

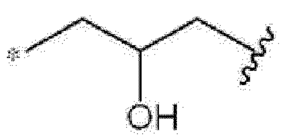

Formula D2

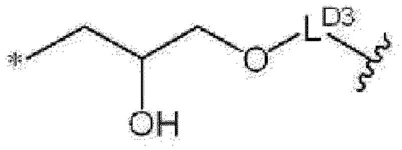

Formula D3

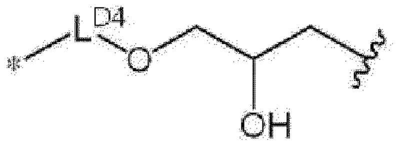

Formula D4

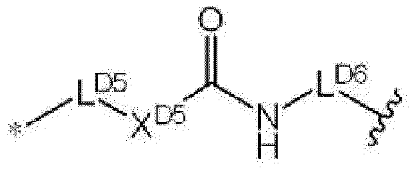

Formula D5

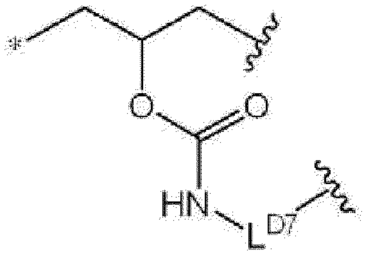

Formula D6

In Formula D2 to Formula D6, $L^{D3}$ to $L^{D7}$ each represent a divalent linking group, $L^{D5}$ and $L^{D6}$ may be the same or different from each other, $X^{D5}$ represents -O- or $-NR^N-$, $R^N$ represents a hydrogen atom or an alkyl group, * represents a binding site with $X^{D1}$ in Formula D1, and the portion of the wavy line represents a binding site with $R^D$ in Formula D1 (preferably $X^{D2}$ in Formula D7 that will be described later).

In Formula D3, $L^{D3}$ is preferably an alkylene group, an arylene group, or a group in which two or more of these are bonded, and more preferably an alkylene group having 1 to 10 carbon atoms, a phenylene group, or a group in which two or more of these are bonded.

In Formula D4, $L^{D4}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $L^{D5}$ is preferably an alkylene group, an arylene group, or a group in which two or more of these are bonded, and more preferably an alkylene group having 1 to 10 carbon atoms, a phenylene group, or a group in which two or more of these are bonded.

In Formula D5, $X^{D5}$ is preferably -O- or -NH-.

In Formula D5, $L^{D6}$ is preferably an alkylene group, an arylene group, or a group in which two or more of these are bonded, and more preferably an alkylene group having 1 to 10 carbon atoms, a phenylene group, or a group in which two or more of these are bonded.

In Formula D6, $L^{D7}$ is preferably an alkylene group, an arylene group, or a group in which two or more of these are bonded, and more preferably an alkylene group having 1 to 10 carbon atoms, a phenylene group, or a group in which two or more of these are bonded.

In a case where $X^{D1}$ in Formula D1 represents $-NR^N-$, $R^N$ is preferably a hydrogen atom or an alkyl group having 1 to 4 carbon atoms, and more preferably a hydrogen atom.

Furthermore, $X^{D1}$ is preferably -O-.

In Formula D1, $R^{D1}$ is preferably a methyl group.

In Formula D1, m is preferably an integer of 1 to 4, more preferably 1 or 2, and even more preferably 1.

The ethylenically unsaturated group represented by $R^D$ in Formula D1 has the same definition as the ethylenically unsaturated group contained in the polymerizable resin RA described above. The ethylenically unsaturated group is particularly preferably a group represented by Formula D7.

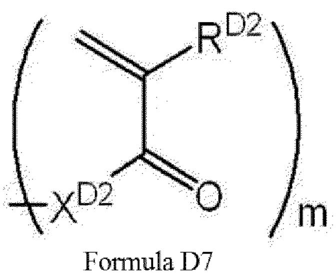

Formula D7

In Formula D7, $X^{D2}$ represents -O- or -NRN-, and $R^N$ represents a hydrogen atom or an alkyl group.

In Formula D7, $R^{D2}$ represents a hydrogen atom or a methyl group.

In Formula D7, m has the same definition as m in Formula D1, and the preferred aspects thereof are also the same. At least one of m pieces of $R^{D2}$ is preferably a methyl group.

$X^{D2}$ in Formula D7 is preferably -O- together with $X^{D1}$.

From the viewpoint of reactivity, the number of atoms between the ethylenically unsaturated group (for example, a (meth)acryloxy group) and the main chain of the addition polymerization-type resin is preferably 50 to 300, more preferably 69 to 278, and even more preferably 135 to 278.

Specific examples of the ethylenically unsaturated group-containing constitutional unit will be shown below, but the present invention is not limited thereto.

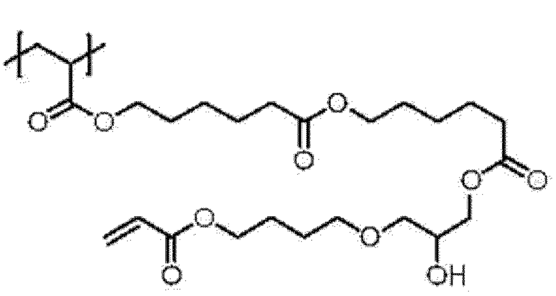

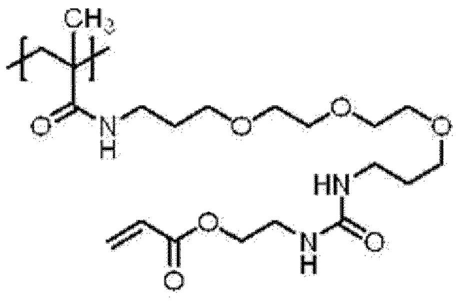

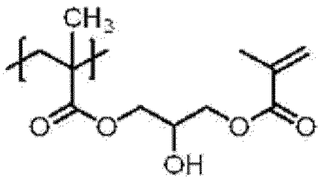

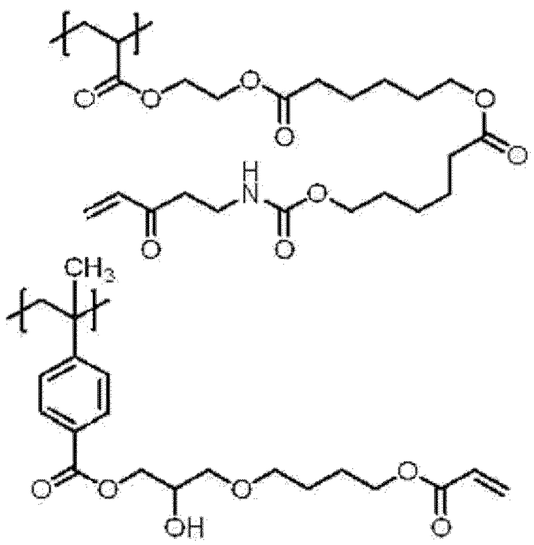

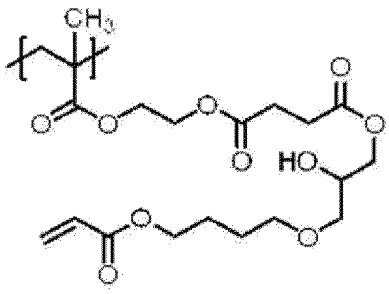

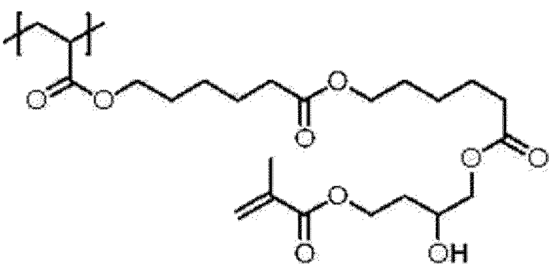

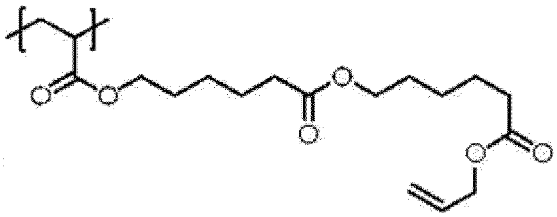

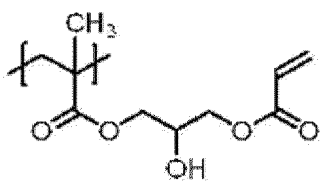

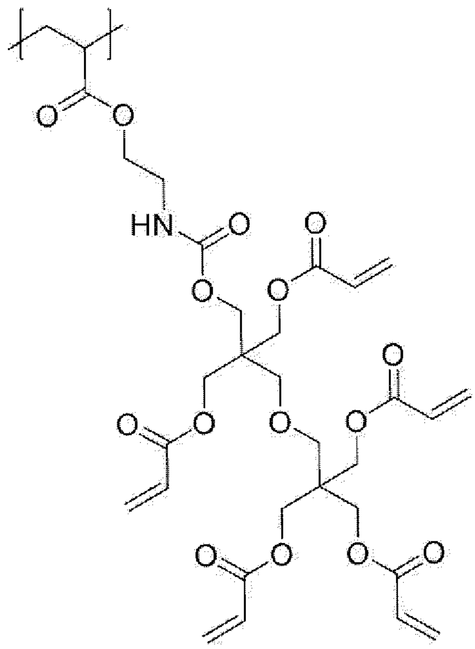

As described above, the ethylenically unsaturated group-containing constitutional unit (preferably the constitutional unit represented by Formula D1) is preferably introduced into the polymerizable resin RA1 by a method of introducing an ethylenically unsaturated group to the synthesized resin by a polymer reaction.

Hereinafter, the method of introducing an ethylenically unsaturated group into the synthesized resin by a polymer reaction will be described.

The ethylenically unsaturated group-containing constitutional unit can be introduced into the polymerizable resin RA1, for example, by a method of reacting a compound (such as glycidyl methacrylate) having an epoxy group and an ethylenically unsaturated group with a polymer having a constitutional unit having a carboxy group such as methacrylic acid, a method of reacting a compound (such as 2-isocyanatoethyl methacrylate) having an isocyanate group and an ethylenically unsaturated group with a polymer having a constitutional unit having an active hydrogen-containing group such as a hydroxyl group or an amino group, and the like.

The reaction rate of the compound having an epoxy group and an ethylenically unsaturated group or a compound having an isocyanate group and an ethylenically unsaturated group with respect to the constitutional unit having a carboxy group or the constitutional unit having an active hydrogen-containing group described above may be adjusted so that the constitutional unit having a carboxy group or the constitutional unit having an active hydrogen-containing group may remain in the polymerizable resin RA1.

The constitutional unit having a carboxy group and the constitutional unit having an active hydrogen-containing group described above are also generally called "constitutional unit before reaction", and these constitutional units into which an ethylenically unsaturated group has been introduced are also called "constitutional unit after reaction".

The aforementioned constitutional unit before reaction corresponds to the constitutional unit having a hydrophilic structure that will be described later. Therefore, the aforementioned reaction rate may be adjusted so that the polymerizable resin RA1 having both the ethylenically unsaturated group-containing constitutional unit and hydrophilic structure (such as a carboxy group or an amino group)-containing constitutional unit is obtained.

The reaction rate is, for example, preferably 10% or more and 100% or less, and more preferably 30% or more and 70% or less.

The reaction rate is a value defined by Equation R.

Equation R Reaction rate = (number of moles of constitutional unit after reaction in the obtained addition polymerization-type resin/total number of moles of constitutional unit before reaction in the obtained addition polymerization-type resin) $\times$ 100

Furthermore, the ethylenically unsaturated group-containing constitutional unit may be introduced into the polymerizable resin RA1 by a method of reacting a compound having a carboxy group and an ethylenically unsaturated group with a polymer containing a constitutional unit having an epoxy group such as glycidyl (meth)acrylate.

Furthermore, the ethylenically unsaturated group-containing constitutional unit may be introduced into the polymerizable resin RA1, for example, by a method of reacting a base compound with a polymer containing a constitutional unit having a partial structure represented by Formula d1 or Formula d2. In this method, an ethylenically unsaturated group is formed by the dissociation reaction of the partial structure represented by Formula d1 or Formula d2, which results in the

introduction of the ethylenically unsaturated group-containing constitutional unit into the polymerizable resin RA1.

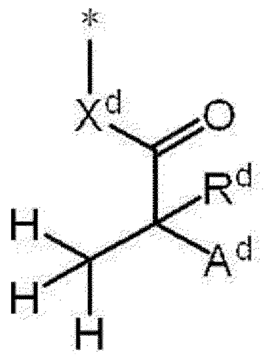

Formula d1

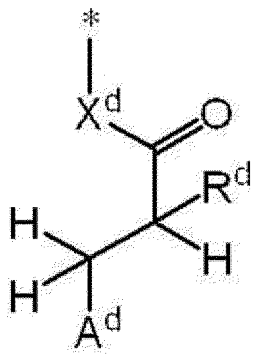

Formula d2

In Formula d1 and Formula d2, $R^d$ represents a hydrogen atom or an alkyl group, $A^d$ represents a halogen atom, $X^d$ represents -O- or -$NR^N$-, $R^N$ represents a hydrogen atom or an alkyl group, and * represents a binding site with other structures.

In Formula d1 and Formula d2, $R^d$ is preferably a hydrogen atom or a methyl group.

In Formula d1 and Formula d2, $A^d$ is preferably a chlorine atom, a bromine atom, or an iodine atom.

In Formula d1 and Formula d2, $X^d$ is preferably -O-. In a case where $X^d$ represents -$NR^N$-, $R^N$ is preferably a hydrogen atom or an alkyl group having 1 to 4 carbon atoms, and more preferably a hydrogen atom.

From the viewpoint of suppressing the occurrence of plate missing, the content of the ethylenically unsaturated group-containing constitutional unit in the polymerizable resin RA1 with respect to the total mass of the polymerizable resin RA1 (that is, an addition polymerization-type resin) is preferably 10% by mass to 70% by mass, more preferably 20% by mass to 70% by mass, even more preferably 30% by mass to 70% by mass, and particularly preferably 30% by mass to 60% by mass.

(Hydrophilic structure)

The polymerizable resin RA1 preferably has a hydrophilic structure in the molecule.

Particularly, from the viewpoint of making it easy to control the amount of a hydrophilic structure to be introduced, the polymerizable resin RA1 preferably contains a constitutional unit having a hydrophilic structure.

From the viewpoint of suppressing the occurrence of plate missing and from the viewpoint of on-press developability, suppression of residues of on-press development, and dispersion stability of the polymerizable resin particles A (particularly dispersion stability in water) as a hydrophilic structure, the polymerizable resin RA1 preferably has an ionic group or an acid group, and more preferably has an ionic group.

An ionic group refers to a group that can be at least partially dissociated as an anion or a cation in water. Furthermore, from the viewpoint of dispersion stability of the polymerizable resin particles A in water, the polymerizable resin RA1 more preferably has a sulfonate group (a salt of a sulfonic acid group) or a sulfonic acid group as a hydrophilic structure.

Meanwhile, from the viewpoint of suppressing the occurrence of plate missing and from the viewpoint of on-press developability, suppression of residues of on-press development, and dispersion stability of the polymerizable resin particles A (particularly dispersion stability in an organic solvent), the polymerizable resin RA1 preferably has a polyalkylene oxide structure or a polyester structure, and more preferably has a polyalkylene oxide structure, as a hydrophilic structure.

**In** addition, from the viewpoint of suppressing the occurrence of plate missing and from the viewpoint of on-press developability, suppression of residues of on-press development, and dispersion stability of the particles, the polymerizable resin RA1 particularly preferably has an ionic group or an acid group and a polyalkylene oxide structure, as hydrophilic structures.

Specifically, from the viewpoint of on-press developability, suppression of residues of on-press development, and dispersion stability of the particles (particularly dispersion stability in water), the acid group is preferably a sulfonic acid group, a carboxylic acid group, a phosphoric acid group, or a sulfuric acid monoester group, more preferably a sulfonic acid group or a carboxylic acid group, and particularly preferably a carboxylic acid group.

Specifically, from the viewpoint of on-press developability, suppression of residues of on-press development, and dispersion stability of particles (particularly dispersion stability in water), the ionic group is preferably a group that produces an anion by dissociation of counterion (that is, an anionic group), more preferably a salt of an acid group.

Specifically, a sulfonate group, a carboxylate group, or a sulfuric acid monoester salt group is even more preferable, and a carboxylate group is particularly preferable.

Here, the countercation of the salt of the acid group may be an inorganic cation or an organic cation, and is preferably an inorganic cation. The countercation may be not only a monovalent cation but also a polyvalent cation, and is preferably a monovalent cation.

As the inorganic cation, an alkali metal ion or an alkaline earth metal ion is more preferable, and an alkali metal ion is even more preferable. Specifically, a lithium ion, a sodium ion, or a potassium ion is particularly preferable.

Examples of the organic cation include a quaternary ammonium cation, a cation obtained by alkylating a nitrogen atom of an aromatic nitrogen-containing heterocycle, and the like.

Examples of the quaternary ammonium cation include a tetramethylammonium cation, a tetraethylammonium cation, and a dimethylbenzylammonium cation.

Examples of the cation obtained by alkylating a nitrogen atom of an aromatic nitrogen-containing heterocycle include a pyridinium cation.

Among these, as the countercation in the salt of the acid group, an alkali metal ion or a quaternary ammonium cation is preferable, and an alkali metal ion is particularly preferable.

Specifically, from the viewpoint of dispersion stability of the polymerizable resin particles A, particularly, from the viewpoint of dispersion stability in an organic solvent, the polyalkylene oxide structure is preferably a polyethylene oxide structure, a polypropylene oxide structure, or a poly(ethylene oxide/propylene oxide) structure.

Furthermore, from the viewpoint of on-press developability and suppressing the occurrence of development residues during on-press development, the polyalkylene oxide structure preferably includes a polypropylene oxide structure, and more preferably includes a polyethylene oxide structure and a polypropylene oxide structure.

From the viewpoint of dispersion stability of the polymerizable resin particles A, particularly, from the viewpoint of dispersion stability in an organic solvent, the number of alkylene oxide structures in the polyalkylene oxide structure is preferably 2 or more, more preferably 5 or more, even more preferably 5 to 200, and particularly preferably 8 to 150.

The polyester structure is not particularly limited. Specifically, preferable examples thereof include a lactone chain formed by ring-opening polymerization and a hydroxycarboxylic acid chain formed by polycondensation.

From the viewpoint of dispersion stability of particles, particularly, from the viewpoint of dispersion stability in an organic solvent, the number of hydroxycarboxylic acid structures (or ring-opened lactone structures) in the polyester structure is preferably 2 or more, more preferably 2 to 20, even more preferably 2 to 10, and particularly preferably 4 to 10.

The polymerizable resin RA1 preferably has a constitutional unit represented by Formula A-1, as a constitutional unit having an ionic group or an acid group that is a hydrophilic structure.

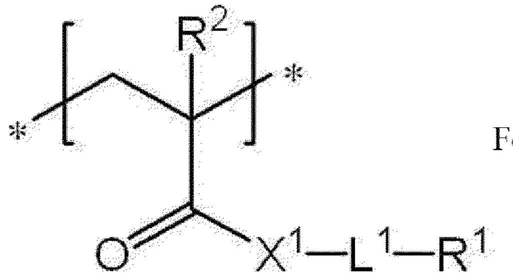

Formula A-1

In Formula A-1, $X^1$ represents -O- or -$NR^3$-, $L^1$ represents a divalent linking group having 1 to 20 carbon atoms, $R^1$ represents an ionic group or an acid group, $R^2$ represents a hydrogen atom or a methyl group, and $R^3$ represents a hydrogen atom, an alkyl group, or an aryl group.

In Formula A-1, the ionic group or acid group represented by $R^1$ is the same as the ionic group or acid group in the aforementioned hydrophilic structure, and the preferable examples thereof are also the same.

In Formula A-1, $X^1$ is preferably -O-.

In Formula A-1, $L^1$ is preferably a divalent linking group having 2 to 10 carbon atoms, more preferably a divalent linking group having 2 to 8 carbon atoms, even more preferably an alkylene group having 2 to 8 carbon atoms, and particularly preferably an alkylene group having 2 to 5 carbon atoms.

Specifically, the divalent linking group is preferably an alkylene group or a group in which one or more alkylene groups are bonded to at least one or more kinds of structures selected from the group consisting of an ether bond and an ester bond, and more preferably an alkylene group.

In Formula A-1, $R^3$ is preferably a hydrogen atom, an alkyl group having 1 to 4 carbon atoms, or a phenyl group, and more preferably a hydrogen atom.

The addition polymerization-type resin preferably has a constitutional unit represented by Formula A-3 or Formula A-4, and more preferably has a constitutional unit represented by Formula A-3, as a constitutional unit having a

polyalkylene oxide structure or a polyester structure that is a hydrophilic structure.

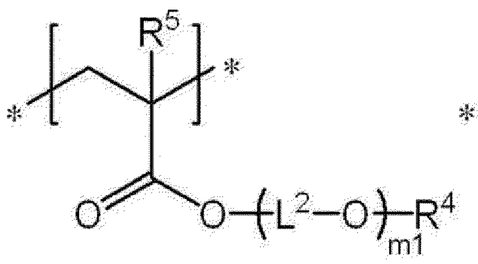

Formula A-3

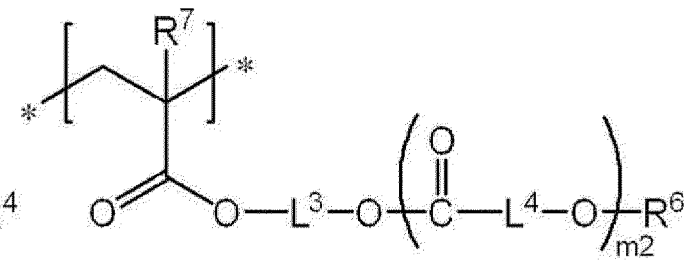

Formula A-4

In Formula A-3 and Formula A-4, $L^2$ represents an ethylene group or a propylene group, $L^3$ represents an alkylene group having 2 to 10 carbon atoms, $L^4$ represents an alkylene group having 1 to 10 carbon atoms, $R^4$ and $R^6$ each independently represent a hydrogen atom, an alkyl group, or an aryl group, $R^5$ and $R^7$ each independently represent a hydrogen atom or a methyl group, m1 represents an integer of 2 to 200, and m2 represents an integer of 2 to 20.

In Formula A-3, $L^2$ is preferably an ethylene group or a 1,2-propylene group.

In Formula A-4, $L^3$ is preferably an alkylene group having 2 to 8 carbon atoms, more preferably an alkylene group having 2 to 4 carbon atoms, and even more preferably an ethylene group.

In Formula A-4, $L^4$ is preferably an alkylene group having 2 to 8 carbon atoms, more preferably an alkylene group having 3 to 8 carbon atoms, and even more preferably an alkylene group having 4 to 6 carbon atoms.

In Formula A-3 and Formula A-4, $R^4$ and $R^6$ preferably each independently represent a hydrogen atom, an alkyl group having 1 to 4 carbon atoms, or a phenyl group, more preferably each independently represent a hydrogen atom or an alkyl group having 1 to 4 carbon atoms, and even more preferably each independently represent a hydrogen atom or a methyl group.

In Formula A-3, m1 is preferably an integer of 5 to 200, and more preferably an integer of 8 to 150.

In Formula A-4, m2 is preferably an integer of 2 to 10, and more preferably an integer of 4 to 10.

From the viewpoint of on-press developability, suppression of residues of on-press development, and dispersion stability of particles, the polymerizable resin RA1 particularly preferably has a constitutional unit represented by Formula A-1 and a constitutional unit represented by Formula A-3 or Formula A-4, and most preferably has a constitutional unit represented by Formula A-1 and a constitutional unit represented by Formula A-3.

From the viewpoint of on-press developability, suppression of residues of on-press development, and dispersion stability of the polymerizable resin particles A, the polymerizable resin RA1 preferably has a group represented by Formula Z, as a hydrophilic structure.

*-Q-W-Y        Formula Z

In Formula Z, Q represents a divalent linking group, W represents a divalent group having a hydrophilic structure or a divalent group having a hydrophobic structure, Y represents a monovalent group having a hydrophilic structure or a monovalent group having a hydrophobic structure, either W or Y has a hydrophilic structure, and * represents a binding site with other structures.

In Formula Z, Q is preferably a divalent linking group having 1 to 20 carbon atoms, and more preferably a divalent linking group having 1 to 10 carbon atoms.

Furthermore, the divalent linking group represented by Q is preferably an alkylene group, an arylene group, an ester bond, an amide bond, or a group formed by combining two or more of these, and more preferably a phenylene group, an ester bond, or an amide bond.

In Formula Z, the divalent group having a hydrophilic structure represented by W is preferably a polyalkyleneoxy group or a group in which $-CH_2CH_2NR^W-$ is bonded to one terminal of a polyalkyleneoxy group. $R^W$ represents a hydrogen atom or an alkyl group.

In Formula Z, the divalent group having a hydrophobic structure represented by W is preferably $-R^{WA}-$, $-O-R^{WA}-O-$, $-R^WN-R^{WA}-NR^W-$, $-OC(=O)-R^{WA}-O-$, or $-OC(=O)-R^{WA}-O-$. $R^{WA}$ each independently represents a linear, branched, or cyclic alkylene group having 6 to 120 carbon atoms, a haloalkylene group having 6 to 120 carbon atoms, an arylene group having 6 to 120 carbon atoms, or an aralkylene group having 6 to 120 carbon atoms. $R^W$ has the same definition as $R^W$ described above.

In Formula Z, the monovalent group having a hydrophilic structure represented by Y is preferably -OH, -C(=O)OH, a polyalkyleneoxy group having a hydrogen atom or an alkyl group on a terminal, or a group in which $-CH_2CH_2N(R^W)-$ is bonded to one terminal of a polyalkyleneoxy group having a hydrogen atom or an alkyl group on the other terminal. $R^W$ has the same definition as $R^W$ described above.

The monovalent group having a hydrophobic structure represented by Y is preferably a linear, branched, or cyclic alkyl group having 6 to 120 carbon atoms, a haloalkyl group having 6 to 120 carbon atoms, an aryl group having 6 to 120 carbon atoms, an alkylaryl group having 6 to 120 carbon atoms, an aralkyl group having 6 to 120 carbon atoms, $-OR^{WB}$, $-C(=O)OR^{WB}$, or $-OC(=O)R^{WB}$. $R^{WB}$ represents an alkyl group having 6 to 20 carbon atoms.

From the viewpoint of on-press developability, suppression of residues of on-press development, and dispersion stability of the polymerizable resin particles A, the content of the constitutional unit having a hydrophilic structure in the polymerizable resin RA1 with respect to the total mass of the polymerizable resin RA1 (that is, an addition polymerization-type resin) is preferably 1% by mass to 30% by mass, more preferably 3% by mass to 20% by mass, even more preferably 5% by mass to 15% by mass, and particularly preferably 5% by mass to 10% by mass.

In a case where the hydrophilic structure is an ionic group, from the viewpoint of on-press developability, suppression of residues of on-press development, and dispersion stability of the polymerizable resin particles A, the content of the constitutional unit having an ionic group in the polymerizable resin RA1 with respect to the total mass of the polymerizable resin RA1 (that is, an addition polymerization-type resin) is preferably 1% by mass to 30% by mass, more preferably 1% by mass to 20% by mass, even more preferably 3% by mass to 15% by mass, and particularly preferably 3% by mass to 10% by mass.

(Crosslinking structure)

The polymerizable resin RA1 may have a crosslinking structure in the molecule.

The crosslinking structure is not particularly limited, but is preferably introduced into the polymerizable resin RA1 by a constitutional unit which is formed by polymerizing a polyfunctional ethylenically unsaturated compound or a constitutional unit in which one or more kinds of reactive groups form a covalent bond in a resin.

From the viewpoint of suppressing the occurrence of plate missing, the number of functional groups in the polyfunctional ethylenically unsaturated compound is preferably 2 to 15, more preferably 3 to 10, even more preferably 4 to 10, and particularly preferably 5 to 10.

In other words, from the viewpoint of suppressing the occurrence of plate missing, the constitutional unit having a crosslinking structure is preferably a branched unit having 2 to 15 functional groups, more preferably a branched unit having 3 to 10 functional groups, even more preferably a branched unit having 4 to 10 functional groups, and particularly preferably a branched unit having 5 to 10 functional groups.

The branched unit having n functional groups refers to a branched unit from which n molecular chains branch off. In other words, it is a constitutional unit having an n-functional branch point (that is, a crosslinking structure).

The ethylenically unsaturated group in the polyfunctional ethylenically unsaturated compound is not particularly limited, and examples thereof include a (meth)acryloxy group, a (meth)acrylamide group, an aromatic vinyl group, a maleimide group, and the like.

The polyfunctional ethylenically unsaturated compound is preferably a polyfunctional (meth)acrylate compound, a polyfunctional (meth)acrylamide compound, or a polyfunctional aromatic vinyl compound.

Examples of the polyfunctional (meth)acrylate compound include diethylene glycol diacrylate, triethylene glycol diacrylate, tetraethylene glycol diacrylate, trimethylolpropane diacrylate, trimethylolpropane triacrylate, 1,4-butanediol diacrylate, 1,6-hexanediol diacrylate, polyethylene glycol diacrylate, polypropylene glycol diacrylate, tricyclodecanedimethylol diacrylate, ditrimethylolpropane tetraacrylate, pentaerythritol triacrylate, pentaerythritol tetraacrylate, dipentaerythritol triacrylate, dipentaerythritol hexaacrylate, triacrylate of tris(β-hydroxyethyl)isocyanurate, and the like.

Examples of the polyfunctional (meth)acrylamide compound include N,N'-methylenebisacrylamide, N-[tris(3-acrylamidepropoxymethyl)methyl]acrylamide, and the like.

Examples of the polyfunctional aromatic vinyl compound include divinyl benzene and the like.

The number of carbon atoms in the constitutional unit having a crosslinking structure is not particularly limited, but is preferably 8 to 100, and more preferably 8 to 70.

As the constitutional unit having a crosslinking structure, from the viewpoint of UV printing durability and suppressing the occurrence of plate missing, at least one kind of constitutional unit selected from the group consisting of the constitutional units represented by the following BR-1 to BR-17 is preferable. Furthermore, the constitutional unit having a crosslinking structure more preferably includes at least one kind of constitutional unit selected from the group consisting of constitutional units represented by the following BR-1 to BR-10 or BR-13 to BR-17. The constitutional unit having a crosslinking structure is even more preferably at least one kind of constitutional unit selected from the group consisting of constitutional units represented by the following BR-1 to BR-7 or BR-13 to BR-17, and particularly preferably a constitutional unit represented by the following BR-1.

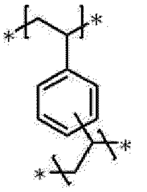
BR - 1

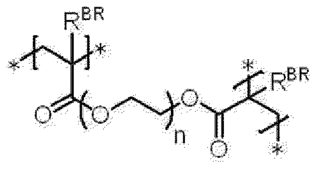
BR - 2

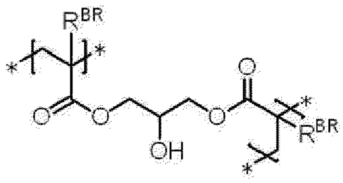
BR - 3

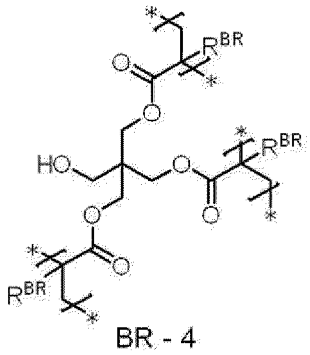
BR - 4

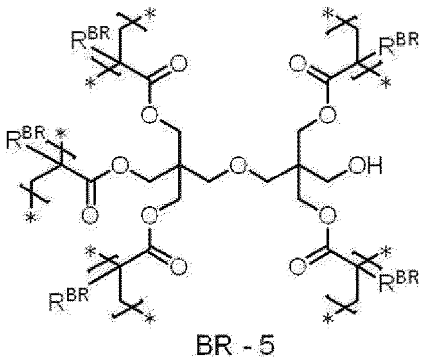
BR - 5

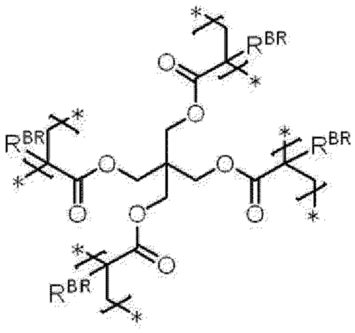
BR - 6

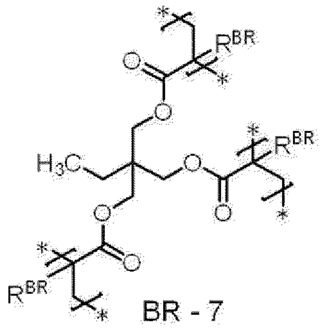
BR - 7

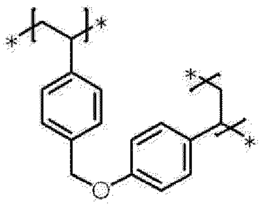
BR - 8

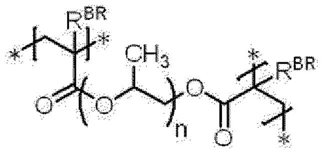
BR - 9

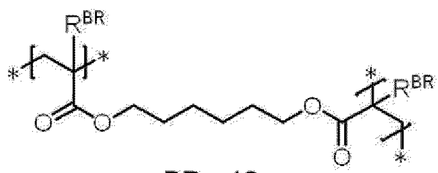
BR - 10

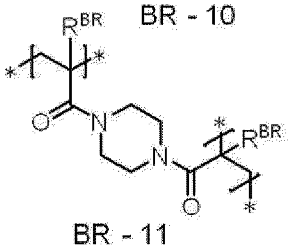
BR - 11

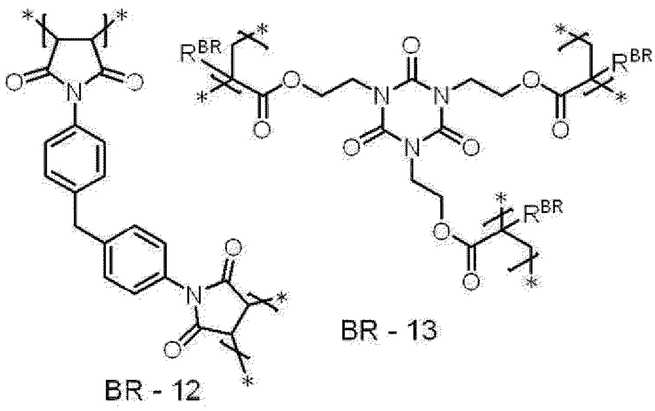
BR - 12

BR - 13

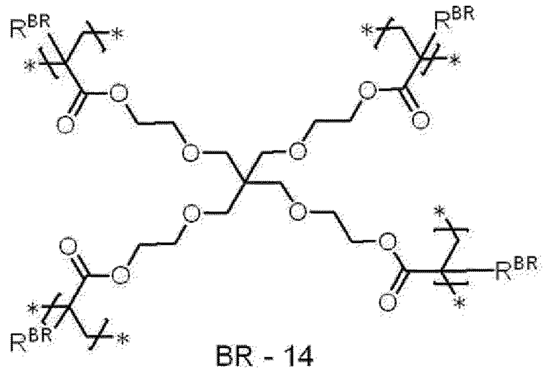

BR - 14

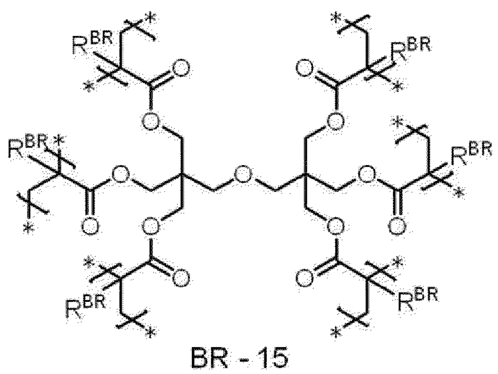

BR - 15

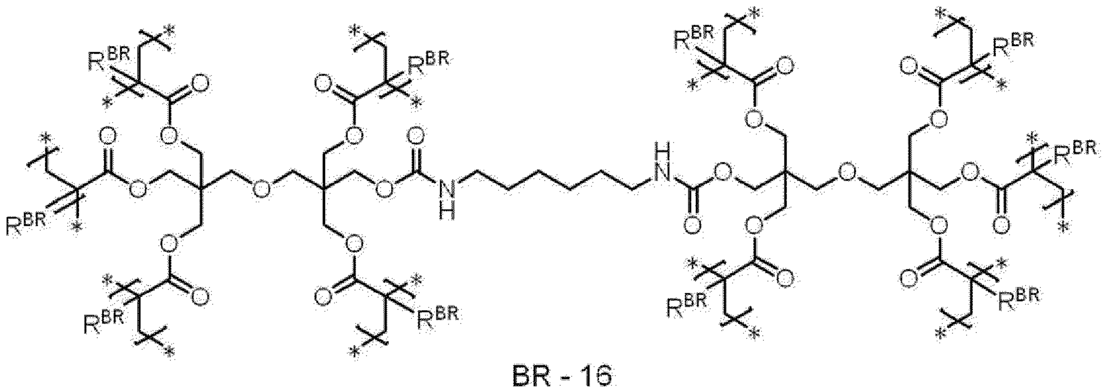

BR - 16

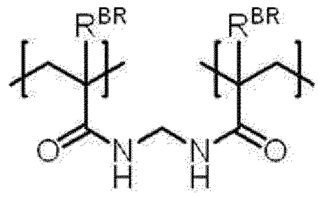

BR - 17

In the constitutional units represented by BR-1 to BR-17, $R^{BR}$ each independently represents a hydrogen atom or a methyl group, and n represents an integer of 1 to 20.

From the viewpoint of suppressing the occurrence of plate missing, the content of the constitutional unit having a crosslinking structure in the polymerizable resin RA1 with respect to the total mass of the polymerizable resin RA1 (that is, an addition polymerization-type resin) is preferably 1% by mass to 50% by mass, more preferably 3% by mass to 30% by mass, even more preferably 5% by mass to 20% by mass, and particularly preferably 5% by mass to 15% by mass.

-Other constitutional units-

The polymerizable resin RA1 may have constitutional units (other constitutional units) in addition to the constitutional unit having an ethylenically unsaturated bond, the constitutional unit having a hydrophilic structure, and the constitutional unit having a crosslinking structure described above.

Preferable examples of compounds (that is, monomers) forming those other constitutional units include an aromatic vinyl compound, a (meth)acrylate compound, a (meth)acrylonitrile compound, a (meth)acrylamide compound, a N-vinyl heterocyclic compound, a vinyl halide compound, a vinyl ester compound, a vinyl ether compound, and a monofunctional ethylenically unsaturated compound such as an $\alpha$-olefin compound.

Superficially, preferable examples of compounds (that is, monomers) forming those other constitutional units include styrene, methyl methacrylate, acrylonitrile, methacrylonitrile, N,N-dimethylacrylamide, 2-hydroxyethyl acrylate, and 2,3-dihydroxypropyl methacrylate, 2-ethylhexyl methacrylate, acryloyl morpholine, diacetone acrylamide, N-isopropylacrylamide, cyclohexyl methacrylate, acryloxymethyl ethylene carbonate, p-t-butylstyrene, methacrylamide, N-vinylpyrrolidone, and the like.

Among these, the polymerizable resin RA1 more preferably has at least one kind of constitutional unit selected

from the group consisting of a constitutional unit derived from an aromatic vinyl compound such as styrene, a constitutional unit derived from an acrylonitrile compound such as acrylonitrile, a constitutional unit derived from a N-vinyl heterocyclic compound such as N-vinylpyrrolidone, and a (meth)acrylate compound such as 2-hydroxyethyl acrylate, and particularly preferably has a constitutional unit derived from an aromatic vinyl compound. Particularly, the polymerizable resin RA1 preferably has a constitutional unit derived from acrylonitrile and a constitutional unit derived from styrene.

As the constitutional unit formed of an aromatic vinyl compound, for example, a constitutional unit represented by Formula A1 is preferable.

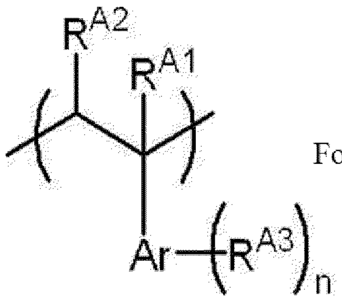

Formula A1

In Formula A1, $R^{A1}$ and $R^{A2}$ each independently represent a hydrogen atom or an alkyl group, Ar represents an aromatic ring group, $R^{A3}$ represents a substituent, and n represents an integer equal to or less than the maximum number of substituents of Ar.

In Formula A1, $R^{A1}$ and $R^{A2}$ preferably each independently represent a hydrogen atom or an alkyl group having 1 to 4 carbon atoms, more preferably each independently represent a hydrogen atom or a methyl group, and even more preferably both represent a hydrogen atom.

In Formula A1, Ar is preferably a benzene ring or a naphthalene ring, and more preferably a benzene ring.

In Formula A1, $R^{A3}$ is preferably an alkyl group or an alkoxy group, more preferably an alkyl group having 1 to 4 carbon atoms or an alkoxy group having 1 to 4 carbon atoms, and even more preferably a methyl group or a methoxy group.

In a case where there is a plurality of $R^{A3}$'s in Formula A1, the plurality of $R^{A3}$'s may be the same as or different from each other.

In Formula A1, n is preferably an integer of 0 to 2, more preferably 0 or 1, and even more preferably 0.

The aromatic vinyl compound for obtaining the aforementioned constitutional unit may have a structure composed of an aromatic ring and a vinyl group bonded thereto. Examples of the compound include a styrene compound, a vinylnaphthalene compound, and the like. Among these, a styrene compound is preferable, and styrene is more preferable.

Examples of the styrene compound include styrene, p-methylstyrene, p-methoxystyrene, β-methylstyrene, p-methyl-β-methylstyrene, α-methylstyrene, p-methoxy-β-methylstyrene, and the like. Among these, for example, styrene is preferable.

Examples of the vinylnaphthalene compound include 1-vinylnaphthalene, methyl-1-vinylnaphthalene, β-methyl-1-vinylnaphthalene, 4-methyl-1-vinylnaphthalene, 4-methoxy-1-vinylnaphthalene, and the like. Among these, for example, 1-vinylnaphthalene is preferable.

Preferable examples of the constitutional unit formed of an acrylonitrile compound include a constitutional unit represented by Formula B1.

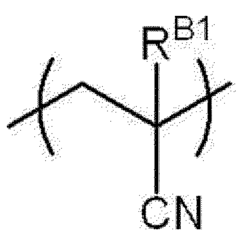

Formula B1

In Formula B1, $R^{B1}$ represents a hydrogen atom or an alkyl group.

In Formula B1, $R^{B1}$ is preferably a hydrogen atom or an alkyl group having 1 to 4 carbon atoms, more preferably a hydrogen atom or a methyl group, and even more preferably a hydrogen atom.

Examples of the acrylonitrile compound for obtaining the aforementioned constitutional unit include (meth) acrylonitrile and the like. Among these, for example, acrylonitrile is preferable.

Preferable examples of the constitutional unit formed of a N-vinyl heterocyclic compound include a constitutional

unit represented by Formula C1.

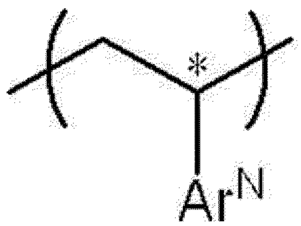

Formula C1

In Formula C1, $Ar^N$ represents a nitrogen atom-containing heterocyclic structure, and the nitrogen atom in $Ar^N$ is bonded to the carbon atom represented by *.

In Formula C1, the heterocyclic structure represented by $Ar^N$ is preferably a pyrrolidone ring, a carbazole ring, a pyrrole ring, a phenothiazine ring, a succinimide ring, a phthalimide ring, a caprolactam ring, or an imidazole ring, and more preferably a pyrrolidone ring.

Furthermore, the heterocyclic structure represented by $Ar^N$ may have a known substituent.

Examples of the N-vinyl heterocyclic compound for obtaining the aforementioned constitutional unit include N-vinylpyrrolidone, N-vinylcarbazole, N-vinylpyrrole, N-vinylphenothiazine, N-vinylsuccinic acid imide, N-vinylphthalimide, N-vinylcaprolactam, and N-vinylimidazole. Among these, N-vinylpyrrolidone is preferable.

The polymerizable resin RA1 may have one kind of those other constitutional units or two or more kinds of those other constitutional units. The polymerizable resin RA1 may not have those other constitutional units.

From the viewpoint of suppressing plate missing, sensitivity, on-press developability, and the like, the content of those other constitutional units in the polymerizable resin RA1 with respect to the total mass of the polymerizable resin RA1 (that is, an addition polymerization-type resin) is preferably 0% by mass to 90% by mass, more preferably 10% by mass to 70% by mass, even more preferably 20% by mass to 60% by mass, and particularly preferably 30% by mass to 60% by mass.

(Synthesis of polymerizable resin particles A containing polymerizable resin RA1)

The method for synthesizing the polymerizable resin particles A containing the polymerizable resin RA1 is not particularly limited as long as it is a method for synthesizing particles that contain the polymerizable resin RA1 and can achieve the ethylenically unsaturated bond valence described above. For example, known resin particle synthesis methods, such as emulsion polymerization, suspension polymerization, dispersion polymerization, soap-free polymerization, and microemulsion polymerization, are used.

From the viewpoint of synthesis suitability for various monomers, dispersibility of the polymerizable resin particles A (particularly, dispersibility in water), control of particle diameter and the like that will be described later, it is preferable to use emulsion polymerization as a method for synthesizing the polymerizable resin particles A containing the polymerizable resin RA1.

Examples of the method for synthesizing the polymerizable resin particles A containing the polymerizable resin RA1 include a method (1') of using a polyfunctional monomer having two or more ethylenically unsaturated groups at the time of synthesizing particles so that the ethylenically unsaturated groups remain in the synthesized particles and a method (2') of introducing an ethylenically unsaturated group into the synthesized particles by a polymer reaction. The latter method (2') is preferable.

Presumably, because the polymerizable resin particles A synthesized by the method (2') have many active ethylenically unsaturated groups on the surface thereof, the reactivity of the polymerizable resin particles A with the polymerizable compound B and the like that will be described later may be enhanced, and a firm crosslinking portion may be easily formed.

In the method (2'), the particles into which an ethylenically unsaturated group is to be introduced may be particles that contain a resin having no ethylenically unsaturated group or particles that contain a resin in which the content of an ethylenically unsaturated group is lower than the intended amount.

Furthermore, in the method (2'), in a case where the site to which an ethylenically unsaturated group is to be introduced (such as the aforementioned carboxy group or an active hydrogen-containing group) is close to the particle surface, more ethylenically unsaturated groups can be introduced into the surface of the polymerizable resin particles A.

As a method for synthesizing such polymerizable resin particles A, for example, a method that is in other words seed polymerization may be used in which the ratio of monomers used for synthesis is changed and the monomers are polymerized, so that there are many constitutional units having a carboxy group such as methacrylic acid or constitutional units having an active hydrogen-containing group (the aforementioned constitutional unit before reaction), which are described above, at sites close to the particle surface.

Specific examples of the polymerizable resin RA1 include the following ones, but the polymerizable resin RA1 is not limited thereto.

In the following specific examples, n represents an integer of 2 to 200.

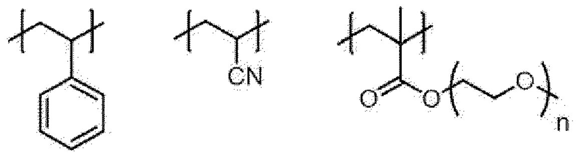

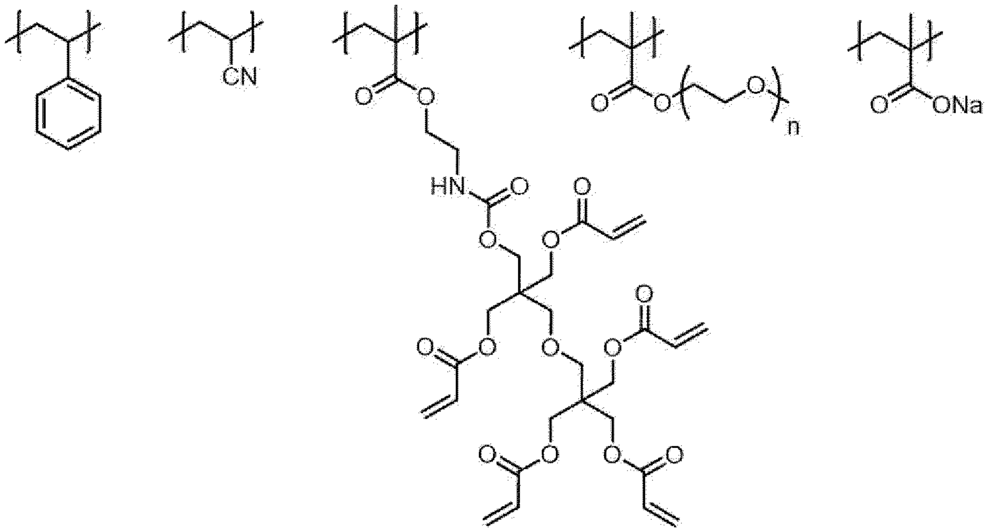

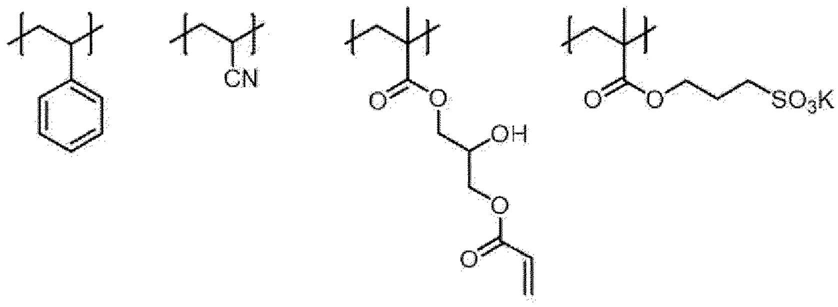

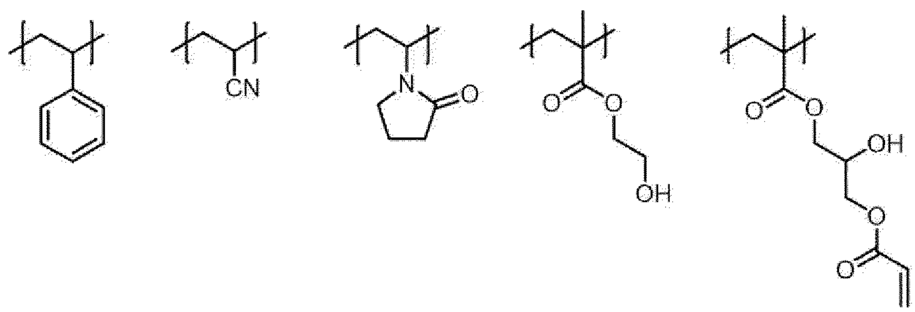

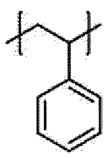 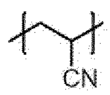 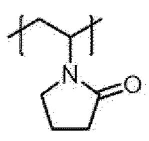 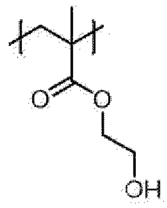 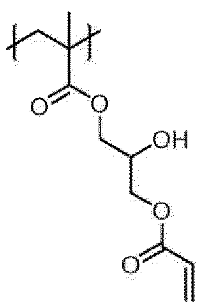 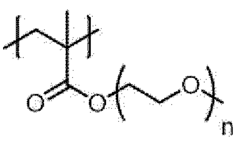

-Polymerizable resin RA2 as another resin-

The polymerizable resin RA in the present invention is not limited to the addition polymerization-type resin, and may be a polycondensation-type resin or a polyaddition-type resin.

The polycondensation-type resin refers to a resin obtained by a polycondensation reaction, and the polyaddition-type resin refers to a resin obtained by a polyaddition reaction. Examples of the polycondensation-type resin include polyamide, polyester, and the like. Examples of the polyaddition-type resin include polyurethane, polyurea, polyurethane urea, polycarbonate, and the like.

More specifically, examples of the polymerizable resin RA2 other than the polymerizable resin RA1 as an addition polymerization-type resin (hereinafter, also called polymerizable resin RA2) include resins having an ethylenically unsaturated group and at least one kind of bond selected from the group consisting of a urea bond, a urethane bond, an amide bond, a carbonate bond, an ester bond, and an imide bond on a main chain, and the like. Among these, a resin having an ethylenically unsaturated group and at least one kind of bond selected from the group consisting of a urea bond, a urethane bond, an amide bond, and an ester bond on a main chain is preferable, and a resin having an ethylenically unsaturated group and at least one kind of bond selected from the group consisting of a urea bond and a urethane bond on a main chain is more preferable.

More specifically, the polymerizable resin RA2 is preferably polyurea, polyurethane, polyurethane urea, polyamide, or polyester having an ethylenically unsaturated group, and more preferably polyurea or polyurethane having an ethylenically unsaturated group.

The polymerizable resin RA2 may be in the form of microgel (crosslinkable resin particles). The microgel may or may not have an ethylenically unsaturated group. The polymerizable resin particles A formed of microgel are preferably microgel encapsulating a compound having an ethylenically unsaturated group (for example, a monomer).

Even being exposed, the compound having an encapsulated ethylenically unsaturated group (for example, a monomer) remains unreacted in the microgel or has a cross-linking reaction only in the microgel. Presumably, as a result, the compound having an encapsulated ethylenically unsaturated group that is to be encapsulated in the microgel (for example, a monomer) may be unlikely to react with the polymerizable compound B and unlikely to contribute to the curing of an exposed portion.

Specifically, the microgel is preferably obtained by the reaction between a polyvalent isocyanate compound that is an adduct of a polyhydric phenol compound having two or more hydroxyl groups in a molecule and isophorone diisocyanate and a compound having active hydrogen.

As the polyhydric phenol compound, a compound having a plurality of benzene rings having a phenolic hydroxyl group is preferable.

As the compound that has a compound having active hydrogen, a polyol compound or a polyamine compound is preferable, a polyol compound is more preferable, and at least one kind of compound selected from the group consisting of propylene glycol, glycerin, and trimethylol propane is even more preferable.

As resin particles obtained by the reaction between a polyvalent isocyanate compound that is an adduct of a polyhydric phenol compound having two or more hydroxyl groups in a molecule and isophorone diisocyanate and a compound having active hydrogen, for example, the polymer particles described in paragraphs "0032" to "0095" of JP2012-206495A are preferable.

The polymerizable resin RA2 preferably has a hydrophilic structure. The hydrophilic structure is the same as the hydrophilic structure of the polymerizable resin RA1, and the preferred aspects thereof are also the same.

Particularly, from the viewpoint of printing durability, receptivity, special color receptivity, suppression of UV plate missing, on-press developability, and suppression of development residues during on-press development, the polymerizable resin RA2 is preferably a resin containing a urea bond.

More specifically, the polymerizable resin RA2 is more preferably a resin that contains a urea bond and has a structure obtained by reacting at least an isocyanate compound represented by Formula (Iso) with water, and particularly preferably includes a resin that has a structure obtained by reacting at least an isocyanate compound represented by

Formula (Iso) with water and has a polyethylene oxide structure and a polypropylene oxide structure as polyoxyalkylene structures.

Furthermore, in the polymerizable resin RA2, the particles that contain the resin containing a urea bond are preferably microgel (that is, crosslinked resin particles).

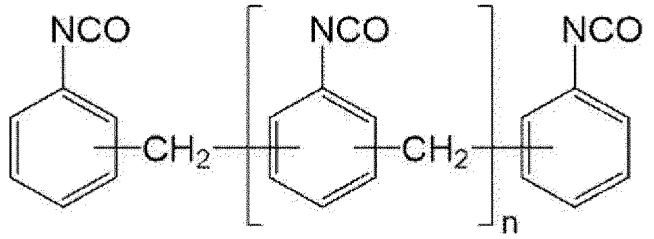

( Iso )

In Formula (Iso), n represents an integer of 0 to 10.

An example of the reaction between the isocyanate compound represented by Formula (Iso) and water is the reaction shown below. In the following example, a 4,4-isomer in which n = 0 is used.

As shown below, in a case where the isocyanate compound represented by Formula (Iso) is reacted with water, the isocyanate group is partially hydrolyzed by water and generates an amino group. The generated amino group reacts with the isocyanate group and generates a urea bond, and a dimer is consequently formed. Furthermore, the following reaction is repeated to form a resin having a urea bond.

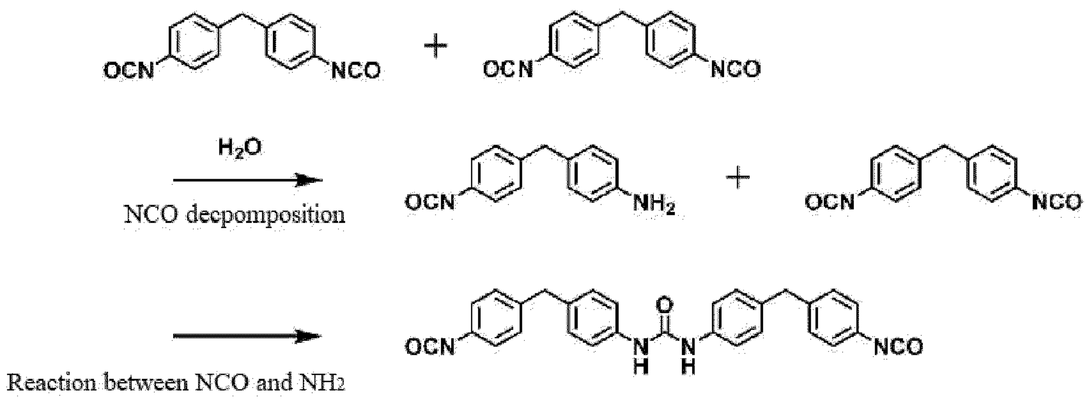


The resin containing a urea bond, which is one of the specific resins a2, has an ethylenically unsaturated group. The ethylenically unsaturated group more preferably has a group represented by Formula (PETA).

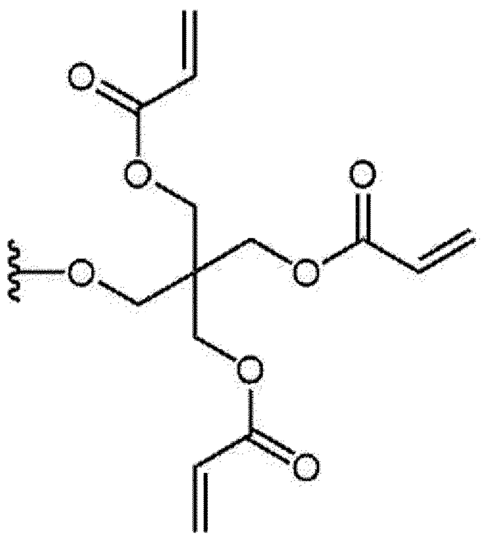

( PETA )

In Formula (PETA), the portion of the wavy line represents a binding position with other structures.

In the reaction between the isocyanate compound represented by Formula (Iso) and water, a compound (for example, a compound having active hydrogen) such as an alcohol compound or an amine compound reactive with an isocyanate group can be added so that the structure of an alcohol compound, an amine compound, or the like is introduced into the polymerizable resin RA2.
Examples of the compound having active hydrogen include the aforementioned compounds having active hydrogen used in microgel, and preferred aspects thereof are also the same.

(Other components)

Examples of components other than the polymerizable resin RA contained in the polymerizable resin particles A (hereinafter, also called other components) include a compound having an ethylenically unsaturated group (for example, a monomer), a polymerization initiator residue, a low-molecular-weight surfactant, and the like.
The content of those other components with respect to the total mass of the polymerizable resin particles A is preferably 20% by mass or less, more preferably 10% by mass or less, even more preferably 5% by mass or less, and particularly preferably 0% by mass. That is, it is particularly preferable that the polymerizable resin particles A be particles consisting of the polymerizable resin RA without containing other components.
Specific examples of the polymerizable resin particles A containing the polymerizable resin RA1 include particles R-2 to R-6 synthesized in Examples, but the polymerizable resin particles A are not limited thereto.
Specific examples of the polymerizable resin particles A containing the polymerizable resin RA2 include particles R-1 and R-7 to R-11 synthesized in Examples, but the polymerizable resin particles A are not limited thereto.

-Particle characteristics-

<<Dispersibility>>

From the viewpoint of developability and on-press developability, the polymerizable resin particles A are preferably water-dispersible particles.
In the present specification, "water-dispersible particles" means that in a case where 5.0 g of particles are mixed with 100 mL of water in an environment of 20°C, dispersed by stirring at a stirring speed of 300 rpm (revolutions per minute, the same shall be applied hereinafter) for 10 minutes, and left to stand in an environment at 20°C for 1 hour, no precipitate is visually observed, or a small amount of precipitate is visually observed but can be easily redispersed.
The polymerizable resin particles A are preferably particles that do not generate visually observed precipitates even after being left to stand for 1 hour as described above or generate small amounts of visually observed precipitates being able to be easily redispersed, and more preferably particles that do not generate visually observed precipitates and exhibit excellent dispersibility.
From the viewpoint of printing durability and developability, the polymerizable resin particles A preferably have dispersibility in an organic solvent.
In the present specifcation, "dispersibility in an organic solvent" refers to a property of being dispersed in at least one organic solvent among MEK/MFG/methanol = 48/30/22 (mass ratio, SP value = 11.1), 1-propanol/water = 1,1 (mass ratio, SP value = 17.7), and simple alcoholic organic solvents (methanol, ethanol, 1-propanol, 2-propanol, 1-butanol, MFG, and the like). These organic solvents may be used as a coating solvent that will be described later to form an image-recording layer in the lithographic printing plate precursor according to the present specification.
In the present specification, MEK represents methyl ethyl ketone, and MFG represents 1-methoxy-2-propanol.
In the present specification, "particles having dispersibility in an organic solvent" refers to particles that generate small amounts of visually observed precipitates being able to be easily redispersed, in a case where 5.0 g of the particles are mixed with 100 mL of at least one of the above organic solvents in an environment at 20°C, dispersed by stirring at a stirring speed of 300 rpm for 10 minutes, and left to stand for 1 hour in an environment at 20°C.
The polymerizable resin particles A are preferably particles that generate small amounts of visually observed precipitates after being left to stand for 1 hour as described above but the precipitates can be easily redispersed, or do not generate visually observed precipitates and exhibit excellent dispersibility.
In a case where the polymerizable resin particles A are particles having dispersibility in an organic solvent, the image-recording layer can be formed by coating by using a coating solution in which the particles are excellently dispersed. Presumably, in a case where the image-recording layer is formed using such a coating solution, the polymerizable resin particles A are unlikely to be aggregated during coating, the condition of the coating surface of the image-recording layer may be excellent accordingly, and excellent printing durability, developability, and on-press developability may be easily obtained.
The SP value of the organic solvent preferable as a coating solvent is 9.3 to 18.0, more preferably 10.0 to 15.0, and even more preferably 10.5 to 12.5.

It is preferable that the polymerizable resin particles A can be dispersed in an organic solvent having the above SP value.

The SP values of typical organic solvents are as follows.

MEK (SP value = 9.3), MFG (SP value = 11.2), methanol (SP value = 14.7), ethanol (SP value = 12.4), 1-propanol (SP value = 11.9), 2-propanol (SP value = 11.2), 1-butanol (SP value = 11.4), water (SP value = 23.4)

The SP value is calculated by the Okitsu method (Toshinao Okitsu, "Journal of the Adhesion Society of Japan" 29 (5) (1993)).

Specifically, the SP value is calculated by the following equation. Note that $\Delta F$ is a value described in the document.

$$\text{SP value } (\delta) = \Sigma\Delta F \text{ (Molar Attraction Constants)/V (molar volume)}$$

The unit of the SP value is $MPa^{1/2}$.

In a case where a mixture of a plurality of organic solvents is used as an organic solvent, the SP value is determined as a weighted average according to the mass ratio of the content of the organic solvents.

Specifically, the weighted average is "X" obtained by the following formula 1.

Specifically, the SP value of an organic solvent A containing two or more kinds of organic solvents equals X calculated by putting the SP value of i kind of (i represents an integer of 1 or more) organic solvent contained in the organic solvent A into Si in the following formula 1, and putting the mass ratio of the content of the i kind of organic solvent to the total mass of the organic solvent A into Wi.

$$X = \frac{\sum(Si \times Wi)}{\sum Wi} \qquad \text{Formula 1}$$

<<Median diameter>>

From the viewpoint of suppressing the occurrence of plate missing, the particle diameter of the specific particles expressed as median diameter is preferably 1,000 nm or less, and more preferably 50 nm to 300 nm.

The method for measuring the median diameter is as described above.

<<Coefficient of variation>>

The coefficient of variation of the particle diameter of the polymerizable resin particles A is preferably 100% or less, more preferably 40% or less, and even more preferably 25% or less.

The lower limit of the coefficient of variation is not particularly limited, and may be 0%.

By appropriately setting reaction conditions, such as stirring speed and temperature, in synthesizing the particles or by increasing the content of the hydrophilic structure (particularly, the amount of polyalkylene oxide structures) in the case of the polymerizable resin RA1, the coefficient of variation can be reduced.

In the present specification, the coefficient of variation of the particle diameter of the polymerizable resin particles A is measured by direct observation of the particle diameter by using the following microscopy.

The aforementioned measurement by direct observation of the particle diameter by using microscopy will be specifically described.

1. Sample preparation

A dispersion (1 g) containing the polymerizable resin particles A is developed on an aluminum cup, solidified by natural drying, and pulverized in a mortar to obtain a powder sample.

2. SEM measurement

The obtained sample is measured with a scanning electron microscope (SEM, manufactured by JEOL Ltd.). Two visual fields including 50 or more particles are obtained, and then diameters of all the particles are measured by the Ferret method (sandwiched by parallel lines: distance between parallel lines = diameter), thereby obtaining particle diameters of 100 or more particles.

3. Coefficient of variation

The particle diameters are expanded in order, the point at which the number of large-diameter particles is the same as the number of small-diameter particles is adopted as a median particle diameter just as the definition of the median diameter, and the coefficient of variation of the particles is determined by microscopy from the range of fluctuation from the median particle diameter.
One kind of polymerizable resin particles A may be used alone, or two or more kinds of polymerizable resin particles A may be used in combination.
In the image-recording layer of the lithographic printing plate precursor, from the viewpoint of suppressing the occurrence of plate missing, the content of the polymerizable resin particles A with respect to the total mass of the image-recording layer is preferably 10% by mass to 60% by mass, more preferably 20% by mass to 60% by mass, and even more preferably 20% by mass to 55% by mass. From the viewpoint of suppressing the occurrence of plate missing and from the viewpoint of on-press developability, the content of the polymerizable resin particles A is even more preferably 25% by mass to 55% by mass, and particularly preferably 30% by mass to 55% by mass.

[Polymerizable compound B]

The polymerizable compound B in the present invention is a compound having an ethylenically unsaturated group other than the polymerizable resin particles A.
In the present specification, the binder polymer that will be described later is not included in the polymerizable compound B, even though the binder polymer is a compound having an ethylenically unsaturated group other than the polymerizable resin particles A.
The ethylenically unsaturated group contained in the polymerizable compound B is the same as the ethylenically unsaturated group contained in the polymerizable resin RA, and the preferable examples thereof are also the same.
The molecular weight of the polymerizable compound B (weight-average molecular weight in a case where the compound has molecular weight distribution) is preferably 2,500 or less, more preferably 50 to 2,500, and even more preferably 70 to 2,000. Furthermore, an aspect in which the polymerizable compound B has a molecular weight (weight-average molecular weight in a case where the compound has molecular weight distribution) of 200 to 2,500 is one of the preferred aspects.
The polymerizable compound B is an addition polymerizable compound having at least one ethylenically unsaturated group (that is, an ethylenically unsaturated compound). The polymerizable compound B preferably has two or more ethylenically unsaturated groups, and more preferably has three or more ethylenically unsaturated groups. The number of ethylenically unsaturated groups contained in the polymerizable compound B is preferably 20 or less, for example.
From the viewpoint of suppressing the occurrence of plate missing, the ethylenically unsaturated bond valence of the polymerizable compound B is, for example, preferably 1 mmol/g to 12 mmol/g, more preferably 5 mmol/g to 12 mmol/g, and even more preferably 7 mmol/g to 12 mmol/g.
The chemical form of the polymerizable compound B is, for example, a monomer or a prepolymer which is in other words a dimer, a trimer, or an oligomer, a mixture of these, or the like.

-Oligomer-

The polymerizable compound B preferably includes an oligomer.
**In** the present specification, an oligomer represents a polymerizable compound which has a molecular weight (weight-average molecular weight in a case where the compound has molecular weight distribution) of 600 to 10,000 and at least one ethylenically unsaturated group.
From the viewpoint of excellent chemical resistance and excellently suppressing residues of on-press development, the molecular weight of the oligomer is preferably 1,000 to 5,000, and more preferably 1,000 to 2,500.
Furthermore, from the viewpoint of improving chemical resistance, the number of ethylenically unsaturated groups in one molecule of the oligomer is preferably 2 or more, more preferably 3 or more, even more preferably 6 or more, and particularly preferably 10 or more.
The upper limit of the number of ethylenically unsaturated groups in the oligomer is not particularly limited, but is preferably 20 or less.
From the viewpoint of further improving chemical resistance and further suppressing residues of on-press development, the oligomer preferably has 7 or more ethylenically unsaturated groups and a molecular weight of 1,000 to 10,000 or less, and more preferably has 7 to 20 ethylenically unsaturated groups and a molecular weight of 1,000 to 5,000 (more preferably 1,000 to 2,500).
From the viewpoint of further improving chemical resistance, the oligomer is preferably at least one kind of

compound selected from the group consisting of a compound having a urethane bond, a compound having an ester bond, and a compound having an epoxy residue, and more preferably a compound having a urethane bond.

**In** the present specification, an epoxy residue refers to a structure formed of an epoxy group. For example, the epoxy residue means a structure similar to a structure established by the reaction between an acid group (carboxylic acid group or the like) and an epoxy group.

<<Compound having urethane bond>>

The compound having a urethane bond is not particularly limited. Examples thereof include a compound obtained by a reaction between a polyisocyanate compound and a compound having a hydroxyl group and an ethylenically unsaturated group.

Examples of the polyisocyanate compound include polyisocyanate compounds having 2 to 5 functional groups. Among these, a polyisocyanate compound having 2 or 3 functional groups is preferable.

As the polyisocyanate compound, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9H-fluorene-2,7-diisocyanate, 9H-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

As the compound having a hydroxyl group and ethylenically unsaturated group, a compound having one hydroxyl group and one or more ethylenically unsaturated groups is preferable, and a compound having one hydroxyl group and two or more ethylenically unsaturated groups is more preferable.

Examples of the compound having a hydroxyl group and an ethylenically unsaturated group include hydroxyethyl (meth)acrylate, glycerin di(meth)acrylate, trimethylolpropane di(meth)acrylate, pentaerythritol tri(meth)acrylate, dipentaerythritol penta(meth)acrylate, and the like.

As the compound having a urethane bond, for example, a compound having at least a group represented by Formula (Ac-1) or Formula (Ac-2) is preferable, and a compound having at least a group represented by Formula (Ac-1) is more preferable.

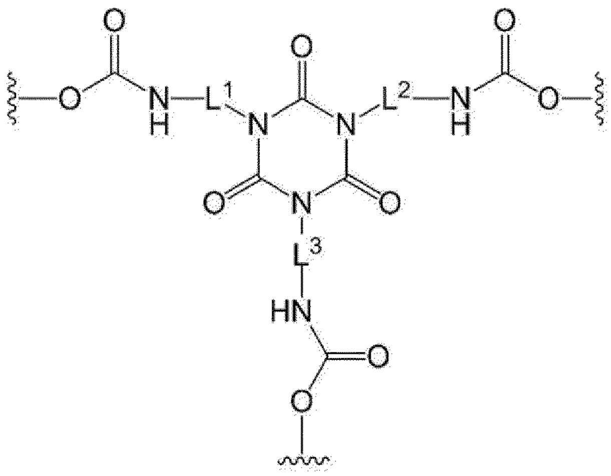

( Ac - 1 )

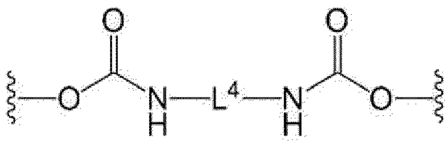

( Ac - 2 )

**In** Formula (Ac-1) and Formula (Ac-2), $L^1$ to $L^4$ each independently represent a divalent hydrocarbon group having 2 to 20 carbon atoms, and the portion of the wavy line represents a binding position with other structures.

**In** Formula (Ac-1) and Formula (Ac-2), $L^1$ to $L^4$ preferably each independently represent an alkylene group having 2 to 20 carbon atoms, more preferably each independently represent an alkylene group having 2 to 10 carbon atoms, and even more preferably each independently represent an alkylene group having 4 to 8 carbon atoms. The alkylene group may have a branched structure or a ring structure. The alkylene group is preferably a linear alkylene group.

The portion of the wavy line in Formula (Ac-1) or Formula (Ac-2) is preferably each independently directly bonded to the portion of the wavy line in a group represented by Formula (Ae-1) or Formula (Ae-2).

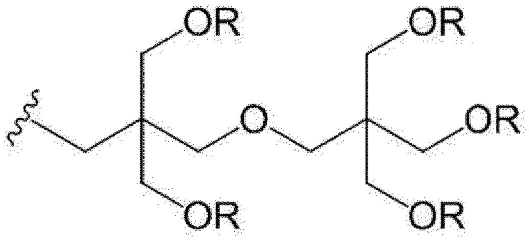

(Ae - 1)

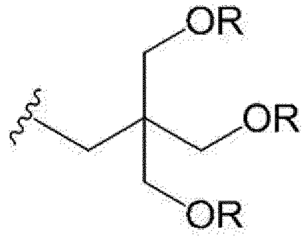

(Ae - 2)

In Formula (Ae-1) and Formula (Ae-2), R each independently represents an acryloyloxy group or a methacryloyloxy group, and the portion of the wavy line represents a binding position with the portion of the wavy line in Formula (Ac-1) and Formula (Ac-2).

As the compound having a urethane bond, a compound may also be used which is prepared by obtaining polyurethane oligomer by a reaction between a polyisocyanate compound and a polyol compound and introducing an ethylenically unsaturated group into the polyurethane oligomer by a polymer reaction. For example, the compound having a urethane bond may be obtained by reacting a polyol compound having an acid group with a polyisocyanate compound so as to obtain a polyurethane oligomer and reacting this polyurethane oligomer with a compound having an epoxy group and an ethylenically unsaturated group.

<<Compound having ester bond>>

The number of ethylenically unsaturated groups in the compound having an ester bond is preferably 3 or more, and more preferably 6 or more.

<<Compound having epoxy residue>>

As the compound having an epoxy residue, a compound containing a hydroxyl group is preferable.

The number of ethylenically unsaturated groups in the compound having an epoxy residue is preferably 2 to 6, and more preferably 2 or 3.

The compound having an epoxy residue can be obtained, for example, by reacting a compound having an epoxy group with an acrylic acid.

As the oligomer used as the polymerizable compound B, commercially available products may also be used. Examples thereof include UA-510H, UA-306H, UA-306I, and UA-306T (manufactured by KYOEISHA CHEMICAL Co., LTD.), UV-1700B, UV-6300B, and UV7620EA (manufactured by NIHON GOSEI KAKO Co., Ltd.), U-15HA (manufactured by SHIN-NAKAMURA CHEMICAL Co, LTD.), EBECRYL450, EBECRYL657, EBECRYL885, EBECRYL800, EBECRYL3416, and EBECRYL860 (manufactured by DAICEL-ALLNEX LTD.), and the like. However, the oligomer is not limited to these.

From the viewpoint of improving chemical resistance and further suppressing residues of on-press development, the content of the aforementioned oligomer with respect to the total mass of the polymerizable compound B in the image-recording layer is preferably 30% by mass to 100% by mass, more preferably 50% by mass to 100% by mass, and even more preferably 80% by mass to 100% by mass.

(Polymerizable compound B1)

From the viewpoint of improving printing durability, the specific compound B may include a compound having an ethylenically unsaturated bond valence of 5.0 mmol/g or more (hereinafter, also called polymerizable compound B1).

The ethylenically unsaturated bond valence of the polymerizable compound B1 is preferably 5.5 mmol/g or more, and more preferably 6.0 mmol/g or more. The upper limit of the ethylenically unsaturated bond valence of the polymerizable compound B1 is, for example, 10.0 mmol/g or less, and more preferably 8.5 mmol/g or less.

In the present specification, the ethylenically unsaturated bond valence of a compound is determined by the following method. First, for a predetermined amount (for example, 0.2 g) of sample compound, the structure of the compound is specified using, for example, pyrolysis GC/MS, FT-IR, NMR, TOF-SIMS, and the like, and the total amount (mmol) of ethylenically unsaturated groups is determined. The determined total amount (mmol) of ethylenically unsaturated groups is divided by the amount (g) of the sample compound, thereby calculating the ethylenically unsaturated bond valence of the compound.

The polymerizable compound B1 is preferably a compound represented by Formula (I), because such a compound satisfies the C=C valence described above.

Formula (I): X-(Y)n

**In** Formula (I), X represents an n-valent organic group having a hydrogen bonding group, Y represents a monovalent group having 2 or more ethylenically unsaturated groups, n represents an integer of 2 or more, and molecular weight of X/(molecular weight of Y × n) is 1 or less.

The hydrogen bonding group represented by X in Formula (I) is not particularly limited as long as it is a group capable of forming a hydrogen bond. The hydrogen bonding group may be a hydrogen bond donating group or a hydrogen bond accepting group. Examples of the hydrogen bonding group include a hydroxyl group, a carboxy group, an amino group, a carbonyl group, a sulfonyl group, a urethane group, a urea group, an imide group, an amide group, a sulfonamide group, and the like. Particularly, from the viewpoint of on-press developability and printing durability, the compound preferably contains, as the hydrogen bonding group, at least one kind of group selected from the group consisting of a urethane group, a urea group, an imide group, an amide group, and a sulfonamide group, more preferably contains at least one kind of group selected from the group consisting of a urethane group, a urea group, an imide group, and an amide group, even more preferably contains at least one kind of group selected from the group consisting of a urethane group, a urea group, and an imide group, and particularly preferably contains at least one kind of group selected from the group consisting of a urethane group and a urea group.

X in Formula (I) is preferably an organic group that does not have an ethylenically unsaturated bond.

Furthermore, from the viewpoint of on-press developability and printing durability, X in Formula (I) is preferably a group obtained by combining two or more kinds of structures selected from the group consisting of a mono- to n-valent aliphatic hydrocarbon group, a mono- to n-valent aromatic hydrocarbon group, a urethane bond, a urea bond, a biuret bond, and an allophanate bond, and more preferably a group obtained by combining two or more kinds of structures selected from the group consisting of a mono- to n-valent aliphatic hydrocarbon group, a mono- to n-valent aromatic hydrocarbon group, a urethane bond, a urea bond, and a biuret bond.

From the viewpoint of on-press developability and printing durability, X in Formula (I) is preferably a group obtained by removing a terminal isocyanate group from a substance prepared by multimerization of a polyfunctional isocyanate compound (including an adduct of a polyfunctional alcohol compound such as trimethylolpropane adduct), more preferably a group obtained by removing a terminal isocyanate group from a substance prepared by multimerization of a difunctional isocyanate compound (including an adduct of a polyfunctional alcohol compound), and particularly preferably a group obtained by removing a terminal isocyanate group from a substance prepared by multimerization of hexamethylene diisocyanate (including an adduct of a polyfunctional alcohol compound).

From the viewpoint of on-press developability and printing durability, the molecular weight of X in Formula (I) is preferably 100 to 1,000, more preferably 150 to 800, and particularly preferably 150 to 500.

The ethylenically unsaturated group represented by Y in Formula (I) is not particularly limited. From the viewpoint of reactivity, on-press developability, and printing durability, the ethylenically unsaturated group is preferably at least one kind of group selected from the group consisting of a vinyl phenyl group, a vinyl ester group, a vinyl ether group, an allyl group, a (meth)acryloxy group, and a (meth)acrylamide group. From the same viewpoint as above, the ethylenically unsaturated group represented by Y in Formula (I) is more preferably at least one kind of group selected from the group consisting of a vinyl phenyl group, a (meth)acryloxy group, and a (meth)acrylamide group, and even more preferably a (meth)acryloxy group. That is, from the viewpoint of on-press developability and printing durability, the ethylenically unsaturated group represented by Y in Formula (I) preferably includes a (meth)acryloxy group.

Y in Formula (I) is preferably a group having 3 or more (meth)acryloxy groups, more preferably a group having 5 or more (meth)acryloxy groups, and even more preferably a group having 5 to 12 (meth)acryloxy groups.

From the viewpoint of on-press developability and printing durability, Y in Formula (I) may have a structure represented by Formula (Y-1) or Formula (Y-2).

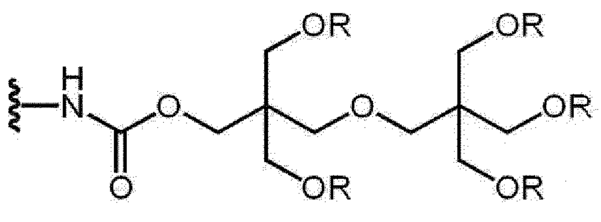
(Y-1)

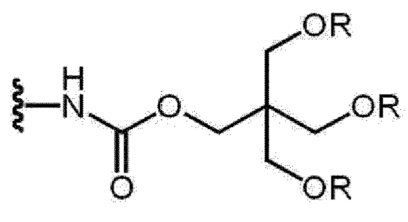
(Y-2)

In Formula (Y-1) and Formula (Y-2), R each independently represents an acryloyl group or a methacryloyl group, and the portion of the wavy line represents a binding position with other structures.

It is preferable that all Rs in Formula (Y-1) or Formula (Y-2) be the same group. Furthermore, it is preferable that all Rs in Formula (Y-1) or Formula (Y-2) be an acryloyl group.

It is preferable that all the n pieces of Y in Formula (I) be the same group.

From the viewpoint of on-press developability and printing durability, the molecular weight of Y in Formula (I) is preferably 200 or more and 1,000 or less, and more preferably 250 or more and 800 or less.

n in Formula (I) is an integer of 2 or more. From the viewpoint of on-press developability and printing durability, n is more preferably 2 or 3.

Molecular weight of X/(molecular weight of Y $\times$ n) is 1 or less. From the viewpoint of on-press developability and printing durability, the value of the expression is preferably 0.01 to 0.8, and more preferably 0.1 to 0.5.

As the structure of the polymerizable compound B1, for example, a structure is preferable which is established by sealing a terminal isocyanate group of a multimerized substance (including an adduct) of a polyfunctional isocyanate compound with a compound having an ethylenically unsaturated group as described above. As the multimerized substance of the polyfunctional isocyanate compound, particularly, a multimerized substance of a difunctional isocyanate compound is preferable.

From the viewpoint of on-press developability and printing durability, the polymerizable compound B1 is preferably a compound obtained by reacting a terminal isocyanate group of a multimerized substance prepared by multimerizing a polyfunctional isocyanate compound with a polyfunctional ethylenically unsaturated compound having a hydroxyl group (also called hydroxy group) on a terminal. Furthermore, from the same viewpoint as above, the polymerizable compound B1 is more preferably a compound obtained by reacting a terminal isocyanate group of a multimerized substance prepared by multimerizing a difunctional isocyanate compound (including an adduct of a polyfunctional alcohol compound) with a polyfunctional ethylenically unsaturated compound having a hydroxyl group. In addition, from the same viewpoint as above, the polymerizable compound B1 is particularly preferably a compound obtained by reacting a terminal isocyanate group of a multimerized substance prepared by multimerizing hexamethylene diisocyanate (including an adduct of a polyfunctional alcohol compound) with a polyfunctional ethylenically unsaturated compound having a hydroxyl group.

As the polyfunctional isocyanate compound, known compounds can be used without particular limitation. This compound may be an aliphatic polyfunctional isocyanate compound or an aromatic polyfunctional isocyanate compound. As the polyfunctional isocyanate compound, specifically, for example, 1,3-bis(isocyanatomethyl) cyclohexane, isophorone diisocyanate, trimethylene diisocyanate, tetramethylene diisocyanate, pentamethylene diisocyanate, hexamethylene diisocyanate, 1,3-cyclopentane diisocyanate, 9h-fluorene-2,7-diisocyanate, 9h-fluoren-9-on-2,7-diisocyanate, 4,4'-diphenylmethane diisocyanate, 1,3-phenylene diisocyanate, tolylene-2,4-diisocyanate, tolylene-2,6-diisocyanate, 1,3-bis(isocyanatomethyl) cyclohexane, 2,2-bis(4-isocyanatophenyl) hexafluoropropane, 1,5-diisocyanatonaphthalene, a dimer or trimer (isocyanurate bond) of these polyisocyanates, and the like are preferable. Furthermore, a biuret compound obtained by reacting the above polyisocyanate compound with a known amine compound may also be used.

Furthermore, the polyfunctional ethylenically unsaturated compound having a hydroxyl group is preferably a hydroxyl group-containing ethylenically unsaturated compound having 3 or more functional groups, and more preferably a hydroxyl group-containing ethylenically unsaturated compound having 5 or more functional groups. The aforementioned hydroxyl group-containing polyfunctional ethylenically unsaturated compound is preferably a polyfunctional (meth) acrylate compound having a hydroxyl group.

From the viewpoint of on-press developability and printing durability, the polymerizable compound B1 preferably has at least one kind of structure selected from the group consisting of an adduct structure, a biuret structure, and an isocyanurate structure. From the same viewpoint as above, the polymerizable compound B1 more preferably has at least one kind of structure selected from the group consisting of a trimethylolpropane adduct structure, a biuret structure, and an isocyanurate structure, and particularly preferably has a trimethylolpropane adduct structure.

From the viewpoint of on-press developability and printing durability, the polymerizable compound B1 preferably has a structure represented by any of Formula (A-1) to Formula (A-3), and more preferably has a structure represented by Formula (A-1).

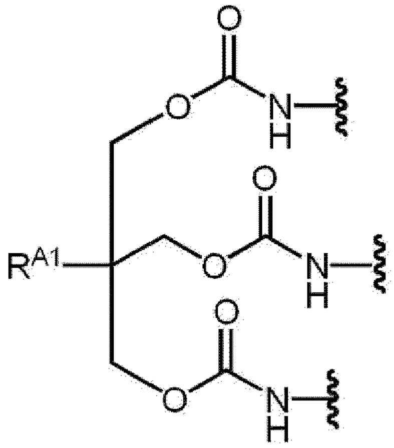

(A - 1)

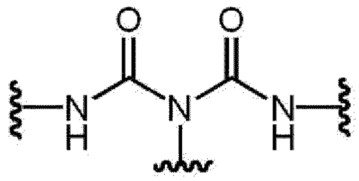

(A - 2)

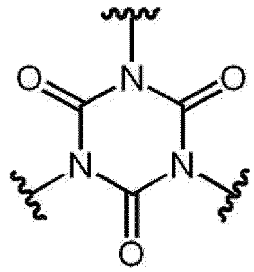

(A - 3)

In Formula (A-1), $R^{A1}$ represents a hydrogen atom or an alkyl group having 1 to 8 carbon atoms, and the portion of the wavy line represents a binding position with other structures.

From the viewpoint of on-press developability and printing durability, $R^{A1}$ in Formula (A-1) is preferably a hydrogen atom or an alkyl group having 1 to 4 carbon atoms, more preferably an alkyl group having 1 to 3 carbon atoms, even more preferably a methyl group or an ethyl group, and particularly preferably an ethyl group.

From the viewpoint of on-press developability and printing durability, the polymerizable compound B1 is preferably a (meth)acrylate compound having a urethane group, that is, a urethane (meth)acrylate oligomer.

As long as the polymerizable compound B1 has an ethylenically unsaturated bond valence of 5.0 mmol/g or more, the polymerizable compound B1 may be an oligomer having a polyester bond (hereinafter, also called polyester (meth)acrylate oligomer) or an oligomer having an epoxy residue (hereinafter, also called epoxy (meth)acrylate oligomer).

The epoxy residue in the epoxy (meth)acrylate oligomer is as described above.

The number of ethylenically unsaturated groups in the polyester (meth)acrylate oligomer as the polymerizable compound B1 is preferably 3 or more, and more preferably 6 or more.

The epoxy (meth)acrylate oligomer as the polymerizable compound B1 is preferably a compound containing a hydroxyl group. The number of ethylenically unsaturated groups in the epoxy (meth)acrylate oligomer is preferably 2 to 6, and more preferably 2 or 3. The epoxy (meth)acrylate oligomer can be obtained, for example, by reacting a compound having an epoxy group with an acrylic acid.

The molecular weight of the polymerizable compound B1 (weight-average molecular weight in a case where the compound has molecular weight distribution) may be more than 1,000, and is preferably 1,100 to 10,000 and more preferably 1,100 to 5,000.

As the polymerizable compound B1, a synthetic product or a commercially available product may be used.

Specific examples of the polymerizable compound B1 include the following commercially available products. However, the polymerizable compound B1 is not limited thereto. The number of functional groups (or the average number of functional groups) and C=C valence of the ethylenically unsaturated group are shown in each bracket.

Specific examples of the polymerizable compound B1 include urethane (meth)acrylate oligomers such as U-10HA (number of functional groups: 10, C=C valence: 8 mmol/g) and U-15HA (number of functional groups: 15, C=C valence: 6 mmol/g) manufactured by SHIN-NAKAMURA CHEMICAL CO, LTD., UA-510H (number of functional groups: 10, C=C valence: 8 mmol/g) manufactured by KYOEISHA CHEMICAL Co., LTD., KRM8452 (number of functional groups: 10, C=C valence: 7 mmol/g) manufactured by DAICEL-ALLNEX LTD., and CN8885NS (number of functional groups: 9, C=C valence: 6 mmol/g) and CN9013NS (number of functional groups: 9, C=C valence: 6 mmol/g) manufactured by Sartomer Company Inc.

Specific examples of the polymerizable compound B1 also include epoxy (meth)acrylate oligomers such as NK OLIGO EA-7420/PGMAc (number of functional groups: 10 to 15, C=C valence: 5 mmol/g) manufactured by SHIN-NAKAMURA CHEMICAL CO, LTD., and CN153 (C=C valence: 5 mmol/g) manufactured by Sartomer Company Inc.

Specific examples of the polymerizable compound B1 also include polyester (meth)acrylate oligomers such as CN2267 (C=C valence: 5 mmol/g) manufactured by Sartomer Company Inc.

In a case where the polymerizable compound B1 is used, the content of the polymerizable compound B1 with respect to the total mass of the polymerizable compound B in the image-recording layer is preferably 10% by mass to 100% by mass, more preferably 50% by mass to 100% by mass, and even more preferably 80% by mass to 100% by mass.

The polymerizable compound B may further include a compound other than the oligomer and the polymerizable compound B1 described above.

The compound other than the oligomer as the polymerizable compound B is preferably a low-molecular-weight compound having a molecular weight less than 1,000 (weight-average molecular weight in a case where the compound has molecular weight distribution).

The low-molecular-weight compound as the polymerizable compound B may take a chemical form such as a monomer, a dimer, a trimer, or a mixture of these.

From the viewpoint of chemical resistance, the low-molecular-weight compound as the polymerizable compound B is preferably at least a compound selected from the group consisting of a compound having three or more ethylenically unsaturated groups and a compound having an isocyanuric ring structure.

The molecular weight (weight-average molecular weight in a case where the compound has molecular weight distribution) of the low-molecular-weight compound as the polymerizable compound B may be 50 or more and less than 1,000, and is preferably 500 or more and less than 600. From the viewpoint of excellent chemical resistance and further suppressing residues of on-press development, the molecular weight is preferably 100 to 600, more preferably 200 to 600, and even more preferably 300 to 600.

In a case where the polymerizable compound B includes the aforementioned low-molecular-weight compound, from the viewpoint of chemical resistance and suppression of residues of on-press development, the ratio of the oligomer to the low-molecular-weight compound (oligomer/low-molecular-weight compound) is preferably 10/1 to 1/10, more preferably 10/1 to 3/7, and even more preferably 10/1 to 7/3, based on mass.

Examples of the low-molecular-weight compound as the polymerizable compound B include unsaturated carboxylic acids (for example, acrylic acid, methacrylic acid, itaconic acid, crotonic acid, isocrotonic acid, maleic acid, and the like), and esters or amides thereof. Among these, esters of unsaturated carboxylic acids and polyhydric alcohol compounds and amides of unsaturated carboxylic acids and polyvalent amine compounds are preferably used. In addition, products of an addition reaction between unsaturated carboxylic acid esters or amides having a nucleophilic substituent such as a hydroxyl group, an amino group, or a mercapto group and monofunctional or polyfunctional isocyanates or epoxies, products of a dehydrocondensation reaction between the aforementioned unsaturated carboxylic acid esters or amides and a monofunctional or polyfunctional carboxylic acid, and the like are also suitably used. Furthermore, products of an addition reaction between unsaturated carboxylic acid esters or amides having an electrophilic substituent such as an isocyanate groups or an epoxy group and monofunctional or polyfunctional alcohols, amines, or thiols, and products of a substitution reaction between unsaturated carboxylic acid esters or amides having a dissociable substituent such as a halogen atom or a tosyloxy group and monofunctional or polyfunctional alcohols, amines, or thiols are also suitable. Moreover, for example, it is also possible to use a group of compounds obtained by substituting the unsaturated carboxylic acid with an unsaturated phosphonic acid, styrene, a vinyl ether, or the like. These compounds are described in JP2006-508380A, JP2002-287344A, JP2008-256850A, JP2001-342222A, JP1997-179296A (JP-H09-179296A), JP1997-179297A (JP-H09-179297A), JP1997-179298A (JP-H09-179298A), JP2004-294935A, JP2006-243493A, JP2002-275129A, JP2003-064130A, JP2003-280187A, JP1998-333321A (JP-H10-333321A), and the like.

Specific examples of monomers of esters of polyhydric alcohol compounds and unsaturated carboxylic acids include acrylic acid esters such as ethylene glycol diacrylate, 1,3-butanediol diacrylate, tetramethylene glycol diacrylate, propylene glycol diacrylate, trimethylolpropane triacrylate, hexanediol diacrylate, tetraethylene glycol diacrylate, pentaerythritol tetraacrylate, sorbitol triacrylate, isocyanuric acid ethylene oxide (EO)-modified triacrylate, and polyester acrylate oligomers, and methacrylic acid esters such as tetramethylene glycol dimethacrylate, neopentyl glycol dimethacrylate, trimethylolpropane trimethacrylate, ethylene glycol dimethacrylate, pentaerythritol trimethacrylate, bis[p-(3-methacryloxy-2-hydroxypropoxy)phenyl] dimethyl methane, and bis[p-(methacryloxyethoxy)phenyl] dimethyl methane. In addition, specific examples of monomers of amides of polyvalent amine compounds and unsaturated carboxylic acids include methylene bisacrylamide, methylene bismethacrylamide, 1,6-hexamethylene bisacrylamide, 1,6-hexamethylene bismethacrylamide, diethylenetriamine trisacrylamide, xylylene bisacrylamide, xylylene bismethacrylamide, and the like.

In addition, urethane-based addition polymerizable compounds produced using an addition reaction between an isocyanate and a hydroxyl group are also suitable, and specific examples thereof include vinyl urethane compounds having two or more polymerizable vinyl groups in one molecule obtained by adding vinyl monomers having a hydroxyl group represented by Formula (M) to a polyisocyanate compound having two or more isocyanate groups in one molecule which is described in, for example, JP1973-041708B (JP-S48-041708B).

Formula (M) $CH_2=C(R^{M4})COOCH_2CH(R^{M5})OH$

In Formula (M), $R^{M4}$ and $R^{M5}$ each independently represent a hydrogen atom or a methyl group.

Furthermore, as the polymerizable compound B, urethane acrylates described in JP1976-37193A (JP-S51-37193A), JP1990-32293B (JP-H02-32293B), JP1990-16765B (JP-H02-16765B), JP2003-344997A, and JP2006-65210A; urethane compounds having an ethylene oxide-based skeleton described in JP1983-49860B (JP-S58-49860B), JP1981-17654B (JP-S56-17654B), JP1987-39417B (JP-S62-39417B), JP1987-39418B (JP-S62-39418B), JP2000-250211A, and JP2007-94138A; urethane compounds having a hydrophilic group described in US7153632B, JP1996-505958A (JP-H08-505958A), JP2007-293221A, and JP2007-293223A, and the like are also suitable.

(Polymerizable compound B2)

The polymerizable compound B may include, as a low-molecular-weight compound, a compound having 1 or 2 ethylenically unsaturated bonding groups (hereinafter, also called polymerizable compound B2).

Preferred aspects of the ethylenically unsaturated group contained in the polymerizable compound B2 are the same as preferred aspects of the ethylenically unsaturated group in the polymerizable compound B1.

Furthermore, from the viewpoint of inhibiting the deterioration of on-press developability, the polymerizable compound B2 is preferably a compound having two ethylenically unsaturated bonding groups (that is, a difunctional polymerizable compound).

From the viewpoint of on-press developability and printing durability, the polymerizable compound B2 is preferably a methacrylate compound, that is, a compound having a methacryloxy group.

From the viewpoint of on-press developability, the polymerizable compound B2 preferably has an alkyleneoxy structure or a urethane bond.

The molecular weight of the polymerizable compound B2 (weight-average molecular weight in a case where the compound has molecular weight distribution) is preferably 50 or more and less than 1,000, more preferably 200 to 900, and even more preferably 250 to 800.

Specific examples of the polymerizable compound B2 will be shown below. However, the polymerizable compound B2 is not limited thereto. In the following compound (2), for example, n + m = 10.

(1)

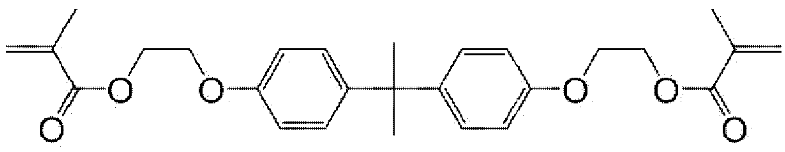

(2)

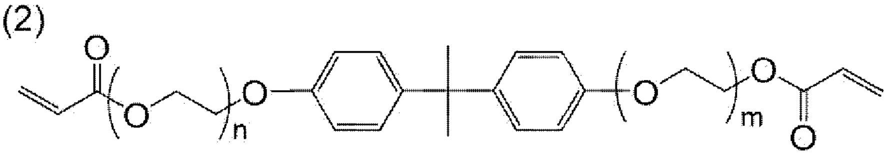

(3)

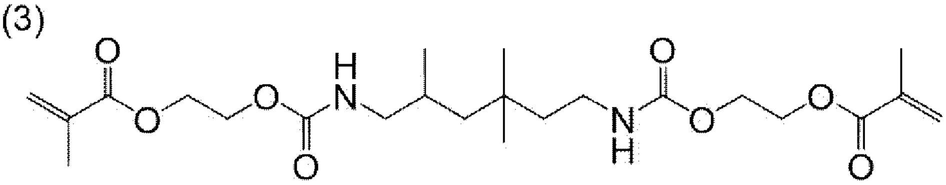

(4)

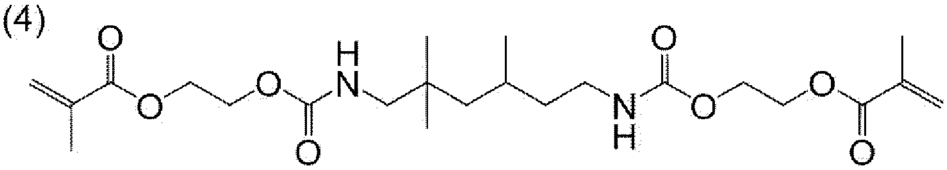

As the polymerizable compound B2, the following commercially available products may be used. However, the polymerizable compound B2 is not limited thereto.

Specific examples of the polymerizable compound B2 include ethoxylated bisphenol A dimethacrylate such as BPE-80N (the above compound (1)), BPE-100, BPE-200, and BPE-500 manufactured by SHIN-NAKAMURA CHEMICAL CO, LTD., and CN104 (the above compound (1)) manufactured by Sartomer Company Inc.

Specific examples of the polymerizable compound B2 include ethoxylated bisphenol A diacrylates such as A-BPE-10 (the above compound (2)) and A-BPE-4 manufactured by SHIN-NAKAMURA CHEMICAL CO, LTD.

Furthermore, specific examples of the polymerizable compound B2 include difunctional methacrylate such as FST 510 manufactured by AZ Electronics.

"FST 510" described above is a product of a reaction between 1 mol of 2,2,4-trimethylhexamethylene diisocyanate and 2 mol of hydroxyethyl methacrylate, which is an 82% by mass methyl ethyl ketone solution of the compound (3).

In a case where the polymerizable compound B2 is used, the content of the polymerizable compound B2 with respect to the total mass of the polymerizable compound B in the image-recording layer is preferably 10% by mass to 100% by mass, more preferably 50% by mass to 100% by mass, and even more preferably 80% by mass to 100% by mass.

The details of how to use the polymerizable compound B, such as the structure of the compound, whether the compound is used alone or used in combination with other compounds, and the amount of the compound to be added, can be randomly set.

That is, one kind of polymerizable compound B may be used alone, or two or more kinds of polymerizable compounds B may be used in combination.

The content of the polymerizable compound B with respect to the total mass of the image-recording layer is preferably 5% by mass to 75% by mass, more preferably 10% by mass to 70% by mass, and particularly preferably 15% by mass to 60% by mass.

In the present specification, as the polymerizable compound B, from the viewpoint of reactivity with the polymerizable resin particles A, a compound having an ethylenically unsaturated bond equivalent of 300 g/mol or less is preferable, and a compound having an ethylenically unsaturated bond equivalent of 150 g/mol or less is more preferable.

The lower limit of the ethylenically unsaturated bond equivalent of the polymerizable compound B is, for example, 50 g/mol.

The ethylenically unsaturated bond equivalent is a value obtained by dividing the molecular weight (g/mol) by the number of ethylenically unsaturated groups.

In the present specification, from the viewpoint of reactivity with the polymerizable resin particles A, the polymerizable compound B is preferably a compound having a molecular weight of 2,500 or less (more preferably 100 to 2,500).

In a case where the polymerizable compound B is a compound that has an ethylenically unsaturated bond equivalent of 300 g/mol or less and/or a molecular weight of 2,500 or less (more preferably 100 to 2,500), from the viewpoint of suppressing the occurrence of plate missing, the content of the polymerizable compound B with respect to the total mass of the image-recording layer is preferably 15% by mass to 80% by mass, more preferably 15% by mass to 70% by mass, and even more preferably 20% by mass to 65% by mass.

In the present specification, the proportion of the total amount of the polymerizable resin particles A and the polymerizable compound B in the image-recording layer is preferably 40% by mass to 90% by mass, more preferably 50% by mass to 85% by mass, and even more preferably 50% by mass to 80% by mass.

[Polymerization initiator]

It is preferable that the image-recording layer contain a polymerization initiator.

The polymerization initiator is not particularly limited, and examples thereof include an electron-accepting polymerization initiator, an electron-donating polymerization initiator, and the like.

The polymerization initiator preferably includes at least an electron-accepting polymerization initiator among the above.

(Electron-accepting polymerization initiator)

From the viewpoint of suppressing the occurrence of plate missing, the image-recording layer preferably contains an electron-accepting polymerization initiator.

The electron-accepting polymerization initiator is a compound that generates a polymerization initiation species such as a radical or a cation by either or both of light energy and heat energy, and can be appropriately selected from known thermal polymerization initiators, compounds having a bond that can be dissociated by little energy, photopolymerization initiators, and the like.

The electron-accepting polymerization initiator is preferably a radical polymerization initiator and more preferably an onium compound.

In addition, as the electron-accepting polymerization initiator, an infrared-ray-sensitive polymerization initiator is preferable.

One kind of electron-accepting polymerization initiator may be used alone, or two or more kinds of electron-accepting polymerization initiators may be used in combination.

Examples of the radical polymerization initiator include (a) organic halide, (b) carbonyl compound, (c) azo

compound, (d) organic peroxide, (e) metallocene compound, (f) azide compound, (g) hexaarylbiimidazole compound, (h) disulfone compound, (i) oxime ester compound, and (j) onium compound.

Among the above electron-accepting polymerization initiators, from the viewpoint of curing properties, for example, (i) oxime ester compound and (j) onium compound are preferable.

As (a) organic halide, for example, the compounds described in paragraphs "0022" and" 0023" of JP2008-195018A are preferable.

As (b) carbonyl compound, for example, the compounds described in paragraph "0024" of JP2008-195018A are preferable.

As (c) azo compound, for example, the azo compounds described in JP1996-108621A (JP-H08-108621A) and the like can be used.

As (d) organic peroxide, for example, the compounds described in paragraph "0025" of JP2008-195018A are preferable.

As (e) metallocene compound, for example, the compounds described in paragraph "0026" of JP2008-195018A are preferable.

Examples of (f) azide compound include compounds such as 2,6-bis(4-azidobenzylidene)-4-methylcyclohexanone.

As (g) hexaarylbiimidazole compound, for example, the compounds described in paragraph "0027" of JP2008-195018A are preferable.

Examples of (h) disulfone compound include the compounds described in JP1986-166544A (JP-S61-166544A) and JP2002-328465A.

As (i) oxime ester compound, for example, the compounds described in paragraphs "0028" to "0030" of JP2008-195018A are preferable.

In the present specification, the electron-accepting polymerization initiator is particularly preferably (j) onium compound.

Hereinafter, (j) onium compound will be specifically described.

As (j) onium compound, from the viewpoint of suppressing the occurrence of plate missing, an iodonium salt compound, a sulfonium salt compound, or an azinium salt compound is preferable, an iodonium salt compound or a sulfonium salt compound is more preferable, and an iodonium salt compound is even more preferable.

Specific examples of these compounds will be shown below.

As the iodonium salt compound, for example, a diaryl iodonium salt compound is preferable. Particularly, a diphenyl iodonium salt compound substituted with an electron donating group such as an alkyl group or an alkoxyl group is more preferable. Furthermore, an asymmetric diphenyl iodonium salt compound is preferable. Specific examples thereof include diphenyliodonium=hexafluorophosphate, 4-methoxyphenyl-4-(2-methylpropyl)phenyliodonium=hexafluorophosphate, 4-(2-methylpropyl)phenyl-p-tolyliodonium=hexafluorophosphate, 4-hexyloxyphenyl-2,4,6-trimethoxyphenyl iodonium=hexafluorophosphate, 4-hexyloxyphenyl-2,4-diethoxyphenyl iodonium=tetrafluoroborate, 4-octyloxyphenyl-2,4,6-trimethoxyphenyl iodonium=1-perfluorobutane sulfonate, 4-octyloxyphenyl-2,4,6-trimethoxyphenyliodonium=-hexafluorophosphate, bis(4-t-butylphenyl)iodonium=hexafluorophosphate, and the like.

As the sulfonium salt compound, for example, a triarylsulfonium salt compound is preferable. Particularly, a triarylsulfonium salt compound is preferable in which at least some of electron-withdrawing groups such as groups on an aromatic ring are substituted with halogen atoms, and a triarylsulfonium salt compound is more preferable in which the total number of halogen atoms as substituents on an aromatic ring is 4 or more. Specific examples thereof include triphenylsulfonium=hexafluorophosphate, triphenylsulfonium=benzoyl formate, bis(4-chlorophenyl)phenylsulfonium=-benzoyl formate, bis(4-chlorophenyl)-4-methylphenylsulfonium=tetrafluoroborate, tris(4-chlorophenyl)sulfonium=3,5-bis(methoxycarbonyl)benzenesulfonate, tris(4-chlorophenyl)sulfonium=hexafluorophosphate, tris(2,4-dichlorophenyl)sulfonium=hexafluorophosphate, and the like.

As a counteranion of the iodonium salt compound and the sulfonium salt compound, a sulfonamide anion or a sulfonimide anion is preferable, and a sulfonimide anion is more preferable.

As the sulfonamide anion, an aryl sulfonamide anion is preferable.

As the sulfonimide anion, a bisaryl sulfonimide anion is preferable.

Specific examples of the sulfonamide anion or the sulfonimide anion will be shown below. In the following specific examples, Ph represents a phenyl group, Me represents a methyl group, and Et represents an ethyl group.

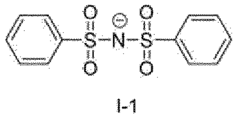
I-1

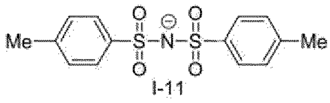
I-11

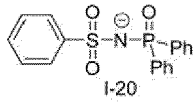
I-20

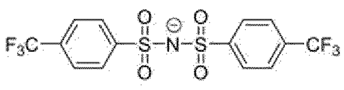
I-2

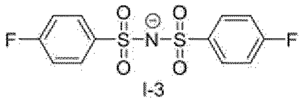
I-3

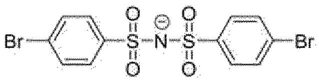
I-4

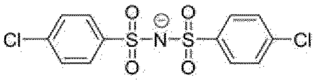
I-5

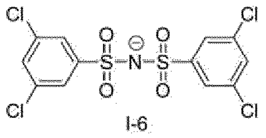
I-6

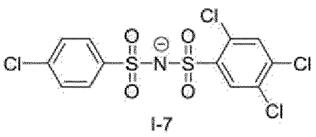
I-7

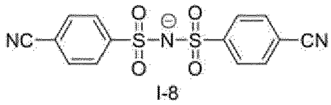
I-8

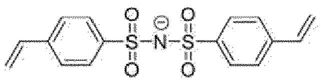
I-9

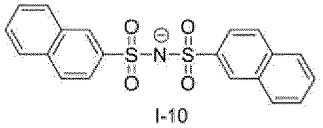
I-10

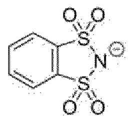
I-12

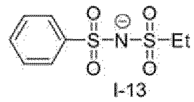
I-13

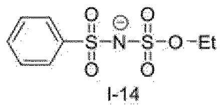
I-14

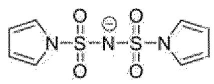
I-15

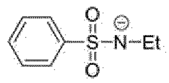
I-16

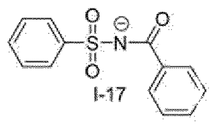
I-17

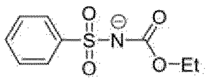
I-18

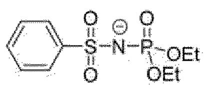
I-19

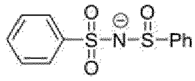
I-21

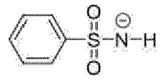
I-22

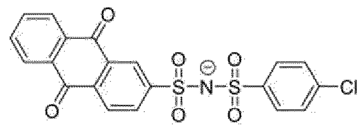
I-23

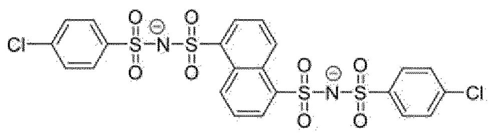
I-24

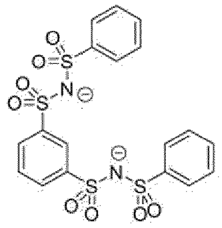
I-25

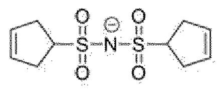
I-26

From the viewpoint of developability and UV printing durability of the lithographic printing plate to be obtained, the electron-accepting polymerization initiator may include a compound represented by Formula (II).

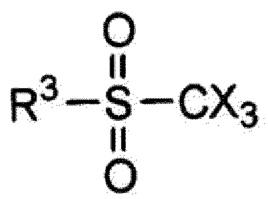
(II)

In Formula (II), X represents a halogen atom, and $R^3$ represents an aryl group.

Specifically, examples of X in Formula (II) include a fluorine atom, a chlorine atom, a bromine atom, and an iodine atom. Among these, a chlorine atom or a bromine atom is preferable because these have excellent sensitivity, and a bromine atom is particularly preferable.

Furthermore, from the viewpoint of excellent balance between sensitivity and storage stability, $R^3$ in Formula (II) is preferably an aryl group substituted with an amide group.

Specific examples of the electron-accepting polymerization initiator represented by Formula (II) include compounds represented by the following formulas..

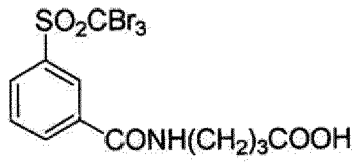 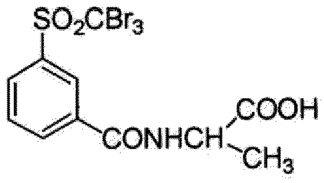 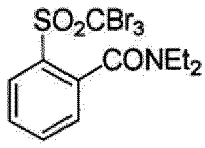

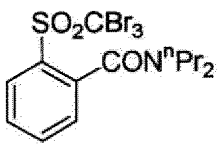 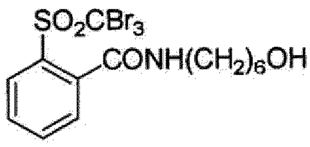 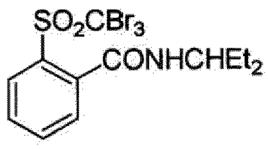

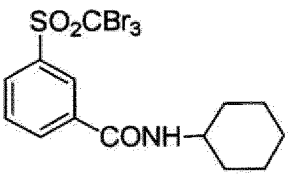 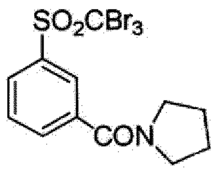 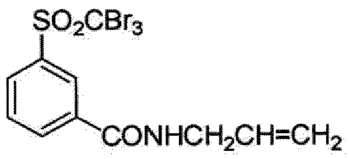

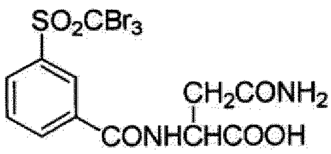 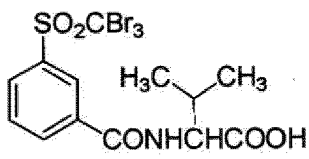 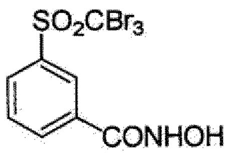

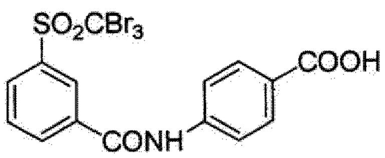 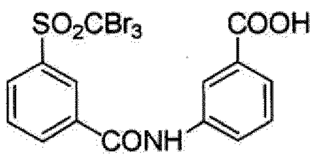 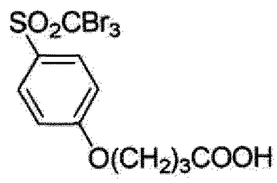

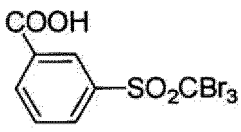 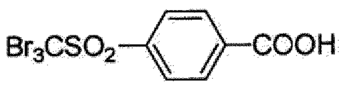 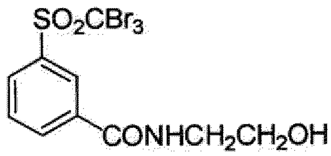

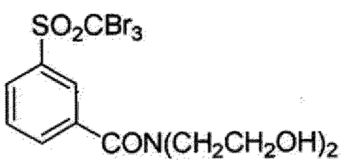 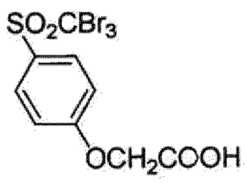 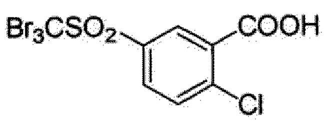

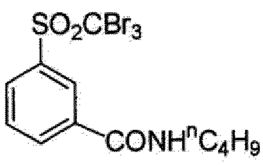 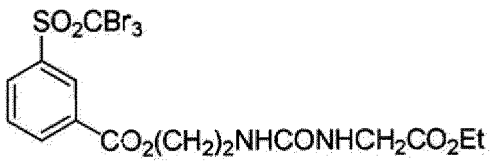

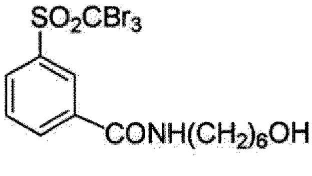

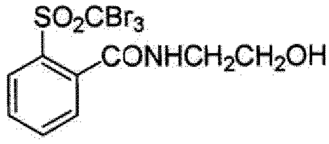

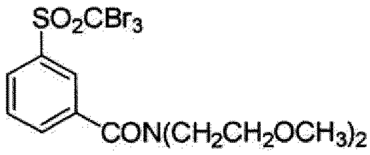

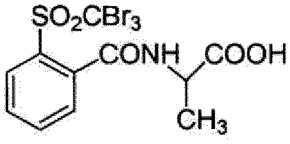

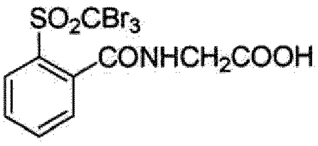

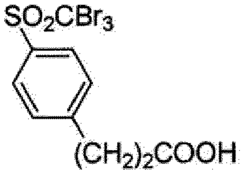

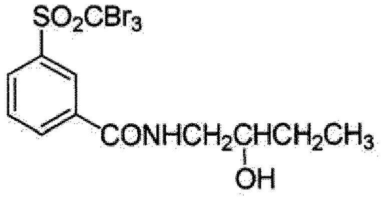

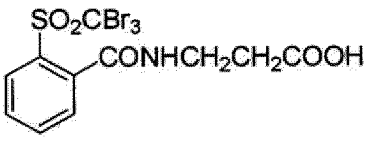

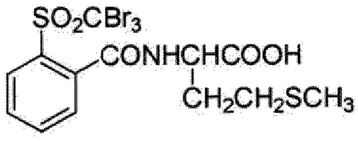

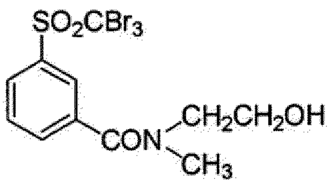

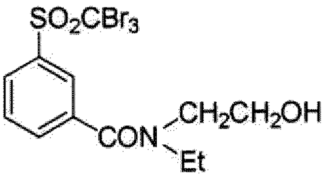

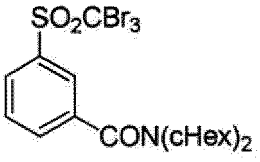

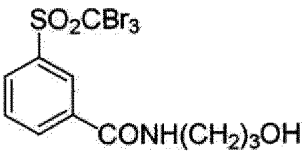

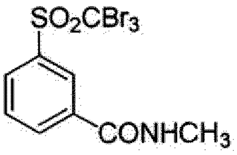

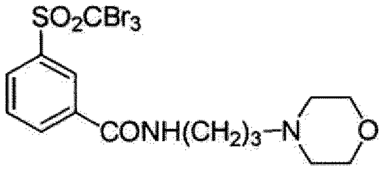

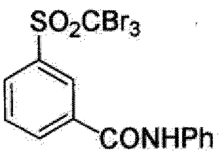

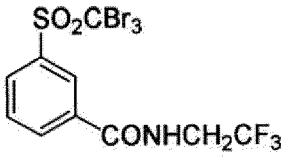

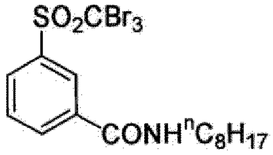

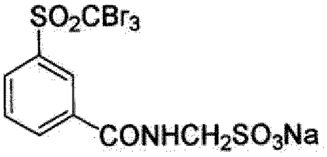

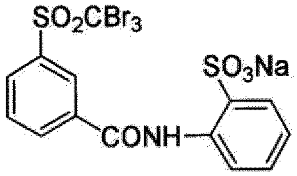

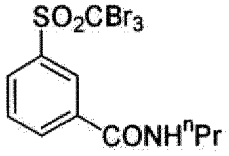

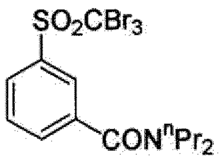
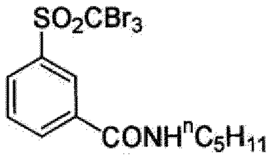
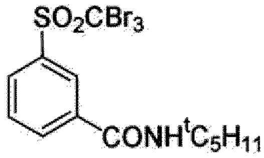

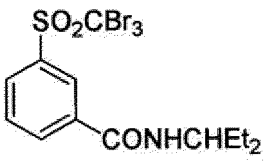
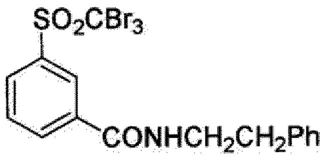
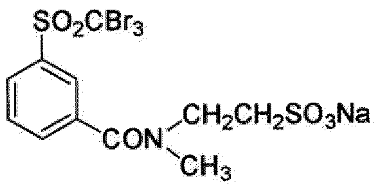

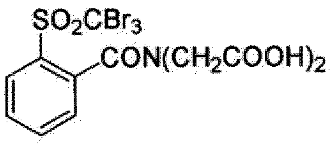
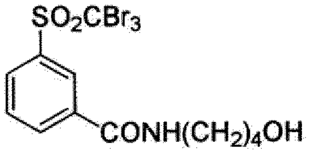

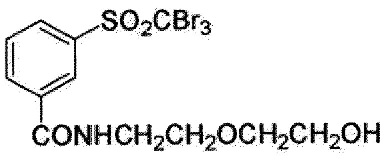
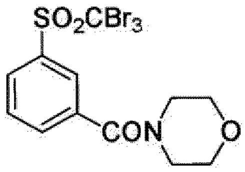
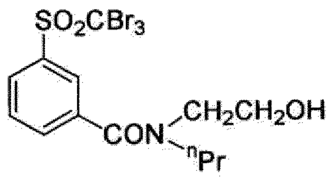

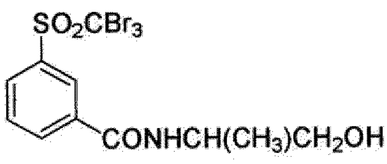
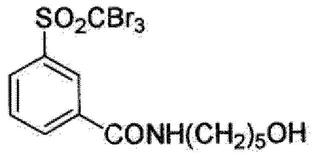

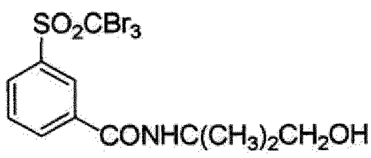
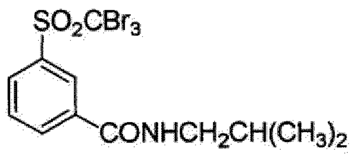

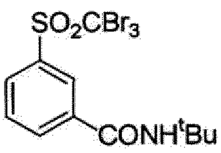
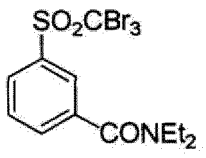
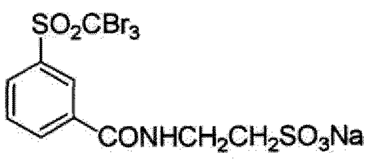

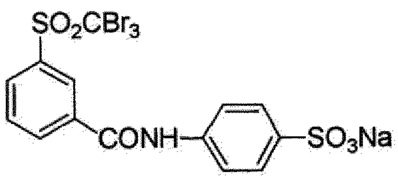
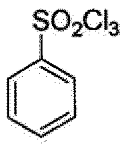
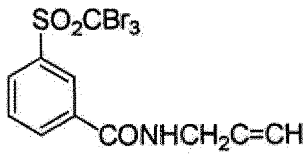

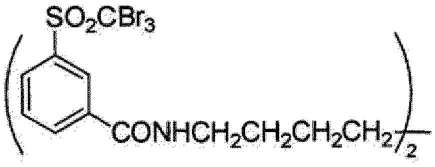

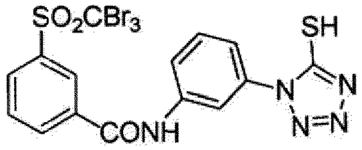

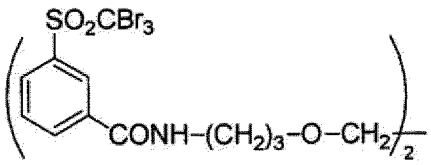

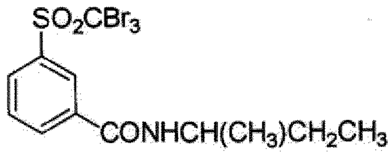

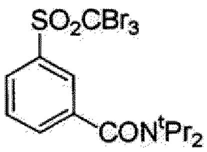

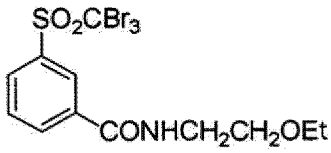

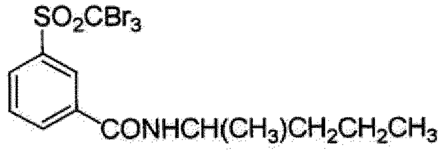

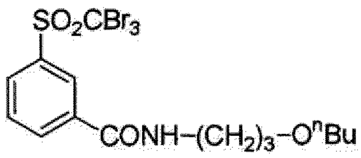

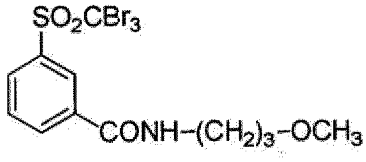

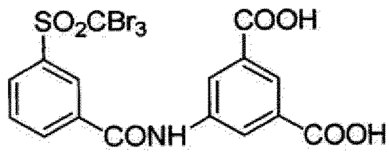

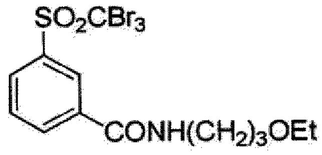

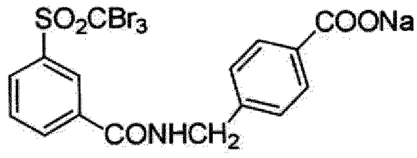

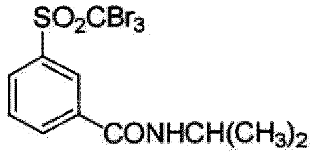

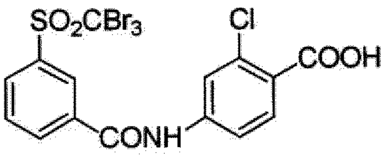

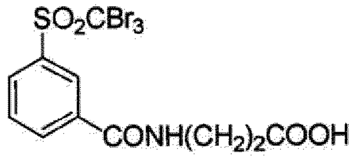

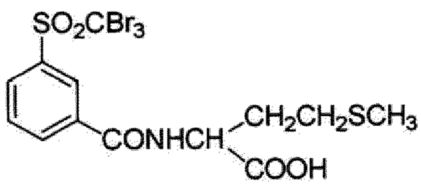

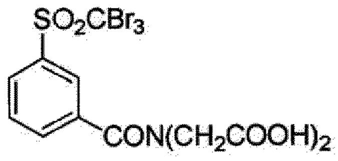

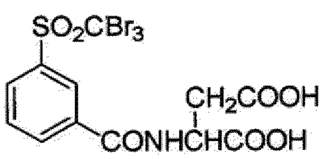

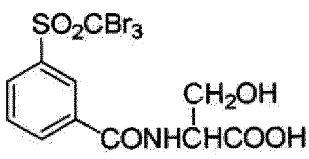

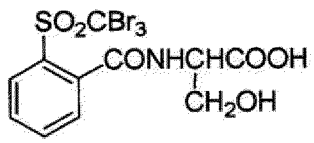

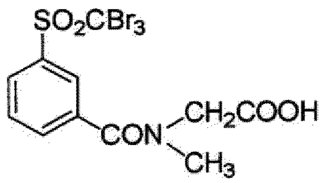
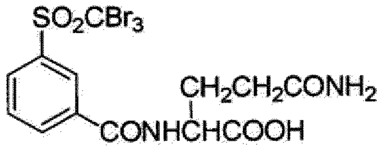
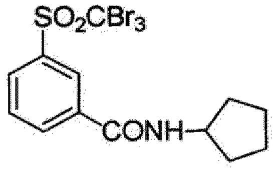

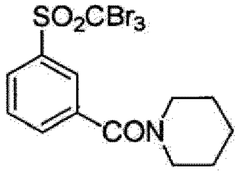
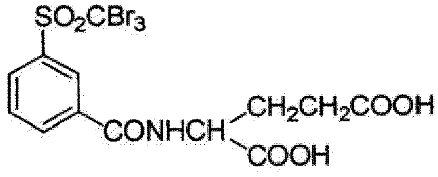

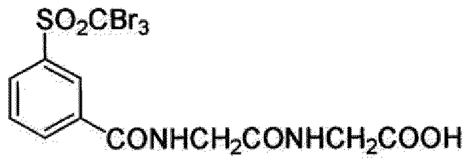
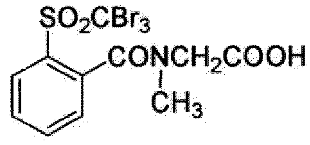

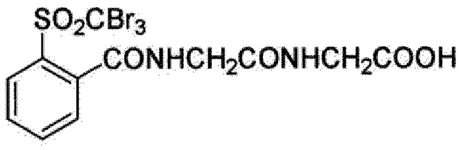
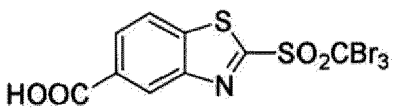

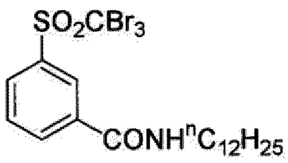
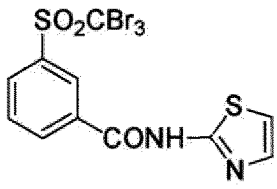
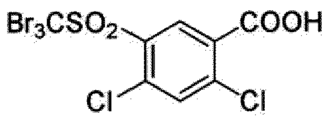

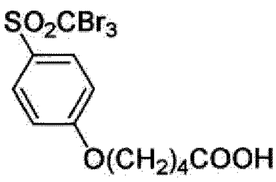
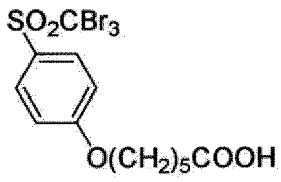

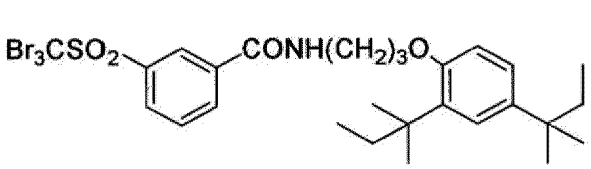
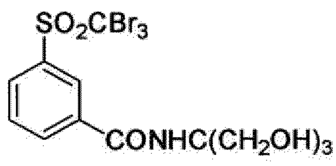

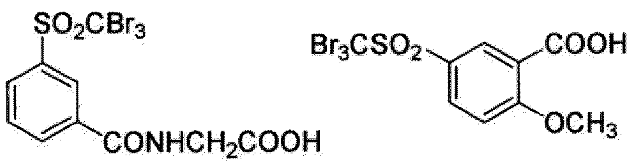
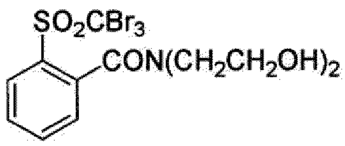

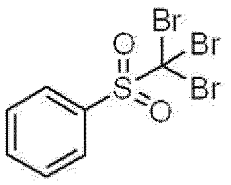

(IS-1)

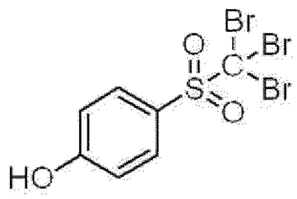

(IS-2)

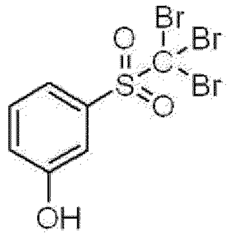

(IS-3)

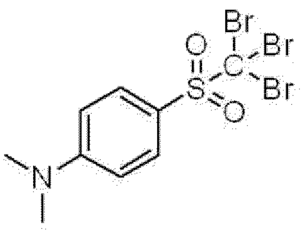

(IS-4)

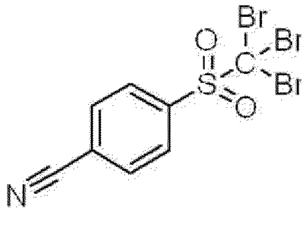

(IS-5)

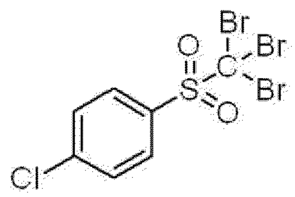

(IS-6)

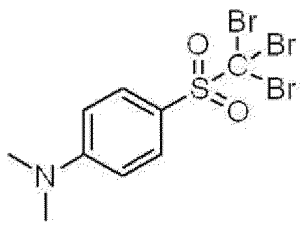

(IS-7)

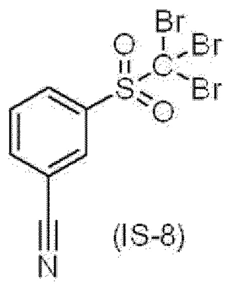

(IS-8)

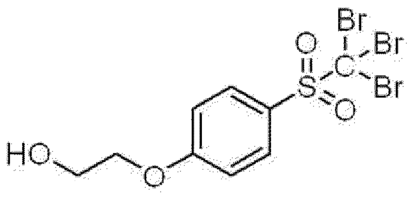

(IS-9)

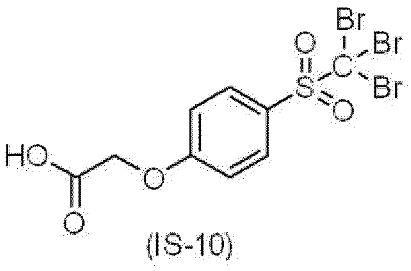

(IS-10)

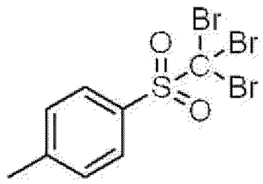

(IS-11)

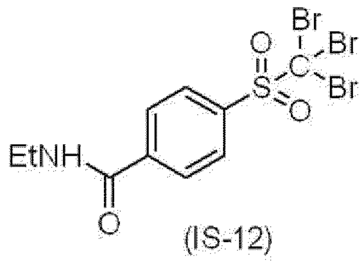

(IS-12)

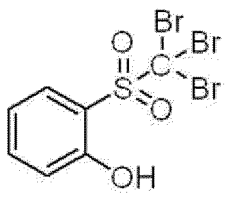

(IS-13)

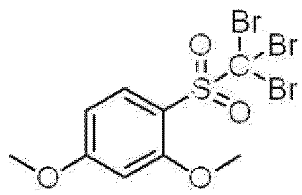

(IS-14)

From the viewpoint of suppressing the occurrence of plate missing, the lowest unoccupied molecular orbital (LUMO) of the electron-accepting polymerization initiator is preferably -3.00 eV or less, and more preferably -3.02 eV or less.

The lower limit of LUMO of the electron-accepting polymerization initiator is preferably -3.80 eV or more, and more preferably -3.60 eV or more.

The content of the electron-accepting polymerization initiator with respect to the total mass of the image-recording layer is preferably 0.1% by mass to 50% by mass, more preferably 0.5% by mass to 30% by mass, and particularly preferably 0.8% by mass to 20% by mass.

(Electron-donating polymerization initiator)

From the viewpoint of chemical resistance in a lithographic printing plate and contribution to the suppression of plate missing, the polymerization initiator preferably further includes an electron-donating polymerization initiator, and more preferably includes both the electron-donating polymerization initiator and the electron-accepting polymerization initiator described above.

Examples of the electron-donating polymerization initiator include the following five kinds of initiators.

(i) Alkyl or arylate complex: considered to generate active radicals by oxidative cleavage of carbon-hetero bond. Specific examples thereof include a borate compound and the like.

(ii) Amino acetate compound: considered to generate active radicals by oxidation-induced cleavage of C-X bond on carbon adjacent to nitrogen. X is preferably a hydrogen atom, a carboxy group, a trimethylsilyl group, or a benzyl group. Specific examples thereof include N-phenylglycines (which may have a substituent in a phenyl group.), N-phenyl iminodiacetic acids (which may have a substituent in a phenyl group), and the like.

(iii) Sulfur-containing compound: compound obtained by substituting nitrogen atoms of the aforementioned amino acetate compound with sulfur atoms and capable of generating active radicals by the same action as that of the amino acetate compound. Specific examples thereof include phenylthioacetic acids (which may have a substituent on a phenyl group) and the like.

(iv) Tin-containing compound: compound obtained by substituting nitrogen atoms of the aforementioned amino acetate compound with tin atoms and capable of generating active radicals by the same action as that of the amino acetate compound.

(v) Sulfinates: capable of generating active radicals by oxidation. Specific examples thereof include sodium aryl sulfinate and the like.

It is preferable that the image-recording layer contain the borate compound among electron-donating polymerization initiators. As the borate compound, a tetraaryl borate compound or a monoalkyltriaryl borate compound is preferable. From the viewpoint of compound stability, a tetraaryl borate compound is more preferable, and a tetraphenyl borate compound is particularly preferable.

A countercation that the borate compound has is not particularly limited, but is preferably an alkali metal ion or a tetraalkyl ammonium ion and more preferably a sodium ion, a potassium ion, or a tetrabutylammonium ion. Furthermore, as the countercation contained in the borate compound, for example, the onium ion in the electron-accepting polymerization initiator is also suitable.

Specifically, as the borate compound, for example, sodium tetraphenyl borate is preferable.

From the viewpoint of suppressing the occurrence of plate missing, the highest occupied molecular orbital (HOMO) of the electron-donating polymerization initiator is preferably -6.00 eV or more, more preferably -5.95 eV or more, and even more preferably -5.93 eV or more.

The upper limit of HOMO of the electron-donating polymerization initiator is preferably -5.00 eV or less, and more preferably -5.40 eV or less.

In the present specification, the highest occupied molecular orbital (HOMO) and the lowest unoccupied molecular orbital (LUMO) are calculated by the following methods.

First, the counteranion in the compound as a subject of calculation is ignored.

The structural optimization is carried out by DFT (B3LYP/6-31G(d)) using quantum chemical calculation software Gaussian 09.

The molecular orbital (MO) energy is calculated by DFT (B3LYP/6-31+G(d,p)/CPCM (solvent = methanol)) using the structure obtained by the structural optimization.

By the following formula, the MO energy Ebare (unit: hartree) obtained by the above MO energy calculation is converted into Escaled (unit: eV) used as the values of HOMO and LUMO in the present specification.

$$\text{Escaled} = 0.823168 \times 27.2114 \times \text{Ebare} - 1.07634$$

27.2114 is a simply a coefficient for converting hartree into eV, and 0.823168 and -1.07634 are adjustment coefficients. These are determined such that the calculated values of HOMO and LUMO of the compound as a calculation object match the measured values.

Specifically, as the electron-donating polymerization initiator, for example, compounds B-1 to B-8 and other

compounds shown below are preferable. It goes without saying that the it is not limited thereto. In the following chemical formulas, Bu represents a n-butyl group, and Z represents a countercation.

Examples of the countercation represented by $Z^+$ include $Na^+$, $K^+$, $N^+(Bu)_4$, and the like. The countercation represented by $Z^+$ may be the onium ion in the aforementioned electron-accepting polymerization initiator.

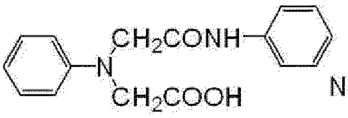

B-1

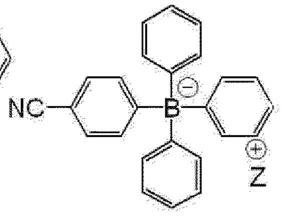

B-2
HOMO=-6.052eV

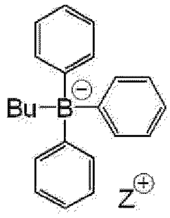

B-3
HOMO=-5.772eV

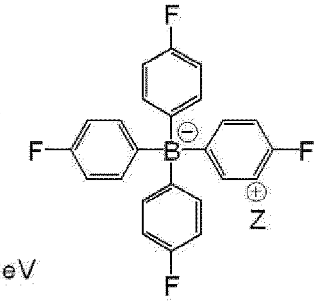

B-4
HOMO=-5.957eV

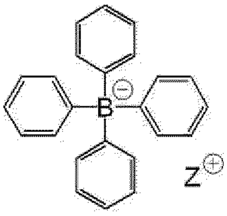

B-5
HOMO=-5.905eV

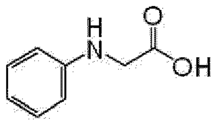

B-6

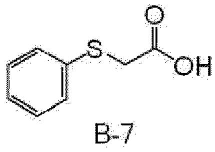

B-7

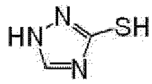

B-8

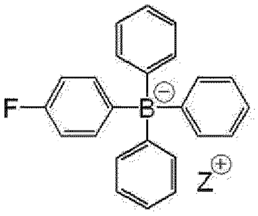

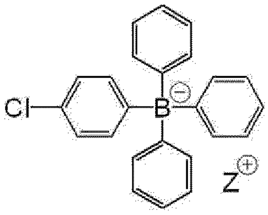

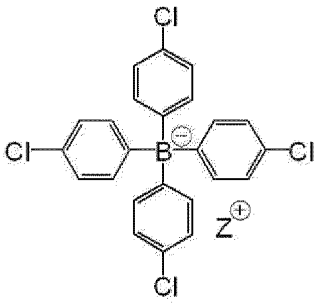

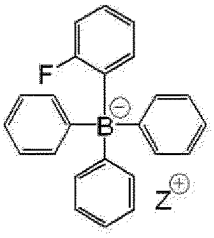

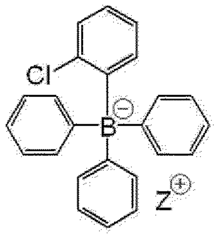

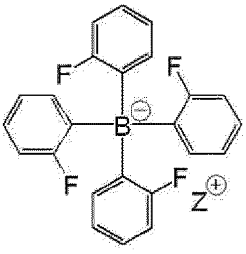

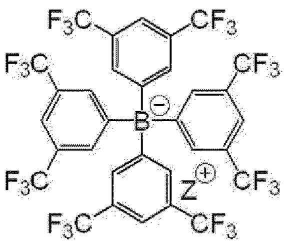

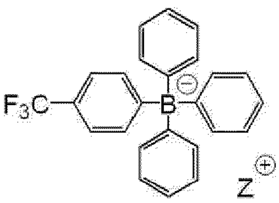

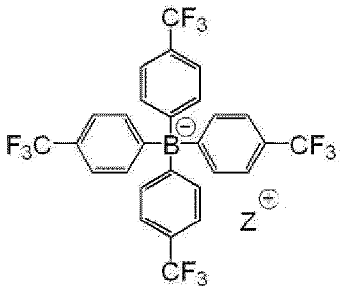

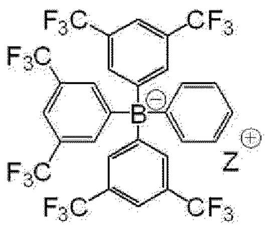

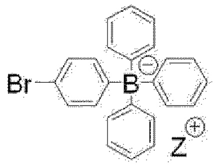
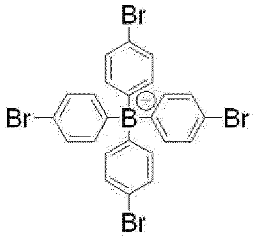
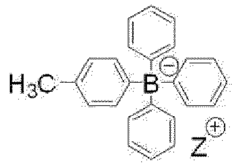
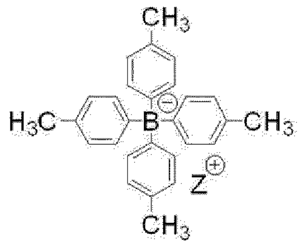

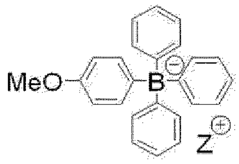
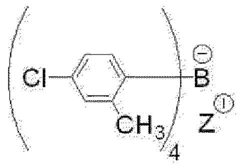
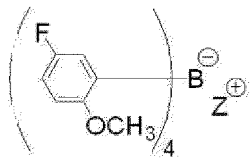
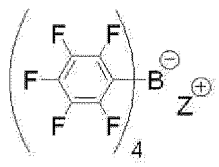

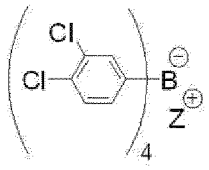
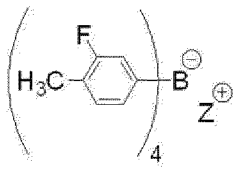
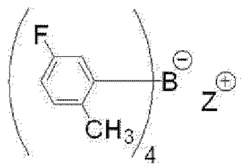
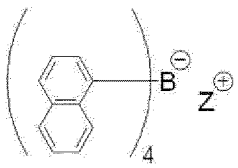

Only one kind of electron-donating polymerization initiator may be added to the image-recording layer, or two or more kinds of electron-donating polymerization initiators may be used in combination.

From the viewpoint of improving reactivity, the content of the electron-donating polymerization initiator with respect to the total mass of the image-recording layer is preferably 0.1% by mass to 10% by mass, more preferably 1.0% by mass to 10% by mass, and even more preferably 3.0% by mass to 7.0% by mass.

One of the preferred aspects is an aspect in which the aforementioned electron-accepting polymerization initiator and the aforementioned electron-donating polymerization initiator form a salt.

Specific examples thereof include an aspect in which the aforementioned onium compound is a salt formed of an onium ion and an anion of the electron-donating polymerization initiator (for example, a tetraphenyl borate anion). Furthermore, for example, an iodonium borate compound is more preferable which is a salt formed of an iodonium cation of the aforementioned iodonium salt compound (for example, a di-p-tolyl iodonium cation) and a borate anion of the aforementioned electron-donating polymerization initiator.

Specific examples of the aspect in which the electron-accepting polymerization initiator and the electron-donating polymerization initiator form a salt will be shown below.

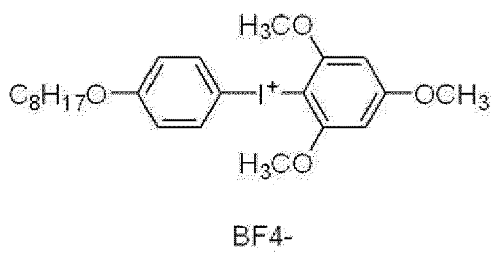

(IA-1)

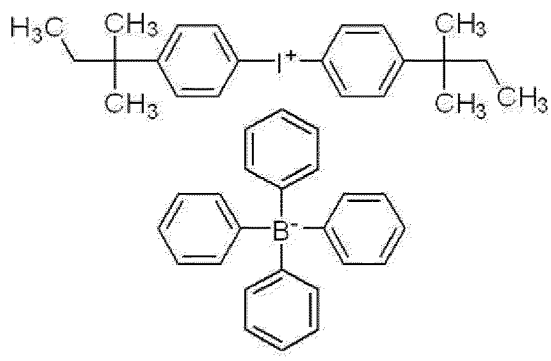

(IA-2)

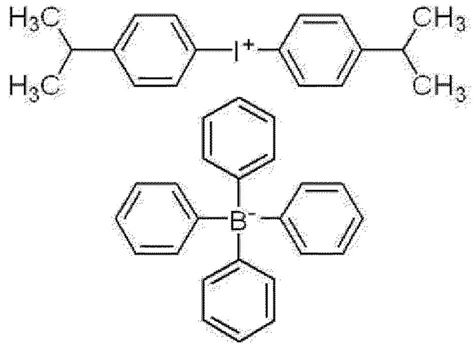

(IA-3)

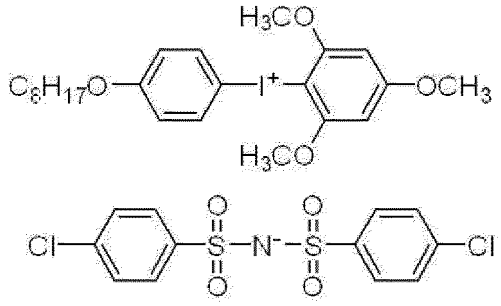

(IA-4)

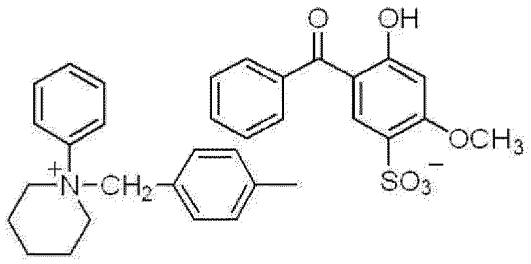

(IA-5)

**In** the present specification, in a case where the image-recording layer contains an onium ion and an anion of the aforementioned electron-donating polymerization initiator, the image-recording layer is regarded as containing an electron-accepting polymerization initiator and the electron-donating polymerization initiator described above.

[Infrared absorber]

The image-recording layer in the present invention preferably contains an infrared absorber.

The infrared absorber is not particularly limited, and examples thereof include pigments and dyes.

As the dye that is used as the infrared absorber, it is possible to use commercially available dyes and known dyes described in publications, for example, "Dye Handbooks" (edited by the Society of Synthetic Organic Chemistry, Japan, 1970). Specific examples thereof include dyes such as an azo dye, a metal complex azo dye, a pyrazolone azo dye, a naphthoquinone dye, an anthraquinone dye, a phthalocyanine dye, a carbonium dye, a quinoneimine dye, a methine dye, a cyanine dye, a squarylium colorant, a pyrylium salt, and a metal thiolate complex.

Among these dyes, for example, a cyanine dye, a squarylium colorant, a pyrylium salt, a nickel thiolate complex, and an indolenine cyanine dye are particularly preferable. Among these, a cyanine dye is particularly preferable.

The infrared absorber is preferably a cationic polymethine colorant having an oxygen or nitrogen atom at the meso-position. As the cationic polymethine colorant, for example, a cyanine dye, a pyrylium colorant, a thiopyrylium colorant, an azulenium colorant, and the like are preferable. From the viewpoint of ease of availability, solubility in a solvent during an introduction reaction, and the like, a cyanine dye is preferable.

Specific examples of the cyanine dye include the compounds described in paragraphs "0017" to "0019" of JP2001-133969A, paragraphs "0016" to "0021" of JP2002-023360A, and paragraphs "0012" to "0037" of JP2002-040638A, and the like. Specifically, as the cyanine dye, for example, the compounds described in paragraphs "0034" to "0041" of JP2002-278057A or paragraphs "0080" to "0086" of JP2008-195018A are preferable, and the compounds described in paragraphs "0035" to "0043" of JP2007-90850A or the compounds described in paragraphs "0105" to "0113" of JP2012-206495A are particularly preferable.

Furthermore, as the cyanine dye, the compounds described in paragraphs "0008" and "0009" of JP1993-5005A (JP-H05-5005A) and paragraphs "0022" to "0025" of JP2001-222101A can also be preferably used.

As pigments, the compounds described in paragraphs "0072" to "0076" of JP2008-195018A are preferable.

One kind of infrared absorber may be used alone, or two or more kinds of infrared absorbers may be used in combination. In addition, as the infrared absorber, a pigment and a dye may be used in combination.

The content of the infrared absorber in the image-recording layer with respect to the total mass of the image-recording layer is preferably 0.1% by mass to 10.0% by mass, and more preferably 0.5% by mass to 5.0% by mass.

-Relationship between electron-donating polymerization initiator and infrared absorber-

From the viewpoint of suppressing the occurrence of plate missing, the image-recording layer contains the electron-donating polymerization initiator and the infrared absorber described above, and HOMO of the infrared absorber - HOMO of the electron-donating polymerization initiator is preferably 0.70 eV or less, and more preferably 0.70 eV to -0.10 eV.
The negative sign means that HOMO of the electron-donating polymerization initiator is higher than HOMO of the infrared absorber.

-Preferred aspects of infrared absorber and electron-accepting polymerization initiator-

From the viewpoint of suppressing the occurrence of plate missing, in a preferred aspect, the infrared absorber has an organic anion that satisfies $\delta d \geq 16$, $\delta p = 16$ to 32, and $\delta h \leq \delta p \times 0.6$ in the Hansen solubility parameters.
From the viewpoint of suppressing the occurrence of plate missing, in a preferred aspect, the electron-accepting polymerization initiator has an organic anion that satisfies $\delta d \geq 16$, $\delta p = 16$ to 32, and $\delta h \leq \delta p \times 0.6$ in the Hansen solubility parameters.
In the present specification, as $\delta d$, $\delta p$, and $\delta h$ in the Hansen solubility parameters, the dispersion element $\delta d$ [unit: $MPa^{0.5}$], the polarity element $\delta p$ [unit: $MPa^{0.5}$], and the hydrogen bond element $\delta h$ [unit: $MPa^{0.5}$] in the Hansen solubility parameters are used. The Hansen solubility parameters are obtained by dividing the solubility parameters introduced by Hildebrand into three components, a dispersion element $\delta d$, a polarity element $\delta p$, and a hydrogen bond element $\delta h$, and expressing the parameters in a three-dimensional space.
Details of the Hansen solubility parameters are described in the document "Hansen Solubility Parameters; A Users Handbook (CRC Press, 2007)" written by Charles M. Hansen.
In the present specification, $\delta d$, $\delta p$, and $\delta h$ of the organic anion in the Hansen solubility parameters are values estimated from the chemical structure by using the computer software "Hansen Solubility Parameters in Practice (HSPiP ver. 4.1.07)".
Specifically, suitable examples of the organic anions that satisfies $\delta d \geq 16$, $\delta p = 16$ to 32, $\delta h \leq \delta p \times 0.6$ in the Hansen solubility parameters include the following anions

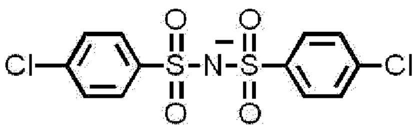

An - 1

[Binder polymer]

The image-recording layer may contain a binder polymer.
As the binder polymer, a known binder polymer used for a lithographic printing plate precursor can be used without limitation.
From the viewpoint of inhibiting on-press developability from deteriorating over time, the glass transition temperature (Tg) of the binder polymer used is preferably 50°C or higher, more preferably 70°C or higher, even more preferably 80°C or higher, and particularly preferably 90°C or higher.
Furthermore, from the viewpoint of ease of permeation of water into the image-recording layer, the upper limit of the glass transition temperature of the binder polymer is preferably 200°C, and more preferably 120°C or lower.
From the viewpoint of further inhibiting on-press developability from deteriorating over time, as the binder polymer having the above glass transition temperature, polyvinyl acetal is preferable.
Polyvinyl acetal is a resin obtained by acetalizing hydroxyl groups of polyvinyl alcohol with an aldehyde.
Particularly, polyvinyl butyral is preferable which is obtained by acetalizing (that is, butyralizing) hydroxyl groups of polyvinyl alcohol with butyraldehyde.
As polyvinyl acetal, a compound having a constitutional unit represented by the following (a) is preferable which is obtained by acetalizing hydroxyl groups of polyvinyl alcohol with an aldehyde.

(a)

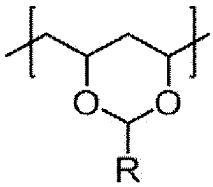

R represents a residue of aldehyde used for acetalization.

Examples of R include a hydrogen atom, an alkyl group, and an ethylenically unsaturated group which will be described later.

The content of the constitutional unit represented by (a) (also described as the amount of ethylene groups in the main chain contained in the constitutional unit represented by (a), which is also called degree of acetalization) with respect to the total content of constitutional units of the polyvinyl acetal (total amount of ethylene groups in the main chain) is preferably 50 mol% to 90 mol%, more preferably 55 mol% to 85 mol%, and even more preferably 55 mol% to 80 mol%.

The degree of acetalization is a value obtained by dividing the amount of ethylene groups to which acetal groups are bonded (amount of ethylene groups in the main chain contained in the constitutional unit represented by (a)) by the total amount of ethylene groups in the main chain and expressing the thus obtained molar fraction as a percentage.

The same shall be applied to the content of each constitutional unit of polyvinyl acetal which will be described later.

From the viewpoint of improving printing durability, the polyvinyl acetal preferably has an ethylenically unsaturated group.

The ethylenically unsaturated group that the polyvinyl acetal has is not particularly limited. From the viewpoint of reactivity, on-press developability, and printing durability, the ethylenically unsaturated group is preferably at least one kind of group selected from the group consisting of a vinyl phenyl group (styryl group), a vinyl ester group, a vinyl ether group, an allyl group, a (meth)acryloxy group, and a (meth)acrylamide group. Among these, a vinyl group, an allyl group, a (meth) acryloxy group, and the like are more preferable.

From the viewpoint of improving printing durability, the polyvinyl acetal preferably has an ethylenically unsaturated group-containing constitutional unit.

The ethylenically unsaturated group-containing constitutional unit may be the aforementioned constitutional unit having an acetal ring or a constitutional unit other than the constitutional unit having an acetal ring.

Particularly, from the viewpoint of increasing crosslink density during exposure, the polyvinyl acetal is preferably a compound in which an ethylenically unsaturated group is introduced into an acetal ring. That is, it is preferable that the constitutional unit represented by (a) have an ethylenically unsaturated group as R.

In a case where the ethylenically unsaturated group-containing constitutional unit is a constitutional unit other than the constitutional unit having an acetal ring, for example, the ethylenically unsaturated group-containing constitutional unit may be a constitutional unit having an acrylate group, specifically, a constitutional unit represented by (d).

(d)

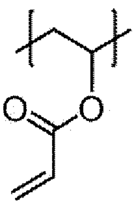

In a case where the ethylenically unsaturated group-containing constitutional unit is a constitutional unit other than the constitutional unit having an acetal ring, the content of the ethylenically unsaturated group-containing constitutional unit (also called amount of acrylate groups) with respect to the total content of constitutional units of the polyvinyl acetal is preferably 1 mol% to 15 mol%, and more preferably 1 mol% to 10 mol%.

From the viewpoint of on-press developability, the polyvinyl acetal preferably further has a hydroxyl group-containing constitutional unit. That is, the polyvinyl acetal preferably contains a constitutional unit derived from vinyl alcohol.

Examples of the hydroxyl group-containing constitutional unit include a constitutional unit represented by (b).

(b)

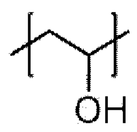

From the viewpoint of on-press developability, the content of the constitutional unit represented by (b) (also called amount of hydroxyl groups) with respect to the total content of constitutional units of the polyvinyl acetal is preferably 5 mol% to 50 mol%, more preferably 10 mol% to 40 mol%, and even more preferably 20 mol% to 40 mol%.
The polyvinyl acetal may further have other constitutional units.
Examples of those other constitutional units include a constitutional unit having an acetyl group, specifically, a constitutional unit represented by (c).

(c)

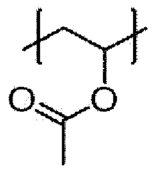

The content of the constitutional unit represented by (c) (also called amount of acetyl groups) with respect to the total content of constitutional units of the polyvinyl acetal is preferably 0.5 mol% to 10 mol%, more preferably 0.5 mol% to 8 mol%, and even more preferably 1 mol% to 3 mol%.
The degree of acetalization, the amount of acrylate groups, the amount of hydroxyl groups, and the amount of acetyl groups can be determined as follows.
That is, by $^1$H NMR spectroscopy, the content expressed as mol% is calculated from the ratio of peak surface area of protons of a methyl or methylene moiety of acetal, a methyl moiety of an acrylate group, and a methyl moiety of a hydroxyl group and an acetyl group.
The weight-average molecular weight of the polyvinyl acetal is preferably 10,000 to 150,000.
The Hansen solubility parameter of the polyvinyl acetal is preferably 17.5 $MPa^{1/2}$ to 20.0 $MPa^{1/2}$, and more preferably 18.0 $MPa^{1/2}$ to 19.5 $MPa^{1/2}$.
Furthermore, in a case where a compound is an addition polymerization-type polymer, a polycondensation-type polymer, or the like, the SP value of the compound is expressed as the total SP value obtained by multiplying the SP values of monomer units by molar fractions. Furthermore, in a case where a compound is a low-molecular-weight compound having no monomer unit, the SP value is expressed as the total solubility parameter of the compound.
In the present specification, the SP value of a polymer may be calculated from the molecular structure of the polymer by the Hoy method described in Polymer Handbook (fourth edition).
Specific examples of the polyvinyl acetal are shown in the following [P-1 to P-3]. However, the polyvinyl acetal used is not limited thereto.
In the following structures, "l" is 50 mol% to 90 mol%, "m" is 0.5 mol% to 10% mol%, "n" is 5 mol% to 50 mol%, and "o" is 1 mol% to 15 mol%.

P-1

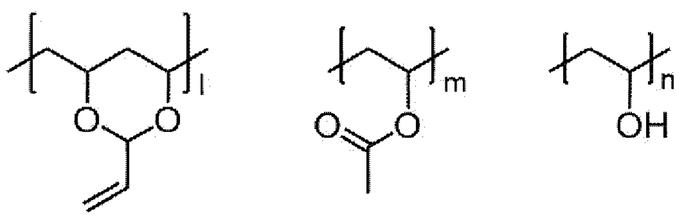

P-2

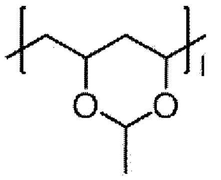 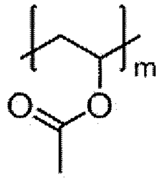 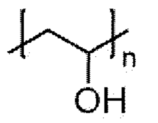 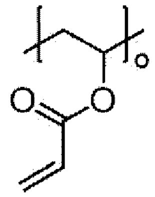

P-3

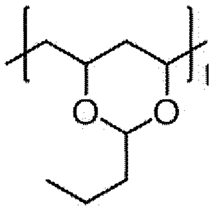 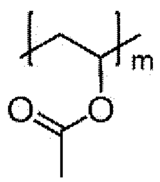 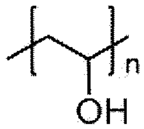

As the polyvinyl acetal, commercially available products can be used.

Examples of commercially available products of polyvinyl acetal include S-LEC BL series (specifically, S-LEC BL-10, BL-1, BL-5Z, BL-7Z, and the like), S-LEC BM series (specifically, S-LEC BM-1, BM-S(Z), BM-5, and the like), S-LEC BH series (specifically, S-LEC BH-S, BH-6, and BH-3(Z)), S-LEC BX series (S-LEC BX-L and the like), and S-LEC KS series (S-LEC KS-10 and the like) manufactured by SEKISUI CHEMICAL CO., LTD.

However, from the viewpoint of suppressing the occurrence of plate missing, it is preferable to increase the content of the polymerizable resin particles A and the polymerizable compound B in the image-recording layer, and the image-recording layer preferably does not contain a binder polymer or contains a small amount of binder polymer.

From the viewpoint of improving developability and suppressing the occurrence of plate missing, the content of the binder polymer with respect to the total mass of the image-recording layer is preferably 30% by mass or less, more preferably 20% by mass or less, even more preferably 10% by mass, and particularly preferably 0% by mass.

[Color developing agent]

The image-recording layer preferably contains a color developing agent, and more preferably contains an acid color-developing agent.

As the color developing agent, an acid color-developing agent is particularly preferable.

"Color developing agent" means a compound that has a property of developing or removing color by a stimulus such as light or an acid and thus changing the color of the image-recording layer. Furthermore, "acid color-developing agent" means a compound having a property of developing or removing color by being heated in a state of accepting an electron accepting compound (for example, a proton of an acid or the like) and thus changing the color of the image-recording layer.

The acid color-developing agent is particularly preferably a colorless compound which has a partial skeleton such as lactone, lactam, sultone, spiropyran, an ester, or an amide and allows such a partial skeleton to rapidly open the ring or to be cleaved when coming into contact with an electron accepting compound.

Examples of the acid color-developing agent include phthalides such as 3,3-bis(4-dimethylaminophenyl)-6-dimethylaminophthalide (also called crystal violet lactone), 3,3-bis(4-dimethylaminophenyl)phthalide, 3-(4-dimethylaminophenyl)-3-(4-diethylamino-2-methylphenyl)-6-dimethylaminophthalide, 3-(4-dimethylaminophenyl)-3-(1,2-dimethylindol-3-yl) phthalide, 3-(4-dimethylaminophenyl)-3-(2-methylindole-3-yl)phthalide, 3,3-bis(1,2-dimethylindol-3-yl)-5-dimethylaminophthalide, 3,3-bis(1,2-dimethylindol-3-yl)-6-dimethylaminophthalide, 3,3-bis(9-ethylcarbazol-3-yl)-6-dimethylaminophthalide, 3,3-bis(2-phenylindol-3-yl)-6-dimethylaminophthalide, 3-(4-dimethylaminophenyl)-3-(1-methylpyrrol-3-yl)-6-dimethylaminophthalide,

3,3-bis[1,1-bis(4-dimethylaminophenyl)ethylen-2-yl]-4,5,6,7-tetrachlorophthalide, 3,3-bis[1,1-bis(4-pyrrolidinophenyl)ethylen-2-yl]-4,5,6,7-tetrabromophthalide, 3,3-bis[1-(4-dimethylaminophenyl)-1-(4-methoxyphenyl)ethylen-2-yl]-4,5,6,7-tetrachlorophth alide, 3,3-bis[1-(4-pyrrolidinophenyl)-1-(4-methoxyphenyl)ethylen-2-yl]-4,5,6,7-tetrachlorophthalid e, 3-[1,1-di(1-ethyl-2-methylindol-3-yl)ethylen-2-yl]-3-(4-diethylaminophenyl)phthalide, 3-[1,1-di(1-ethyl-2-methylindol-3-yl)ethylen-2-yl]-3-(4-N-ethyl-N-phenylaminophenyl)phthali de, 3-(2-ethoxy-4-diethylaminophenyl)-3-(1-n-octyl-2-methylindol-3-yl)-phthalide, 3,3-bis(1-n-octyl-2-methylindol-3-yl)-phthalide, and 3-(2-methyl-4-diethylaminophenyl)-3-(1-n-octyl-2-methylindol-3-yl)-phthalide,

4,4-bis-dimethylaminobenzhydrinbenzyl ether, N-halophenyl-leucoauramine, N-2,4,5-trichlorophenylleucoauramine, rhodamine-B-anilinolactam, rhodamine-(4-nitroanilino)lactam, rhodamine-B-(4-chloroanilino)lactam, 3,7-bis(diethylamino)-10-benzoylphenoxazine, benzoyl leucomethylene blue, 4-nitrobenzoyl methylene blue,

fluorans such as 3,6-dimethoxyfluoran, 3-dimethylamino-7-methoxyfluoran, 3-diethylamino-6-methoxyfluoran, 3-diethylamino-7-methoxyfluoran, 3-diethylamino-7-chlorofluoran, 3-diethylamino-6-methyl-7-chlorofluoran, 3-diethylamino-6,7-dimethylfluoran, 3-N-cyclohexyl-N-n-butylamino-7-methylfluoran, 3-diethylamino-7-dibenzylaminofluoran, 3-diethylamino-7-octylaminofluoran, 3-diethylamino-7-di-n-hexylaminofluoran, 3-diethylamino-7-anilinofluoran, 3-diethylamino-7-(2'-fluorophenylamino)fluoran, 3-diethylamino-7-(2'-chlorophenylamino)fluoran, 3-diethylamino-7-(3'-chlorophenylamino)fluoran, 3-diethylamino-7-(2',3'-dichlorophenylamino)fluoran, 3-diethylamino-7-(3'-trifluoromethylphenylamino)fluoran, 3-di-n-butylamino-7-(2'-fluorophenylamino)fluoran, 3-di-n-butylamino-7-(2'-chlorophenylamino)fluoran, 3-N-isopentyl-N-ethylamino-7-(2'-chlorophenylamino)fluoran,

3-N-n-hexyl-N-ethylamino-7-(2'-chlorophenylamino)fluoran, 3-diethylamino-6-chloro-7-anilinofluoran, 3-di-n-butylamino-6-chloro-7-anilinofluoran, 3-diethylamino-6-methoxy-7-anilinofluoran, 3-di-n-butylamino-6-ethoxy-7-anilinofluoran, 3-pyrrolidino-6-methyl-7-anilinofluoran, 3-piperidino-6-methyl-7-anilinofluoran, 3-morpholino-6-methyl-7-anilinofluoran, 3-dimethylamino-6-methyl-7-anilinofluoran, 3-diethylamino-6-methyl-7-anilinofluoran, 3-di-n-butylamino-6-methyl-7-anilinofluoran, 3-di-n-pentylamino-6-methyl-7-anilinofluoran, 3-N-ethyl-N-methylamino-6-methyl-7-anilinofluoran, 3-N-n-propyl-N-methylamino-6-methyl-7-anilinofluoran, 3-N-n-propyl-N-ethylamino-6-methyl-7-anilinofluoran, 3-N-n-butyl-N-methylamino-6-methyl-7-anilinofluoran, 3-N-n-butyl-N-ethylamino-6-methyl-7-anilinofluoran, 3-N-isobutyl-N-methylamino-6-methyl-7-anilinofluoran, 3-N-isobutyl-N-ethylamino-6-methyl-7-anilinofluoran, 3-N-isopentyl-N-ethylamino-6-methyl-7-anilinofluoran, 3-N-n-hexyl-N-methylamino-6-methyl-7-anilinofluoran, 3-N-cyclohexyl-N-ethylamino-6-methyl-7-anilinofluoran, 3-N-cyclohexyl-N-n-propylamino-6-methyl-7-anilinofluoran, 3-N-cyclohexyl-N-n-butylamino-6-methyl-7-anilinofluoran, 3-N-cyclohexyl-N-n-hexylamino-6-methyl-7-anilinofluoran, 3-N-cyclohexyl-N-n-octylamino-6-methyl-7-anilinofluoran,

3-N-(2'-methoxyethyl)-N-methylamino-6-methyl-7-anilinofluoran, 3-N-(2'-methoxyethyl)-N-ethylamino-6-methyl-7-anilinofluoran, 3-N-(2'-methoxyethyl)-N-isobutylamino-6-methyl-7-anilinofluoran, 3-N-(2'-ethoxyethyl)-N-methylamino-6-methyl-7-anilinofluoran, 3-N-(2'-ethoxyethyl)-N-ethylamino-6-methyl-7-anilinofluoran, 3-N-(3'-methoxypropyl)-N-methylamino-6-methyl-7-anilinofluoran, 3-N-(3'-methoxypropyl)-N-ethylamino-6-methyl-7-anilinofluoran, 3-N-(3'-ethoxypropyl)-N-methylamino-6-methyl-7-anilinofluoran, 3-N-(3'-ethoxypropyl)-N-ethylamino-6-methyl-7-anilinofluoran, 3-N-(2'-tetrahydrofurfuryl)-N-ethylamino-6-methyl-7-anilinofluoran, 3-N-(4'-methylphenyl)-N-ethylamino-6-methyl-7-anilinofluoran, 3-diethylamino-6-ethyl-7-anilinofluoran, 3-diethylamino-6-methyl-7-(3'-methylphenylamino) fluoran, 3-diethylamino-6-methyl-7-(2',6'-dimethylphenylamino)fluoran, 3-di-n-butylamino-6-methyl-7-(2',6'-dimethylphenylamino)fluoran, 3-di-n-butylamino-7-(2',6'-dimethylphenylamino)fluoran, 2,2-bis[4'-(3-N-cyclohexyl-N-methylamino-6-methylfluoran)-7-ylaminophenyl]propane, 3-[4'-(4-phenylaminophenyl)aminophenyl]amino-6-methyl-7-chlorofluoran, and 3-[4'-(dimethylaminophenyl)]amino-5,7-dimethylfluoran,

phthalides such as 3-(2-methyl-4-diethylaminophenyl)-3-(1-ethyl-2-methylindol-3-yl)-4-azaphthalide, 3-(2-n-propoxycarbonylamino-4-di-n-propylaminophenyl)-3-(1-ethyl-2-methylindol-3-yl)-4-a zaphthalide, 3-(2-methylamino-4-di-n-propylaminophenyl)-3-(1-ethyl-2-methylindol-3-yl)-4-azaphthalide, 3-(2-methyl-4-di-n-hexylaminophenyl)-3-(1-n-octyl-2-methylindol-3-yl)-4,7-diazaphthalide, 3,3-bis(2-ethoxy-4-diethylaminophenyl)-4-azaphthalide, 3,3-bis(1-n-octyl-2-methylindol-3-yl)-4-azaphthalide, 3-(2-ethoxy-4-diethylaminophenyl)-3-(1-ethyl-2-methylindol-3-yl)-4-azaphthalide, 3-(2-ethoxy-4-diethylaminophenyl)-3-(1-octyl-2-methylindol-3-yl)-4 or 7-azaphthalide, 3-(2-ethoxy-4-diethylaminophenyl)-3-(1-ethyl-2-methylindol-3-yl)-4 or 7-azaphthalide, 3-(2-hexyloxy-4-diethylaminophenyl)-3-(1-ethyl-2-methylindol-3-yl)-4 or 7-azaphthalide, 3-(2-ethoxy-4-diethylaminophenyl)-3-(1-ethyl-2-phenylindol-3-yl)-4 or 7-azaphthalide, 3-(2-butoxy-4-diethylaminophenyl)-3-(1-ethyl-2-phenylindol-3-yl)-4 or 7-azaphthalide 3-methyl-spiro-dinaphthopyran, 3-ethyl-spiro-dinaphthopyran, 3-phenyl-spiro-dinaphthopyran, 3-benzyl-spiro-dinaphthopyran, 3-methyl-naphtho-(3-methoxybenzo)spiropyran, 3-propyl-spiro-dibenzopyran-3,6-bis(dimethylamino)fluorene-9-spiro-3'-(6'-dimethylamino) p hthalide, and 3,6-bis(diethylamino)fluorene-9-spiro-3'-(6'-dimethylamino) phthalide,

2'-anilino-6'-(N-ethyl-N-isopentyl)amino-3'-methylspiro[isobenzofuran-1(3H),9'-(9H)xanthe n-3-one, 2'-anilino-6'-(N-ethyl-N-(4-methylphenyl))amino-3'-methylspiro[isobenzofuran-1(3H),9'-(9H )xanthen]-3-one, 3'-N,N-dibenzylamino-6'-N,N-diethylaminospiro[isobenzofuran-1(3H),9'-(9H)xanthen]-3-on e, 2'-(N-methyl-N-phenyl)amino-6'-(N-ethyl-N-(4-methylphenyl))aminospiro[isobenzofuran-1( 3H),9'-(9H)xanthen]-3-one, and the like.

Particularly, the acid color-developing agent is preferably at least one kind of compound selected from the group consisting of a spiropyran compound, a spirooxazine compound, a spirolactone compound, and a spirolactam compound.

From the viewpoint of visibility, the hue of the colorant after color development is preferably green, blue, or black.

Furthermore, from the viewpoint of color developability and visibility of exposed portions, the acid color-developing agent is preferably a leuco colorant.

The leuco colorant is not particularly limited as long as it has a leuco structure. The leuco colorant preferably has a spiro structure, and more preferably has a spirolactone ring structure.

From the viewpoint of color developability and visibility of exposed portions, the leuco colorant preferably has a

phthalide structure or a fluoran structure.

Furthermore, from the viewpoint of color developability and visibility of exposed portions, the leuco colorant having the phthalide structure or the fluoran structure is preferably a compound represented by any of Formula (Le-1) to Formula (Le-3), and more preferably a compound represented by Formula (Le-2).

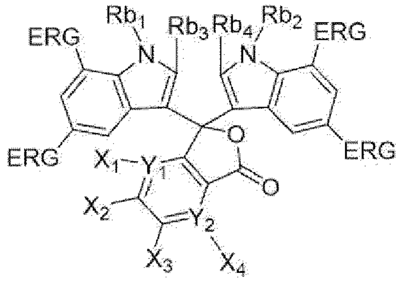

(Le - 1)

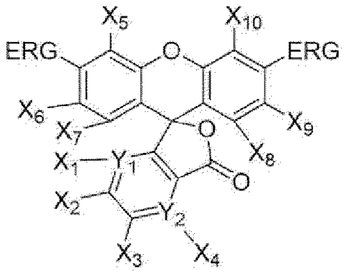

(Le - 2)

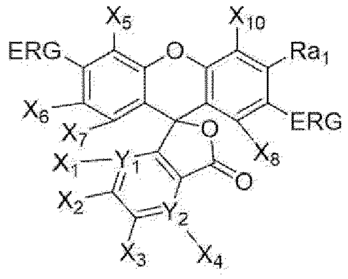

(Le - 3)

In Formula (Le-1) to Formula (Le-3), ERG each independently represents an electron donating group, $X_1$ to $X_4$ each independently represent a hydrogen atom, a halogen atom, or a dialkylanilino group, $X_5$ to $X_{10}$ each independently represent a hydrogen atom, a halogen atom, or a monovalent organic group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

As the electron donating groups represented by ERG in Formula (Le-1) to Formula (Le-3), from the viewpoint of color developability and visibility of exposed portions, an amino group, an alkylamino group, an arylamino group, a dialkylamino group, a monoalkyl monoarylamino group, a diarylamino group, an alkoxy group, an aryloxy group or an alkyl group is preferable, an amino group, alkylamino group, arylamino group, dialkylamino group, monoalkyl monoarylamino group, diarylamino group, alkoxy group, or an aryloxy group is more preferable, a monoalkyl monoarylamino group or a diarylamino group is even more preferable, and a monoalkyl monoarylamino group is particularly preferable.

From the viewpoint of color developability and visibility of exposed portions, $X_1$ to $X_4$ in Formula (Le-1) to Formula (Le-3) preferably each independently represent a hydrogen atom or a chlorine atom, and more preferably each independently represent a hydrogen atom.

From the viewpoint of color developability and visibility of exposed portions, $X_5$ to $X_{10}$ in Formula (Le-2) or Formula (Le-3) preferably each independently represent a hydrogen atom, a halogen atom, an alkyl group, an aryl group, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, or an cyano group, more preferably each independently represent a hydrogen atom, a halogen atom, an alkyl group, an aryl group, an alkoxy group, or an aryloxy group, even more preferably each independently represent a hydrogen atom, a halogen atom, an alkyl group, or an aryl group, and particularly preferably each independently represent a hydrogen atom.

From the viewpoint of color developability and visibility of exposed portions, it is preferable that at least one of $Y_1$ or $Y_2$ in Formula (Le-1) to Formula (Le-3) be C, and it is more preferable that both of $Y_1$ and $Y_2$ be C.

From the viewpoint of color developability and visibility of exposed portions, $Ra_1$ in Formula (Le-1) to Formula (Le-3) is preferably an alkyl group or an alkoxy group, more preferably an alkoxy group, and particularly preferably a methoxy group.

From the viewpoint of color developability and visibility of exposed portions, $Rb_1$ to $Rb_4$ in Formula (Le-1) to Formula (Le-3) preferably each independently represent a hydrogen atom or an alkyl group, more preferably each independently represent an alkyl group, and particularly preferably each independently represent a methyl group.

Furthermore, from the viewpoint of color developability and visibility of exposed portions, the leuco colorant having a phthalide structure or a fluoran structure is more preferably a compound represented by any of Formula (Le-4) to Formula (Le-6), and even more preferably a compound represented by Formula (Le-5).

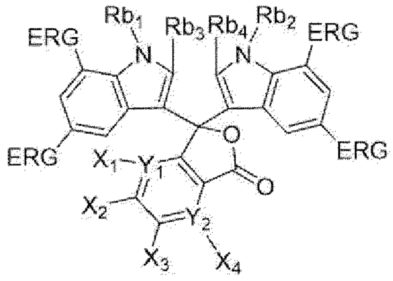
( Le - 4 )

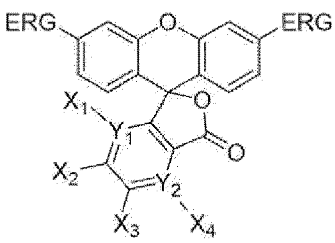
( Le - 5 )

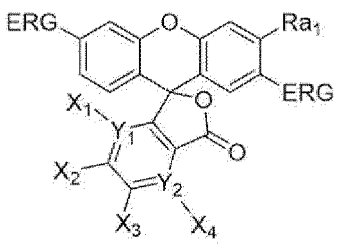
( Le - 6 )

In Formula (Le-4) to Formula (Le-6), ERG each independently represents an electron donating group, $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ represents a hydrogen atom, an alkyl group, or an alkoxy group, and $Rb_1$ to $Rb_4$ each independently represent an alkyl group or an aryl group.

ERG, $X_1$ to $X_4$, $Y_1$, $Y_2$, $Ra_1$, and $Rb_1$ to $Rb_4$ in Formula (Le-4) to Formula (Le-6) have the same definitions as ERG, $X_1$ to $X_4$, $Y_1$, $Y_2$, $Ra_1$, and $Rb_1$ to $Rb_4$ in Formula (Le-1) to Formula (Le-3) respectively, and preferred aspects thereof are also the same.

Furthermore, from the viewpoint of color developability and visibility of exposed portions, the leuco colorant having a phthalide structure or a fluoran structure is more preferably a compound represented by any of Formula (Le-7) to Formula (Le-9), and particularly preferably a compound represented by Formula (Le-8).

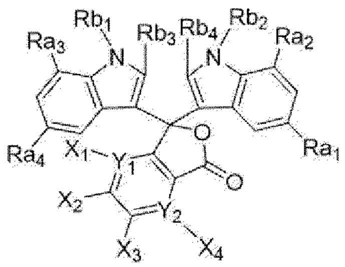
( Le - 7 )

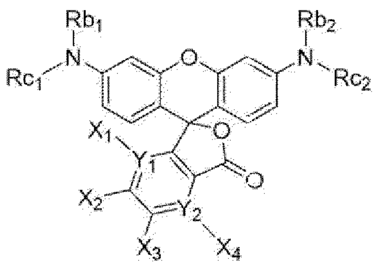
( Le - 8 )

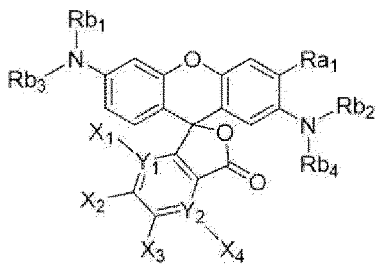
( Le - 9 )

In Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

$X_1$ to $X_4$, $Y_1$, and $Y_2$ in Formula (Le-7) to Formula (Le-9) have the same definition as $X_1$ to $X_4$, $Y_1$, and $Y_2$ in Formula (Le-1) to Formula (Le-3) respectively, and preferred aspects thereof are also the same.

From the viewpoint of color developability and visibility of exposed portions, $Ra_1$ to $Ra_4$ in Formula (Le-7) to Formula (Le-9) preferably each independently represent an alkyl group or an alkoxy group, more preferably each independently represent an alkoxy group, and particularly preferably each independently represent a methoxy group.

From the viewpoint of color developability and visibility of exposed portions, $Rb_1$ to $Rb_4$ in Formula (Le-7) to Formula (Le-9) preferably each independently represent a hydrogen atom, an alkyl group, or an aryl group substituted with an alkoxy group, more preferably each independently represent an alkyl group, and particularly preferably each independently represent a methyl group.

From the viewpoint of color developability and visibility of exposed portions, $Rc_1$ and $Rc_2$ in Formula (Le-7) to Formula (Le-9) preferably each independently represent a phenyl group or an alkylphenyl group, and more preferably each independently represent a phenyl group.

In Formula (Le-8), from the viewpoint of color developability and visibility of exposed portions, $X_1$ to $X_4$ preferably each represent a hydrogen atom, and $Y_1$ and $Y_2$ preferably each represent C.

Furthermore, from the viewpoint of color developability and visibility of exposed portions, in Formula (Le-8), $Rb_1$ and $Rb_2$ preferably each independently represent an alkyl group or an aryl group substituted with an alkoxy group.

The alkyl group in Formula (Le-1) to Formula (Le-9) may be linear or branched or may have a ring structure.

The number of carbon atoms in the alkyl group in Formula (Le-1) to Formula (Le-9) is preferably 1 to 20, more

preferably 1 to 8, even more preferably 1 to 4, and particularly preferably 1 or 2.

The number of carbon atoms in the aryl group in Formula (Le-1) to Formula (Le-9) is preferably 6 to 20, more preferably 6 to 10, and particularly preferably 6 to 8.

Each of the groups in Formula (Le-1) to Formula (Le-9), such as a monovalent organic group, an alkyl group, an aryl group, a dialkylanilino group, an alkylamino group, and an alkoxy group, may have a substituent. Examples of the substituent include an alkyl group, an aryl group, a halogen atom, an amino group, an alkylamino group, an arylamino group, a dialkylamino group, a monoalkyl monoarylamino group, a diarylamino group, a hydroxyl group, an alkoxy group, an aryloxy group, an acyl group, an alkoxycarbonyl group, an aryloxycarbonyl group, a cyano group, and the like. These substituents may be further substituted with these substituents.

Specific examples of the leuco colorant having a phthalide structure or a fluoran structure that are suitably used include the following compounds (S-1) to (S-14).

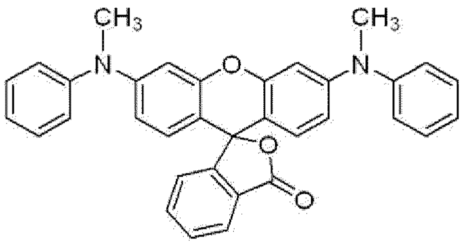

S - 1

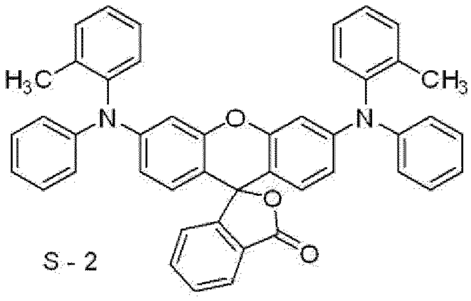

S - 2

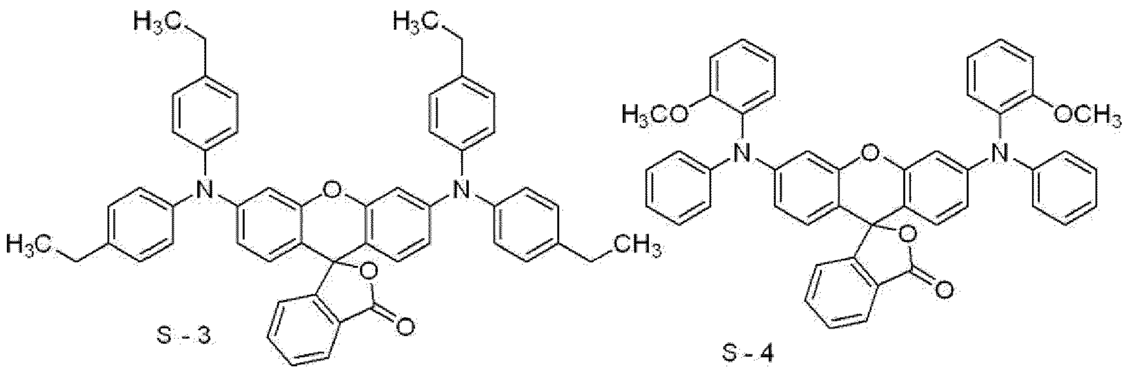

S - 3

S - 4

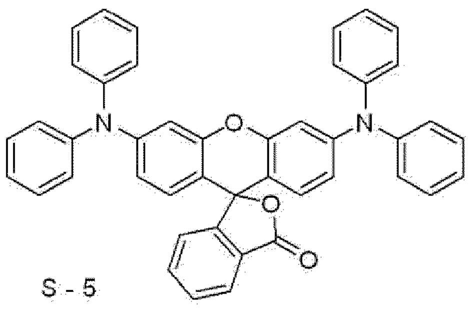

S - 5

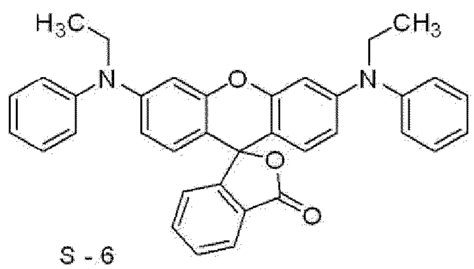

S - 6

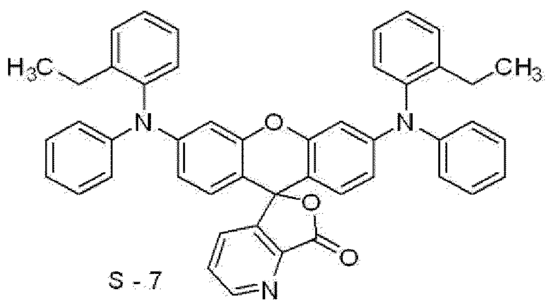

S - 7

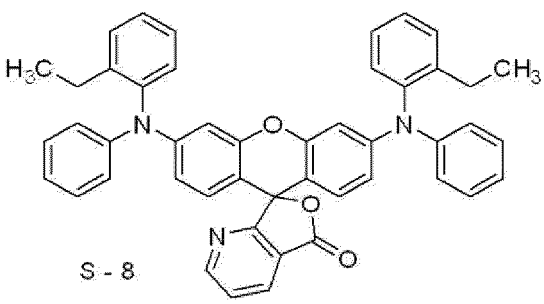

S - 8

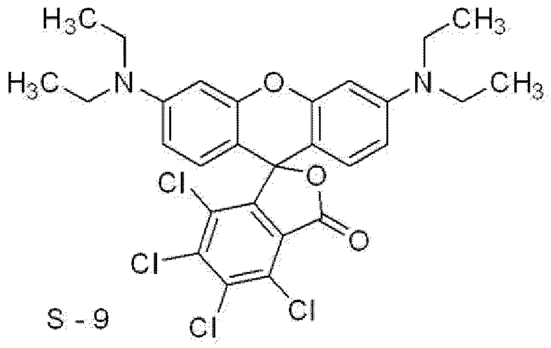

S - 9

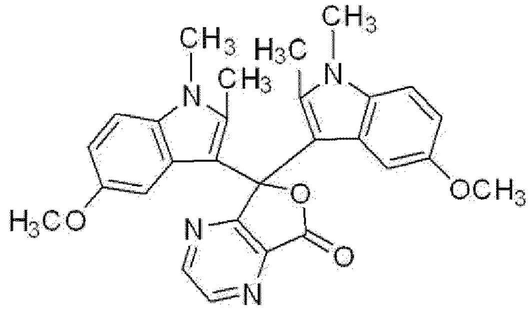

S - 10

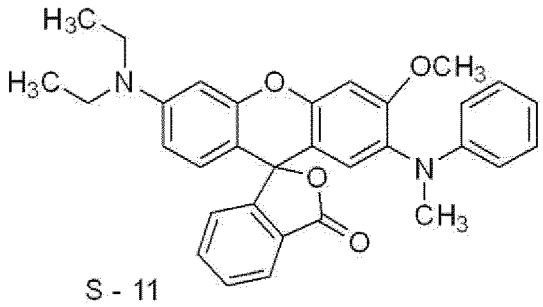

S - 11

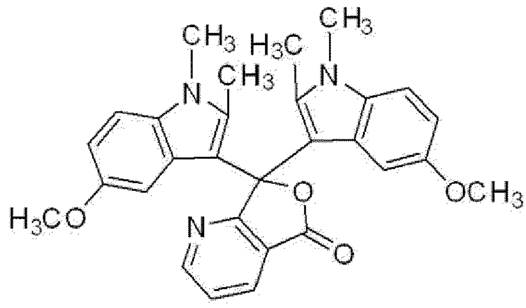

S - 12

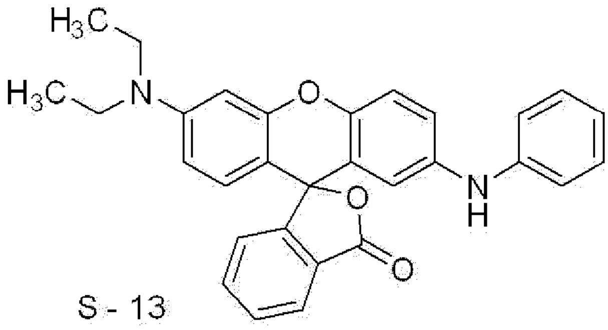

S - 13

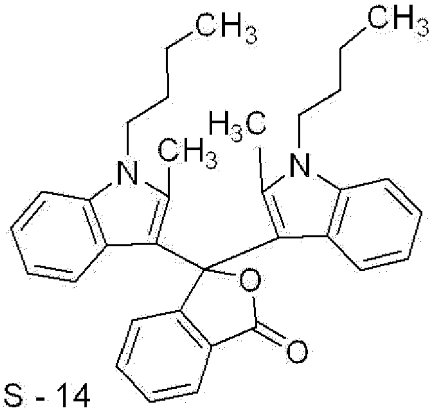

S - 14

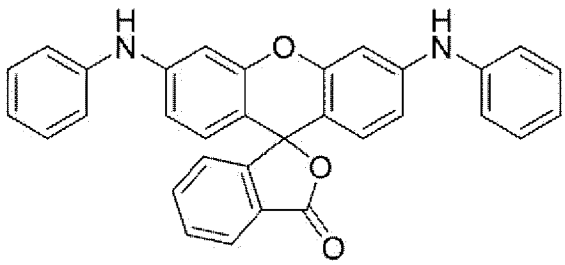

As the acid color-developing agent, commercially available products can also be used.

Examples of the products of the acid color-developing agent include ETAC, RED500, RED520, CVL, S-205, BLACK305, BLACK400, BLACK100, BLACK500, H-7001, GREEN300, NIRBLACK78, BLUE220, H-3035, BLUE203, ATP, H-1046, and H-2114 (all manufactured by Fukui Yamada Chemical Co., Ltd.), ORANGE-DCF, Vermilion-DCF, PINK-DCF, RED-DCF, BLMB, CVL, GREEN-DCF, and TH-107 (all manufactured by Hodogaya Chemical Co., Ltd.), ODB, ODB-2, ODB-4, ODB-250, ODB-BlackXV, Blue-63, Blue-502, GN-169, GN-2, Green-118, Red-40, and Red-8 (all manufactured by Yamamoto Chemicals, Inc.), crystal violet lactone (manufactured by Tokyo Chemical Industry Co., Ltd.), and the like.

Among these commercially available products, ETAC, S-205, BLACK305, BLACK400, BLACK100, BLACK500, H-7001, GREEN300, NIRBLACK78, H-3035, ATP, H-1046, H-2114, GREEN-DCF, Blue-63, GN-169, and crystal violet

lactone are preferable because these form a film having excellent visible light absorbance.

One kind of each of these color developing agents (preferably acid color-developing agents) may be used alone. Alternatively, two or more kinds of these components can be used in combination.

The content of the color developing agent (preferably an acid color-developing agent) with respect to the total mass of the image-recording layer is preferably 0.5% by mass to 10% by mass, and more preferably 1% by mass to 5% by mass.

[Chain transfer agent]

The image-recording layer may contain a chain transfer agent.

The chain transfer agent contributes to the improvement of printing durability of the lithographic printing plate.

As the chain transfer agent, a thiol compound is preferable, a thiol having 7 or more carbon atoms is more preferable from the viewpoint of boiling point (low volatility), and a compound having a mercapto group on an aromatic ring (aromatic thiol compound) is even more preferable. The thiol compound is preferably a monofunctional thiol compound.

Specific examples of the chain transfer agent include the following compounds.

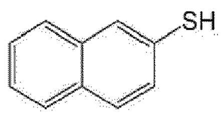

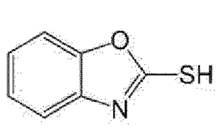 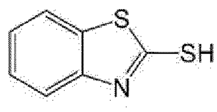 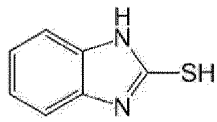

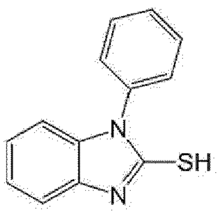 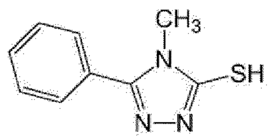 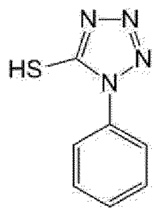

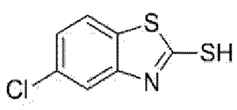 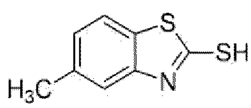 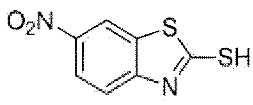 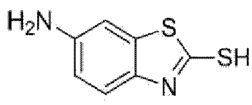

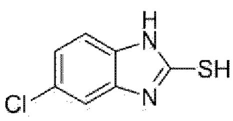 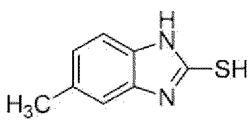 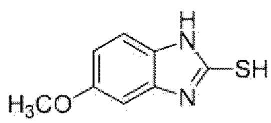 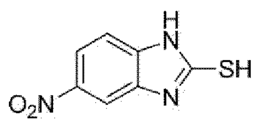

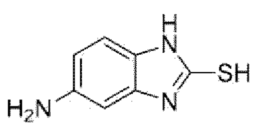 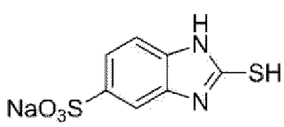 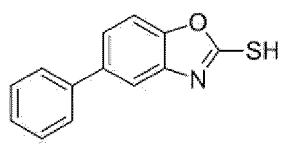

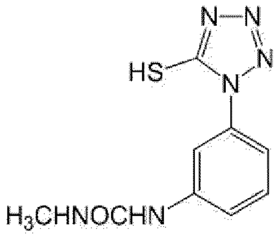
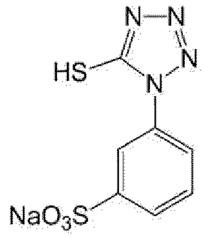
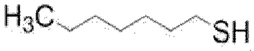
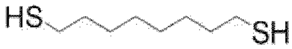
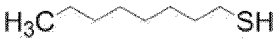
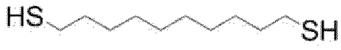
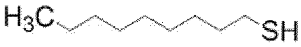
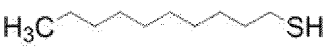
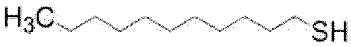
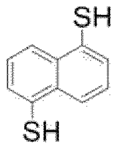
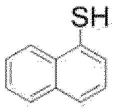
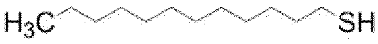
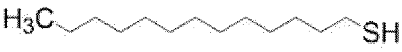
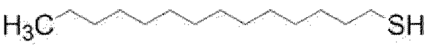
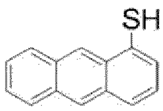
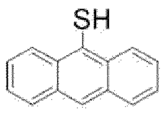
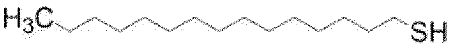
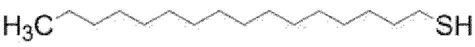
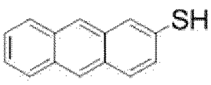
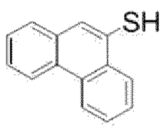
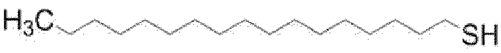
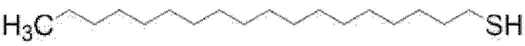
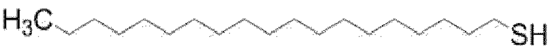
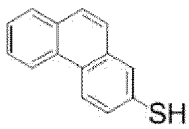
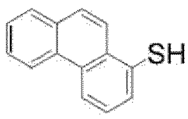
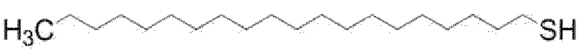
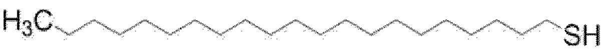
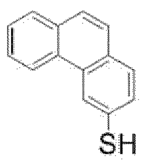
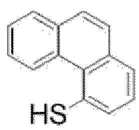
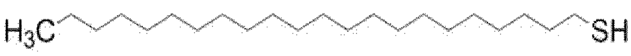

Only one kind of chain transfer agent may be added to the image-recording layer, or two or more kinds of chain transfer agents may be used in combination.

The content of the chain transfer agent with respect to the total mass of the image-recording layer is preferably 0.01% by mass to 50% by mass, more preferably 0.05% by mass to 40% by mass, and even more preferably 0.1% by mass to 30% by mass.

[Other resin particles]

In order to improve the on-press developability of the lithographic printing plate precursor, the image-recording layer may contain other resin particles different from the polymerizable resin particles A.

Those other resin particles are preferably resin particles that can convert the image-recording layer into hydrophobic in a case where heat is applied.

Those other resin particles are preferably at least one kind of particles selected from hydrophobic thermoplastic resin particles, thermally reactive resin particles, resin particles having a polymerizable group other than the polymerizable resin particles A, microcapsules encapsulating a hydrophobic compound, and microgel (that is, crosslinked resin particles).

Among these, resin particles having a polymerizable group other than the polymerizable resin particles A and microgel are preferable.

As the hydrophobic thermoplastic resin particles, for example, the hydrophobic thermoplastic resin particles described in Research Disclosure No. 33303 published in January 1992, JP1997-123387A (JP-H09-123387A), JP1997-131850A (JP-H09-131850A), JP1997-171249A (JP-H09-171249A), JP1997-171250A (JP-H09-171250A), and EP931647B are suitable.

Specific examples of resins constituting the hydrophobic thermoplastic resin particles include homopolymers or copolymers of monomers of ethylene, styrene, vinyl chloride, methyl acrylate, ethyl acrylate, methyl methacrylate, ethyl methacrylate, vinylidene chloride, acrylonitrile, vinylcarbazole, acrylates or methacrylates having polyalkylene structures, and the like and mixtures of these. For example, copolymers having polystyrene, styrene, and acrylonitrile or polymethyl methacrylate are preferable.

The volume average particle diameter of the hydrophobic thermoplastic resin particles is preferably 0.01 μm to 2.0 μm.

Examples of the thermally reactive resin particles include resin particles having a thermally reactive group. The resin particles having a thermally reactive group form a hydrophobized region through crosslinking by a thermal reaction and the accompanying change in functional groups.

As the thermally reactive group in the resin particles having a thermally reactive group, any functional group performing any reaction may be used as long as a chemical bond is formed. As the thermally reactive group, a polymerizable group is preferable. As the thermally reactive group, for example, an ethylenically unsaturated group that causes a radical polymerization reaction (for example, an acryloyl group, a methacryloyl group, a vinyl group, an allyl groups, and the like), a cationically polymerizable group (for example, a vinyl group, a vinyloxy group, an epoxy group, an oxetanyl group, and the like), an isocyanate group or a blocked isocyanate group that causes an addition reaction, an epoxy group, a vinyloxy group, an active hydrogen atom-containing functional group that is a reaction partner thereof (for example, an amino group, a hydroxyl group, a carboxy group, and the like), a carboxy group that causes a condensation reaction, a hydroxyl group or an amino group that is a reaction partner of the carboxy group, an acid anhydride that causes a ring-opening addition reaction, an amino group or a hydroxyl group which is a reaction partner of the acid anhydride, and the like are suitable.

Examples of the microcapsules include microcapsules encapsulating all or some of the constituent components of the image-recording layer as described in JP2001-277740A and JP2001-277742A. The constituent components of the image-recording layer can also be incorporated into the exterior of the microcapsules. In a preferred aspect, the image-recording layer containing microcapsules contains microcapsules that encapsulate hydrophobic constituent components and hydrophilic constituent components that are on the outside of the microcapsules.

The microgel (crosslinked resin particles) can contain some of the constituent components of the image-recording layer, in at least one of the interior or the surface of the microgel.

In order to encapsulate the constituent components of the image-recording layer in microcapsules or microgel, known methods can be used.

The average particle diameter of each of the microcapsules and the microgel is preferably 0.01 μm to 3.0 μm, more preferably 0.05 μm to 2.0 μm, and particularly preferably 0.10 μm to 1.0 μm. In a case where the average particle diameter is in this range, excellent resolution and temporal stability are obtained.

In a case where the image-recording layer contains other resin particles, the content of those other resin particles is preferably 0% by mass to 30% by mass with respect to the total mass of the image-recording layer.

[Low-molecular-weight hydrophilic compound]

In order to suppress the deterioration of printing durability and improve on-press developability, the image-recording layer may contain a low-molecular-weight hydrophilic compound.

The low-molecular-weight hydrophilic compound is preferably a compound having a molecular weight less than 1,000, more preferably a compound having a molecular weight less than 800, and even more preferably a compound having a molecular weight less than 500.

Examples of the low-molecular-weight hydrophilic compound include water-soluble organic compounds including glycols such as ethylene glycol, diethylene glycol, triethylene glycol, propylene glycol, dipropylene glycol, and tripropylene glycol, ether or ester derivatives of these glycols, polyols such as glycerin, pentaerythritol, and tris(2-hydroxyethyl)isocyanurate, organic amines and salts thereof such as triethanolamine, diethanolamine, and monoethanolamine, organic sulfonic acids and salts thereof such as alkyl sulfonate, toluene sulfonate, and benzene sulfonate, organic sulfamic acids and salts thereof such as alkylsulfamate, organic sulfuric acids and salts thereof such as alkyl sulfate and alkyl ether sulfate, organic phosphonic acids and salts thereof such as phenyl phosphate, organic carboxylic acids and salts thereof such as tartaric acid, oxalic acid, citric acid, malic acid, lactic acid, gluconic acid, and amino acid, betaines, and the like.

As the low-molecular-weight hydrophilic compound, at least one compound selected from polyols, organic sulfates, organic sulfonates, and betaines is preferably incorporated into the image-recording layer.

Specific examples of the organic sulfonates include alkyl sulfonates such as sodium n-butyl sulfonate, sodium n-hexyl sulfonate, sodium 2-ethylhexyl sulfonate, sodium cyclohexyl sulfonate, and sodium n-octyl sulfonate; alkyl sulfonates having an ethylene oxide chain such as sodium 5,8,11-trioxapentadecane-1-sulfonate, sodium 5,8,11-trioxaheptadecane-1-sulfonate, sodium 13-ethyl-5,8,11-trioxaheptadecane-1-sulfonate, and sodium 5,8,11,14-tetraoxatetracosane-1-sulfonate; aryl sulfonates such as sodium benzenesulfonate, sodium p-toluenesulfonate, sodium p-hydroxybenzene sulfonate, sodium p-styrene sulfonate, sodium dimethyl isophthalate-5-sulfonate, sodium 1-naphthyl sulfonate, sodium 4-hydroxynaphthyl sulfonate, disodium 1,5-naphthalene disulfonate, and trisodium 1,3,6-naphthalene trisulfonate, the compounds described in paragraphs "0026" to "0031" of JP2007-276454A and paragraphs "0020" to "0047" of JP-2009-154525A, and the like. The salt may be a potassium salt or a lithium salt.

Examples of the organic sulfates include sulfates of alkyl, alkenyl, alkynyl, aryl, or heterocyclic monoether of polyethylene oxide. The number of ethylene oxide units is preferably 1 to 4, and the salt is preferably a sodium salt, a potassium salt, or a lithium salt. Specific examples thereof include the compounds described in paragraphs "0034" to "0038" of JP2007-276454A.

As the betaines, compounds in which a nitrogen atom is substituted with a hydrocarbon substituent having 1 to 5 carbon atoms are preferable. Specifically, examples thereof include trimethylammonium acetate, dimethylpropylammonium acetate, 3-hydroxy-4-trimethylammoniobutyrate, 4-(1-pyridinio)butyrate, 1-hydroxyethyl-1-imidazolioacetate, trimethylammonium methanesulfonate, dimethylpropylammonium methanesulfonate, 3-trimethylammonio-1-propanesulfonate, 3-(1-pyridinio)-1-propanesulfonate, and the like.

The low-molecular-weight hydrophilic compound substantially does not have a surface activation action because a hydrophobic portion in this compound has a small structure. Therefore, this compound prevents dampening water from permeating the image area of the image-recording layer and deteriorating hydrophobicity or film hardness of the image area. Accordingly, in a case where the low-molecular-weight hydrophilic compound is incorporated into the image-recording layer, the image-recording layer can maintain excellent ink receiving properties and printing durability.

One kind of low-molecular-weight hydrophilic compound may be used alone, or two or more kinds of low-molecular-weight hydrophilic compounds may be used by being mixed together.

The content of the low-molecular-weight hydrophilic compound with respect to the total mass of the image-recording layer is preferably 0.5% by mass to 20% by mass, more preferably 1% by mass to 15% by mass, and even more preferably 2% by mass to 10% by mass. In a case where the content is within this range, excellent on-press developability and printing durability can be obtained.

[Oil sensitizing agent]

In order to improve receptivity, the image-recording layer may contain an oil sensitizing agent such as a phosphonium compound, a nitrogen-containing low-molecular-weight compound, or an ammonium group-containing polymer.

Particularly, in a case where an inorganic lamellar compound is incorporated into a water-soluble resin layer, these compounds function as a surface coating agent for the inorganic lamellar compound and can inhibit the receptivity deterioration caused in the middle of printing by the inorganic lamellar compound.

As the oil sensitizing agent, it is preferable to use a phosphonium compound, a nitrogen-containing low-molecular-weight compound, and an ammonium group-containing polymer in combination, and it is more preferable to use a phosphonium compound, quaternary ammonium salts, and an ammonium group-containing polymer in combination.

Examples of the phosphonium compound include the phosphonium compounds described in JP2006-297907A and JP2007-50660A. Specific examples thereof include tetrabutylphosphonium iodide, butyltriphenylphosphonium bromide, tetraphenylphosphonium bromide, 1,4-bis(triphenylphosphonio)butane=di(hexafluorophosphate), 1,7-bis(triphenylphosphonio)heptane=sulfate, 1,9-bis(triphenylphosphonio)nonane=naphthalene-2,7-disulfonate, and the like.

Examples of the nitrogen-containing low-molecular-weight compound include amine salts and quaternary ammonium salts. In addition, examples thereof also include imidazolinium salts, benzimidazolinium salts, pyridinium salts, and quinolinium salts. Among these, quaternary ammonium salts and pyridinium salts are preferable. Specific examples thereof include tetramethylammonium=hexafluorophosphate, tetrabutylammonium=hexafluorophosphate,

dodecyltrimethylammonium=p-toluene sulfonate, benzyltriethylammonium=hexafluorophosphate, benzyldimethyloctylammonium=hexafluorophosphate, benzyldimethyldodecylammonium=hexafluorophosphate, compounds described in paragraphs "0021" to "0037" of JP2008-284858A and paragraphs "0030" to "0057" of JP2009-90645A, and the like.

The ammonium group-containing polymer may have an ammonium group in the structure. As such a polymer, a polymer is preferable in which the content of (meth)acrylate having an ammonium group in a side chain as a copolymerization component is 5 mol% to 80 mol%. Specific examples thereof include the polymers described in paragraphs "0089" to "0105" of JP2009-208458A.

The reduced specific viscosity (unit: ml/g) of an ammonium group-containing polymer determined according to the measurement method described in JP2009-208458A is preferably in a range of 5 to 120, more preferably in a range of 10 to 110, and particularly preferably in a range of 15 to 100. In a case where the reduced specific viscosity is converted into a weight-average molecular weight (Mw), the weight-average molecular weight is preferably 10,000 to 1,500,000, more preferably 17,000 to 140,000, and particularly preferably 20,000 to 130,000.

Specific examples of the ammonium group-containing polymer will be shown below.

(1) 2-(Trimethylammonio)ethylmethacrylate=p-toluenesulfonate/3,6-dioxaheptylmethacrylate copolymer (molar ratio: 10/90, Mw: 45,000)
(2) 2-(Trimethylammonio)ethylmethacrylate=hexafluorophosphate/3,6-dioxaheptylmethacrylate copolymer (molar ratio: 20/80, Mw: 60,000)
(3) 2-(Ethyldimethylammonio)ethylmethacrylate=p-toluenesulfonate/hexylmethacrylate copolymer (molar ratio: 30/70, Mw: 45,000)
(4) 2-(Trimethylammonio)ethylmethacrylate=hexafluorophosphate/2-ethylhexylmethacrylate copolymer (molar ratio: 20/80, Mw: 60,000)
(5) 2-(Trimethylammonio)ethylmethacrylate=methylsulfate/hexylmethacrylate copolymer (molar ratio: 40/60, Mw: 70,000)
(6) 2-(Butyldimethylammonio)ethylmethacrylate=hexafluorophosphate/3,6-dioxaheptylmethacryl ate copolymer (molar ratio: 25/75, Mw: 65,000)
(7) 2-(Butyldimethylammonio)ethylacrylate=hexafluorophosphate/3,6-dioxaheptylmethacrylate copolymer (molar ratio: 20/80, Mw: 65,000)
(8) 2-(Butyldimethylammonio)ethylmethacrylate=13-ethyl-5,8,11-trioxa-1-heptadecanesulfonate/ 3,6-dioxaheptylmethacrylate copolymer (molar ratio: 20/80, Mw: 75,000)
(9) 2-(Butyldimethylammonio)ethylmethacrylate=hexafluorophosphate/3,6-dioxaheptylmethacryl ate12-hydroxy-3-methacryloyloxypropylmethacrylate copolymer (molar ratio: 15/80/5, Mw: 65,000)

The content of the oil sensitizing agent with respect to the total mass of the image-recording layer is preferably 0.01% by mass to 30.0% by mass, more preferably 0.1% by mass to 15.0% by mass, and even more preferably 1% by mass to 10% by mass.

[Colorant]

The image-recording layer can contain dyes having high absorption in a visible light region as image colorants.

In a case where the image-recording layer contains colorants, it is easy to distinguish between an image area and a non-image area in the formed image. Therefore, it is preferable to incorporate the colorants into the image-recording layer.

Specifically, examples of the colorants include oil yellow #101, oil yellow #103, oil pink #312, oil green BG, oil blue BOS, oil blue #603, oil black BY, oil black BS, and oil black T-505 (manufactured by Orient Chemical Industries Co., Ltd.) victoria pure blue, crystal violet (CI42555), methyl violet (CI42535), ethyl violet, ethyl violet 6HNAPS, rhodamine B (CI145170B), malachite green (CI42000), methylene blue (CI52015), and the dyes described in JP1987-293247A (JP-S62-293247A). Furthermore, pigments such as phthalocyanine pigments, azo pigments, carbon black, and titanium oxide can also be suitably used.

The amount of colorants added is preferably 0.005% by mass to 10% by mass with respect to the total mass of the image-recording layer.

[Fluorine-containing copolymer]

The image-recording layer preferably contains a fluorine-containing copolymer, and more preferably contains a fluorine-containing copolymer having a constitutional unit formed of a fluorine-containing monomer. Among fluorine-containing copolymers, a fluoroaliphatic group-containing copolymer is preferable.

**In** a case where the fluorine-containing copolymer (preferably a fluoroaliphatic group-containing copolymer) is

used, it is possible to inhibit surface abnormalities resulting from foaming during the formation of the image-recording layer and to improve the condition of the coating surface, and the formed image-recording layer has higher ink receptivity.

**In** addition, the image-recording layer containing the fluorine-containing copolymer (preferably a fluoroaliphatic group-containing copolymer) has high gradation and highly sensitive, for example, to laser light. Therefore, the obtained lithographic printing plate exhibits excellent fogging properties by scattered light, reflected light, and the like and has excellent printing durability.

The fluoroaliphatic group-containing copolymer preferably has a constitutional unit formed of a fluoroaliphatic group-containing monomer. Particularly, the fluoroaliphatic group-containing copolymer preferably has a constitutional unit formed of a compound represented by any of Formula (F1) and Formula (F2).

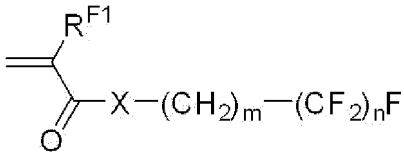

(F1)

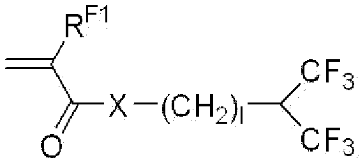

(F2)

In Formula (F1) and Formula (F2), $R^{F1}$ each independently represents a hydrogen atom or a methyl group, X each independently represents an oxygen atom, a sulfur atom, or $-N(R^{F2})-$, m represents an integer of 1 to 6, n represents an integer of 1 to 10, l represents an integer of 0 to 10, and $R^{F2}$ represents a hydrogen atom or an alkyl group having 1 to 4 carbon atoms.

The alkyl group having 1 to 4 carbon atoms represented by $R^{F2}$ in Formula (F1) and Formula (F2) is preferably a methyl group, an ethyl group, a n-propyl group, or a n-butyl group, and more preferably a hydrogen atom or a methyl group.

X in Formula (F1) and Formula (F2) is preferably an oxygen atom.

m in Formula (F1) is preferably 1 or 2, and more preferably 2.

n in Formula (F1) is preferably 2, 4, 6, 8, or 10, and more preferably 4 or 6.

l in Formula (F2) is preferably 0.

Specific examples of the fluoroaliphatic group-containing monomer containing the compound represented by any of Formula (F1) and Formula (F2) and the fluorine-containing monomer will be shown below, but the fluoroaliphatic group-containing monomer and the fluorine-containing monomer are not limited thereto.

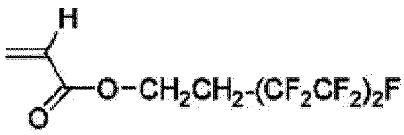

F-1

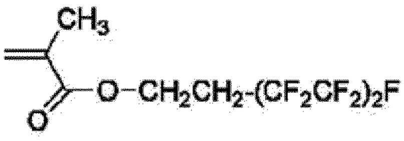

F-2

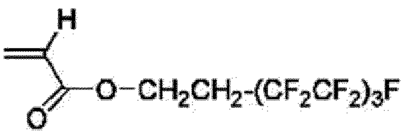

F-3

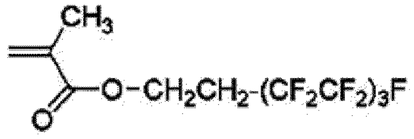

F-4

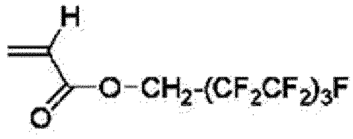

F-5

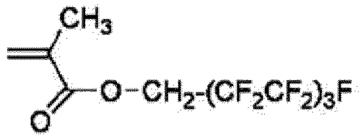

F-6

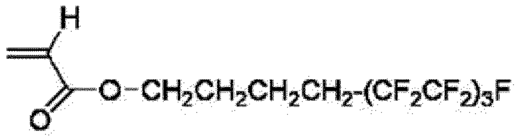

F-7

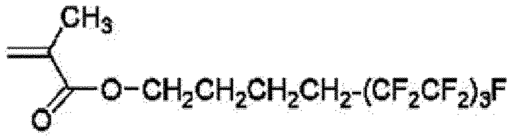

F-8

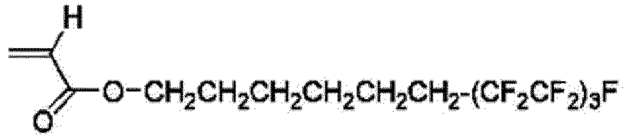

F-9

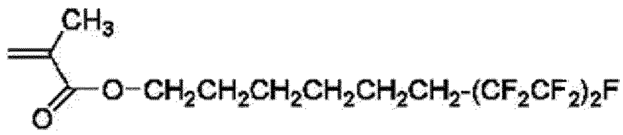

F-10

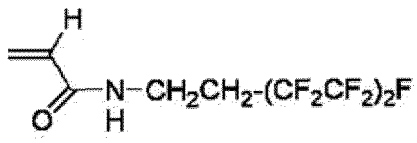

F-11

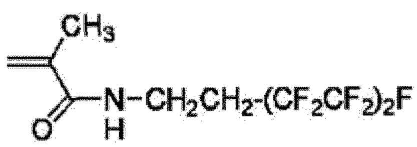

F-12

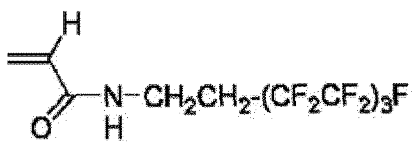

F-13

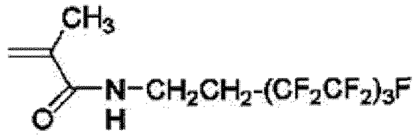

F-14

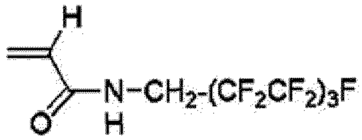

F-15

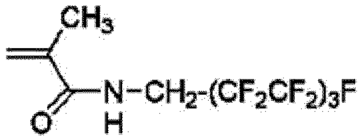

F-16

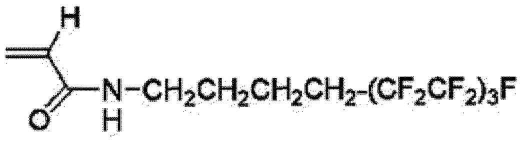

F-17

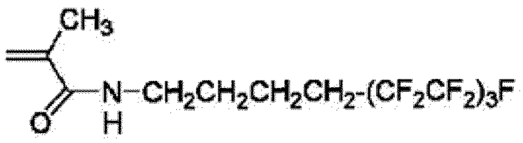

F-18

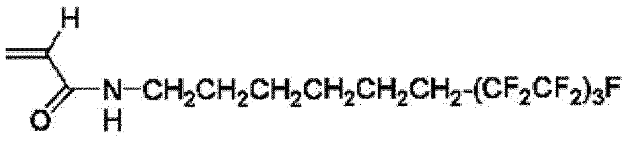

F-19

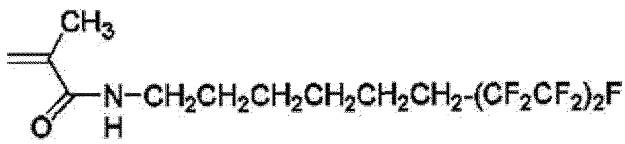

F-20

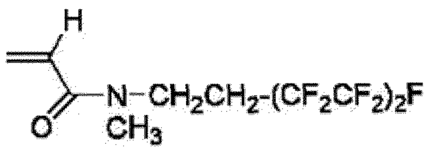

F-21

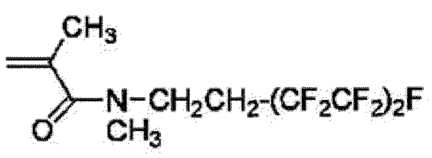

F-22

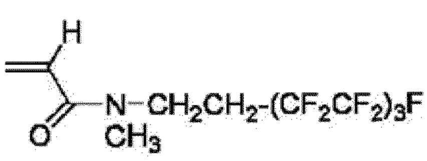

F-23

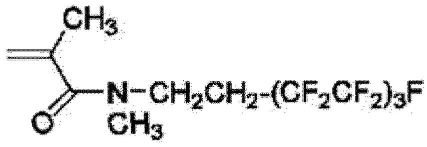

F-24

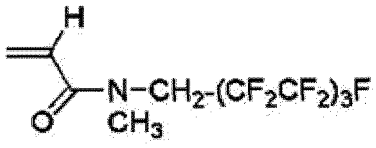

F-25

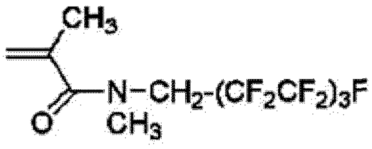

F-26

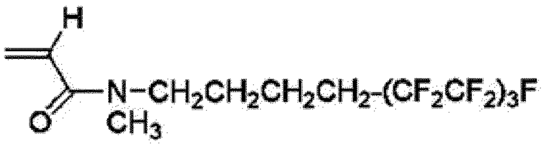

F-27

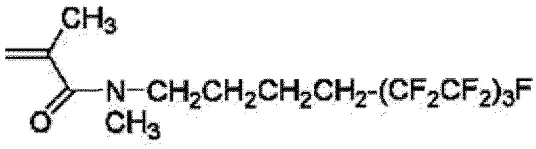

F-28

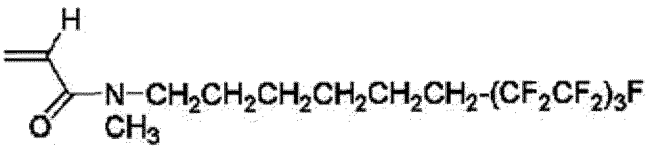

F-29

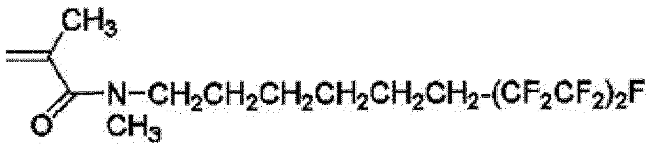

F-30

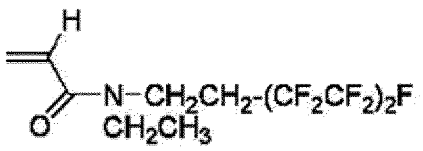

F-31

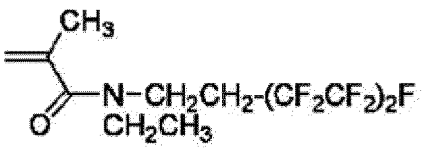

F-32

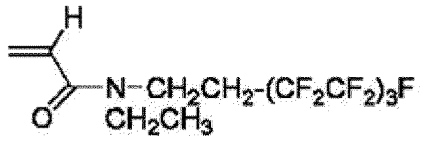

F-33

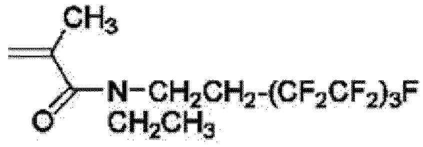

F-34

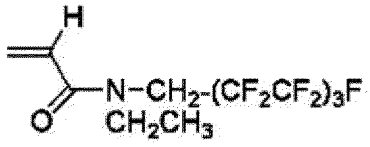

F-35

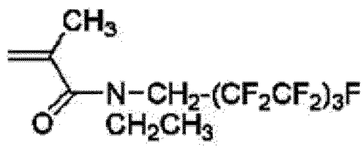

F-36

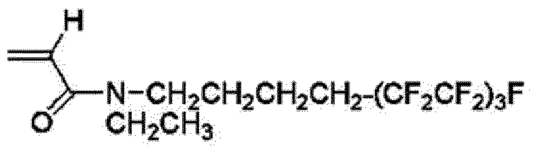

F37

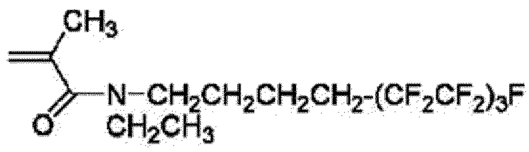

F38

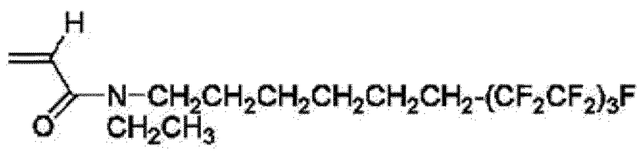

F-39

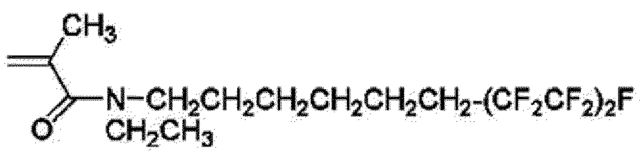

F-40

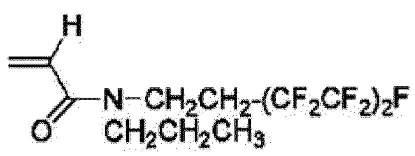

F-41

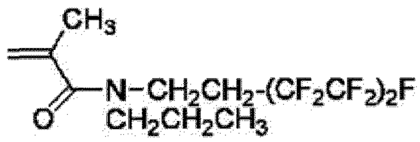

F-42

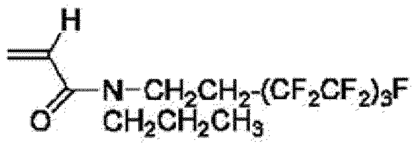

F-43

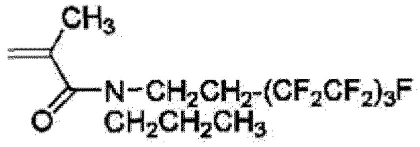

F-44

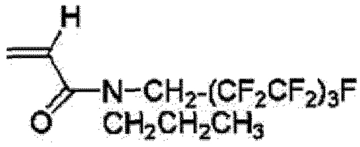

F-45

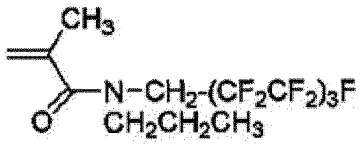

F-46

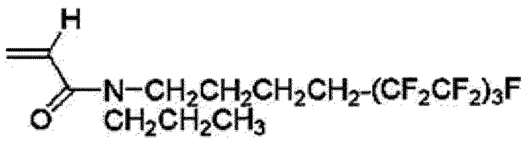

F-47

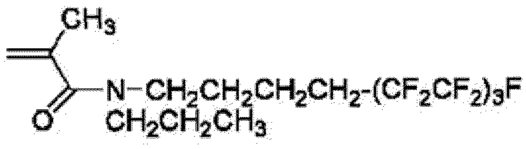

F-48

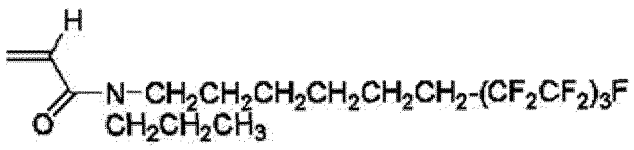

F-49

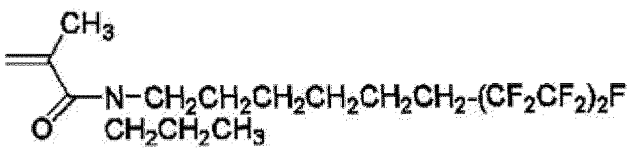

F-50

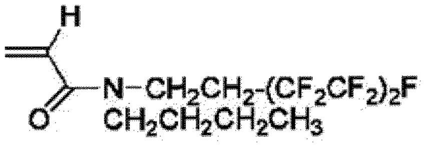

F-51

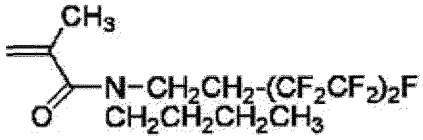

F-52

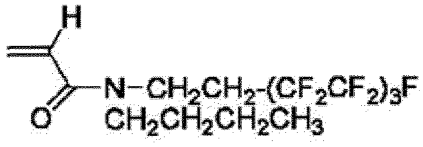

F-53

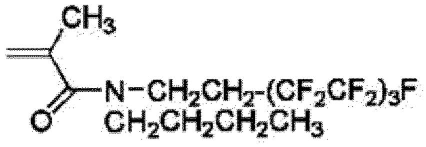

F-54

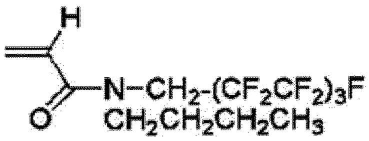

F-55

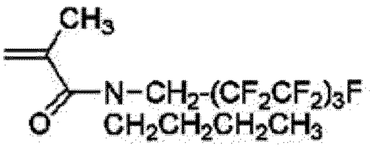

F-56

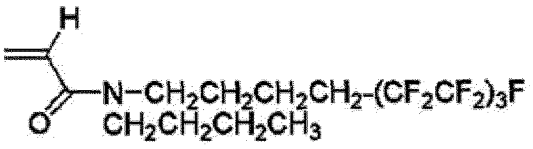

F-57

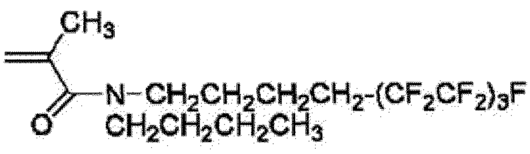

F-58

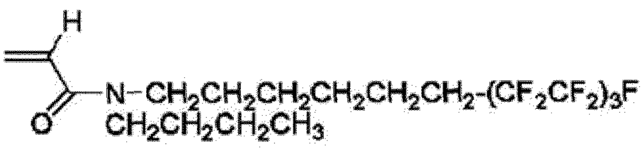

F-59

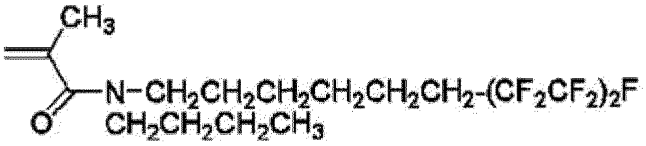

F-60

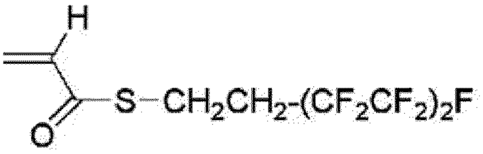

F-61

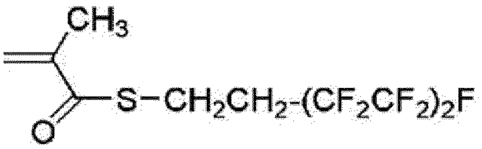

F-62

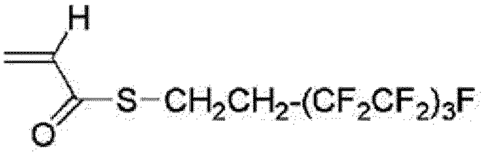

F-63

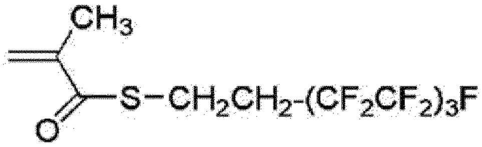

F-64

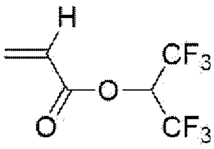

F-65

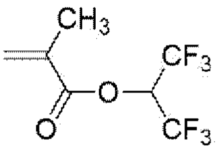

F-66

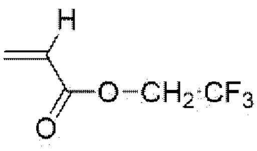

F-67

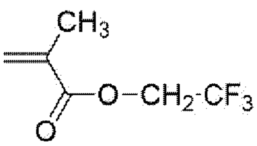

F-68

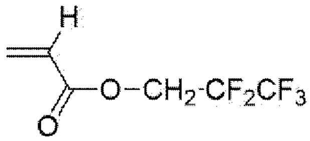

F-69

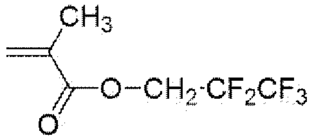

F-70

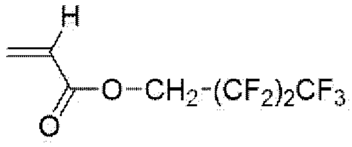

F-71

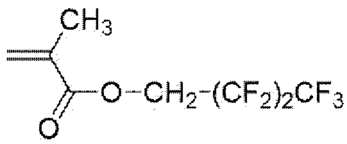

F-72

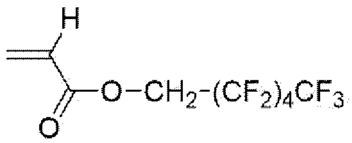

F-73

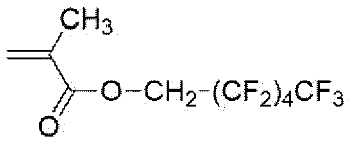

F-74

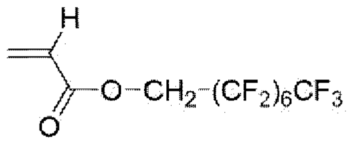

F-75

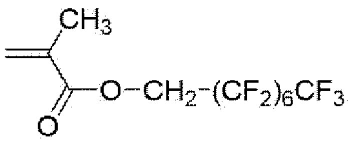

F-76

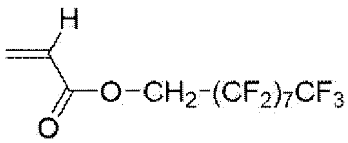

F-77

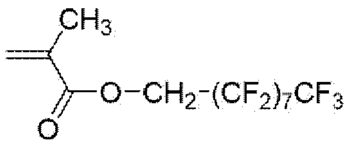

F-78

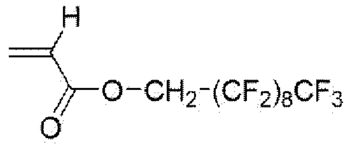
F-79

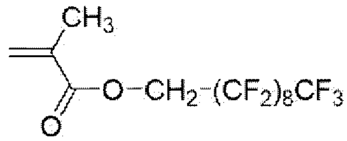
F-80

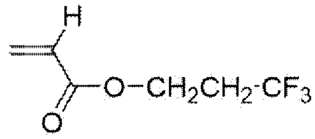
F-81

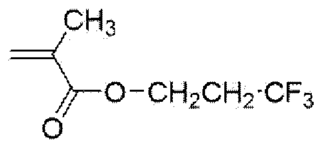
F-82

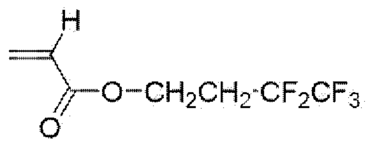
F-83

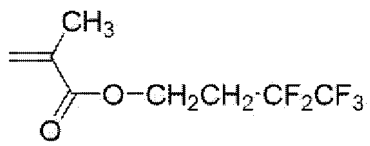
F-84

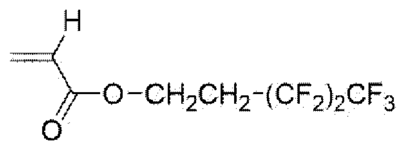
F-85

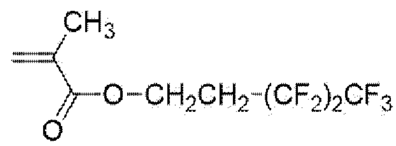
F-86

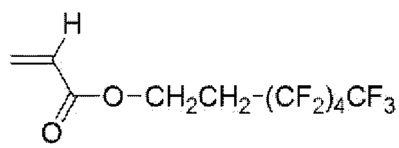
F-87

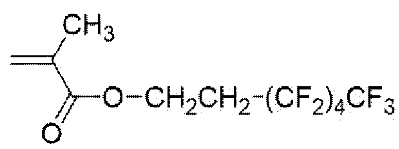
F-88

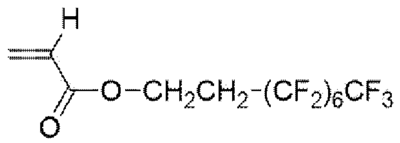

F-89

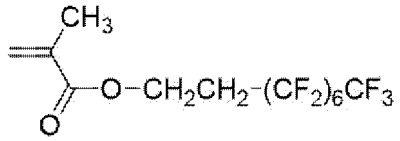

F-90

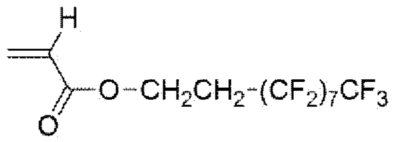

F-91

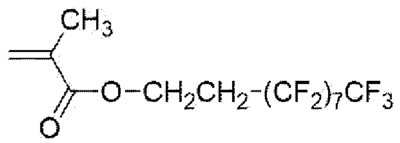

F-92

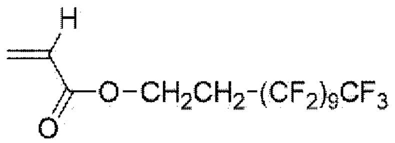

F-93

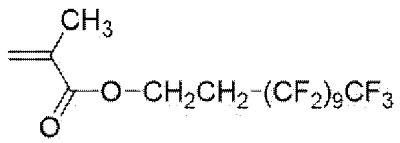

F-94

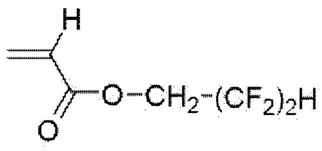

F-95

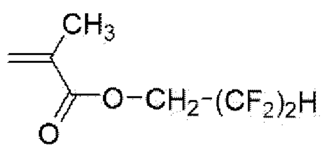

F-96

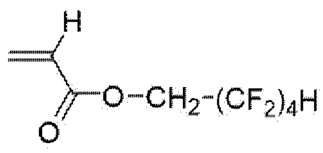

F-97

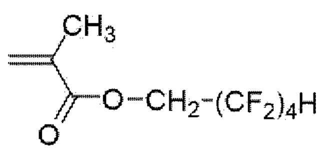

F-98

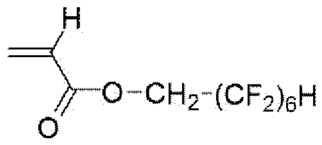
F-99

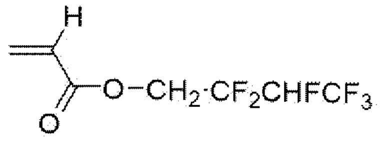
F-100

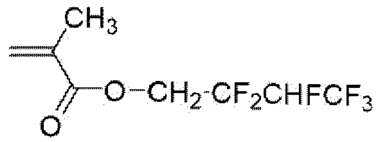
F-101

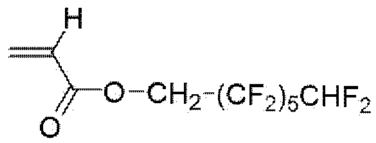
F-102

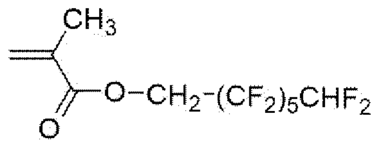
F-103

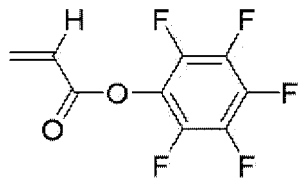
F-104

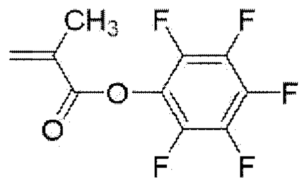
F-105

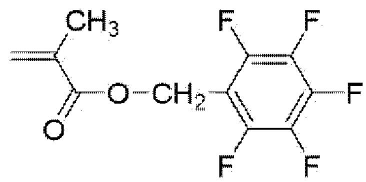
F-106

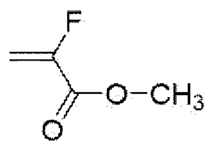
F-107

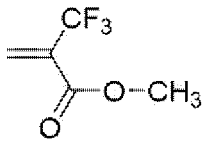

F-108

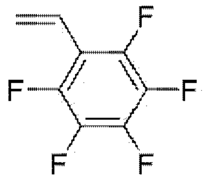

F-109

It is preferable that the fluorine-containing copolymer further has a constitutional unit formed of at least one kind of compound selected from the group consisting of poly(oxyalkylene) acrylate and a poly(oxyalkylene) methacrylate, in addition to the constitutional unit formed of a fluorine-containing monomer.

Furthermore, the fluoroaliphatic group-containing copolymer preferably further has a constitutional unit formed of at least one kind of compound selected from the group consisting of poly(oxyalkylene) acrylate and a poly(oxyalkylene) methacrylate, in addition to the constitutional unit formed of a compound represented by any of Formula (F1) and Formula (F2).

The polyoxyalkylene group in the poly(oxyalkylene) acrylate and poly(oxyalkylene) methacrylate can be represented by $-(OR^{F3})_x-$. $R^{F3}$ represents an alkyl group, and x represents an integer of 2 or more. $R^{F3}$ is preferably a linear or branched alkylene group having 2 to 4 carbon atoms. As the linear or branched alkylene group having 2 to 4 carbon atoms, $-CH_2CH_2-$, $-CH_2CH_2CH_2-$, $-CH(CH_3)CH_2-$, or $-CH(CH_3)CH(CH_3)-$ is preferable. x is preferably an integer of 2 to 100.

In the polyoxyalkylene groups, x pieces of "$OR^{F3}$" may be the same as or different from each other. That is, the polyoxyalkylene group may be composed of two or more kinds of "$OR^{F3}$" that are regularly or irregularly bonded to each other. For example, the polyoxyalkylene group may be composed of a linear or branched oxypropylene unit and an oxyethylene unit that are regularly or irregularly bonded to each other. More specifically, the polyoxyalkylene group may be composed of a block of a linear or branched oxypropylene unit and a block of an oxyethylene unit that are bonded to each other.

The polyoxyalkylene group may have one or more linking groups (for example, -CONH-Ph-NHCO-, -S-, and the like, in which Ph represents a phenylene group).

The molecular weight of the polyoxyalkylene group is preferably 250 to 3,000.

As the poly(oxyalkylene) acrylate and the poly(oxyalkylene) methacrylate described above, commercially available products or synthetic products may be used.

The poly(oxyalkylene) acrylate and the poly(oxyalkylene) methacrylate can be synthesized, for example, by reacting a hydroxypoly(oxyalkylene) compound with acrylic acid, methacrylic acid, acryloyl chloride, methacryloyl chloride, acrylic acid anhydride, or the like by known methods.

As the aforementioned hydroxypoly(oxyalkylene) compound, commercially available products may be used. Examples thereof include ADEKA (registered trademark) PLURONIC manufactured by ADEKA Corporation, ADEKA polyether manufactured by ADEKA Corporation, Carbowax (registered trademark) manufactured by Union Carbide Corporation, Triton manufactured by The Dow Chemical Company., PEG manufactured by DKS Co. Ltd., and the like.

As the poly(oxyalkylene) acrylate and the poly(oxyalkylene) methacrylate, poly(oxyalkylene) diacrylate or the like synthesized by known methods may also be used.

[Other components]

The image-recording layer can contain, as other components, a surfactant (other than the fluoroaliphatic group-containing copolymer), a polymerization inhibitor, a higher fatty acid derivative, a plasticizer, inorganic particles, an inorganic lamellar compound, and the like. Specifically, the description in paragraphs "0114" to "0159" of JP2008-284817A can be referred to.

[Formation of image-recording layer]

The image-recording layer in the lithographic printing plate precursor a can be formed, for example, by preparing a coating solution by dispersing or dissolving the necessary components described above in a known solvent (coating solvent), coating a support with the coating solution by a known method such as bar coating, and drying the coating

solution, as described in paragraphs "0142" and "0143" of JP2008-195018A.

The coating amount (solid content) of the image-recording layer after coating and drying varies with uses, but is preferably 0.3 g/m$^2$ to 3.0 g/m$^2$. In a case where the coating amount is in this range, excellent sensitivity and excellent film characteristics of the image-recording layer are obtained.

Examples of the coating solvent include MEK/MFG/methanol = 48/30/22 (mass ratio, SP value = 11.1), 1-propanol/water = 1/1 (mass ratio, SP value = 17.7), an alcoholic organic solvent used alone, and the like.

[Protective layer]

The lithographic printing plate precursor may have a layer, such as a protective layer containing a water-soluble resin or the like (also called an overcoat layer or the like in some cases), on the image-recording layer. However, due to the high ethylenically unsaturated bond valence of the image-recording layer, oxygen barrier properties obtained from a protective layer or the like are not necessary.

Therefore, for the lithographic printing plate precursor, an aspect is preferable in which the image-recording layer is exposed without being provided with a layer such as a water-soluble resin layer.

[Aluminum support]

The aluminum support of the lithographic printing plate precursor according to the present invention to be used can be appropriately selected from known aluminum supports for a lithographic printing plate precursor. Hereinafter, the aluminum support will be also simply called "support".

As the aluminum support, an aluminum support having a hydrophilic surface (hereinafter, also called "hydrophilic aluminum support") is preferable.

For the aluminum support in the lithographic printing plate precursor, from the viewpoint of suppressing scratches and contamination, a water contact angle on a surface of the aluminum support on the image-recording layer side that is determined by an airborne water droplet method is preferably 110° or less, more preferably 90° or less, even more preferably 80° or less, still more preferably 50° or less, particularly preferably 30° or less, more particularly preferably 20° or less, and most preferably 10° or less.

In the present specification, the water contact angle on a surface of the aluminum support on the image-recording layer side that is determined by an airborne water droplet method is measured by the following method.

The lithographic printing plate precursor is immersed in a solvent capable of removing the image-recording layer (for example, a solvent used in a coating solution for an image-recording layer), and the image-recording layer is scraped off with at least one of sponge or cotton or dissolved in a solvent, so that the surface of the aluminum support is exposed.

There may be the hydrophilic compound, which will be described later, on the surface of the aluminum support exposed by the above method. Therefore, the contact angle of water on the surface may be adjusted, for example, by the hydrophilic compound remaining on the surface of the aluminum support.

The water contact angle on a surface of the exposed aluminum support on the image-recording layer side is measured using a measurement device, a fully automatic contact angle meter (for example, DM-501 manufactured by Kyowa Interface Science Co., Ltd.), as a water droplet contact angle on the surface at 25°C (after 0.2 seconds).

As the aluminum support in the present invention, an aluminum plate is preferable which has been roughened using a known method and has undergone an anodic oxidation treatment. That is, the aluminum support in the present invention preferably has an aluminum plate and an aluminum anodic oxide film disposed on the aluminum plate.

[Preferred aspect of support]

One of the examples of preferred aspects of the aluminum support used in the present invention (the aluminum support according to this example is also called "support (1)") is as below.

That is, the support (1) has an aluminum plate and an anodic oxide film of aluminum disposed on the aluminum plate, the anodic oxide film is at a position closer to a side of the image-recording layer than the aluminum plate and has micropores extending in a depth direction from the surface of the anodic oxide film on the side of the image-recording layer, the average diameter of the micropores within the surface of the anodic oxide film is more than 10 nm and 100 nm or less, and a value of brightness L* of the surface of the anodic oxide film on the side of the image-recording layer is 70 to 100 in the L*a*b* color space.

Fig. 1 is a schematic cross-sectional view of an embodiment of an aluminum support 12a.

The aluminum support 12a has a laminated structure in which an aluminum plate 18 and an anodic oxide film 20a of aluminum (hereinafter, also simply called "anodic oxide film 20a") are laminated in this order. The anodic oxide film 20a in the aluminum support 12a is positioned so that the anodic oxide film 20a is closer to the image-recording layer side than the aluminum plate 18. That is, it is preferable that the lithographic printing plate precursor have at least an anodic oxide film, an

image-recording layer, and an optionally provided protective layer in this order on an aluminum plate.

-Anodic oxide film-

Hereinafter, preferred aspects of the anodic oxide film 20a will be described.

The anodic oxide film 20a is a film prepared on a surface of the aluminum plate 18 by an anodic oxidation treatment. This film has uniformly distributed ultrafine micropores 22a approximately perpendicular to the surface of the film. The micropores 22a extend from a surface of the anodic oxide film 20a on the image-recording layer side (a surface of the anodic oxide film 20a opposite to the aluminum plate 18) along the thickness direction (toward the aluminum plate 18).

Within the surface of the anodic oxide film, the average diameter (average opening diameter) of the micropores 22a in the anodic oxide film 20a is preferably more than 10 nm and 100 nm or less. Particularly, from the viewpoint of balance between printing durability, antifouling properties, and image visibility, the average diameter of the micropores 22a is more preferably 15 nm to 60 nm, even more preferably 20 nm to 50 nm, and particularly preferably 25 to 40 nm. The internal diameter of the pores may be larger or smaller than the pore diameter within the surface layer.

In a case where the average diameter is more than 10 nm, printing durability and image visibility are further improved. Furthermore, in a case where the average diameter is 100 nm or less, printing durability is further improved.

The average diameter of the micropores 22a is determined by observing the surface of the anodic oxide film 20a with a field emission scanning electron microscope (FE-SEM) at 150,000X magnification (N = 4), measuring the size (diameter) of 50 micropores existing in a range of 400 nm × 600 nm in the obtained 4 images, and calculating the arithmetic mean thereof.

In a case where the shape of the micropores 22a is not circular, the equivalent circular diameter is used. "Equivalent circular diameter" is a diameter determined on an assumption that the opening portion is in the form of a circle having the same projected area as the projected area of the opening portion.

The depth of the micropores 22a is not particularly limited, but is preferably 10 nm to 3,000 nm, more preferably 50 nm to 2,000 nm, and even more preferably 300 nm to 1,600 nm.

The depth is a value obtained by taking a photograph (150,000X magnification) of a cross section of the anodic oxide film 20a, measuring the depths of 25 or more micropores 22a, and calculating the average thereof.

The shape of the micropores 22a is not particularly limited. In Fig. 2, the micropores 22a have a substantially straight tubular shape (substantially cylindrical shape). However, the micropores 22a may have a conical shape that tapers along the depth direction (thickness direction). The shape of the bottom portion of the micropores 22a is not particularly limited, and may be a curved (convex) or flat surface shape.

In the L*a*b* color space, the value of brightness L* of the surface of the aluminum support 12a on the image-recording layer side (surface of the anodic oxide film 20a on the image-recording layer side) is preferably 70 to 100. Especially, the value of brightness L* is preferably 75 to 100 and more preferably 75 to 90, because printing durability and image visibility are better balanced in this range.

The brightness L* is measured using a color difference meter Spectro Eye manufactured by X-Rite, Incorporated.

For example, an aspect is also preferable in which the micropores in the support (1) are each constituted with a large diameter portion that extends to a position at a depth of 10 nm to 1,000 nm from the surface of the anodic oxide film and a small diameter portion that is in communication with the bottom portion of the large diameter portion and extends to a position at a depth of 20 nm to 2,000 nm from a communication position, an average diameter of the large diameter portion within the surface of the anodic oxide film is 15 nm to 100 nm, and an average diameter of the small diameter portion at a communication position is 13 nm or less (hereinafter, the support according to this aspect will be also called "support (2)").

Fig. 2 is a schematic cross-sectional view of an embodiment of the aluminum support 12a that is different from what is shown in Fig. 1.

In Fig. 2, an aluminum support 12b includes an aluminum plate 18 and an anodic oxide film 20b having micropores 22b each composed of a large diameter portion 24 and a small diameter portion 26.

The micropores 22b in the anodic oxide film 20b are each composed of the large diameter portion 24 that extends to a position at a depth of 10 nm to 1,000 nm (depth D: see Fig. 2) from the surface of the anodic oxide film and the small diameter portion 26 that is in communication with the bottom portion of the large diameter portion 24 and further extends from the communication position to a position at a depth of 20 nm to 2,000 nm.

Hereinafter, the large diameter portion 24 and the small diameter portion 26 will be specifically described.

The average diameter of the large diameter portion 24 within the surface of the anodic oxide film 20b is the same as the average diameter of the micropores 22a in the aforementioned anodic oxide film 20a within the surface of the anodic oxide film, which is more than 10 nm and 100 nm or less. The suitable range thereof is also the same.

The method for measuring the average diameter of the large diameter portion 24 within the surface of the anodic oxide film 20b is the same as the method for measuring the average diameter of the micropores 22a in the anodic oxide film 20a within the surface of the anodic oxide film.

The bottom portion of the large diameter portion 24 is in a position at a depth of 10 nm to 1,000 nm (hereinafter,

also called depth D) from the surface of the anodic oxide film. That is, the large diameter portion 24 is a pore portion extending to a position at a depth of 10 nm to 1,000 nm from the surface of the anodic oxide film in the depth direction (thickness direction). The depth is preferably 10 nm to 200 nm.

The depth is a value obtained by taking a photograph (150,000X magnification) of a cross section of the anodic oxide film 20b, measuring the depths of 25 or more large diameter portions 24, and calculating the average thereof.

The shape of the large diameter portion 24 is not particularly limited. Examples of the shape of the large diameter portion 24 include a substantially straight tubular shape (substantially cylindrical shape) and a conical shape that tapers along the depth direction (thickness direction). Among these, a substantially straight tubular shape is preferable.

As shown in Fig. 2, the small diameter portion 26 is a pore portion that is in communication with the bottom portion of the large diameter portion 24 and further extends from the communication position in the depth direction (thickness direction).

The average diameter of the small diameter portion 26 at the communication position is preferably 13 nm or less. Particularly, the average diameter is preferably 11 nm or less, and more preferably 10 nm or less. The lower limit thereof is not particularly limited, but is 5 nm or more in many cases.

The average diameter of the small diameter portion 26 is obtained by observing the surface of the anodic oxide film 20a with FE-SEM at 150,000X magnification (N = 4), measuring the size (diameter) of the micropores (small diameter portion) existing in a range of 400 nm × 600 nm in the obtained 4 images, and calculating the arithmetic mean thereof. In a case where the large diameter portion is deep, if necessary, the upper portion of the anodic oxide film 20b (region where the large diameter portion is located) may be cut (for example, by using argon gas), then the surface of the anodic oxide film 20b may be observed with FE-SEM described above, and the average diameter of the small diameter portion may be determined.

In a case where the shape of the small diameter portion 26 is not circular, the equivalent circular diameter is used. "Equivalent circular diameter" is a diameter determined on an assumption that the opening portion is in the form of a circle having the same projected area as the projected area of the opening portion.

The bottom portion of the small diameter portion 26 is in a position 20 nm to 2,000 nm distant from the communication position with the large diameter portion 24 in the depth direction. In other words, the small diameter portion 26 is a pore portion that extends further from the communication position with the large diameter portion 24 in the depth direction (thickness direction), and the depth of the small diameter portion 26 is 20 nm to 2,000 nm. The depth is preferably 500 nm to 1,500 nm.

The depth is a value determined by taking a photograph (50,000X magnification) of a cross section of the anodic oxide film 20b, measuring the depths of 25 or more small diameter portions, and calculating the average thereof.

The shape of the small diameter portion 26 is not particularly limited. Examples of the shape of the small diameter portion 26 include a substantially straight tubular shape (substantially cylindrical shape) and a conical shape that tapers along the depth direction. Among these, a substantially straight tubular shape is preferable.

[Method for manufacturing aluminum support]

As a method for manufacturing the aluminum support in the present invention, for example, a manufacturing method is preferable in which the following steps are sequentially performed.

- ·Roughening treatment step: step of performing roughening treatment on aluminum plate
- ·Anodic oxidation treatment step: step of subjecting aluminum plate having undergone roughening treatment to anodic oxidation
- ·Pore widening treatment step: step of bringing aluminum plate having anodic oxide film obtained by anodic oxidation treatment step into contact with aqueous acid solution or aqueous alkali solution so that diameter of micropores in anodic oxide film increases

Hereinafter, the procedure of each step will be specifically described.

(Roughening treatment step)

The roughening treatment step is a step of performing a roughening treatment including an electrochemical roughening treatment on the surface of the aluminum plate. This step is preferably performed before the anodic oxidation treatment step which will be described later. However, in a case where the surface of the aluminum plate already has a preferable shape, the roughening treatment step may not be performed.

As the roughening treatment, only an electrochemical roughening treatment may be performed, or an electrochemical roughening treatment and mechanical roughening treatment and/or a chemical roughening treatment may be performed in combination.

In a case where the mechanical roughening treatment and the electrochemical roughening treatment are combined, it is preferable to perform the electrochemical roughening treatment after the mechanical roughening treatment.

It is preferable to perform the electrochemical roughening treatment by using direct current or alternating current in an aqueous solution containing nitric acid or hydrochloric acid as a main component.

The method of the mechanical roughening treatment is not particularly limited. Examples thereof include the method described in JP1975-40047B (JP-S50-40047B).

Furthermore, the chemical roughening treatment is not particularly limited, and examples thereof include known methods.

After the mechanical roughening treatment, it is preferable to perform the following chemical etching treatment.

By the chemical etching treatment performed after the mechanical roughening treatment, the edge portion of surface irregularities of the aluminum plate smoothed, so that ink clotting that may occur during printing is prevented, the antifouling properties of the printing plate are improved, and unnecessary substances such as abrasive particles remaining on the surface are removed.

Examples of the chemical etching treatment include etching with an acid and etching with an alkali. One of the examples of particularly efficient etching methods is a chemical etching treatment using an aqueous alkali solution (hereinafter, also called "alkaline etching treatment").

The alkaline agent used in the aqueous alkali solution is not particularly limited. Examples thereof include caustic soda, caustic potash, sodium metasilicate, sodium carbonate, sodium aluminate, and sodium gluconate.

The aqueous alkali solution may contain aluminum ions.

The concentration of the alkaline agent in the aqueous alkali solution is preferably 0.01% by mass or more, and more preferably 3% by mass or more. Furthermore, the concentration of the alkaline agent is preferably 30% by mass or less.

In a case where the alkaline etching treatment is performed, in order to remove products generated by the alkaline etching treatment, it is preferable to perform the chemical etching treatment by using a low-temperature aqueous acidic solution (hereinafter, also called "desmutting treatment").

The acid used in the aqueous acidic solution is not particularly limited, and examples thereof include sulfuric acid, nitric acid, and hydrochloric acid. The temperature of the aqueous acidic solution is preferably 20°C to 80°C.

As the roughening treatment step, a method is preferable in which the treatments described in an aspect A or an aspect B are performed in the following order.

-Aspect A-

(2) Chemical etching treatment using aqueous alkali solution (first alkaline etching treatment)
(3) Chemical etching treatment using aqueous acidic solution (first desmutting treatment)
(4) Electrochemical roughening treatment using aqueous solution containing nitric acid as main component (first electrochemical roughening treatment)
(5) Chemical etching treatment using aqueous alkali solution (second alkaline etching treatment)
(6) Chemical etching treatment using aqueous acidic solution (second desmutting treatment)
(7) Electrochemical roughening treatment in aqueous solution containing hydrochloric acid as main component (second electrochemical roughening treatment)
(8) Chemical etching treatment using aqueous alkali solution (third alkaline etching treatment)
(9) Chemical etching treatment using aqueous acidic solution (third desmutting treatment)

-Aspect B-

(10) Chemical etching treatment using aqueous alkali solution (fourth alkaline etching treatment)
(11) Chemical etching treatment using aqueous acidic solution (fourth desmutting treatment)
(12) Electrochemical roughening treatment using aqueous solution containing hydrochloric acid as main component (third electrochemical roughening treatment)
(13) Chemical etching treatment using aqueous alkali solution (fifth alkaline etching treatment)
(14) Chemical etching treatment using aqueous acidic solution (fifth desmutting treatment)

If necessary, (1) mechanical roughening treatment may be performed before the treatment (2) of the aspect A or

before the treatment (10) of the aspect B.

The amount of the aluminum plate dissolved by the first alkaline etching treatment and the fourth alkaline etching treatment is preferably 0.5 g/$m^2$ to 30 g/$m^2$, and more preferably 1.0 g/$m^2$ to 20 g/$m^2$.

Examples of the aqueous solution containing nitric acid as a main component used in the first electrochemical roughening treatment of the aspect A include aqueous solutions used in an electrochemical roughening treatment using direct current or alternating current. Examples thereof include an aqueous solution obtained by adding aluminum nitrate, sodium nitrate, ammonium nitrate, or the like to a 1 to 100 g/L aqueous nitric acid solution.

Examples of the aqueous solution containing hydrochloric acid as a main component used in the second electrochemical roughening treatment of the aspect A and in the third electrochemical roughening treatment of the aspect B include aqueous solutions used in the general electrochemical roughening treatment using direct current or alternating current. Examples thereof include an aqueous solution obtained by adding 0 g/L to 30 g/L of sulfuric acid to a 1 g/L to 100 g/L aqueous hydrochloric acid solution. Nitrate ions such as aluminum nitrate, sodium nitrate, and ammonium nitrate; hydrochloric acid ions such as aluminum chloride, sodium chloride, and ammonium chloride may be further added to this solution.

As the waveform of an alternating current power source for the electrochemical roughening treatment, a sine wave, a square wave, a trapezoidal wave, a triangular wave, and the like can be used. The frequency is preferably 0.1 Hz to 250 Hz.

Fig. 3 is an example of waveform graph of alternating current used for the electrochemical roughening treatment.

In Fig. 3, ta represents an anodic reaction time, tc represents a cathodic reaction time, tp represents the time taken for current to reach a peak from 0, Ia represents the peak current on the anodic cycle side, Ic represents the peak current on the cathodic cycle side, AA represents current for an anodic reaction of an aluminum plate, and CA represents current for a cathodic reaction of an aluminum plate. For a trapezoidal wave, the time tp taken for current to reach a peak from 0 is preferably 1 ms to 10 ms. Regarding the conditions of one cycle of alternating current used for the electrochemical roughening, a ratio tc/ta of the cathodic reaction time tc to the anodic reaction time ta of the aluminum plate is preferably within a range of 1 to 20, a ratio Qc/Qa of an electricity quantity Qc during the cathodic reaction to an electricity quantity Qa during the anodic reaction of the aluminum plate is preferably within a range of 0.3 to 20, and the anodic reaction time ta is preferably within a range of 5 ms to 1,000 ms. The peak current density of the trapezoidal wave is preferably 10 A/$dm^2$ to 200 A/$dm^2$ at both the anodic cycle side Ia and the cathodic cycle side Ic of the current. Ic/Ia is preferably 0.3 to 20. At a point time when the electrochemical roughening has ended, the total quantity of electricity that participates in the anodic reaction of the aluminum plate is preferably 25 C/$dm^2$ to 1,000 C/$dm^2$.

The electrochemical roughening using alternating current can be performed using the device shown in Fig. 4.

Fig. 4 is a lateral view showing an example of a radial cell in an electrochemical roughening treatment using alternating current.

In Fig. 4, 50 represents a main electrolytic cell, 51 represents an alternating current power source, 52 represents a radial drum roller, 53a and 53b represent main poles, 54 represents an electrolytic solution supply port, 55 represents an electrolytic solution, 56 represents a slit, 57 represents an electrolytic solution path, 58 represents an auxiliary anode, 60 represents an auxiliary anode tank, and W represents an aluminum plate. In Fig. 4, the arrow A1 represents a supply direction of an electrolytic solution, and the arrow A2 represents a discharge direction of the electrolytic solution. In a case where two or more electrolytic cells are used, the electrolysis conditions may be the same as or different from each other.

The aluminum plate W is wound around the radial drum roller 52 immersed and disposed in the main electrolytic cell 50. While being transported, the aluminum plate W is electrolyzed by the main poles 53a and 53b connected to the alternating current power source 51. From the electrolytic solution supply port 54, the electrolytic solution 55 is supplied to the electrolytic solution path 57 between the radial drum roller 52 and the main poles 53a and 53b through the slit 56. The aluminum plate W treated in the main electrolytic cell 50 is then electrolyzed in the auxiliary anode tank 60. In the auxiliary anode tank 60, the auxiliary anode 58 is disposed to face the aluminum plate W. The electrolytic solution 55 is supplied to flow in the space between the auxiliary anode 58 and the aluminum plate W.

In view of easily manufacturing a predetermined printing plate precursor, the amount of the aluminum plate dissolved by the second alkaline etching treatment is preferably 1.0 g/$m^2$ or more, and more preferably 2.0 g/$m^2$ to 10 g/$m^2$.

In view of easily manufacturing a predetermined printing plate precursor, the amount of the aluminum plate dissolved by the third alkaline etching treatment and the fourth alkaline etching treatment is preferably 0.01 g/$m^2$ to 0.8 g/$m^2$, and more preferably 0.05 g/$m^2$ to 0.3 g/$m^2$.

In the chemical etching treatment (first to fifth desmutting treatments) using an aqueous acidic solution, an aqueous acidic solution containing phosphoric acid, nitric acid, sulfuric acid, chromic acid, hydrochloric acid, or a mixed acid consisting of two or more of these acids is suitably used.

The concentration of the acid in the aqueous acidic solution is preferably 0.5% by mass to 60% by mass.

(Anodic oxidation treatment step)

The procedure of the anodic oxidation treatment step is not particularly limited as long as the aforementioned micropores can be obtained. Examples thereof include known methods.

In the anodic oxidation treatment step, an aqueous solution of sulfuric acid, phosphoric acid, oxalic acid, or the like can be used as an electrolytic cell. For example, the concentration of sulfuric acid is 100 g/L to 300 g/L.

The conditions of the anodic oxidation treatment are appropriately set depending on the electrolytic solution used. For example, the liquid temperature is 5°C to 70°C (preferably 10°C to 60°C), the current density is 0.5 $A/dm^2$ to 60 $A/dm^2$ (preferably 5 $A/dm^2$ to 60 $A/dm^2$), the voltage is 1 V to 100 V (preferably 5 V to 50 V), the electrolysis time is 1 second to 100 seconds (preferably 5 seconds to 60 seconds), and the film amount is 0.1 $g/m^2$ to 5 $g/m^2$ (preferably 0.2 $g/m^2$ to 3 $g/m^2$).

(Pore widening treatment)

The pore widening treatment is a treatment of enlarging the diameter of micropores (pore diameter) present in the anodic oxide film formed by the aforementioned anodic oxidation treatment step (pore diameter enlarging treatment).

The pore widening treatment can be carried out by bringing the aluminum plate obtained by the anodic oxidation treatment step into contact with an aqueous acid solution or an aqueous alkali solution. The contact method is not particularly limited, and examples thereof include a dipping method and a spraying method.

[Undercoat layer]

The lithographic printing plate precursor preferably has an undercoat layer (called interlayer in some cases) between the image-recording layer and the support.

The undercoat layer enhances the adhesiveness between the support and the image-recording layer in an exposed portion, and enables the image-recording layer to be easily peeled from the support in a non-exposed portion. Therefore, in some cases, the undercoat layer inhibits the deterioration of printing durability and contributes to the improvement of developability. Furthermore, in the case of exposure to infrared laser, the undercoat layer functions as a heat insulating layer and thus sometimes brings about an effect of preventing sensitivity reduction resulting from the diffusion of heat generated by exposure to the support.

The compounds that are used in the undercoat layer may be low-molecular-weight compounds or polymers.

Examples of compounds that are used in the undercoat layer include polymers having adsorbent groups that can be adsorbed onto the surface of the support and hydrophilic groups. The compound used for the undercoat layer is preferably a polymer having an adsorbent group and a hydrophilic group that can be adsorbed onto the surface of the support and further having a crosslinking group.

If necessary, as the compounds that are used in the undercoat layer, two or more kinds of compounds may be used as a mixture.

In a case where the compounds that are used in the undercoat layer are polymers, copolymers of monomers having adsorbent groups, monomers having hydrophilic groups, and monomers having crosslinking groups are preferable.

As the adsorbent groups that can be adsorbed onto the surface of the support, a phenolic hydroxyl group, a carboxy group, $-PO_3H_2$, $-OPO_3H_2$, $-CONHSO_2-$, $-SO_2NHSO_2-$, and $-COCH_2COCH_3$ are preferable. As the hydrophilic groups, a sulfo group or salts thereof and salts of a carboxy group are preferable. As the crosslinking groups, an acryloyl group, a methacryloyl group, an acrylamide group, a methacrylamide group, an allyl group, and the like are preferable.

The polymer may have a crosslinking group introduced by the formation of a salt of a polar substituent of the polymer and a compound that has a substituent having charge opposite to that of the polar substituent and an ethylenically unsaturated bond, or may be further copolymerized with monomers other than the monomers described above and preferably with hydrophilic monomers.

As the compounds used for the undercoat layer, specifically, for example, silane coupling agents having addition polymerizable ethylenic double bond reactive groups described in JP1998-282679A (JP-H10-282679A) and phosphorus compounds having ethylenic double bond reactive groups described in JP1990-304441A (JP-H02-304441A) are suitable. The low-molecular-weight compounds or polymer compounds having crosslinking groups (preferably ethylenically unsaturated groups), functional groups that interact with the surface of the support, and hydrophilic groups described in JP2005-238816A, JP2005-125749A, JP2006-239867A, and JP2006-215263A are also preferably used.

For example, the high-molecular-weight polymers having adsorbent groups that can be adsorbed onto the surface of the support, hydrophilic groups, and crosslinking groups described in JP2005-125749A and JP2006-188038A are more preferable.

The content of the ethylenically unsaturated group in the polymer used in the undercoat layer is preferably 0.1

mmol to 10.0 mmol per gram of the polymer, and more preferably 0.2 mmol to 5.5 mmol per gram of the polymer.

The weight-average molecular weight (Mw) of the polymer used in the undercoat layer is preferably 5,000 or more, and more preferably 10,000 to 300,000.

-Hydrophilic compound-

From the viewpoint of developability, it is preferable that the undercoat layer contain a hydrophilic compound.

The hydrophilic compound is not particularly limited, and known hydrophilic compounds used for the undercoat layer can be used.

Preferable examples of hydrophilic compounds include phosphonic acids having an amino group such as carboxymethyl cellulose and dextrin, an organic phosphonic acid, an organic phosphoric acid, an organic phosphinic acid, an amino acid, a hydrochloride of amine having a hydroxyl group, and the like.

In addition, examples of preferable hydrophilic compounds include a compound having an amino group or a functional group capable of inhibiting polymerization and a group that interacts with the surface of the support (for example, 1,4-diazabicyclo[2.2.2]octane (DABCO), 2,3,5,6-tetrahydroxy-p-quinone, chloranil, sulfophthalic acid, ethylenediaminetetraacetic acid (EDTA) or a salt thereof, hydroxyethyl ethylenediaminetriacetic acid or a salt thereof, dihydroxyethyl ethylenediaminediacetic acid or a salt thereof, hydroxyethyl iminodiacetic acid or a salt thereof, and the like).

From the viewpoint of suppressing scratches and contamination, it is preferable to use hydroxycarboxylic acid or a salt thereof as the hydrophilic compound.

Furthermore, from the viewpoint of suppressing scratches and contamination, it is preferable that the hydrophilic compound (preferably hydroxycarboxylic acid or a salt thereof) be contained not only in the undercoat layer but also in a layer on the aluminum support. In addition, the layer on the aluminum support is preferably a layer on the side where the image-recording layer is formed or a layer in contact with the aluminum support.

Preferable examples of the layer on the aluminum support include a layer in contact with the aluminum support, such as the undercoat layer or the image-recording layer. Furthermore, a layer other than the layer in contact with the aluminum support, for example, the protective layer or the image-recording layer may contain a hydrophilic compound (preferably hydroxycarboxylic acid or a salt thereof). From the viewpoint of suppressing scratches and contamination, an aspect is also preferable in which the image-recording layer in the lithographic printing plate precursor contains hydroxycarboxylic acid or a salt thereof.

Moreover, regarding the lithographic printing plate precursor, for example, an aspect is also preferable in which the surface of the aluminum support on the image-recording layer side is treated with a composition (for example, an aqueous solution or the like) containing at least hydroxycarboxylic acid or a salt thereof. In a case where the above aspect is adopted, at least some of the hydroxycarboxylic acid or a salt thereof used for treatment can be detected in a state of being contained in the layer on the image-recording layer side (for example, the image-recording layer or the undercoat layer) that is in contact with the aluminum support.

In a case where the layer that is in contact with the aluminum support, such as the undercoat layer, contains hydroxycarboxylic acid or a salt thereof, the surface of the aluminum support on the image-recording layer side can be hydrophilized, and it is easy for the surface of the aluminum support on the image-recording layer side to have a water contact angle of 110° or less measured by an airborne water droplet method. As a result, a lithographic printing plate precursor in which scratches and contamination is excellently suppressed is obtained.

"Hydroxycarboxylic acid" is the generic term for organic compounds having one or more carboxy groups and one or more hydroxyl groups in one molecule. These compounds are also called hydroxy acid, oxy acid, oxycarboxylic acid, or alcoholic acid (see Iwanami Dictionary of Physics and Chemistry, 5th Edition, published by Iwanami Shoten, Publishers. (1998)).

The hydroxycarboxylic acid or a salt thereof is preferably represented by Formula (HC).

$$R^{HC}(OH)_{mhc}(COOM^{HC})_{nhc} \qquad \text{Formula (HC)}$$

In Formula (HC), $R^{HC}$ represents an (mhc + nhc)-valent organic group, $M^{HC}$ each independently represents a hydrogen atom, an alkali metal, or an onium, and mhc and nhc each independently represent an integer of 1 or more. In a case where n is 2 or more, Ms may be the same or different from each other.

Examples of the (mhc + nhc)-valent organic group represented by $R^{HC}$ in Formula (HC) include an (mhc + nhc)-valent hydrocarbon group and the like. The hydrocarbon group may have a substituent and/or a linking group.

Examples of the hydrocarbon group include an (mhc + nhc)-valent group derived from aliphatic hydrocarbon, such as an alkylene group, an alkanetriyl group, an alkanetetrayl group, an alkanepentayl group, an alkenylene group, an alkenetriyl group, an alkenetetrayl group, and alkenepentayl group, an alkynylene group, an alkynetriyl group, alkynetetrayl group, or an alkynepentayl group, an (mhc + nhc)-valent group derived from aromatic hydrocarbon, such as an arylene group, an arenetriyl group, an arenetetrayl group, or an arenepentayl group, and the like.

Examples of the substituent that can be introduced into the hydrocarbon group include substituents other than a hydroxyl group and a carboxyl group, such as an alkyl group, an alkenyl group, an alkynyl group, an aralkyl group, an aryl group, and the like. Specific examples of the substituent include a methyl group, an ethyl group, a propyl group, a butyl group, a pentyl group, a hexyl group, a heptyl group, an octyl group, a nonyl group, a decyl group, an undecyl group, a dodecyl group, a tridecyl group, a hexadecyl group, an octadecyl group, eicosyl group, isopropyl group, isobutyl group, s-butyl group, t-butyl group, isopentyl group, a neopentyl group, a 1-methylbutyl group, an isohexyl group, a 2-ethylhexyl group, a 2-methylhexyl group, a cyclohexyl group, a cyclopentyl group, a 2-norbornyl group, a methoxymethyl group, a methoxyethoxyethyl group, an allyloxymethyl group, a phenoxymethyl group, an acetyloxymethyl group, a benzoyloxymethyl group, a benzyl group, a phenethyl group, an α-methylbenzyl group, a 1-methyl-1-phenylethyl group, a p-methylbenzyl group, a cinnamyl group, an allyl group, a 1-propenylmethyl group, a 2-butenyl group, a 2-methylallyl group, a 2-methylpropenylmethyl group, a 2-propynyl group, a 2-butynyl group, a 3-butynyl group, a phenyl group, a biphenyl group, a naphthyl group, a tolyl group, a xylyl group, a mesityl group, a cumenyl group, a methoxyphenyl group, an ethoxyphenyl group, a phenoxyphenyl group, an acetoxyphenyl group, a benzoyloxyphenyl group, a methoxycarbonylphenyl group, an ethoxycarbonylphenyl group, a phenoxycarbonylphenyl group, and the like.

Furthermore, the linking group is composed of at least one atom selected from the group consisting of a hydrogen atom, a carbon atom, an oxygen atom, a nitrogen atom, a sulfur atom, and a halogen atom, and the number of atoms is preferably 1 to 50. Specific examples thereof include an alkylene group, a substituted alkylene group, an arylene group, a substituted arylene group, and the like. The linking group may have a structure in which a plurality of these divalent groups are linked through any of an amide bond, an ether bond, a urethane bond, a urea bond, and an ester bond.

Examples of the alkali metal represented by $M^{HC}$ include lithium, sodium, potassium, and the like. Among these, sodium is particularly preferable.

Examples of the onium represented by $M^{HC}$ include ammonium, phosphonium, sulfonium, and the like. Among these, ammonium is particularly preferable.

From the viewpoint of suppressing scratches and contamination, $M^{HC}$ is preferably an alkali metal or an onium, and more preferably an alkali metal.

The total number of mhc and nhc is preferably 3 or more, more preferably 3 to 8, and even more preferably 4 to 6.

The molecular weight of the hydroxycarboxylic acid or a salt thereof is preferably 600 or less, more preferably 500 or less, and particularly preferably 300 or less. The molecular weight is preferably 76 or more.

Specifically, examples of the hydroxycarboxylic acid constituting the hydroxycarboxylic acid or a salt of the hydroxycarboxylic acid include gluconic acid, glycolic acid, lactic acid, tartronic acid, hydroxybutyrate (such as 2-hydroxybutyrate, 3-hydroxybutyrate, or γ-hydroxybutyrate), malic acid, tartaric acid, citramalic acid, citric acid, isocitric acid, leucine acid, mevalonic acid, pantoic acid, ricinoleic acid, ricineraidic acid, cerebronic acid, quinic acid, shikimic acid, a monohydroxybenzoic acid derivative (such as salicylic acid, creosotic acid (homosalicylic acid, hydroxy(methyl) benzoate), vanillic acid, or syringic acid), a dihydroxybenzoic acid derivative (such as pyrocatechuic acid, resorcylic acid, protocatechuic acid, gentisic acid, or orsellinic acid), a trihydroxybenzoic acid derivative (such as gallic acid), a phenyl acetate derivative (such as mandelic acid, benzilic acid, or atrolactic acid), a hydrocinnamic acid derivative (such as melilotic acid, phloretic acid, coumaric acid, umbellic acid, caffeic acid, ferulic acid, sinapic acid, cerebronic acid, or carminic acid), and the like.

Among these, as the aforementioned hydroxycarboxylic acid or a hydroxycarboxylic acid constituting a salt of the hydroxycarboxylic acid, from the viewpoint of suppressing scratches and contamination, a compound having two or more hydroxyl groups is preferable, a compound having 3 or more hydroxyl groups is more preferable, a compound having 5 or more hydroxyl groups is even more preferable, and a compound having 5 to 8 hydroxyl groups is particularly preferable.

Furthermore, as a hydroxycarboxylic acid having one carboxy group and two or more hydroxyl groups, gluconic acid or shikimic acid is preferable.

As hydroxycarboxylic acid having two or more carboxy groups and one hydroxyl group, citric acid or malic acid is preferable.

As hydroxycarboxylic acid having two or more carboxy groups and two or more hydroxyl groups, tartaric acid is preferable.

Among these, gluconic acid is particularly preferable as the aforementioned hydroxycarboxylic acid.

One kind of hydrophilic compound may be used alone, or two or more kinds of hydrophilic compounds may be used in combination.

In a case where the undercoat layer contains a hydrophilic compound (preferably hydroxycarboxylic acid or a salt thereof), the content of the hydrophilic compound (preferably hydroxycarboxylic acid or a salt thereof) with respect to the total mass of the undercoat layer is preferably 0.01% by mass to 50% by mass, more preferably 0.1% by mass to 40% by mass, and particularly preferably 1.0% by mass to 30% by mass.

In order to prevent contamination over time, the undercoat layer may contain a chelating agent, a secondary or tertiary amine, a polymerization inhibitor, and the like, in addition to the compounds described above.

The undercoat layer is formed on the aluminum support by a known coating method.

The coating amount (solid content) of the undercoat layer is preferably 0.1 $mg/m^2$ to 100 $mg/m^2$, and more preferably 1 $mg/m^2$ to 30 $mg/m^2$.

<Method for preparing lithographic printing plate and lithographic printing method>

The method for preparing a lithographic printing plate is not particularly limited as long as it is a method for preparing a lithographic printing plate by using the lithographic printing plate precursor according to the present invention.
The method for preparing a lithographic printing plate according to the present invention preferably includes a step of subjecting the lithographic printing plate precursor according to the present invention to image-wise light exposure (hereinafter, this step will be also called "image exposure step") and a step of removing the image-recording layer in a non-image area on a printer by supplying at least one material selected from the group consisting of a printing ink and dampening water to the exposed lithographic printing plate precursor (hereinafter, this step will be also called "on-press development treatment step"). The above plate preparation method will be also called "on-press development method".
The lithographic printing method according to the present invention is a method of preparing a lithographic printing plate by using the lithographic printing plate precursor according to the present invention and performing printing. The lithographic printing method includes a step of subjecting the lithographic printing plate precursor according to the present invention to image-wise light exposure (hereinafter, this step will be also called "image exposure step"), a step of removing the image-recording layer in a non-image area on a printer by supplying at least one material selected from the group consisting of a printing ink and dampening water to the exposed lithographic printing plate precursor (hereinafter, this step will be also called "on-press development treatment step"), and a step of performing printing by using the obtained lithographic printing plate (this step will be also called "printing step").
Among the lithographic printing plate precursors, a key plate precursor is subjected to the development treatment step without being subjected to the image exposure step.
Hereinafter, regarding the method for preparing a lithographic printing plate according to the present invention and the lithographic printing method according to the present invention, preferred aspects of each step will be described in order. Note that the lithographic printing plate precursor can also be developed using a developer.

[Image exposure step]

The step of subjecting the lithographic printing plate precursor to image-wise light exposure can be performed according to the image exposure operation of the general lithographic printing plate precursor.
The image-wise light exposure is performed by exposing the precursor to a laser through a transparent original picture having a linear image, a halftone dot image, or the like or performed by laser scanning or the like according to digital data. The wavelength of a light source to be used is preferably 700 nm to 1,400 nm. As the light source of 700 nm to 1,400 nm, a solid-state laser or a semiconductor laser that radiates infrared is suitable. In a case where an infrared laser is used, the output is preferably 100 mW or higher, the exposure time per pixel is preferably 20 $\mu s$ or less, and the amount of irradiation energy is preferably 10 $mJ/cm^2$ to 300 $mJ/cm^2$. In order to shorten the exposure time, a multibeam laser device is preferably used. The exposure mechanism may be any one of an in-plane drum method, an external surface drum method, a flat head method, or the like. The image-wise light exposure can be carried out by a common method using a platesetter or the like.

[On-press development treatment step]

The development treatment for the exposed lithographic printing plate precursor can be performed by a usual method.
In the case of on-press development, in a case where at least one material selected from the group consisting of a printing ink and dampening water is supplied to the exposed lithographic printing plate precursor on a printer, in an exposed portion of the image-recording layer, the image-recording layer cured by exposure forms a printing ink-receiving portion (that is, an image area) having a lipophilic surface. On the other hand, in a non-exposed portion, by at least one material selected from the group consisting of a printing ink and dampening water supplied, the non-cured image-recording layer is dissolved or dispersed and removed, and thus a hydrophilic surface is exposed in that portion. As a result, the dampening water adheres to the exposed hydrophilic surface, the printing ink sticks to the image-recording layer in the exposed area, and printing starts.
What is first supplied to the surface of the lithographic printing plate precursor may be dampening water or printing ink. However, in order to promote on-press developability by permeation of dampening water, it is preferable that dampening water be supplied first.

<Printing step>

Printing performed using the obtained lithographic printing plate can be carried out by a general method.
Printing can be performed by supplying the desired printing ink and, if necessary, dampening water to the lithographic printing plate.
The amount of printing ink and dampening water to be supplied is not particularly limited, and may be appropriately set according to the desired printing.
The method of supplying the printing ink and dampening water to the lithographic printing plate is not particularly limited, and a known method can be used.
The recording medium to be printed is not particularly limited, and known recording media can be used as desired.

[Development treatment step using developer]

In the method for preparing a lithographic printing plate precursor and the lithographic printing method, instead of the on-press development treatment step described above, a step of developing the exposed lithographic printing plate precursor by using a developer (development treatment using a developer) may be performed.
The development treatment step using a developer is preferably, for example, development for removing a non-exposed portion of the exposed lithographic printing plate precursor by supplying a developer having a pH of 2 to 11.
Hereinafter, the development treatment step using a developer will be described.

(Development treatment using developer)

The developer used in the development treatment step using a developer is not particularly limited, and a known developer known in the related art may be used. The developer may contain at least one kind of compound selected from the group consisting of a surfactant and a water-soluble polymer compound. In a preferred aspect, a developer having a pH of 2 to 11 is used.
If necessary, a water-soluble polymer compound can be incorporated into the developer so that development and a gum solution treatment step are performed at the same time. In this case, a post-rinsing step is unnecessary, and it is possible to perform both the development and gum solution treatment as one step by using one solution and to subsequently perform a drying step. Therefore, the development treatment using a developer is preferably a development treatment performed on the exposed lithographic printing plate precursor by using a developer having a pH of 2 to 11. After the development treatment, it is preferable to remove an excess of developer by using a squeeze roller and to subsequently perform drying.
As described above, in the development treatment step using a developer in the method for preparing a lithographic printing plate, it is preferable to perform the development treatment and the gum solution treatment as one step by using one solution.
To perform the development and the gum solution treatment as one step by using one solution means that the development treatment and the gum solution treatment are carried out as one step using one solution, instead of being carried out as separate steps.
The development treatment using a developer can be more suitably performed using an automatic development treatment machine having a developer supply unit and a development treatment unit that comprises a rubbing member. Particularly, an automatic development treatment machine using a rotary brush roll as a rubbing member is preferable. The number of rotary brush rolls is preferably 2 or more.
Furthermore, the automatic development treatment machine preferably comprises, after the development treatment unit, a unit for removing an excess of developer, such as a squeeze roller, and a drying unit such as hot air device. In addition, the automatic development treatment machine may comprise, before the development treatment unit, a preheating unit for treat the exposed lithographic printing plate precursor with heat.
The treatment performed using the above automatic development treatment machine has an advantage of being applicable to handle development residues derived from a water-soluble resin layer and/or the image-recording layer that are produced during so-called on-press development treatment.
In the development treatment step using a developer, in a case where a manual treatment is to be performed, as the development treatment using a developer, for example, a method of impregnating sponge, absorbent cotton, or the like with an aqueous solution, treating the entire plate surface while rubbing it, and drying the plate after the treatment ends is suitable. In a case where an immersion treatment is to be performed, for example, a method of immersing the lithographic printing plate precursor in a bath, a deep tank, or the like containing an aqueous solution for about 60 seconds, stirring the solution, and then drying the plate while rubbing it with absorbent cotton, a sponge, or the like is suitable.
During the development treatment using a developer, it is preferable to use a device that has a simple structure

and simplifies steps.

For example, in an alkaline development treatment, a pre-rinsing step is performed to remove a water-soluble resin layer, development is then performed using a high pH alkaline developer, a post-rinsing step is subsequently performed to remove alkali, a gum treatment is performed by a gumming step, and a drying step is performed for drying. Furthermore, in a simple development treatment, development and gumming can be simultaneously performed using one solution. In this case, the post-rinsing step and the gum treatment step can be skipped, and it is preferable to perform development and gumming (gum solution treat) by using one solution and then to perform a drying step if necessary.

Furthermore, it is preferable to simultaneously perform the removal of a water-soluble resin layer, development, and gumming by using one solution, without performing the pre-rinsing step. In addition, after the development and gumming, it is preferable to remove an excess of developer by using a squeeze roller and then perform drying.

In the development treatment using a developer, a method of immersing the precursor in a developer once or a method of immersing the precursor in a developer twice or more times may be used. Particularly, a method of immersing the precursor in the aforementioned developer once or twice is preferable.

The immersion may be performed by dipping the exposed lithographic printing plate precursor in a developer tank filled with a developer or spraying a developer onto the surface of the exposed lithographic printing plate precursor from a spray or the like.

Even though the precursor is immersed in a developer twice or more times, in a case where the precursor is immersed twice or more times in the same developer or in a developer and another developer (fatigued developer) in which the components of the image-recording layer are dissolved or dispersed by the development treatment, the treatment is called a development treatment using one solution (one-solution treatment).

In the development treatment using a developer, it is preferable to use a rubbing member and to install the rubbing member such as a brush in a development bath for removing the non-image area of the image-recording layer.

The development treatment using a developer can be carried out according to a conventional method, preferably at a temperature of 0°C to 60°C and more preferably at a temperature of 15°C to 40°C, for example, by immersing the lithographic printing plate precursor having undergone the exposure treatment in a developer and rubbing the precursor with a brush, by drawing up a treatment solution stored in an external tank with a pump, spraying the solution from a spray nozzle, and rubbing the precursor with a brush, or the like. These development treatments can also be performed a plurality of times in succession. For example, the treatments can be performed by drawing up a developer stored in an external tank with a pump, spraying the developer from a spray nozzle, rubbing the precursor with a brush, then spraying the developer again from the spray nozzle, and rubbing the precursor with a brush, or the like. In a case where the development treatment is performed using an automatic development machine, the developer is fatigued as the throughput increases. Therefore, it is preferable to restore the treatment ability by using a replenishing developer or a fresh developer.

For the development treatment using a developer, a gum coater or an automatic development machine known in the related art for a presensitized plate (PS) and computer to plate (CTP) can also be used. In a case where an automatic development machine is used, for example, it is possible to use any of a method of drawing up a developer stored in a development tank or a developer stored in an external tank by using a pump and treating the printing plate by spraying the developer from a spray nozzle, a method of immersing and transporting the printing plate in a tank filled with a developer by using a guide roller in the developer, or a so-called disposable treatment method of treating the plate by supplying a substantially unused developer to each plate as much as needed. In any of the methods, a development machine having a rubbing mechanism consisting of a brush, molleton, or the like is more preferable. For example, it is possible to use commercially available automatic development machines (Clean Out Unit C85/C125, Clean-Out Unit + C85/120, FCF 85V, FCF 125V, FCF News (manufactured by Glunz & Jensen), Azura CX85, Azura CX125, and Azura CX150 (manufactured by Agfa Graphics). It is also possible to use an apparatus composed of a laser exposure unit and an automatic development machine unit that are integrated.

(Developer)

The pH of the developer used in the development treatment using a developer is preferably 2 to 11, more preferably 5 to 9, and even more preferably 7 to 9.

From the viewpoint of developability and dispersibility of the image-recording layer, it is advantageous to set the pH higher. However, from the viewpoint of printing properties and further suppressing contamination, it is more effective to set the pH lower.

The pH mentioned herein is a value measured at 25°C by using a pH meter (model: HM-31, manufactured by DKK-TOA CORPORATION).

Examples of components contained in the developer used in the development treatment using a developer include a surfactant, a water-soluble polymer compound, a wetting agent, a preservative, a chelating compound, an antifoaming agent, an organic acid, an organic solvent, an inorganic acid, an inorganic salt, and the like.

[Other steps]

The method for preparing a lithographic printing plate and the lithographic printing method may have other known steps in addition to the steps described above. Examples of those other steps include a step of heating the entire surface of the lithographic printing plate precursor at least any timing among before exposure, during exposure, or between exposure and development, a plate inspection step of checking the position, orientation, and the like of the lithographic printing plate precursor before each step, a checking step of checking the printed image after the development treatment step, and the like.

Performing the step of heating the entire surface of the lithographic printing plate precursor can bring advantages such as accelerating the image-forming reaction in the image-recording layer, improving sensitivity and printing durability, and stabilizing sensitivity. In a case where the precursor is to be heated before development, from the viewpoint suppressing the effect of the non-image area, it is preferable to heat the precursor under a mild condition of 150°C or lower. In a case where the precursor is to be heated after development, it is preferable to use extremely severe conditions. From the viewpoint of obtaining a sufficient image-strengthening action and inhibiting problems such as deterioration of the support and thermal decomposition of the image area, for example, it is preferable to heat the precursor at a temperature ranging from 100°C to 500°C.

Examples

Hereinafter, the present invention will be specifically described based on examples, but the present invention is not limited thereto. In the present examples, unless otherwise specified, "%" and "part" mean "% by mass" and "part by mass" respectively. Unless otherwise described, the molecular weight of a polymer compound is a weight-average molecular weight (Mw), and the ratio of repeating constitutional units of a polymer compound is expressed as molar percentage. The weight-average molecular weight (Mw) is a value measured by gel permeation chromatography (GPC) and expressed in terms of polystyrene.

<Synthesis of resin particles R-1>

The method for preparing the microgel as resin particles R-1 will be described below.

-Preparation of polyvalent isocyanate compound (1)-

Bismuth tris(2-ethylhexanoate) (NEOSTANN U-600, manufactured by NITTO KASEI CO., LTD., 43 mg) was added to an ethyl acetate (25.31 g) suspension solution of 17.78 g (80 mmol) of isophorone diisocyanate and 7.35 g (20 mmol) of a polyhydric phenol compound (1) having the following structure, and the obtained solution was stirred. The reaction temperature was set to 50°C at a point in time when heat release subsided, and the solution was stirred for 3 hours, thereby obtaining an ethyl acetate solution of the polyvalent isocyanate compound (1) (50% by mass).

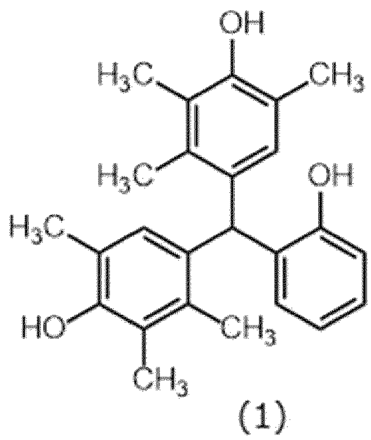

(1)

-Preparation of microgel-

The following oil-phase components and water-phase components were mixed together and emulsified at 12,000 rpm for 10 minutes by using a homogenizer. The obtained emulsion was stirred at 45°C for 4 hours, a 10% by mass aqueous solution of 5.20 g of 1,8-diazabicyclo[5.4.0]undec-7-ene-octylate (U-CAT SA102, manufactured by San-Apro

Ltd.) was added thereto, and the solution was stirred at room temperature for 30 minutes and left to stand at 45°C for 24 hours. Distilled water was added thereto so that the concentration of solid contents was adjusted to 20% by mass, thereby obtaining an aqueous dispersion of microgel. The average particle diameter of the microgel measured by a light scattering method was 0.28 μm.

~Oil-phase component~

(Component 1) ethyl acetate: 12.0 g
(Component 2) an adduct obtained by addition of trimethylolpropane (6 molar equivalents), xylene diisocyanate (18 molar equivalents), and polyoxyethylene having one methylated terminal (1 molar equivalent, the number of repeating oxyethylene units: 90) (50% by mass ethyl acetate solution, manufactured by Mitsui Chemicals, Inc.): 3.76 g
(Component 3) polyvalent isocyanate compound (1) (as 50% by mass ethyl acetate solution): 15.0 g
(Component 4) 65% by mass ethyl acetate solution of dipentaerythritol pentaacrylate (SR399, manufactured by Sartomer Company Inc.): 11.54 g
(Component 5) 10% ethyl acetate solution of sulfonate type surfactant (PIONINE A-41-C, manufactured by TAKEMOTO OIL & FAT Co., Ltd.): 4.42 g

~Water-phase component~

Distilled water: 46.87 g
Acetone (15 g) was added to 1 g of the obtained aqueous dispersion of microgel, and the dispersion was centrifuged (radius 15 cm, 14,500 rpm). The supernatant was analyzed by liquid chromatography (HPLC) to detect the amount of encapsulated monomers eluted. As a result of repeatedly rinsing the microgel 3 times by the addition of acetone and centrifugation as described above, monomers encapsulated in the microgel were not detected.
After the rinsing described above, the microgel as the resin particles R-1 had an ethylenically unsaturated bond valence (that is, C=C valence) of 0.5 mmol/g, a median diameter of 210 nm, and a coefficient of variation of 24%.
Furthermore, the dispersibility of the resin particles R-1 was checked by the method described above. As a result, the resin particles R-1 were found to be water-dispersible and organic solvent-dispersible particles.

<Synthesis of resin particles R-2>

The following compound B-1 (n = 45, 10.0 g) as a dispersion unit, 85.0 g of distilled water, and 240.0 g of n-propanol were added to a 1,000 ml four-neck flask, and the mixture was heated and stirred at 70°C in a nitrogen atmosphere.
Then, a mixture of 20.0 g of the following compound A-1, 70.0 g of the following compound A-2, and 0.7 g of 2,2'-azobisisobutyronitrile that were mixed together in advance was added dropwise to the four-neck flask for 2 hours.
After the dropwise addition ended, the reaction continued for 5 hours, then 0.5 g of 2,2'-azobisisobutyronitrile was added thereto, and the solution was heated to 80°C. Thereafter, the reaction was performed for a total of 19 hours by adding 0.4 g of 2,2'-azobisisobutyronitrile every 6 hours.
The reaction solution was left to cool to room temperature (25°C), thereby obtaining a dispersion of resin particles R-2 (solid content 23%).

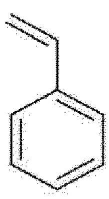

A-1

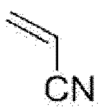

A-2

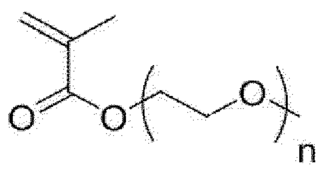

B-1

The resin particles R-2 had an ethylenically unsaturated bond valence (that is, C=C valence) of 0 mmol/g, a median diameter of 150 nm, and a coefficient of variation of 23%.
Furthermore, the dispersibility of the resin particles R-2 was checked by the method described above. As a result, the resin particles R-2 were found to be water-dispersible and organic solvent-dispersible particles.

<Synthesis of resin particles R-3>

2-Butanone (20 g) was weighed out, put in a 500 mL three-neck flask, and heated to 70°C under a nitrogen stream. A mixed solution consisting of 12.6 g of KARENZ-MOI (2-methacryloyloxyethyl isocyanate, manufactured by SHOWA DENKO K.K.), 15 g of the above compound A-1, 15.0 g of the above compound A-2, 10 g of the above compound B-1 (n = 45), 5 g of methyl methacrylate, 0.6 g of V-65 (2,2'-azobis(2,4-dimethylvaleronitrile), manufactured by FUJIFILM Wako Pure Chemical Corporation), and 44 g of 2-butanone was added dropwise to the reaction container for 2 hours.
After dropwise addition ended, the reaction was continued for 2 more hours. After 2 hours, 0.1 g of V-65 was added thereto, the temperature was raised to 80°C, and the reaction was continued for 2 hours.
After the reaction ended, the reaction solution was cooled to room temperature (25°C, the same shall be applied hereinafter). Then, 30 g of 2-butanone, 0.1 g of tetramethylpiperidine N-oxide, 43 g of SR399 (manufactured by Sartomer Company Inc.), and 0.2 g of NEOSTANN U-600 (manufactured by NITTO KASEI CO., LTD.) were added to the reaction solution, thoroughly stirred, and then heated to 70°C. After 6 hours, the reaction solution was cooled to room temperature.
Subsequently, 400 ml of water was added to a 1 L stainless steel beaker and stirred with a mechanical stirrer, and in this state, the entirety of the aforementioned reaction solution was added thereto at a rate of 1 ml/min. The supernatant was removed except for the obtained white precipitate, and the precipitate was repeatedly rinsed with water twice.
A 0.1 N (mol/L) aqueous NaOH solution (200 ml) and 100 ml of pure water were added to the stainless steel beaker without performing a drying step, and the obtained solution was stirred, thereby obtaining a white dispersion.
The obtained dispersion was emulsified at 18,000 rpm for 12 minutes by using a homogenizer, thereby obtaining a dispersion of resin particles R-3 (solid content 21%).
The resin particles R-3 had an ethylenically unsaturated bond valence (that is, C=C valence) of 4.0 mmol/g, a median diameter of 140 nm, and a coefficient of variation of 23%.
Furthermore, the dispersibility of the resin particles R-3 was checked by the method described above. As a result, the resin particles R-3 were found to be water-dispersible and organic solvent-dispersible particles.

<Synthesis of resin particles R-4>

Resin particles R-4 were synthesized by the same method as that used for synthesizing the resin particles R-3, except that the type and amount of the monomers used were appropriately changed.
The resin particles R-4 had an ethylenically unsaturated bond valence (that is, C=C valence) of 2.8 mmol/g, a median diameter of 140 nm, and a coefficient of variation of 27%.
Furthermore, the dispersibility of the resin particles R-4 was checked by the method described above. As a result, the resin particles R-4 were found to be water-dispersible particles.

<Synthesis of resin particles R-5>

-Synthesis of precursor R-5'-

Deionized water (20 parts), 0.3 parts of Rongalite, 0.01 parts of disodium ethylenediaminetetraacetate, and 0.0025 parts of ferrous sulfate heptahydrate were put in a three-neck flask, and the mixture was stirred at 250 rpm at 60°C in a nitrogen atmosphere.
Then, 4.0 parts of the above compound A-1, 4.0 parts of the above compound A-2, 2.0 parts of the following compound A-3, 6.0 parts of the following compound A-4, 1.6 parts of methacrylic acid, 0.60 parts of sodium dodecylbenzenesulfonate, 0.58 parts of peroxide polymerization initiator (manufactured by NOF CORPORATION, trade name PERBUTYL H), and 17 parts of deionized water were added thereto and stirred at room temperature for 30 minutes, thereby preparing an emulsified liquid.
Twenty-five percent of the obtained emulsified liquid was added to the aforementioned three-neck flask for 30 minutes, and then continuously heated and stirred for 30 minutes. Thereafter, the remaining 75% was added dropwise thereto for 2 hours. After the dropwise addition ended, the reaction solution was heated and stirred for 2 hours. The reaction solution was left to cool to room temperature (25°C), thereby obtaining a dispersion of a precursor R-5' (solid content 35%). The average particle diameter of the precursor R-5' was 120 nm.

-Synthesis of resin particles R-5-

The dispersion of the precursor R-5' (12.5 parts), 1.0 part of glycidyl acrylate, 0.2 parts of tetrabutylammonium bromide, and 30.0 parts of 1-methoxy-2-propanol were added to a three-neck flask and stirred at 90°C for 12 hours. The reaction solution was left to cool to room temperature (25°C), thereby obtaining a dispersion of resin particles R-5 (solid content 10%).

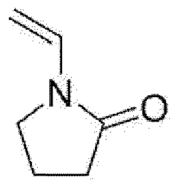

A-3

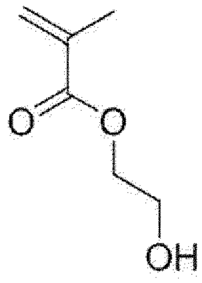

A-4

The resin particles R-5 had an ethylenically unsaturated bond valence (that is, C=C valence) of 0.93 mmol/g, a median diameter of 124 nm, and a coefficient of variation of 30%.

Furthermore, the dispersibility of the resin particles R-5 was checked by the method described above. As a result, the resin particles R-5 were found to be water-dispersible and organic solvent-dispersible particles.

<Synthesis of resin particles R-6>

Resin particles R-6 were synthesized by the same method as that used for synthesizing the resin particles R-5, except that the type and amount of the monomers used were appropriately changed.

The resin particles R-6 had an ethylenically unsaturated bond valence (that is, C=C valence) of 0.93 mmol/g, a median diameter of 95 nm, and a coefficient of variation of 19%.

Furthermore, the dispersibility of the resin particles R-6 was checked by the method described above. As a result, the resin particles R-6 were found to be water-dispersible and organic solvent-dispersible particles.

The details of the resin particles R-2 to R-6 are as follows.

Herein, the constitutional units A-1' to A-6' and the constitutional units B-1' to B-3' each represent constitutional units constituting the resin particles R-2 to R-6, and the amount of the constitutional units represents the content [% by mass] of each constitutional unit contained in the resin particles R-2 to R-6.

| Resin particles | Constitutional unit | | | |
|---|---|---|---|---|
| | Type | Amount (% by mass) | Type | Amount (% by mas |
| R-2 | A-1'/A-2' | 20/70 | B-1'(n=45) | 10 |
| R-3 | A-1'/A-2'/A-6' | 15/15/55 | B-3'/B-1'(n=45) | 5/10 |
| R-4 | A-1'/A-2'/A-5' | 20/10/60 | B-2' | 10 |
| R-5 | A-1'/A-2'/A-3' /A-4'/A-5' | 20/20/10 /30/20 | - | 0 |
| R-6 | A-1'/A-2'/A-3' /A-4'/A-5' | 20/20/30 /10/20 | B-1'(n=45) | 10 |

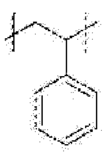

A-1'

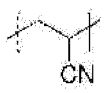

A-2'

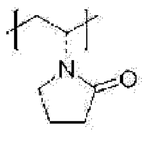

A-3'

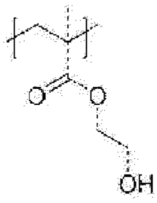

A-4'

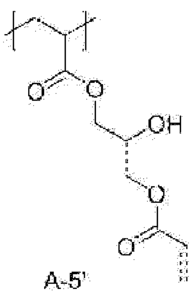

A-5'

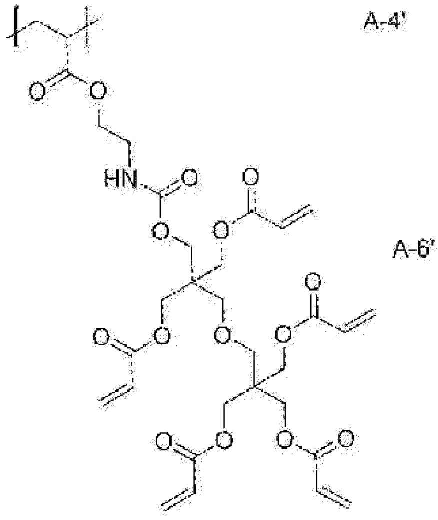

A-6'

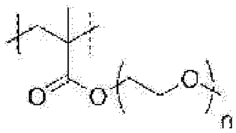

B-1'

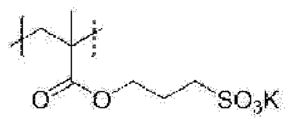

B-2'

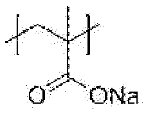

B-3'

<Synthesis of resin particles R-7>

Resin particles R-7 were synthesized by the following method.

-Synthesis of wall material A-

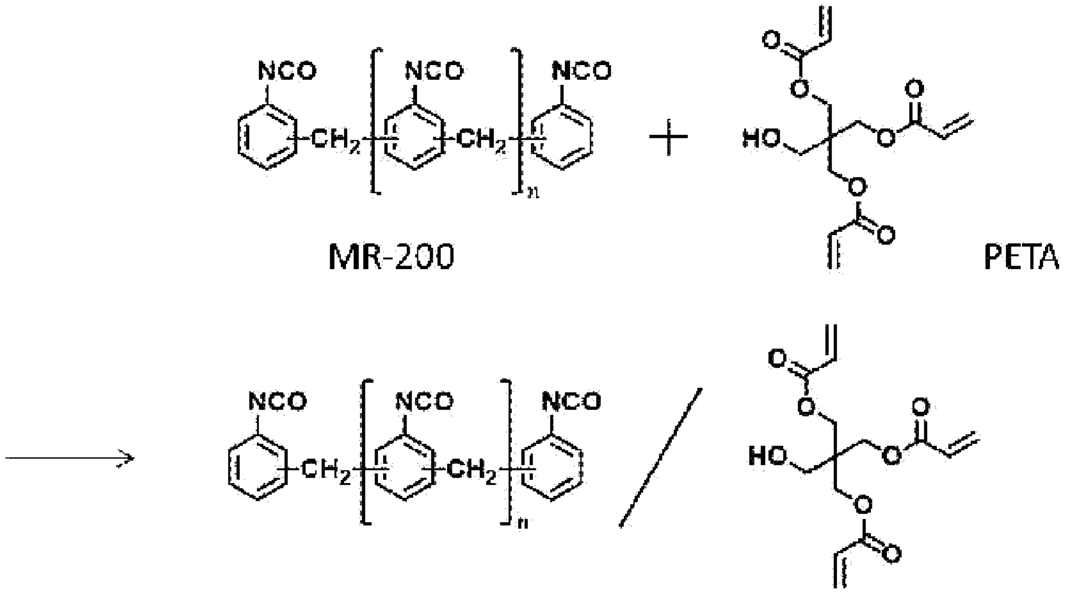

MR-200

PETA

Wall material A

MR-200 described above (a compound represented by Formula (Iso), n = 0 to 10, manufactured by TOSOH CORPORATION): 9.5 g, PETA described above (pentaerythritol triacrylate, manufactured by Nippon Kayaku Co., Ltd., SR444): 0.5 g, and ethyl acetate: 10 g were added to a three-neck flask, stirred at room temperature, and heated to 60°C.

Then, 0.05 g of NEOSTANN U-600 (manufactured by NITTO KASEI CO., LTD.) was added to the three-neck flask, and the reaction solution was heated and stirred for 3 hours. Then, the reaction solution was cooled to room temperature, thereby obtaining a wall material A (solid content 50% by mass).

-Synthesis of wall material B-

In the following formula, Me represents a methyl group.

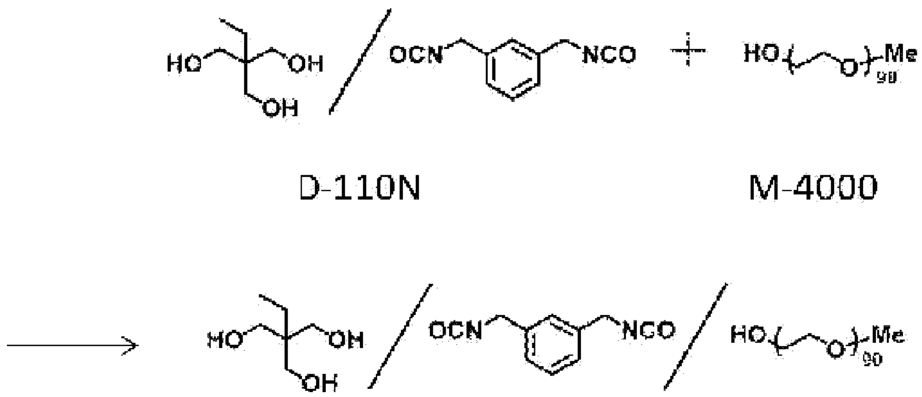

D-110N

M-4000

Wall material B

TAKENATE D-110N described above (manufactured by Mitsui Chemicals, Inc., 5.0 g), 5.0 g of the aforementioned UNIOX (registered trademark) M-4000 (manufactured by NOF CORPORATION), and 10 g of ethyl acetate were added to a three-neck flask, stirred at room temperature, and then heated to 60°C.

Then, 0.05 g of NEOSTANN U-600 (manufactured by NITTO KASEI CO., LTD.) was added to the three-neck flask, and the reaction solution was heated and stirred for 3 hours. Thereafter, the reaction solution was cooled to room temperature, thereby obtaining a wall material B (solid content 50% by mass).

-Synthesis of resin particles R-7-

PIONIN A-41-C (manufactured by TAKEMOTO OIL & FAT Co., Ltd., 0.45 g), 14.99 g of the wall material A, 7.49 g of SR399E (dipentaerythritol pentaacrylate, manufactured by Sartomer Company Inc.), 3.78 g of the wall material B, and

16.56 g of ethyl acetate were added to an aluminum cup, and stirred at room temperature.

Then, 46.89 g of pure water was added to the aluminum cup, and the reaction solution was stirred with a homogenizer at 12,000 rpm for 12 minutes. Thereafter, 16.64 g of pure water was further added, and the reaction solution was heated to 45°C and then heated and stirred for 4 hours.

Subsequently, 5.17 g of a 10% aqueous solution of U-CAT SA 102 (manufactured by San-Apro Ltd.) was added thereto. Then, the container was put in a constant-temperature tank and aged for 48 hours, thereby obtaining a dispersion of the resin particles R-7 (solid content 20%).

The resin particles R-7 had an ethylenically unsaturated bond valence (that is, C=C valence) of 0.50 mmol/g.

Furthermore, the resin particles R-7 had a median diameter of 190 nm and a coefficient of variation of 27.1%.

The resin contained in the resin particles R-7 will be shown below.

In the following resins, the subscripts under each compound (monomer) and the subscripts at the right lower side of the parentheses represent the content ratio (mass ratio).

Wall material A

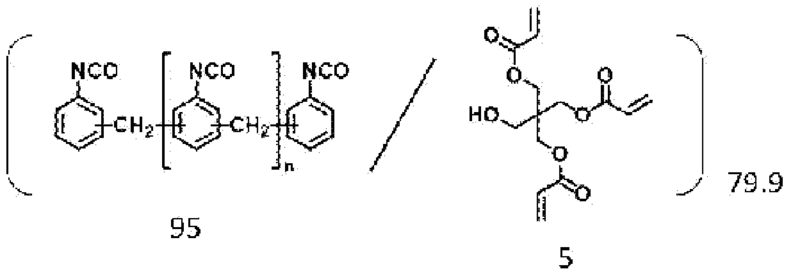

79.9

95

5

Wall material B

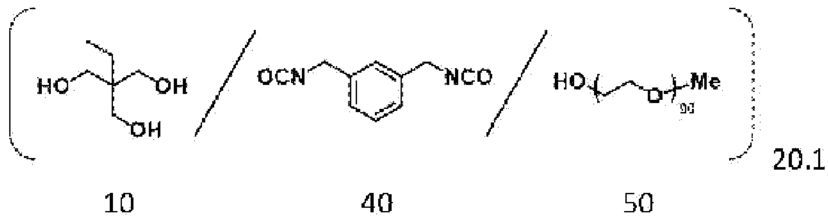

20.1

10 40 50

<Synthesis of resin particles R-8>

Resin particles R-8 were synthesized by the following method.

-Synthesis of wall material B-

A wall material B was synthesized by the same method as that used for synthesizing the wall material B in the resin particles R-7.

-Synthesis of wall material C-

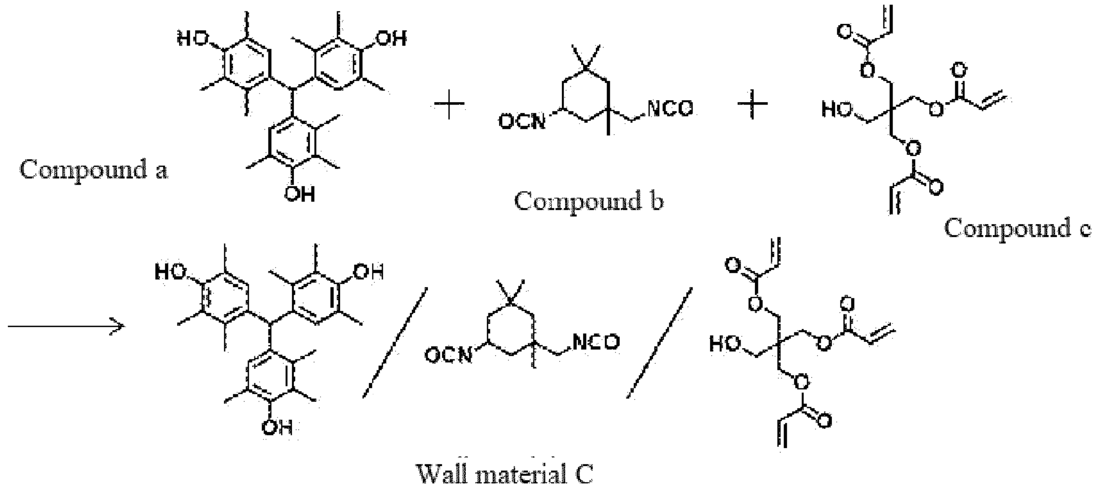

Compound a
Compound b
Compound c

Wall material C

The above compound a (2.375 g), 7.125 g of the above compound b, 0.5 g of the above compound c, and 10 g of ethyl acetate were added to a three-neck flask, and the solution was stirred at room temperature and then heated to 60°C.

Then, 0.05 g of NEOSTANN U-600 (manufactured by NITTO KASEI CO., LTD.) was added to the three-neck flask, and the reaction solution was heated and stirred for 3 hours. Thereafter, the reaction solution was cooled to room temperature, thereby obtaining a wall material C (solid content 50% by mass).

-Synthesis of wall material D-

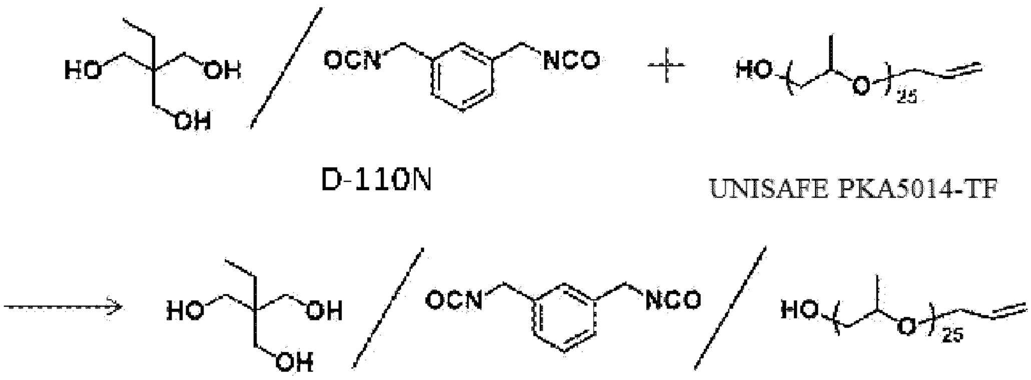

D-110N
UNISAFE PKA5014-TF

Wall material D

TAKENATE D-110N described above (manufactured by Mitsui Chemicals, Inc., 5.0 g), 5.0 g of UNISAFE PKA5014-TF described above (polypropylene glycol allyl ether, manufactured by NOF CORPORATION), and 10 g of ethyl acetate were added to a three-neck flask, stirred at room temperature, and then heated to 60°C.

Then, 0.05 g of NEOSTANN U-600 (manufactured by NITTO KASEI CO., LTD.) was added to the three-neck flask, and the reaction solution was heated and stirred for 3 hours. Thereafter, the reaction solution was cooled to room temperature, thereby obtaining a wall material D (solid content 50% by mass).

-Synthesis of resin particles R-8-

PIONIN A-41-C (manufactured by TAKEMOTO OIL & FAT Co., Ltd., 0.45 g), 14.99 g of the wall material C, 7.49 g of SR399E (manufactured by Sartomer Company Inc.), 1.89 g of the wall material B, 1.89 g of the wall material D, and 16.56 g of ethyl acetate were added to an aluminum cup, and stirred at room temperature.

Then, 46.89 g of pure water was added to the aluminum cup, and the reaction solution was stirred with a homogenizer at 12,000 rpm for 12 minutes. Thereafter, 16.64 g of pure water was further added, and the reaction solution was heated to 45°C and then heated and stirred for 4 hours.

Subsequently, 5.17 g of a 10% aqueous solution of U-CAT SA 102 (manufactured by San-Apro Ltd.) was added

thereto. Then, the container was put in a constant-temperature tank and aged for 48 hours, thereby obtaining a dispersion of the resin particles R-8 (solid content 20%).

The resin particles R-8 had an ethylenically unsaturated bond valence (that is, C=C valence) of 0.50 mmol/g.

Furthermore, the resin particles R-8 had a median diameter of 220 nm and a coefficient of variation of 29.3%.

The resin contained in the resin particles R-8 will be shown below.

In the following resins, the subscripts under each compound (monomer) and the subscripts at the right lower side of the parentheses represent the content ratio (mass ratio).

Wall material C

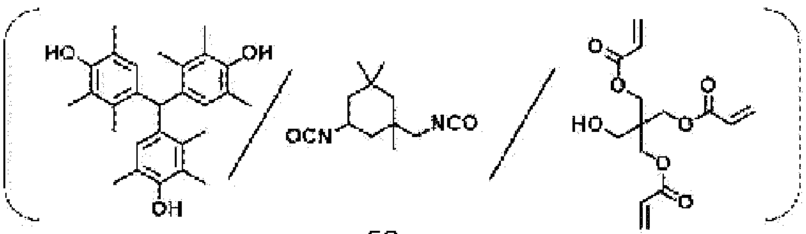

79.8

15 60 25

Wall material B

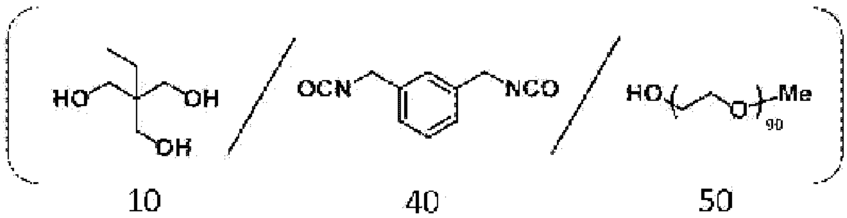

10.1

10 40 50

Wall material D

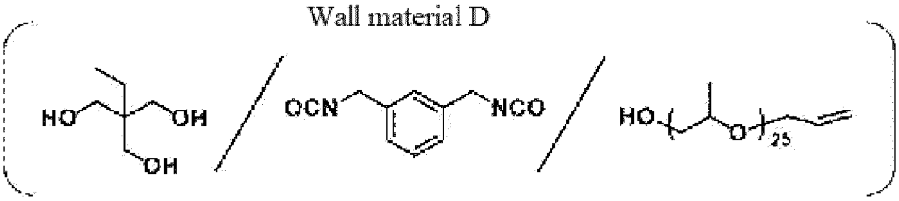

10.1

10 40 50

<Synthesis of resin particles R-9>

Resin particles R-9 were synthesized by the following method.

-Synthesis of wall material C-

A wall material C was synthesized by the same method as that used for synthesizing the wall material C in the resin particles R-8.

-Synthesis of wall material D-

A wall material D was synthesized by the same method as that used for synthesizing the wall material D in the resin particles R-8.

-Synthesis of resin particles (20)-

PIONIN A-41-C (manufactured by TAKEMOTO OIL & FAT Co., Ltd., 0.45 g), 14.99 g of the wall material C, 7.49 g of SR399E (manufactured by Sartomer Company Inc.), 3.78 g of the wall material D, and 16.56 g of ethyl acetate were added to an aluminum cup, and stirred at room temperature.

Then, 46.89 g of pure water was added to the aluminum cup, and the reaction solution was stirred with a homogenizer at 12,000 rpm for 12 minutes. Thereafter, 16.64 g of pure water was further added, and the reaction solution was heated to 45°C and then heated and stirred for 4 hours.

Subsequently, 5.17 g of a 10% aqueous solution of U-CAT SA 102 (manufactured by San-Apro Ltd.) was added thereto. Then, the container was put in a constant-temperature tank and aged for 48 hours, thereby obtaining a dispersion of the resin particles R-9 (solid content 20%).

The resin particles R-9 had an ethylenically unsaturated bond valence (that is, C=C valence) of 0.50 mmol/g.

Furthermore, the resin particles R-9 had a median diameter of 225 nm and a coefficient of variation of 28.7%.

The resin contained in the resin particles R-9 will be shown below.

In the following resins, the subscripts under each compound (monomer) and the subscripts at the right lower side of the parentheses represent the content ratio (mass ratio).

Wall material C

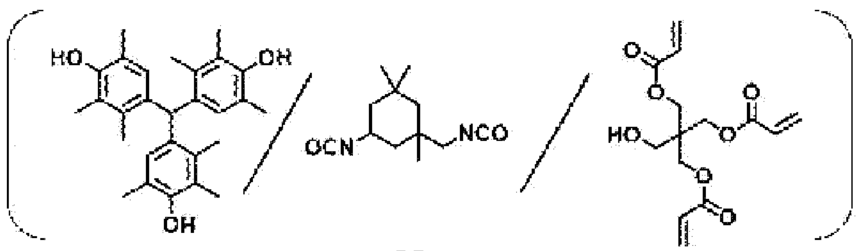

79.9

15 60 25

Wall material D

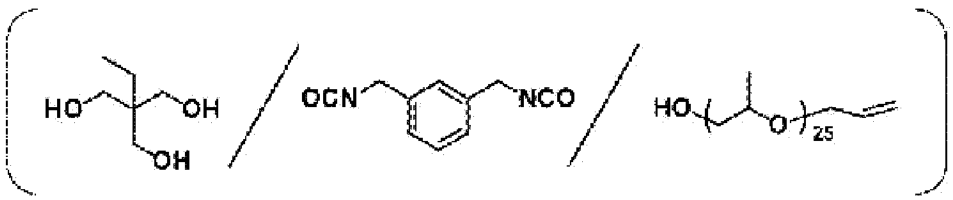

20.1

10 40 50

<Synthesis of resin particles R-10>

Resin particles R-10 were synthesized by the following method.

-Synthesis of wall material A-

A wall material A was synthesized by the same method as that used for synthesizing the wall material A in the resin particles R-7.

-Synthesis of wall material B-

A wall material B was synthesized by the same method as that used for synthesizing the wall material B in the resin particles R-7.

-Synthesis of wall material D-

A wall material D was synthesized by the same method as that used for synthesizing the wall material D in the resin particles R-8.

-Synthesis of resin particles R-10-

PIONIN A-41-C (manufactured by TAKEMOTO OIL & FAT Co., Ltd., 0.45 g), 14.99 g of the wall material A, 7.49 g of SR399E (manufactured by Sartomer Company Inc.), 1.89 g of the wall material B, 1.89 g of the wall material D, and 16.56

g of ethyl acetate were added to an aluminum cup, and stirred at room temperature.

Then, 46.89 g of pure water was added to the aluminum cup, and the reaction solution was stirred with a homogenizer at 12,000 rpm for 12 minutes. Thereafter, 16.64 g of pure water was further added, and the reaction solution was heated to 45°C and then heated and stirred for 4 hours.

Subsequently, 5.17 g of a 10% aqueous solution of U-CAT SA 102 (manufactured by San-Apro Ltd.) was added thereto. Then, the container was put in a constant-temperature tank and aged for 48 hours, thereby obtaining a dispersion of the resin particles R-10 (solid content 20%).

The resin particles R-10 had an ethylenically unsaturated bond valence (that is, C=C valence) of 0.50 mmol/g.

Furthermore, the resin particles R-10 had a median diameter of 190 nm and a coefficient of variation of 26.5%.

The resin contained in the resin particles R-10 will be shown below.

In the following resins, the subscripts under each compound (monomer) and the subscripts at the right lower side of the parentheses represent the content ratio (mass ratio). Me represents a methyl group.

Wall material A

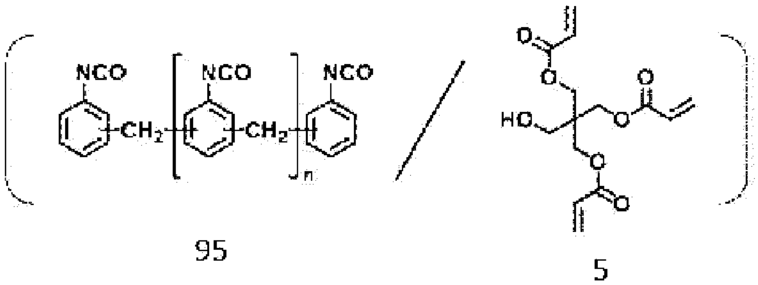

79.8

95 5

Wall material B

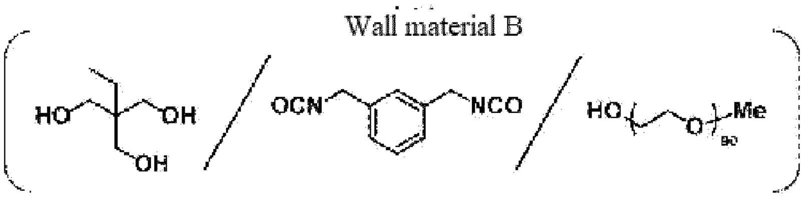

10.1

10 40 50

Wall material D

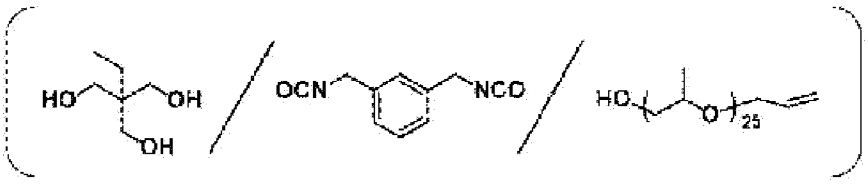

10.1

10 40 50

<Synthesis of resin particles R-11>

Resin particles R-11 were synthesized by the following method.

-Synthesis of wall material A-

A wall material A was synthesized by the same method as that used for synthesizing the wall material A in the resin particles R-7.

-Synthesis of wall material D-

A wall material D was synthesized by the same method as that used for synthesizing the wall material D in the resin particles R-8.

-Synthesis of resin particles R-11-

PIONIN A-41-C (manufactured by TAKEMOTO OIL & FAT Co., Ltd., 0.45 g), 14.99 g of the wall material A, 7.49 g of SR399E (manufactured by Sartomer Company Inc.), 3.78 g of the wall material D, and 16.56 g of ethyl acetate were added to an aluminum cup, and stirred at room temperature.

Then, 46.89 g of pure water was added to the aluminum cup, and the reaction solution was stirred with a homogenizer at 12,000 rpm for 12 minutes. Thereafter, 16.64 g of pure water was further added, and the reaction solution was heated to 45°C and then heated and stirred for 4 hours.

Subsequently, 5.17 g of a 10% aqueous solution of U-CAT SA 102 (manufactured by San-Apro Ltd.) was added thereto. Then, the container was put in a constant-temperature tank and aged for 48 hours, thereby obtaining a dispersion of the resin particles R-11 (solid content 20%).

The resin particles R-11 had an ethylenically unsaturated bond valence (that is, C=C valence) of 0.50 mmol/g.

Furthermore, the resin particles R-11 had a median diameter of 185 nm and a coefficient of variation of 29.5%.

The resin contained in the resin particles R-11 will be shown below.

In the following resins, the subscripts under each compound (monomer) and the subscripts at the right lower side of the parentheses represent the content ratio (mass ratio).

Wall material A

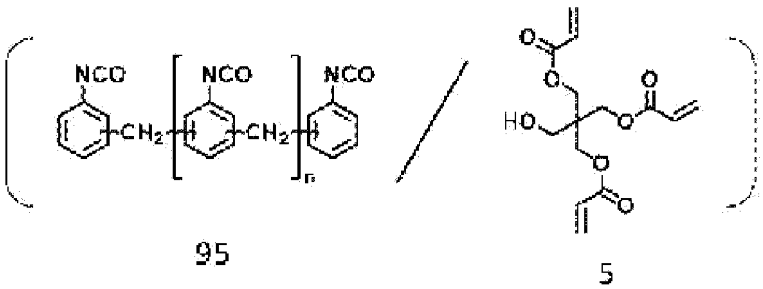

79.9

95 5

Wall material D

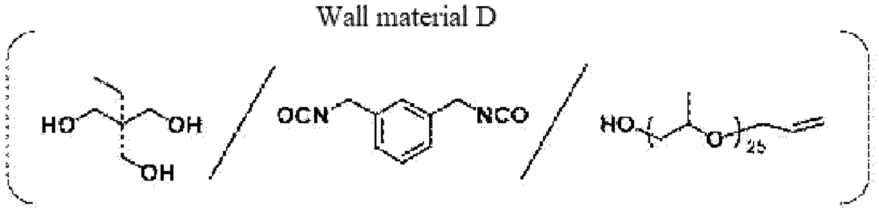

20.1

10 40 50

<Synthesis of resin particles R-12>

A microgel dispersion (solid content 20%) was obtained by the same method as in "Preparation of microgel" in the synthesis of the resin particles R-1.

The obtained microgel dispersion was used as a dispersion of resin particles R-12 (solid content: 20%).

The resin particles R-12 were resin particles encapsulating a monomer, and had an ethylenically unsaturated bond valence (that is, C=C valence) of 4.00 mmol/g.

The resin particles R-12 had a median diameter of 200 nm and a coefficient of variation of 30%.

<Synthesis of resin particles R-13>

-Preparation of oil-phase component-

Polymeric MDI WANNATE (registered trademark) PM-200 (polyfunctional isocyanate compound: manufactured by Wanhua Chemical Group Co., Ltd.): 6.66 g, a 50% by mass ethyl acetate solution of TAKENATE (registered trademark) D-116N (adduct of trimethylolpropane (TMP), m-xylylene diisocyanate (XDI), and polyethylene glycol monomethyl ether (EO90) (following structure)" manufactured by Mitsui Chemicals, Inc.: 5.46 g, a 65% by mass ethyl acetate solution of SR399 (dipentaerythritol pentaacrylate, manufactured by Sartomer Company Inc.): 11.24 g, ethyl acetate: 14.47 g, and PIONIN A-41-C (manufactured by TAKEMOTO OIL & FAT Co., Ltd.): 0.45 g were mixed together and stirred at room temperature (25°C) for 15 minutes, thereby obtaining an oil-phase component.

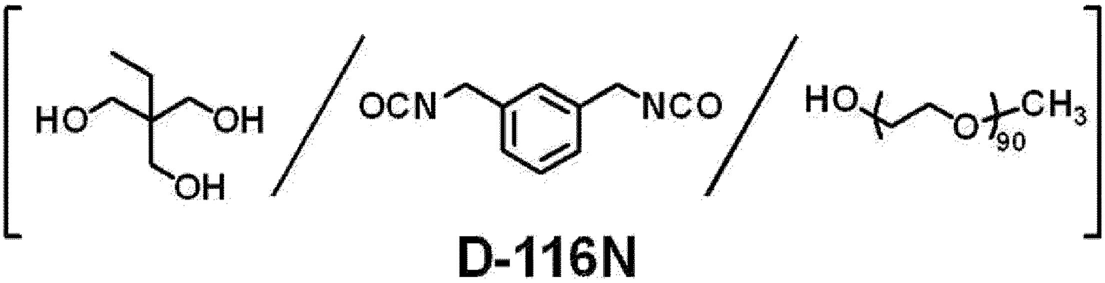

**D-116N**

-Preparation of water-phase component-

As a water-phase component, 47.2 g of distilled water was prepared.

-Formation of microcapsule-

The oil-phase component and the water-phase component were mixed together, and the obtained mixture was emulsified at 12,000 rpm for 16 minutes by using a homogenizer, thereby obtaining an emulsion.

Distilled water (16.8 g) was added to the obtained emulsion, and the obtained liquid was stirred at room temperature for 180 minutes.

After stirring, the liquid was heated at 45°C, and stirred for 5 hours in a state of being kept at 45°C so that ethyl acetate was distilled away from the liquid. Distilled water was added thereto so that the concentration of solid contents was adjusted to 20% by mass, thereby obtaining an aqueous dispersion of resin particles R-13.

The resin particles R-13 were microcapsules encapsulating a monomer and had an ethylenically unsaturated bond valence of 4.00 mmol/g.

The resin particles R-13 had a median diameter of 165 nm and a coefficient of variation of 32%.

<Preparation of support A>

(A-a) Alkaline etching treatment

An aqueous solution of caustic soda having a caustic soda concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 5 $g/m^2$.

(A-b) Desmutting treatment using aqueous acidic solution (first desmutting treatment)

Next, a desmutting treatment was performed using an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

(A-c) Electrochemical roughening treatment

Next, an electrochemical roughening treatment was performed using alternating current and an electrolytic solution having a hydrochloric concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride.

The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 $A/dm^2$ in terms of the peak current value of the alternating current waveform. In addition, the quantity of electricity was 450 $C/dm^2$ which was the total quantity of electricity used for the aluminum plate to have an anodic reaction, and the electrolysis treatment was performed 4 times by conducting electricity of 112.5 $C/dm^2$ for 4 seconds at each treatment session. A carbon electrode was used as the counter electrode of the aluminum plate. Then, a rinsing treatment was performed.

(A-d) Alkaline etching treatment

An aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/m$^2$. Then, a rinsing treatment was performed.

(A-e) Desmutting treatment using aqueous acidic solution

Next, a desmutting treatment was performed using an aqueous acidic solution. Specifically, the desmutting treatment was performed for 3 seconds by spraying the aqueous acidic solution onto the aluminum plate. In the desmutting treatment, an aqueous solution having a sulfuric acid concentration of 170 g/L and an aluminum ion concentration of 5 g/L was used as aqueous acidic solution. The liquid temperature was 30°C.

(A-f) Anodic oxidation treatment

By using an anodic oxidation treatment device 610 for direct current electrolysis having the structure shown in Fig. 5, an anodic oxidation treatment was performed to form an anodic oxide film.

The anodic oxidation treatment was performed under the conditions of a sulfuric acid concentration in the electrolytic solution of 170 g/L, an electrolytic solution temperature 50°C, a current density of 30 A/dm$^2$, and a film amount 2.4 g/m$^2$.

In the anodic oxidation treatment device 610 shown in Fig. 5, an aluminum plate 616 is transported as indicated by the arrow in Fig. 5. In a power supply tank 612 containing an electrolytic solution 618, the aluminum plate 616 is positively (+) charged by a power supply electrode 620. Then, the aluminum plate 616 is transported upwards by a roller 622 in the power supply tank 612, makes a turn downwards by a nip roller 624, then transported toward an electrolytic treatment tank 614 containing an electrolytic solution 626, and makes a turn by a roller 628 so as to move in the horizontal direction. Subsequently, the aluminum plate 616 is negatively (-) charged by an electrolysis electrode 630. As a result, an anodic oxide film is formed on the surface of the aluminum plate 616. The aluminum plate 616 exits from the electrolytic treatment tank 614 and is then transported for the next step. In the anodic oxidation device 610, the roller 622, the nip roller 624, and the roller 628 constitute a direction change unit. Furthermore, in the inter-tank portion between the power supply tank 612 and the electrolytic treatment tank 614, the aluminum plate 616 is transported in a ridge shape and an inverted U shape by the rollers 622, 624, and 628. The power supply electrode 620 and the electrolysis electrode 630 are connected to a direct current power source 634.

(A-g) Pore widening treatment

The aluminum plate having undergone the above anodic oxidation treatment was immersed in an aqueous solution of caustic soda at a temperature of 40°C and having a caustic soda concentration of 5% by mass and an aluminum ion concentration of 0.5% by mass for 3 seconds, thereby performing a pore widening treatment. Then, rinsing was performed by means of spraying.

The details of the obtained support A are as below.

Support A: average diameter of micropores within the surface of the anodic oxide film: 12 nm, value of brightness L* of the surface of the anodic oxide film in the L*a*b* color space: 81

<Preparation of support B>

An aluminum alloy plate made of a material 1S having a thickness of 0.3 mm was subjected to (A-a) Mechanical roughening treatment (brush grain method) to (A-i) Desmutting treatment in aqueous acidic solution described in paragraphs "0126" to "0134" of JP2012-158022A.

Then, an anodic oxide film was formed by performing (A-j) First-stage anodic oxidation treatment to (A-m) Third-stage anodic oxidation treatment described in paragraphs "0135" to "0138" of JP2012-158022A by appropriately adjusting the treatment conditions, and the obtained support was used as a support B.

A rinsing treatment was performed between all the treatment steps. After the rinsing treatment, water was drained using a nip roller.

The details of the obtained support are as below.

Support B: value of brightness L* of surface of anodic oxide film in L*a*b* color space: 83, average diameter of large diameter portion of micropores within surface of oxide film: 35 nm (depth 100 nm), average diameter of small diameter portion of micropores at communication position: 10 nm (depth 1,000 nm), ratio of depth of large diameter portion to average diameter of large diameter portion: 2.9

<Preparation of support C>

(C-a) Alkaline etching treatment

From a spray tube, an aqueous solution of caustic soda having a caustic soda (sodium hydroxide) concentration of 26% by mass and an aluminum ion concentration of 6.5% by mass was sprayed onto the aluminum plate at a temperature of 70°C, thereby performing an etching treatment. Then, rinsing was performed by means of spraying. The amount of dissolved aluminum within the surface to be subjected to the electrochemical roughening treatment later was 1.0 g/$m^2$.

(C-b) Desmutting treatment in aqueous acidic solution (first desmutting treatment)

Next, a desmutting treatment was performed in an aqueous acidic solution. In the desmutting treatment, a 150 g/L aqueous sulfuric acid solution was used as the aqueous acidic solution. The liquid temperature was 30°C. The desmutting treatment was performed for 3 seconds by spraying the desmutting liquid. Then, a rinsing treatment was performed.

(C-c) Electrochemical roughening treatment in aqueous hydrochloric acid solution

Next, an electrolytic roughening treatment was performed using alternating current and an electrolytic solution having a hydrochloric acid concentration of 14 g/L, an aluminum ion concentration of 13 g/L, and a sulfuric acid concentration of 3 g/L. The liquid temperature of the electrolytic solution was 30°C. The aluminum ion concentration was adjusted by adding aluminum chloride. The waveform of the alternating current was a sine wave in which positive and negative waveforms are symmetrical, the frequency was 50 Hz, the ratio of the anodic reaction time and the cathodic reaction time in one cycle of the alternating current was 1:1, and the current density was 75 A/$dm^2$ in terms of the peak current value of the alternating current waveform. In addition, the quantity of electricity was 450 C/$dm^2$ which is the total quantity of electricity used for the aluminum plate to have an anodic reaction, and the electrolysis treatment was performed 4 times by conducting electricity of 125 C/$dm^2$ for 4 seconds at each treatment session. A carbon electrode was used as the counter electrode of the aluminum plate. Then, a rinsing treatment was performed.

(C-d) Alkaline etching treatment

From a spray tube, an aqueous solution of caustic soda having a caustic soda concentration of 5% by mass and an aluminum ion concentration of 0.5% by mass was sprayed onto the aluminum plate having undergone the electrochemical roughening treatment at a temperature of 45°C, thereby performing an etching treatment. The amount of dissolved aluminum within the surface having undergone the electrochemical roughening treatment was 0.2 g/$m^2$. Then, a rinsing treatment was performed.

(C-e) Desmutting treatment in aqueous acidic solution

Next, a desmutting treatment was performed in an aqueous acidic solution. In the desmutting treatment, a waste liquid generated in the anodic oxidation treatment step (170 g/L aqueous sulfuric acid solution containing dissolved aluminum ions at 5.0 g/L) was used as an aqueous acidic solution. The liquid temperature was 30°C. The desmutting treatment was performed for 3 seconds by spraying the desmutting liquid.

(C-f) First-stage anodic oxidation treatment

By using the anodic oxidation treatment device for direct current electrolysis having the structure shown in Fig. 5, a first-stage anodic oxidation treatment was performed. Specifically, the anodic oxidation treatment was performed under the conditions described in the column of "First anodic oxidation treatment" shown in Table 1, thereby forming an anodic oxide film having a predetermined film amount.

(C-g) Pore widening treatment

The aluminum plate having undergone the above anodic oxidation treatment was immersed in an aqueous solution of caustic soda at a temperature of 35°C and having a caustic soda concentration of 5% by mass and an aluminum ion concentration of 0.5% by mass under the conditions shown in the following Table 1, thereby performing a pore widening treatment. Then, rinsing was performed by means of spraying.

(C-h) Second-stage anodic oxidation treatment

By using the anodic oxidation treatment device for direct current electrolysis having the structure shown in Fig. 5, a second-stage anodic oxidation treatment was performed. Specifically, the anodic oxidation treatment was performed under the conditions described in the column of "Second anodic oxidation treatment" shown in the following Table 1, thereby forming an anodic oxide film having a predetermined film amount.

Through the above treatments, a support C was obtained.

For the obtained support C, Table 2 shows the brightness L* of the micropores within the surface of the anodic oxide film in the L*a*b* color space, the average diameter of the large diameter portion within the surface of the anodic oxide film having micropores, the average diameter (nm) of the small diameter portion at a communication position, the depth (nm) of the large diameter portion and the small diameter portion, the pit density (micropore density, unit; number of micropores/μ$m^2$), and the film amount (nm) of the anodic oxide film from the bottom portion of the small diameter portion to the surface of the aluminum plate.

In Table 1, the film amount in the column of "First anodic oxidation treatment" and the film amount in the column of "Second anodic oxidation treatment" represent the film amount obtained by each treatment. As electrolytic solutions, the aqueous solutions containing the liquid components in Table 1 were used.

[Table 1]

<table>
<tr><td rowspan="10">Support C</td><td colspan="7">First anodic oxidation treatment</td></tr>
<tr><td>Liquid type</td><td>Liquid component</td><td>Component concentration (g/L)</td><td>Temperature (°C)</td><td>Current density (Å/$dm^2$)</td><td>Time (s)</td><td>Film amount (g/$m^2$)</td></tr>
<tr><td>Sulfuric acid</td><td>$H_2SO_4$/Al</td><td>170/5</td><td>40</td><td>8</td><td>4</td><td>0.25</td></tr>
<tr><td colspan="4">Pore widening treatment</td><td colspan="3" rowspan="3"></td></tr>
<tr><td colspan="2">Liquid type</td><td>Temperature (°C)</td><td>Time (s)</td></tr>
<tr><td colspan="2">NaOH5%/Al0.5%</td><td>35</td><td>3</td></tr>
<tr><td colspan="7">Second anodic oxidation treatment</td></tr>
<tr><td>Liquid type</td><td>Liquid component</td><td>Component concentration (g/L)</td><td>Temperature (°C)</td><td>Current density (Å/$dm^2$)</td><td>Time (s)</td><td>Film amount (g/$m^2$)</td></tr>
<tr><td>Sulfuric acid</td><td>$H_2SO_4$/Al</td><td>170/5</td><td>50</td><td>13</td><td>25</td><td>3.35</td></tr>
</table>

[Table 2]

| Support | Large diameter portion | | | Small diameter portion | | | Density of micropores (number/$\mu m^2$) | Film thickness (nm) | Brightness L* |
|---|---|---|---|---|---|---|---|---|---|
| | Average diameter (nm) | Shape | Depth (nm) | Average diameter of communication position (nm) | Shape | Depth (nm) | | | |
| C | 26 | Straight tubular | 100 | 10 | Straight tubular | 1,400 | 1,080 | 1,500 | 78 |

<Preparation of support D>

-Alkaline etching treatment-

An aqueous solution of caustic soda having a caustic soda concentration of 26% by mass and an aluminum ion concentration of 6.5% by mass was sprayed onto the aluminum plate at a temperature of 55°C, thereby performing an etching treatment. Then, rinsing was performed by means of spraying. The amount of dissolved aluminum within the surface to be subjected to the electrochemical roughening treatment later was 3 g/$m^2$.

-Desmutting treatment using aqueous acidic solution (first desmutting treatment)-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Electrochemical roughening treatment-

Next, an electrochemical roughening treatment was performed using an electrolytic solution at a hydrochloric acid concentration and alternating current. The liquid temperature of the electrolytic solution was 40°C. The waveform of the alternating current was a sine wave in which the positive and negative waveforms are symmetrical, and the frequency was 50 Hz. The quantity of electricity was 300 C/$dm^2$, which is the total quantity of electricity that the aluminum plate stores during the anodic reaction. A carbon electrode was used as the counter electrode of the aluminum plate. Then, a rinsing treatment was performed.

-Alkaline etching treatment-

An aqueous solution of caustic soda having a caustic soda concentration of 5% by mass and an aluminum ion concentration of 0.5% by mass was sprayed onto the aluminum plate having undergone the electrochemical roughening treatment at a temperature of 35°C so that an etching amount was 0.1 g/$m^2$ or less, thereby performing an etching treatment. Then, a rinsing treatment was performed.

-Desmutting treatment using aqueous acidic solution-

Next, a desmutting treatment was performed using an aqueous acidic solution. In the desmutting treatment, a 170 g/L aqueous sulfuric acid solution was used as the aqueous acidic solution. The liquid temperature was 30°C. The desmutting treatment was performed for 3 seconds by spraying the aqueous acidic solution onto the aluminum plate. Then, a rinsing treatment was performed.

-Anodic oxidation treatment-

An anodic oxidation treatment was performed using 170 g/L of a sulfuric acid solution and direct current at a liquid temperature of 40°C so that the amount of the anodic oxide film was 3 g/$m^2$.

Through the above treatments, a support D was obtained.

In each support, the average diameter of the micropores (average diameter of the large diameter portion and the small diameter portion) is a value obtained by observing the surface of the large diameter portion and the surface of the small diameter portion with FE-SEM at 150,000X magnification (N= 4), and measuring the diameters of the micropores (large diameter portion and small diameter portion) in a range of 400 nm × 600 nm in the obtained 4 images, and calculating the average thereof. In a case where the large diameter portion was deep, it was difficult to measure the diameter of the small diameter portion, and the diameter of an enlarged portion in the small diameter portion needed to be measured, the upper portion of the anodic oxide film was cut, and then various diameters were calculated.

In each support, the depth of the micropores (depth of the large diameter portion and the small diameter portion) is a value obtained by observing the cross section of the support (anodic oxide film) with FE-SEM (observation of the depth of the large diameter portion: 150,000X magnification, observation of depth of small diameter portion: 50,000X magnification), measuring the depths of 25 random micropores in the obtained image, and calculating the average thereof.

[Examples 1 to 25 and Comparative Examples 1 to 5]

<Preparation of lithographic printing plate precursor>

The lithographic printing plate precursors of Examples 1 to 25 and Comparative Examples 1 to 5 were prepared by the following method.

<Formation of undercoat layer>

Each of the supports described in Table 3 to Table 5 was coated with a coating solution (1) for an undercoat layer having the following composition so that the dry coating amount was 20 $mg/m^2$, followed by drying, thereby forming an undercoat layer.

-Coating solution (1) for undercoat-

·Polymer (U-1) [the following structure]: 0.18 parts
·Hydroxyethyl iminodiacetic acid: 0.10 parts
·Water: 61.4 parts

(U-1)

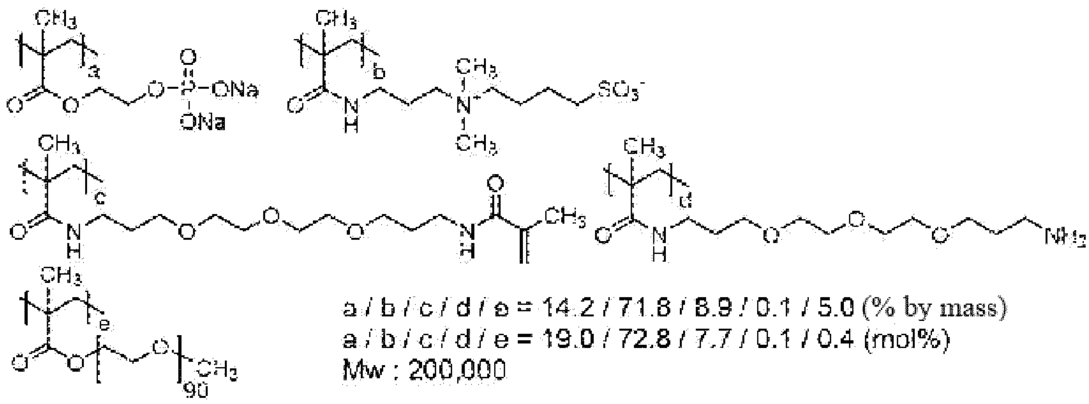

a / b / c / d / e = 14.2 / 71.8 / 8.9 / 0.1 / 5.0 (% by mass)
a / b / c / d / e = 19.0 / 72.8 / 7.7 / 0.1 / 0.4 (mol%)
Mw : 200,000

<Formation of image-recording layer>

According to the following Coating solution (1) for image-recording layer and Table 3 to Table 5, a coating solution for an image-recording layer was prepared. The content of each compound shown in Table 3 to Table 5 is amount of solid content (part by mass).

A photosensitive solution obtained by mixing together the components described in the following Coating solution (1) for image-recording layer other than resin particles and a dispersion containing each resin particles synthesized in the synthesis examples described above were mixed together immediately before coating so that the compositions described in Table 3 to Table 5 were obtained, and the obtained mixture was stirred, thereby preparing the coating solution for an image-recording layer containing resin particles.

The undercoat layer was coated with the coating solution (1) for an image-recording layer so that the dry coating amount was 959 $mg/m^2$, and dried, thereby forming an image-recording layer.

[Coating solution (1) for image-recording layer]

·Resin particles (resin particles described in Table 3 to Table 5): amount described in Table 3 to Table 5
·Compounds having ethylenically unsaturated group (compounds described in Table 3 to Table 5): amount described in Table 3 to Table 5
·Electron-accepting polymerization initiator (compound described in Table 3 to Table 5): amount described in Table 3 to Table 5
·Electron-donating polymerization initiator (compound described in Table 3 to Table 5): amount described in Table 3 to

Table 5
·Infrared absorber (compound described in Table 3 to Table 5): amount described in Table 3 to Table 5
·Binder polymer (compound described in Table 3 to Table 5): amount described in Table 3 to Table 5
·Color developing agent (compound described in Table 3 to Table 5): amount described in Table 3 to Table 5
·Oil sensitizing agent (compound described in Table 3 to Table 5): amount described in Table 3 to Table 5
·Low-molecular-weight hydrophilic compound (compound described in Table 3 to Table 5): amount described in Table 3 to Table 5
·The following mixed solvent: amount that yields a concentration of solid contents of 7% by mass

-Mixing ratio of mixed solvent-

·2-Butanone: 5 parts
·1-Methoxy-2-propanol: 4 parts
·Distilled water: 5 parts

<Formation of protective layer>

If necessary, the image-recording layer was bar-coated with a coating solution for a protective layer having the following composition and dried in an oven at 120°C for 60 seconds, thereby forming a protective layer having a dry coating amount of 0.15 g/$m^2$.
For an example in which the protective layer was formed, "Present" is written in the column of Protective layer in Table 3 to Table 5.

[Coating solution for protective layer]

·Inorganic lamellar compound dispersion (1) [described below]: 1.5 g
·6% by mass aqueous solution of polyvinyl alcohol: 0.55 g
(CKS50 manufactured by NIHON GOSEI KAKO Co., Ltd., modified with sulfonic acid, saponification degree: 99 mol% or higher, degree of polymerization: 300)
·6% by mass aqueous solution of polyvinyl alcohol: 0.03 g
(PVA-405, manufactured by KURARAY CO., LTD., saponification degree: 81.5 mol%, polymerization degree: 500)
·1% by mass aqueous solution of surfactant: 0.86 g
(polyoxyethylene lauryl ether, EMALEX 710 (registered trademark), manufactured by NIHON EMULSION Co., Ltd.)
·Deionized water: 6.0 g

[Preparation of inorganic lamellar compound dispersion (1)]

Synthetic mica (SOMASIF ME-100 manufactured by Co-op Chemical Co., Ltd.) (6.4 g) was added to 193.6 g of deionized water and was dispersed using a homogenizer until the average particle diameter (the laser scattering method) reached 3 μm. The aspect ratio of the obtained dispersed particles was 100 or higher.

<Evaluation of lithographic printing plate precursor>

By using Magnus 800 Quantum (platesetter) manufactured by Kodak Japan Ltd. that was equipped with an infrared semiconductor laser, the lithographic printing plate precursor prepared as above was exposed under the conditions of output of 27 W, an outer drum rotation speed of 450 rpm, and a resolution of 2,400 dpi (dot per inch, 1 inch is equal to 2.54 cm) (irradiation energy equivalent to 110 mJ/$cm^2$).
The exposure image included a solid image and a 3% halftone dot chart of Amplitude Modulation Screen (AM screen).

(1) UV printing durability

The exposed precursor obtained as above was mounted on a Kikuban-sized (636 mm × 939 mm) cylinder of a printer SX-74 manufactured by Heidelberger Druckmaschinen AG without being developed. This printer was connected to

a 100 L-capacity dampening water circulation tank having a non-woven fabric filter and a temperature control device. A circulation device was filled with 80 L of dampening water containing 2.0% by mass of dampening water S-Z1 (manufactured by FUJIFILM Corporation), and an ultraviolet-curable ink T&K UV OFS K-HS black GE-M (manufactured by T&K TOKA CO., LTD.) was used as printing ink. The dampening water and ink were supplied by a standard automatic printing start method, and then printing was performed TOKUBISHI art paper (ream weight: 76.5 kg, manufactured by MITSUBISHI PAPER MILLS LIMITED.) at a printing rate of 10,000 sheets/hour.

As the number of sheets of printed matter increased, the image area gradually wore, and thus the ink density on the printed matter decreased. For the AM screen 3% halftone dots in the printed matter, the area ratio of the halftone dots was measured using a Gretag density meter (manufactured by GretagMacbeth). When the measured area ratio was 1% lower than the area ratio measured after 500 sheets were printed, the number of prints at that point in time was adopted as the number of sheets of completely printed paper and used for evaluating printing durability. The evaluation was based on relative printing durability to 100 which represents the printing durability of a lithographic printing plate precursor capable of printing 50,000 sheets. The higher the numerical value, the better the printing durability.

Relative printing durability = (number of sheets of printed matter obtained from subject lithographic printing plate precursor)/50,000 $\times$ 100

(2) UV plate missing

A piano wire (ESCO CO., LTD.) having a diameter of 0.4 mm was attached to the halftone dot portion of the exposed precursor obtained as above in the direction perpendicular to the rotation direction of the plate cylinder, and the precursor was mounted on the Kikuban-sized cylinder of printer SX-74 manufactured by Heidelberger Druckmaschinen AG without being subjected to a development treatment. This printer was connected to a 100 L-capacity dampening water circulation tank having a non-woven fabric filter and a temperature control device. A circulation device was filled with dampening water (80 L) containing 2.0% dampening water S-Z1 (manufactured by FUJIFILM Corporation), and T&K UV OFS K-HS black GE-M (manufactured by T&K TOKA CO., LTD.) was used as printing ink. The dampening water and ink were supplied by a standard automatic printing start method, and then printing was performed on TOKUBISHI art paper (manufactured by MITSUBISHI PAPER MILLS LIMITED., ream weight: 76.5 kg) at a printing rate of 10,000 sheets/hour.

When the number of printing sheets reached 2,000, the piano wire was removed from the plate, the plate was set in the printer again, and printing was started. For the 100th printed matter obtained after the resumption of printing, the image area corresponding to the position to which the piano wire was attached was observed, and whether defective sticking occurred was visually checked using 50x magnifying glass. Then, printing was continued, and for every 2,000th printed matter, the image area was checked in the same manner as described above. The evaluation ended at the stage where defective sticking occurred or the number of printing sheets exceeded 40,000 from the start of checking of defective sticking.

The evaluation score for plate missing was calculated by the following equation. That is, the higher the evaluation score, the less likely it is that plate missing will occur. The highest evaluation score is "20".

$$\text{Evaluation score} = (\text{number of printing sheets at the end of evaluation})/2{,}000$$

(3) On-press developability

Printing was performed on 500 sheets in the same manner as in the evaluation of UV printing durability described above.

During the on-press development described above, the number of printing papers used until no ink was transferred to a non-image area was measured as the on-press developability. It can be said that the smaller the number of printing papers, the better the on-press developability.

In a case where development could not be performed at a point in time when 100 printing papers were used, "100 or more" was written in tables.

(4) Visibility (color developability)

In Trendsetter 3244VX manufactured by CREO CO., LTD. that was equipped with a water cooling-type 40 W infrared semiconductor laser, each of the obtained lithographic printing plate precursors was exposed under the conditions of an output of 11.5 W, an outer drum rotation speed of 220 rpm, and a resolution of 2,400 dpi. The exposure was carried out in an environment of 25°C and 50% RH.

The color development of the lithographic printing plate precursor was measured immediately after the exposure

and after 2 hours of storage in a dark place (25°C) after exposure. The measurement was performed by the specular component excluded (SCE) method by using a spectrocolorimeter CM2600d and operation software CM-S100W manufactured by Konica Minolt, Inc. The color developability was evaluated by a difference ΔL between an L* value of the exposed portion and an L* value of the non-exposed portion by using L* values (brightness) of the L*a*b* color space. The higher the value of ΔL, the better the color developability.

(5) Residues of on-press development

As soon as printing was performed to evaluate UV printing durability described above, the state where the removed residues adhered to the dampening roller was evaluated. In this way, the development residues generated during on-press development were evaluated.
The indicators are as follows. The larger the value, the further the development residues are suppressed.

5: No residue is found on the dampening roller.
4: Few residues are found on the dampening roller.
3: Residues are found on the dampening roller.
2: Many residues are found on the dampening roller.
1: There are so many residues found on the dampening roller.

The results of the above evaluation are shown in the following Table 3 to Table 5.
In Table 3 to Table 5, "C=C group" refers to "ethylenically unsaturated group" and "C=C valence" refers to "ethylenically unsaturated bond valence"

[Table 3]

| | | | Example | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| Support | | | A | A | A | A | A | A | B | A | A | A | B |
| Solid content of coating solution of image-recording layer [part by mass] | Resin particles | R-1 | - | - | - | - | - | - | - | - | - | - | - |
| | | R-2 | - | - | - | - | - | - | - | - | - | - | - |
| | | R-3 | 500 | 400 | 200 | 100 | - | - | 150 | 500 | - | - | - |
| | | R-4 | - | - | - | - | - | - | - | - | 300 | - | - |
| | | R-5 | - | - | - | - | - | - | - | - | - | 200 | - |
| | | R-6 | - | - | 200 | 300 | 400 | 400 | 150 | - | - | - | 400 |
| | Compound having C=C group | M-1 | - | - | - | - | - | - | 200 | - | 200 | - | - |
| | | M-2 | - | - | - | - | - | - | - | - | - | 150 | - |
| | | M-3 | - | - | - | - | - | - | - | - | 200 | - | - |
| | | M-4 | 200 | 200 | 200 | 200 | 200 | 150 | - | - | - | 150 | - |
| | | M-5 | - | - | - | - | - | - | - | - | - | - | 400 |
| | | M-6 | - | - | - | - | - | - | 200 | - | - | 20 | - |
| | Electron-accepting polymerization initiator | I-1 | 120 | 120 | 120 | 120 | 120 | 120 | - | 128 | - | - | 123 |
| | | I-2 | - | - | - | - | - | - | 83 | - | 175 | 126 | - |
| | | I-3 | - | - | - | - | - | - | - | - | - | - | - |
| | | I-4 | - | - | - | - | - | - | - | - | - | - | - |
| | Electron-donating polymerization initiator | B-1 | 40 | 40 | 40 | 40 | 40 | 40 | - | - | - | - | 12 |
| | | B-2 | - | - | - | - | - | - | 12 | 24 | 41 | - | - |
| | | B-3 | - | - | - | - | - | - | - | - | - | - | 24 |
| | | B-4 | - | - | - | - | - | - | - | - | - | 17 | - |
| | Infrared absorber | D-1 | 45 | 45 | 45 | 45 | 45 | 45 | - | - | - | - | - |
| | | D-2 | - | - | - | - | - | - | 45 | 16 | 49 | - | 15 |
| | | D-3 | - | - | - | - | - | - | - | - | - | 48 | 20 |
| | | D-4 | - | - | - | - | - | - | - | - | - | - | - |

(continued)

| | | | Example | | | | | | | | | | |
|---|---|---|---|---|---|---|---|---|---|---|---|---|---|
| | | | 1 | 2 | 3 | 4 | 5 | 6 | 7 | 8 | 9 | 10 | 11 |
| Support | | | A | A | A | A | A | A | B | A | A | A | B |
| | | D-5 | - | - | - | - | - | - | - | - | - | - | - |
| | Binder polymer | P-1 | - | 100 | 100 | - | - | - | - | - | - | - | - |
| | | P-2 | - | - | - | - | - | - | - | - | - | - | - |
| | | P-3 | - | - | - | 100 | 100 | 150 | - | 100 | - | - | - |
| | Color developing agent | S-15 | 20 | 20 | 20 | 20 | 20 | 20 | - | - | - | - | 25 |
| | | S-2 | - | - | - | - | - | - | 34 | 55 | - | - | - |
| | | S-16 | - | - | - | - | - | - | - | - | 25 | - | - |
| | | S-14 | - | - | - | - | - | - | - | - | - | 44 | - |
| | Low-molecular-weigh hydrophilic compound | T-1 | - | - | - | - | - | - | 32 | - | - | 32 | - |
| | | T-2 | 30 | 30 | 30 | 30 | 30 | 30 | - | - | 80 | - | 80 |
| | | T-3 | - | - | - | - | - | - | - | 21 | - | 12 | - |
| | Oil sensitizing agent | C-1 | 10 | 10 | 10 | 10 | 10 | 10 | - | - | - | - | 20 |
| | | C-2 | - | - | - | - | - | - | - | 10 | - | - | - |
| | | C-3 | - | - | - | - | - | - | - | - | 15 | - | - |
| | Surfactant | F-781F | 4 | 4 | 4 | 4 | 4 | 4 | 4 | 4 | 4 | 4 | 4 |
| | Content [part by mass] | | 969 | 969 | 969 | 969 | 969 | 969 | 910 | 858 | 1089 | 803 | 1123 |
| | C=C valence [mmol/g] | | 3.58 | 3.19 | 2.55 | 2.20 | 1.88 | 1.50 | 2.95 | 2.53 | 3.98 | 3.43 | 4.38 |
| Protective layer | | | Absent | Absent | Absent | Absent | Absent | Absent | Absent | Absent | Absent | Absent | Present |
| Evaluation | UV printing durability | | 235 | 215 | 189 | 180 | 171 | 163 | 180 | 158 | 228 | 210 | 246 |
| | UV plate missing | | 20 | 20 | 19 | 18 | 15 | 14 | 12 | 12 | 20 | 19 | 19 |
| | On-press developability [sheets] | | 10 | 13 | 21 | 19 | 17 | 20 | 12 | 34 | 32 | 38 | 13 |
| | Visibility ($\Delta L$) | | 4.3 | 4.1 | 4.2 | 3.9 | 4.8 | 4.6 | 5.4 | 5.6 | 3.8 | 4.1 | 4.1 |
| | Residues of on-press development | | 1 | 2 | 1 | 1 | 1 | 2 | 1 | 1 | 1 | 2 | 1 |

[Table 4]

| | | | Example | | | | | | | | |
|---|---|---|---|---|---|---|---|---|---|---|---|
| | | | 12 | 13 | 14 | 15 | 16 | 17 | 18 | 19 | 20 |
| Support | | | A | A | B | A | A | A | A | A | A |
| Solid content of coating solution of image-recording layer [part by mass] | Resin particles | R-1 | - | 400 | 450 | 450 | - | - | - | - | - |
| | | R-5 | 200 | - | - | - | - | - | - | - | - |
| | | R-7 | - | - | - | - | 450 | - | - | - | - |
| | | R-8 | - | - | - | - | - | 450 | - | - | - |
| | | R-9 | - | - | - | - | - | - | 450 | - | - |
| | | R-10 | - | - | - | - | - | - | - | 450 | - |
| | | R-11 | - | - | - | - | - | - | - | - | 450 |
| | Compound having C=C group | M-1 | - | - | - | - | - | - | - | - | - |
| | | M-2 | 400 | - | - | - | - | - | - | - | - |
| | | M-3 | - | 400 | 153 | 153 | 153 | 153 | 153 | 153 | 153 |
| | | M-4 | - | - | 17 | 17 | 17 | 17 | 17 | 17 | 17 |
| | | M-5 | - | - | - | - | - | - | - | - | - |
| | | M-6 | - | - | - | - | - | - | - | - | - |
| | Electron-accepting polymerization initiator | I-1 | - | 105 | 132 | 132 | 132 | 132 | 132 | 132 | 132 |
| | | I-2 | 97 | 23 | - | - | - | - | - | - | - |
| | | I-3 | - | - | - | - | - | - | - | - | - |
| | | I-4 | - | - | - | - | - | - | - | - | - |
| | Electron-donating polymerization initiator | B-1 | - | 23 | 50 | 50 | 50 | 50 | 50 | 50 | 50 |
| | | B-2 | 41 | - | - | - | - | - | - | - | - |
| | | B-3 | - | - | - | - | - | - | - | - | - |
| | | B-4 | - | - | - | - | - | - | - | - | - |
| | Infrared absorber | D-1 | 24 | - | 26 | 26 | 26 | 26 | 26 | 26 | 26 |
| | | D-2 | - | - | - | - | - | - | - | - | - |
| | | D-3 | 30 | - | - | - | - | - | - | - | - |

(continued)

| | | | Example | | | | | | | | |
|---|---|---|---|---|---|---|---|---|---|---|---|
| | | | 12 | 13 | 14 | 15 | 16 | 17 | 18 | 19 | 20 |
| Support | | | A | A | B | A | A | A | A | A | A |
| | | D-4 | - | 40 | - | - | - | - | - | - | - |
| | | D-5 | - | - | - | - | - | - | - | - | - |
| | Binder polymer | P-1 | - | - | - | - | - | - | - | - | - |
| | | P-2 | - | 100 | - | - | - | - | - | - | - |
| | | P-3 | - | - | - | - | - | - | - | - | - |
| | Color developing agent | S-1 | - | - | 60 | - | - | 60 | - | - | - |
| | | S-4 | - | - | - | 60 | 60 | - | - | - | - |
| | | S-11 | 25 | - | - | - | - | - | 60 | - | - |
| | | S-10 | - | 39 | - | - | - | - | - | 60 | 60 |
| | Low-molecular-weigh hydrophilic compound | T-1 | - | - | - | - | - | - | - | - | - |
| | | T-2 | - | - | 6 | 6 | 6 | 6 | 6 | 6 | 6 |
| | | T-3 | - | - | - | - | - | - | - | - | - |
| | Oil sensitizing agent | C-1 | - | - | - | - | - | - | - | - | - |
| | | C-2 | - | - | - | - | - | - | - | - | - |
| | | C-3 | - | - | - | - | - | - | - | - | - |
| | Surfactant | F-781F | 4 | 4 | 4 | 4 | 4 | 4 | 4 | 4 | 4 |
| | Content [part by mass] | | 621 | 1134 | 898 | 898 | 898 | 898 | 898 | 898 | 898 |
| | C=C valence [mmol/g] | | 4.87 | 3.96 | 2.18 | 2.18 | 2.18 | 2.18 | 2.18 | 2.18 | 2.18 |
| Protective layer | | | Absent | Absent | Absent | Absent | Absent | Absent | Absent | Absent | Absent |
| Evaluation | UV printing durability | | 250 | 238 | 206 | 210 | 210 | 210 | 210 | 210 | 210 |
| | UV plate missing | | 18 | 20 | 18 | 17 | 17 | 17 | 17 | 17 | 17 |
| | On-press developability [sheets] | | 18 | 23 | 16 | 15 | 15 | 15 | 15 | 15 | 15 |
| | Visibility (ΔL) | | 8.0 | 9.0 | 12.8 | 11.5 | 12.4 | 11.6 | 8.2 | 7.8 | 7.8 |
| | Residues of on-press development | | 2 | 2 | 1 | 1 | 4 | 4 | 4 | 5 | 4 |

[Table 5]

| | | | Example | | | | | Comparative Example | | | | |
|---|---|---|---|---|---|---|---|---|---|---|---|---|
| | | | 21 | 22 | 23 | 24 | 25 | 1 | 2 | 3 | 4 | 5 |
| Support | | | A | B | A | B | A | A | A | B | A | B |
| Solid content of coating solution of image-recording layer [part by mass] | Resin particles | R-1 | - | - | - | - | - | 431 | - | - | 500 | - |
| | | R-2 | - | - | - | 200 | - | - | - | 330 | - | - |
| | | R-3 | - | 400 | 500 | 200 | 500 | - | 300 | - | - | - |
| | | R-4 | - | - | - | - | - | - | - | - | - | - |
| | | R-5 | 200 | - | - | - | - | - | - | - | - | 300 |
| | | R-6 | - | - | - | - | - | - | - | - | - | - |
| | Compound having C=C group | M-1 | - | - | - | - | - | 98 | - | - | - | - |
| | | M-2 | - | 140 | - | - | - | - | - | - | - | 50 |
| | | M-3 | - | - | - | 200 | - | - | 50 | 100 | - | - |
| | | M-4 | - | - | 200 | - | 200 | - | - | - | - | - |
| | | M-5 | 600 | - | - | - | - | - | - | - | - | - |
| | | M-6 | - | - | - | - | - | - | - | - | - | 100 |
| | Electron-accepting polymerization initiator | I-1 | - | - | - | - | - | - | 160 | - | 110 | - |
| | | I-2 | 80 | 106 | - | - | - | 184 | - | - | - | - |
| | | I-3 | - | - | 100 | - | 95 | - | - | - | - | 120 |
| | | I-4 | - | - | - | 100 | - | - | - | 100 | - | - |
| | Electron-donating polymerization initiator | B-1 | 20 | - | - | 20 | - | 9 | 40 | 20 | 49 | - |
| | | B-2 | - | - | - | - | 40 | - | - | - | - | - |
| | | B-3 | - | - | 100 | - | - | - | - | - | - | 60 |
| | | B-4 | - | 45 | - | - | - | - | - | - | - | - |
| | Infrared absorber | D-1 | - | - | - | - | - | - | 45 | - | - | - |
| | | D-2 | - | 32 | - | - | - | - | - | - | 18 | - |
| | | D-3 | - | - | - | - | - | 28 | - | - | - | 50 |
| | | D-4 | 24 | - | - | 40 | - | - | - | 40 | - | - |

(continued)

| | | | Example | | | | | Comparative Example | | | | |
|---|---|---|---|---|---|---|---|---|---|---|---|---|
| | | | 21 | 22 | 23 | 24 | 25 | 1 | 2 | 3 | 4 | 5 |
| Support | | | A | B | A | B | A | A | A | B | A | B |
| | | D-5 | - | - | 37 | - | 35 | - | - | - | - | - |
| | Binder polymer | P-1 | - | - | - | - | - | 173 | - | - | - | 200 |
| | | P-2 | - | - | - | - | - | - | - | - | - | - |
| | | P-3 | - | 100 | - | - | - | - | 250 | - | - | 100 |
| | Color developing agent | S-15 | - | - | 20 | - | 20 | - | 60 | - | - | - |
| | | S-2 | - | 20 | - | - | - | - | - | - | 31 | - |
| | | S-16 | - | - | - | 40 | - | - | - | 40 | - | - |
| | | S-14 | 30 | - | - | - | - | - | - | - | - | 28 |
| | Low-molecular-weigh hydrophilic compound | T- 1 | - | - | - | - | 20 | 29 | - | - | 5 | - |
| | | T-2 | - | - | 30 | - | - | 60 | 30 | - | - | - |
| | | T-3 | 40 | - | - | 20 | - | - | - | 20 | - | - |
| | Oil sensitizing agent | C-1 | - | - | 10 | - | - | 25 | 10 | - | - | 21 |
| | | C-2 | - | - | - | - | - | 23 | - | - | - | 23 |
| | | C-3 | - | - | - | - | 10 | 30 | - | - | 16 | 5 |
| | Surfactant | F-781F | 4 | 4 | 4 | 4 | 4 | 4 | 4 | 4 | 3 | 4 |
| | Total amount [part by mass] | | 998 | 847 | 1001 | 824 | 924 | 1094 | 949 | 654 | 732 | 1061 |
| | C=C valence [mmol/g] | | 7.01 | 3.49 | 3.46 | 3.50 | 3.75 | 0.88 | 1.27 | 1.59 | 0.34 | 1.02 |
| Protective layer | | | Absent | Absent | Absent | Absent | Absent | Present | Present | Absent | Absent | Absent |
| Evaluation | UV printing durability | | 255 | 245 | 200 | 213 | 230 | 155 | 160 | 80 | 120 | 60 |
| | UV plate missing | | 19 | 14 | 20 | 20 | 18 | 3 | 6 | 2 | 1 | 0 |
| | On-press developability [sheets] | | 9 | 21 | 36 | 12 | 39 | 32 | 35 | 13 | 17 | 80 |
| | Visibility ($\Delta L$) | | 3.7 | 5.9 | 3.9 | 3.3 | 4.5 | 1.1 | 4.5 | 3.6 | 5.0 | 3.4 |
| | Residues of on-press development | | 1 | 2 | 1 | 2 | 1 | 1 | 1 | 1 | 2 | 1 |

As is evident from the results shown in Table 3 to Table 5, the lithographic printing plate precursor according to the present invention has excellent UV printing durability and is unlikely to cause UV plate missing.

Particularly, it has been revealed that in a case where the lithographic printing plate precursor according to the present invention uses the resin particles R-7 to R-11 as in Examples 16 to 20, development residues are excellently suppressed during on-press development.

Furthermore, it has been revealed that in a case where the lithographic printing plate precursor according to the present invention uses the leuco colorants S-1 to S-4, S-11, and S-10 as in Examples 12 to 20, the visibility is particularly excellent.

In the coating solution (1) for an image-recording layer and the coating solution (2) for an image-recording layer, the following compounds were used.

[Compound having C=C group]

M-1: tris(acryloyloxyethyl) isocyanurate, C=C valence: 7.09 mmol/g, molecular weight: 423.38, C=C equivalent: 141 g/mol, A-9300 manufactured by SHIN-NAKAMURA CHEMICAL CO, LTD.
M-2: dipentaerythritol pentaacrylate, C=C valence: 9.53 mmol/g, molecular weight: 524.52, C=C equivalent: 105 g/mol, SR399 manufactured by Sartomer Company Inc.
M-3: dipentaerythritol hexaacrylate, C=C valence: 10.37 mmol/g, molecular weight: 578.57, C=C equivalent: 96 g/mol, A-DPH manufactured by SHIN-NAKAMURA CHEMICAL CO, LTD.
M-4: urethane acrylate oligomer, C=C valence: 7.22 mmol/g, molecular weight: 2,078.16, C=C equivalent: 1,839 g/mol, U-15HA manufactured by SHIN-NAKAMURA CHEMICAL CO, LTD.
M-5: pentaerythritol tetraacrylate, C=C valence: 11.35 mmol/g, molecular weight: 352.34, C=C equivalent: 88 g/mol, U-15HA manufactured by SHIN-NAKAMURA CHEMICAL CO, LTD.
M-6: polytetramethylene glycol diacrylate, C=C valence: 2.58 mmol/g, molecular weight: 775.07, C=C equivalent: 388 g/mol, A-PTMG-65 manufactured by SHIN-NAKAMURA CHEMICAL CO, LTD.

[Polymerization initiator]

(Electron-accepting polymerization initiator)

I-1 to I-4: compounds having the following structures
I-1 is an electron-accepting polymerization initiator having an organic anion that satisfies δd ≥ 16, δp = 16 to 32, and δh ≤ δp × 0.6 in the Hansen solubility parameters.

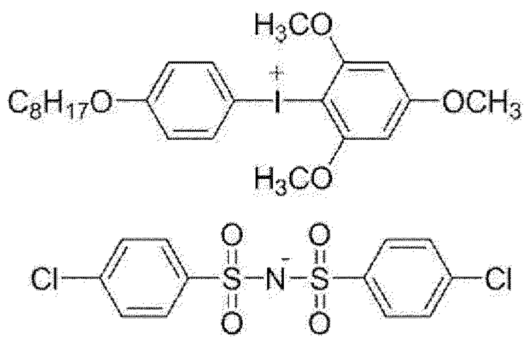

I - 1

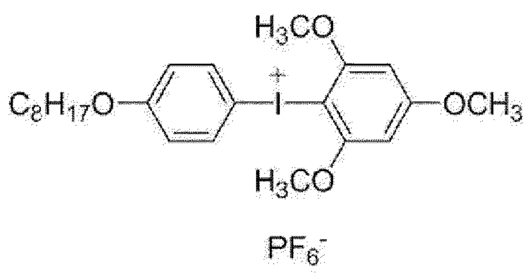

I - 2

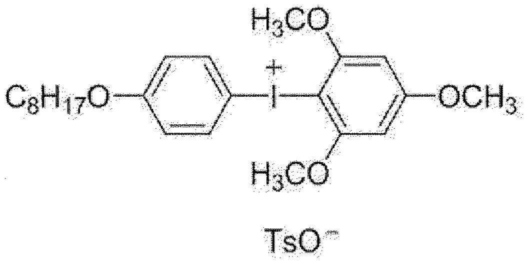

I - 3

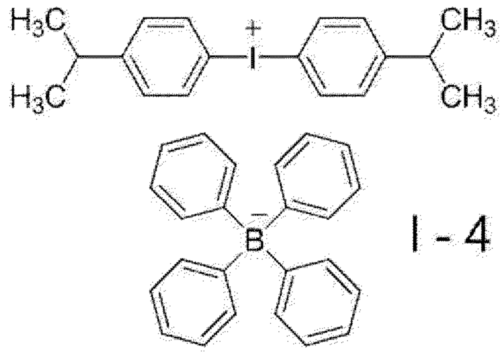

I - 4

(Electron-donating polymerization initiator)

B-1 to B-4: compounds having the following structures

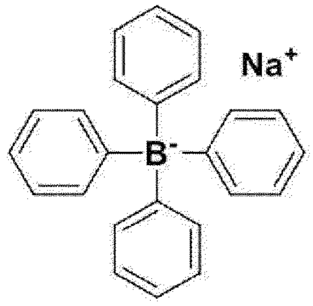

**B-1**

**HOMO = -5.92 eV**

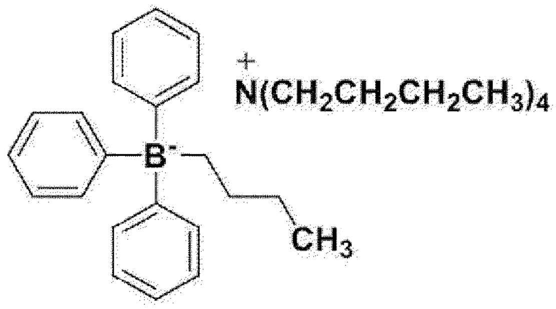

**B-2**

**HOMO = -5.77 eV**

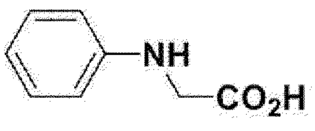

**B-3**

**HOMO = -5.91 eV**

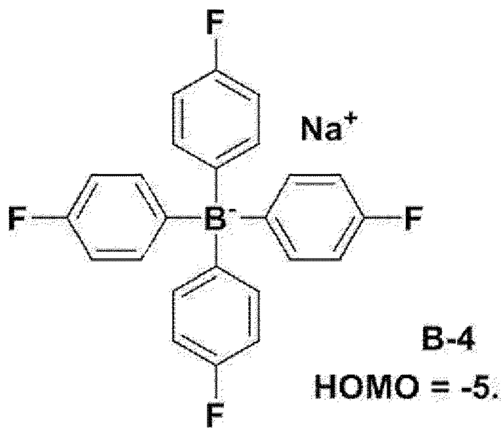

**B-4**

**HOMO = -5.96 eV**

[Infrared absorber]

D-1: Compound having the following structure, HOMO = -5.35 eV
D-2: Compound having the following structure, HOMO = -5.45 eV
D-3: Compound having the following structure, HOMO = -5.27 eV
D-4: Compound having the following structure, HOMO = -5.43 eV
D-5: Compound having the following structure, HOMO = -5.13 eV
D-1 is an infrared absorber having an organic anion that satisfies $\delta d \geq 16$, $\delta p = 16$ to 32, and $\delta h \leq \delta p \times 0.6$ in the Hansen solubility parameters.

D-1

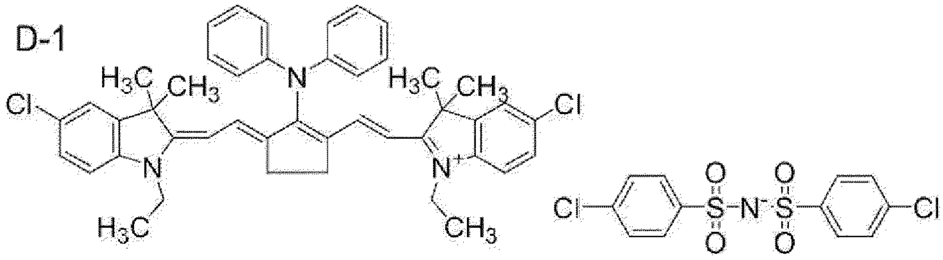

D-2

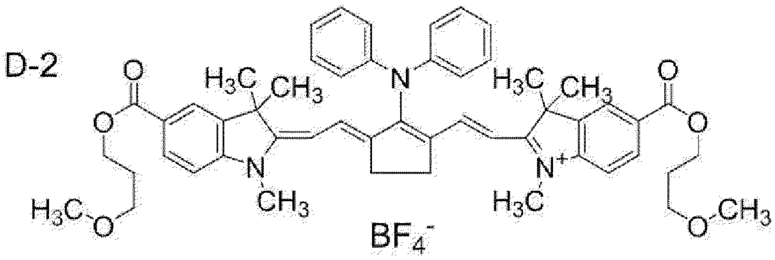

D-3

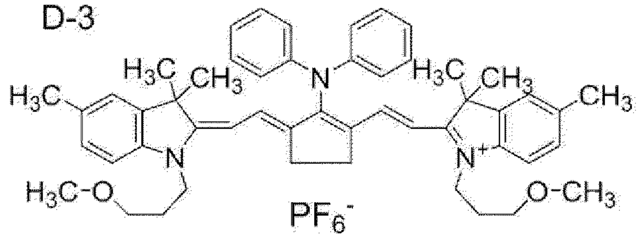

D-4

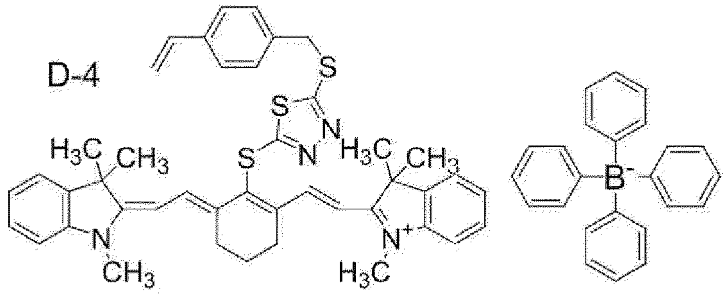

D-5

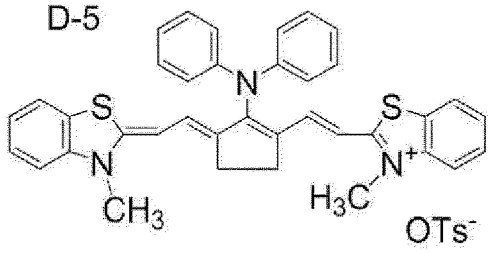

[Binder polymer]

P-1: Compound having the following structure (n = 2, weight-average molecular weight: 60,000, C=C valence: 0.33 mmol/g)

P-2: Compound having the following structure (n = 2, weight-average molecular weight: 35,000, C=C valence: 1.48 mmol/g)

P-3: Polymethylmethacrylate (PMMA), weight-average molecular weight: 120,000, C=C valence: 0 mmol/g, manufactured by Sigma-Aldrich Co LLC.

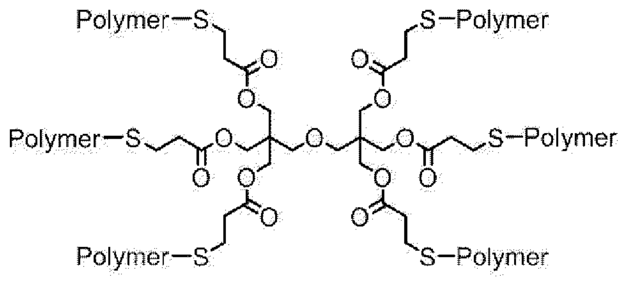

Polymer =

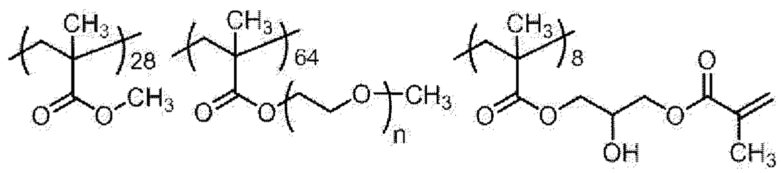

P-1

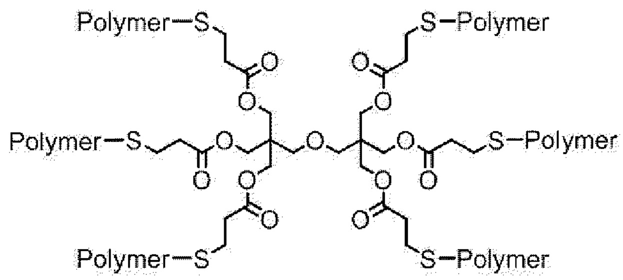

Polymer =

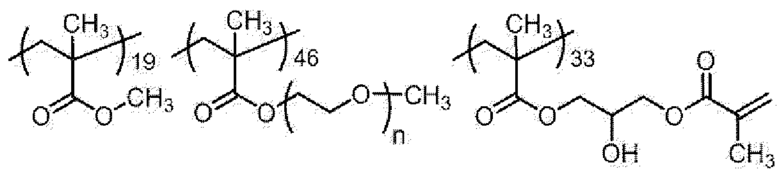

P-2

In the above structural formula, the content of each constitutional unit (subscript at the right lower side of the parentheses) represents the mass ratio.

[Color developing agent]

S-15: Leuco colorant (acid color-developing agent), S-205 manufactured by Fukui Yamada Chemical Co., Ltd.
S-2: Leuco colorant (acid color-developing agent), GN-169 manufactured by Yamamoto Chemicals, Inc.
S-16: Leuco colorant (acid color-developing agent), Black-XV manufactured by Yamamoto Chemicals, Inc.
S-14: Leuco colorant (acid color-developing agent), Red-40 manufactured by Yamamoto Chemicals, Inc.
S-1, S-4, S-11, and S-10: Specific examples of the above leuco colorants having phthalide structure or fluoran structure, the same compounds as S-1, S-4, S-11, and S-10 respectively

[Oil sensitizing agent]

C-1: Compound having the following structure
C-2: Benzyldimethyloctylammonium·$PF_6$ salt
C-3: Compound having the following structure

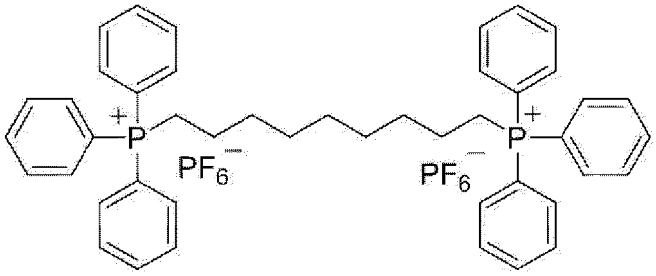

C - 1

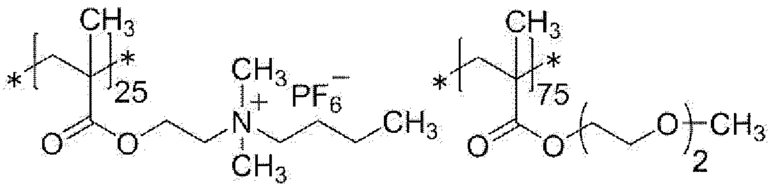

C - 3

[Low-molecular-weight hydrophilic compound]

T-1: Tris(2-hydroxyethyl) isocyanurate
T-2: The following compound
T-3: Hydroxypropyl cellulose, Klucel M, manufactured by Hercules Incorporated

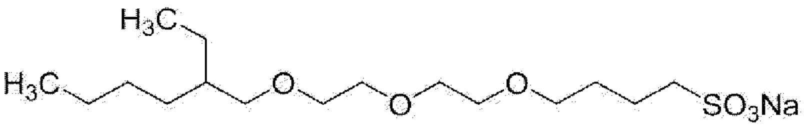

T - 2

[Surfactant]

F-781F: Fluorine-based surfactant, MEGAFACE F-781F, manufactured by DIC Corporation

[Examples 26 to 31]

Lithographic printing plate precursors of Examples 26 to 31 were prepared by the following method.

<Preparation of coating solutions (2) and (3) for undercoat layer>

Coating solutions (2) and (3) for an undercoat layer having the following compositions were prepared.

-Composition of coating solution (2) for undercoat layer-

·Polymer (U-1) [the above structure]: 0.18 parts
·Surfactant (EMALEX 710 (registered trademark), manufactured by NIHON EMULSION Co., Ltd.): 0.03 parts
·Water: 28.0 parts

-Composition of coating solution (3) for undercoat layer-

·Polymer (U-1) [the above structure]: 0.18 parts
·Surfactant (EMALEX 710 (registered trademark), manufactured by NIHON EMULSION Co., Ltd.): 0.03 parts
·Hydrophilic compound (compounds described in Table 6): amounts described in Table 6.
·Water: 28.0 parts

<Preparation of lithographic printing plate precursor>

The aforementioned support A was coated with a coating solution for an undercoat layer of the type described in Table 6 so that the dry coating amount was 20 mg/$m^2$, followed by drying, thereby forming an undercoat layer. The undercoat layer was coated with the coating solution (1) for an image-recording layer having the composition described in Table 6 (the coating solution containing the components described in Table 6, which was prepared using a mixed solvent of 2-butanone:1-methoxy-2-propanol (MFG):distilled water = 5:4:5 (mass ratio) so that the solid content was 7% by mass) so that the dry coating amount was 959 mg/$m^2$, followed by drying, thereby forming an image-recording layer.

The coating solution (1) for an image-recording layer was prepared by mixing and stirring together the resin particles immediately before coating.

(5) Evaluation of scratches and contamination suppression

In Luxel PLATESETTER T-6000III manufactured by FUJIFILM Corporation that was equipped with an infrared semiconductor laser, each of the obtained lithographic printing plate precursors was exposed under the conditions of an outer drum rotation speed of 1,000 rpm, a laser output of 70%, and resolution of 2,400 dpi. After the exposure treatment, the lithographic printing plate obtained in an environment of a temperature of 25°C and a humidity of 70% was scratched by a scratch tester.

As the scratch tester, HEIDON scratching Intersity TESTER HEIDEN-18 was used. In addition, a sapphire needle having a diameter of 0.1 mm was used, and the scratch load was 50 (g). Without being subjected to a development treatment, the scratched plate was mounted on the plate cylinder of DIA IF2 printer manufactured by Mitsubishi Heavy Industries, Ltd. By using dampening water containing IF102 (manufactured by FUJIFILM Corporation)/tap water = 3/97 (volume ratio) and Values-G (N) black ink (manufactured by DIC Corporation), on-press development was performed by supplying the dampening water and the ink according to the standard automatic printing start method of DIA IF2. Then, printing was performed using TOKUBISHI art paper (ream weight: 76.5 kg) at a printing rate of 10,000 sheets/hour, and whether the scratched portion turned into a printing stain was evaluated. In addition, regarding the intermediate points such as 9 points and 7 points, in a case the scratches and contamination of an example is at the intermediate level of the upper evaluation standard, the intermediate points were given to the example. The evaluation standards of 10 to 6 points are preferable. The results are shown in Table 6.

-Evaluation standard-

10: The scratched portion does not turn into a printing stain.
8: Slight printing stains that cannot be visually identified are observed on the scratched portion.
6: Slight printing stains are visually observed on the scratched portion.
4: Printing stains are visually observed on the scratched portion.
2: Noticeable printing stains are observed on the scratched portion.

[Table 6]

| | | | Example | | | | | |
|---|---|---|---|---|---|---|---|---|
| | | | 26 | 27 | 28 | 29 | 30 | 31 |
| Support | Type | | A | A | A | A | A | A |
| | Surface contact angle [°] | | 80 | 60 | 20 | 9 | 8 | 6 |
| Layer in contact with support (undercoat layer) | Type of coating solution for undercoat layer | | (2) | (3) | (3) | (3) | (3) | (3) |
| | Hydrophilic compound | Type | - | Ethylenediaminetetraacetic acid 4Na | Ethylenediaminetetraacetic acid 4Na | Tartaric acid 2K | Shikimic acid Na | Gluconic acid Na |
| | | Part by mass | - | 0.01 | 0.03 | 0.08 | 0.06 | 0.07 |
| Solid content of coating solution of image-recording layer [part by mass] | Resin particles | R-1 | - | - | - | - | - | - |
| | | R-5 | 200 | 200 | 200 | 200 | 200 | 200 |
| | | R-7 | - | - | - | - | - | - |
| | | R-8 | - | - | - | - | - | - |
| | | R-9 | - | - | - | - | - | - |
| | | R-10 | - | - | - | - | - | - |
| | | R-11 | - | - | - | - | - | - |
| | Compound having C=C group | M-1 | - | - | - | - | - | - |
| | | M-2 | 400 | 400 | 400 | 400 | 400 | 400 |
| | | M-3 | - | - | - | - | - | - |
| | | M-4 | - | - | - | - | - | - |
| | | M-5 | - | - | - | - | - | - |
| | | M-6 | - | - | - | - | - | - |
| | Electron-accepting polymerization initiator | I-1 | - | - | - | - | - | - |
| | | I-2 | 97 | 97 | 97 | 97 | 97 | 97 |
| | | I-3 | - | - | - | - | - | - |
| | | I-4 | - | - | - | - | - | - |

(continued)

| | | Example | | | | | |
|---|---|---|---|---|---|---|---|
| | | 26 | 27 | 28 | 29 | 30 | 31 |
| Electron-donating polymerization initiator | B-1 | - | - | - | - | - | - |
| | B-2 | 41 | 41 | 41 | 41 | 41 | 41 |
| | B-3 | - | - | - | - | - | - |
| | B-4 | - | - | - | - | - | - |
| Infrared absorber | D-1 | 24 | 24 | 24 | 24 | 24 | 24 |
| | D-2 | - | - | - | - | - | - |
| | D-3 | 30 | 30 | 30 | 30 | 30 | 30 |
| | D-4 | - | - | - | - | - | - |
| | D-5 | - | - | - | - | - | - |
| Binder polymer | P-1 | - | - | - | - | - | - |
| | P-2 | - | - | - | - | - | - |
| | P-3 | - | - | - | - | - | - |
| Color developing agent | S-1 | - | - | - | - | - | - |
| | S-4 | - | - | - | - | - | - |
| | S-11 | 25 | 25 | 25 | 25 | 25 | 25 |
| | S-10 | - | - | - | - | - | - |
| Low-molecular-weigh hydrophilic compound | T-1 | - | - | - | - | - | - |
| | T-2 | - | - | - | - | - | - |
| | T-3 | - | - | - | - | - | - |
| Oil sensitizing agent | C-1 | - | - | - | - | - | - |
| | C-2 | - | - | - | - | - | - |
| | C-3 | - | - | - | - | - | - |
| Surfactant | F-781F | 4 | 4 | 4 | 4 | 4 | 4 |
| Total amount [part by mass] | | 621 | 621 | 621 | 621 | 521 | 621 |
| C=C valence [mmol/g] | | 4.87 | 4.87 | 4.87 | 4.87 | 4.87 | 4.87 |

(continued)

| | Example | | | | | |
|---|---|---|---|---|---|---|
| | 26 | 27 | 28 | 29 | 30 | 31 |
| Protective layer | Absent | Absent | Absent | Absent | Absent | Absent |
| Evaluation Suppression of scratch stain | 5 | 6 | 7 | 10 | 10 | 10 |

As is evident from the results shown in Table 6, according to the lithographic printing plate precursors of Examples 26 to 31, the smaller the surface contact angle of the aluminum support, the further the scratches and contamination is suppressed.

"Surface contact angle" shown in Table 6 represents a water contact angle on a surface of the aluminum support on the image-recording layer side that is measured by an airborne water droplet method. The contact angle was measured by the method described above.

The details of the hydrophilic compounds shown in Table 6 are as follows.

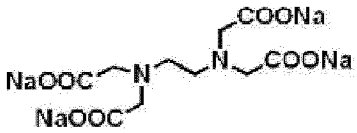
Ethylenediaminetetraacetic acid 4Na

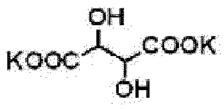
Tartaric acid 2K

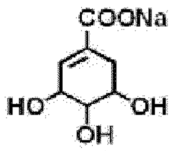
Shikimic acid Na

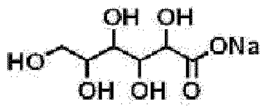
Gluconic acid Na

[Examples 32 to 38]

The lithographic printing plate precursors of Examples 32 to 38 were prepared by the following method.

<Preparation of coating solution (4) for undercoat layer>

The coating solution (4) for an undercoat layer having the following composition was prepared.

-Composition of coating solution (4) for undercoat layer-

·Polymer (U-1) [the following structure]: 0.14 parts
·CHELEST 400 (EDTA·4Na·$4H_2O$, manufactured by CHELEST CORPORATION): 0.035 parts
·CHELEST 3EAF (N-(2-hydroxyethyl)iminodiacetic acid, manufactured by CHELEST CORPORATION): 0.035 parts
·Surfactant (EMALEX 710, manufactured by NIHON EMULSION Co., Ltd.): 0.0016 parts
·Preservative (BIOHOPE L, manufactured by K·I Chemical Industry Co., LTD.): 0.0015 parts
·Water: 3.29 parts

<Preparation of lithographic printing plate precursor>

The support described in Table 7 was coated with a coating solution for an undercoat layer of the type described in Table 7 so that the dry coating amount was 20 mg/$m^2$, followed by drying, thereby forming an undercoat layer. The undercoat layer was coated with the coating solution (2) for an image-recording layer having the composition described in Table 7 (here, the coating solution (2) for an image-recording layer contained the components described in Table 7, which was prepared using a mixed solvent of 2-butanone:1-methoxy-2-propanol (MFG):distilled water = 5:4:5 (mass ratio) so that the solid content was 7% by mass) so that the dry coating amount was the value described in Table 7, followed by drying, thereby forming an image-recording layer.

The coating solution (2) for an image-recording layer was prepared by mixing and stirring together the resin particles immediately before coating.

<Evaluation of lithographic printing plate precursor>

The obtained lithographic printing plate precursor was evaluated in terms of (1) to (4) described above, in the same manner as in Example 1.

The results are shown in Table 7.

[Table 7]

| | | | Example | | | | | | |
|---|---|---|---|---|---|---|---|---|---|
| | | | 32 | 33 | 34 | 35 | 36 | 37 | 38 |
| Support | | Type | C | C | C | C | C | D | C |
| Layer in contact with support (undercoat layer) | Type of coating solution for undercoat layer | | (4) | (4) | (4) | (4) | (4) | (1) | (4) |
| Solid content of coating solution of image-recording layer [part by mass] | Infrared absorber | D-6 | 20 | 20 | 20 | 20 | - | - | - |
| | | D-7 | - | - | - | - | 20 | - | 20 |
| | | D-8 | - | - | - | - | - | 26 | - |
| | Electron-accepting polymerization initiator | I-3 | 109 | 109 | - | 109 | 109 | - | 109 |
| | | I-5 | - | - | 100 | - | - | 60 | - |
| | Color developing agent | S-17 | 25 | 25 | 25 | 25 | 25 | - | 25 |
| | | S-18 | - | - | - | - | - | 30 | - |
| | Electron-donating polymerization initiator | B-1 | 25 | 25 | 25 | 25 | 25 | 50 | 25 |
| | Compound having C=C group | M-7 | 175 | 200 | 200 | 175 | 175 | 200 | 175 |
| | | M-1 | 100 | - | - | 100 | 100 | - | 100 |
| | | M-8 | - | 50 | - | - | - | 50 | - |
| | | M-9 | - | - | - | - | - | 50 | - |
| | Resin particles | R-12 | 400 | - | 300 | 400 | - | 200 | - |
| | | R-13 | - | 400 | - | - | 500 | - | 500 |
| | Binder polymer | P-4 | - | - | - | - | - | 150 | - |
| | Low-molecular-weight hydrophilic compound | T-2 | 12 | 12 | 12 | 12 | 12 | - | 12 |
| | Additive | O-1 | 40 | 40 | 40 | 40 | 40 | - | 40 |
| | Surfactant | U-1 | 4 | 4 | 4 | 4 | 4 | - | - |
| | | U-2 | - | - | - | - | - | - | 4 |
| | C=C valence [mmol/g] | | 3.97 | 3.62 | 2.94 | 3.97 | 3.97 | 3.27 | 3.97 |
| Dry coating amount g/m$^2$ | | | 0.90 | 0.90 | 0.90 | 0.90 | 1.00 | 0.82 | 1.00 |
| Evaluation | UV printing durability | | 240 | 220 | 200 | 220 | 250 | 201 | 251 |
| | UV plate missing | | 18 | 18 | 16 | 17 | 19 | 18 | 20 |
| | On-press developability [sheets] | | 20 | 20 | 18 | 18 | 22 | 19 | 22 |
| | Visibility (ΔL) | | 13.0 | 13.0 | 12.5 | 12.0 | 12.8 | 4.8 | 12.7 |

As is evident from the results shown in Table 7, the lithographic printing plate precursor according to the present invention has excellent on-press developability and excellent UV printing durability and is unlikely to cause UV plate missing.

Furthermore, it has been revealed that the lithographic printing plate precursors of Examples 32 to 38 are also excellent in visibility.

The compounds used in the coating solution (2) for an image-recording layer are as follows.

[Compound having C=C group]

M-7: Compound synthesized by the following method (C=C valence: 6.8 mmol/g, weight-average molecular weight: 150,000, C=C equivalent: 147 g/mol)

M-8: Compound having the following structure (C=C valence: 4.25 mmol/g, molecular weight: 470.6, C=C equivalent: 471 g/mol)

M-9: Compound having the following structure (C=C valence: 4.42 mmol/g, molecular weight: 452.6, C=C equivalent: 453 g/mol)

-Synthesis of M-7-

A mixed solution of TAKENATE (registered trademark) D-116N (manufactured by Mitsui Chemicals, Inc., 4.7 parts by mass) as polyisocyanate, ARONIX (registered trademark) M-403 (manufactured by TOAGOSEI CO., LTD.) as a hydroxyl group-containing polyfunctional acrylate in such an amount that the ratio of the NCO value of polyisocyanate to the hydroxyl number of hydroxyl group-containing polyfunctional acrylate is 1:1, 0.02 parts by mass of t-butylbenzoquinone, and 11.5 parts by mass of methyl ethyl ketone was heated at 65°C. NEOSTANN U-600 (bismuth-based polycondensation catalyst, manufactured by NITTO KASEI CO., LTD., 0.11 parts by mass) was added to the reaction solution, and the reaction solution was heated at the same temperature for 4 hours. The reaction solution was cooled to room temperature (25°C), and methyl ethyl ketone was added thereto, thereby synthesizing a urethane acrylate solution having a solid content of 50% by mass.

Subsequently, by using recycling GPC (instrument: LC908-C60, column: JAIGEL-1H-40 and 2H-40 (manufactured by Japan Analytical Industry Co., Ltd.)) and tetrahydrofuran (THF) as an eluent, molecular weight fractionation of the urethane acrylate solution was performed.

The weight-average molecular weight of the compound M-7 was measured by the following measurement instruments and methods.

GPC measurement instrument: TOSOH HLC-8320 GPC, GPC mobile phase: THF
Inspector: Differential Refractometer (RI), flow rate: 0.35 mL/min
Columns: TSKgel SuperHZM-M, TSKgel SuperHZ4000, TSKgel SuperHZ3000, and TSKgel SuperHZ2000 were connected and used.
Column temperature: 40°C
Standard sample for molecular weight calibration curve: polystyrene (PS)

The ethylenically unsaturated bond valence (C=C valence) of the compound M-7 was calculated based on the structure of the compound (model) obtained by the structural analysis performed by 1H-NMR spectroscopy.

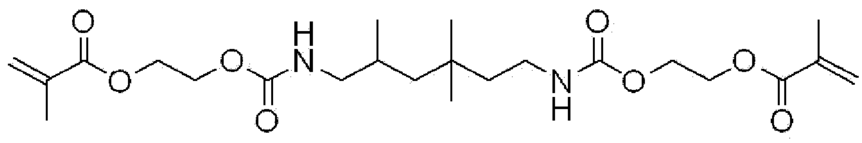

M-8

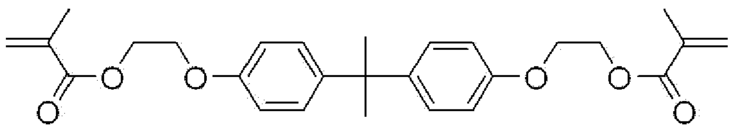

M-9

[Polymerization initiator]

(Electron-accepting polymerization initiator)

I-5: Compound having the following structure

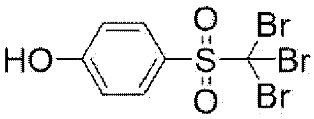

I-5

[Infrared absorber]

D-6: Compound having the following structure, (HOMO = -5.42 eV)
D-7: Compound having the following structure, (HOMO = -5.31 eV)
D-8: Compound having the following structure, (HOMO = -5.32 eV)

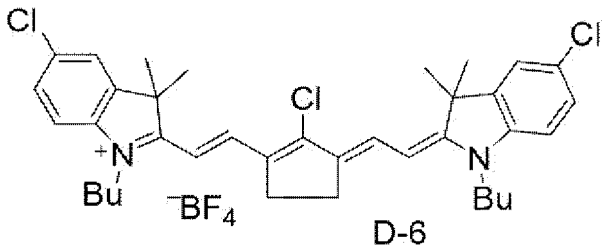

D-6

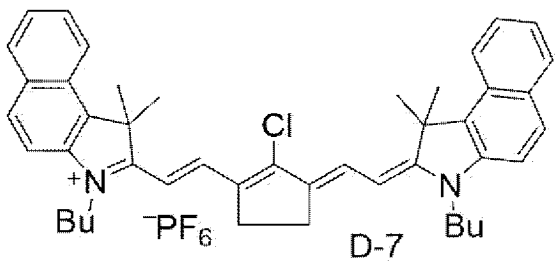

D-7

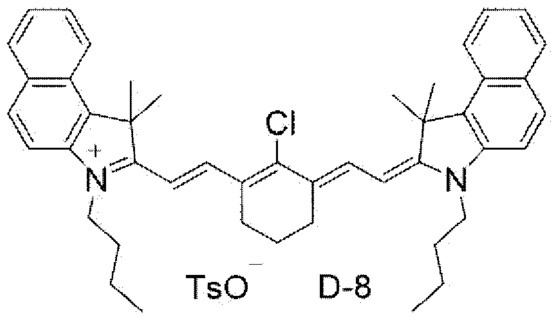

D-8

[Binder polymer]

P-4: Partially acetylated polyvinyl butyral, S-LEC BL-10 manufactured by SEKISUI CHEMICAL CO., LTD. (degree of acetalization 70 mol%, amount of hydroxyl groups 28 mol%, amount of acetyl groups 2 mol%, Tg: 67°C)

[Color developing agent]

S-17: Compound having the following structure
S-18: Compound having the following structure

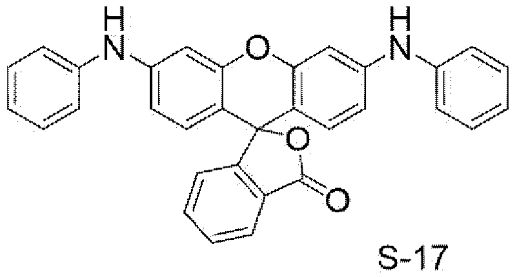

S-17

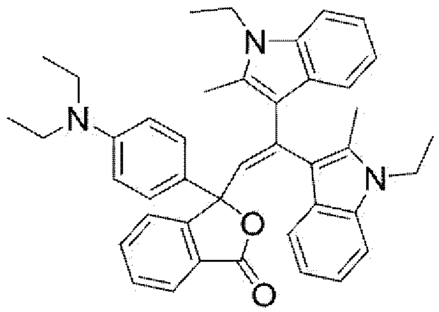

S-18

[Additive]

O-1: Chain transfer agent, compound having the following structure

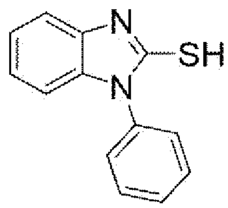

O-1

[Surfactant (fluoroaliphatic group-containing copolymer)]

U-1: Compound having the following structure
U-2: Compound having the following structure

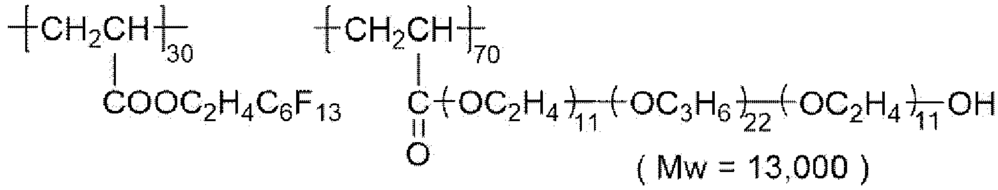

( Mw = 13,000 )

U-1

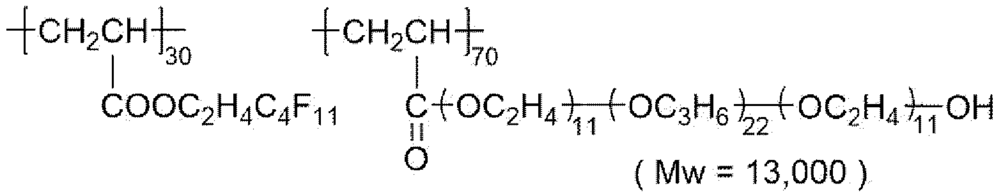

( Mw = 13,000 )

U-2

In the above structural formula, the content of each constitutional unit (subscript at the right lower side of the parentheses) represents the mass ratio.

Explanation of References

18: aluminum plate
12a, 12b: aluminum support
20a, 20b: anodic oxide film
22a, 22b: micropore
24: large diameter portion
26: small diameter portion
50: main electrolytic cell
51: alternating current power source
52: radial drum roller
53a, 53b: main pole
54: electrolytic solution supply port
55: electrolytic solution
56: auxiliary anode
60: auxiliary anode tank
A1: electrolytic solution supply direction
A2: electrolytic solution discharge direction
ta: anodic reaction time
tc: cathodic reaction time
tp: time taken for current to reach peak from 0
Ia: peak current on anodic cycle side
Ic: peak current on cathodic cycle side
W: aluminum plate
AA: current of anodic reaction of aluminum plate
CA: current of cathodic reaction of aluminum plate
610: anodic oxidation treatment device
616: aluminum plate
618: electrolytic solution
612: power supply tank
614: electrolytic treatment tank
616: aluminum plate
620: power supply electrode
622: roller
624: nip roller
626: electrolytic solution
628: roller
630: electrolysis electrode
634: direct current power source
ECa: current of anodic reaction of aluminum plate
ECb: current of cathodic reaction of aluminum plate

## Claims

1. A lithographic printing plate precursor, comprising:

    an aluminum support; and
    an image-recording layer formed on the aluminum support,
    wherein the image-recording layer comprises resin particles A having an ethylenically unsaturated group and a compound B having an ethylenically unsaturated group other than the resin particles A and has an ethylenically unsaturated bond valence of 1.5 mmol/g or more; wherein the aluminum support has an aluminum plate and an anodic oxide film of aluminum disposed on the aluminum plate,
    the anodic oxide film is at a position closer to a side of the image-recording layer than the aluminum plate and has micropores extending in a depth direction from a surface of the anodic oxide film on the side of the image-recording layer,
    an average diameter of the micropores within the surface of the anodic oxide film is more than 10 nm and 100 nm or less, and
    in the L*a*b* color space, a value of brightness L* of the surface of the anodic oxide film on the side of the image-recording layer is 70 to 100.

2. The lithographic printing plate precursor according to claim 1,
wherein the ethylenically unsaturated bond valence of the image-recording layer is 2.1 mmol/g or more.

3. The lithographic printing plate precursor according to claim 1 or 2,
wherein an ethylenically unsaturated bond equivalent of the compound B is 300 g/mol or less.

4. The lithographic printing plate precursor according to any one of claims 1 to 4,
wherein the compound B comprises a compound having an ethylenically unsaturated bond valence of 5.0 mmol/g or more.

5. The lithographic printing plate precursor according to claim 4,
wherein the compound having an ethylenically unsaturated bond valence of 5.0 mmol/g or more comprises at least one kind of structure selected from the group consisting of an adduct structure of a polyfunctional alcohol compound, a biuret structure, and an isocyanurate structure.

6. The lithographic printing plate precursor according to any one of claims 1 to 5,

    wherein the resin particles A are particles containing a resin having an ethylenically unsaturated group,
    the resin having an ethylenically unsaturated group contained in the resin particles A is a resin further having a hydrophilic structure, and.

    the hydrophilic structure of the resin having an ethylenically unsaturated group comprises a polyalkylene oxide structure.

7. The lithographic printing plate precursor according to claim 6,
wherein the resin having an ethylenically unsaturated group contained in the resin particles A is an addition polymerization-type resin.

8. The lithographic printing plate precursor according to claim 6,

    wherein the resin having an ethylenically unsaturated group in the resin particles A includes a resin that has a structure obtained by reacting at least water and an isocyanate compound represented by the following Formula (Iso) and has a polyethylene oxide structure and a polypropylene oxide structure as a polyoxyalkylene structure:

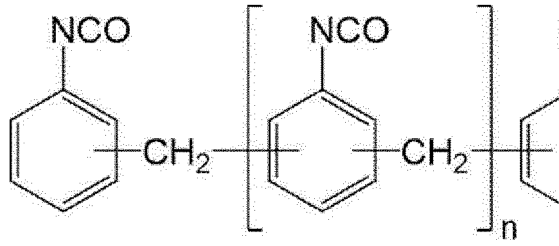

(Iso)

in Formula (Iso), n represents an integer of 0 to 10.

**9.** The lithographic printing plate precursor according to any one of claims 1 to 8,

wherein the image-recording layer further comprises an electron-donating polymerization initiator and an infrared absorber, and
HOMO of the infrared absorber - HOMO of the electron-donating polymerization initiator is 0.70 eV or less.

**10.** The lithographic printing plate precursor according to any one of claims 1 to 9 ,

wherein the image recording layer further comprises an infrared absorber, and
the infrared absorber has an organic anion that satisfies $\delta d \geq 16$, $\delta p = 16$ to 32, and $\delta h \leq \delta p \times 0.6$ in the Hansen solubility parameters.

**11.** The lithographic printing plate precursor according to any one of claims 1 to 10,

wherein the image recording layer further comprises polymerization initiator, and
the polymerization initiator comprises an electron-accepting polymerization initiator, and
the electron-accepting polymerization initiator has an organic anion that satisfies $\delta d \geq 16$, $\delta p = 16$ to 32, and $\delta h \leq \delta p \times 0.6$ in the Hansen solubility parameters.

**12.** The lithographic printing plate precursor according to any one of claims 1 to 10,

wherein the image recording layer further comprises polymerization initiator, and
the polymerization comprises includes an electron-accepting polymerization initiator, and
the electron-accepting polymerization initiator comprises a compound represented by Formula (II):

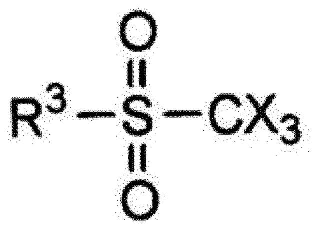

(II)

wherein, in Formula (II), X represents a halogen atom, and $R^3$ represents an aryl group.

**13.** The lithographic printing plate precursor according to any one of claims 1 to 12,

wherein the image recording layer comprises an acid color-developing agent,
the acid color-developing agent comprises a leuco colorant having a phthalide structure or a fluoran structure, and
the leuco colorant having a phthalide structure or a fluoran structure is a compound represented by any of Formula (Le-7) to Formula (Le-9):

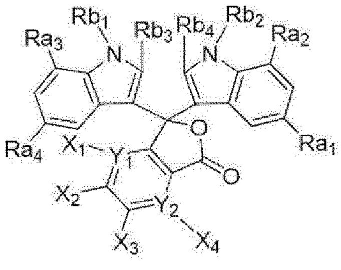 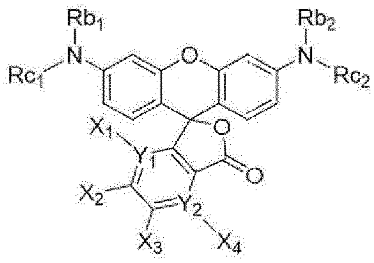 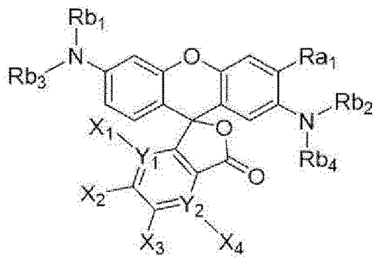

(Le - 7) (Le - 8) (Le - 9)

wherein, in Formula (Le-7) to Formula (Le-9), $X_1$ to $X_4$ each independently represent a hydrogen atom, a halogen atom, or a dialkylanilino group, $Y_1$ and $Y_2$ each independently represent C or N, $X_1$ does not exist in a case where $Y_1$ is N, $X_4$ does not exist in a case where $Y_2$ is N, $Ra_1$ to $Ra_4$ each independently represent a hydrogen atom, an alkyl group, or an alkoxy group, $Rb_1$ to $Rb_4$ each independently represent an alkyl group or an aryl group, and $Rc_1$ and $Rc_2$ each independently represent an aryl group.

**14.** The lithographic printing plate precursor according to any one of claims 1 to 13, wherein the image-recording layer further comprises polyvinyl acetal as a binder resin.

**15.** A method for preparing a lithographic printing plate, comprising:

a step of subjecting the lithographic printing plate precursor according to any one of claims 1 to 14 to image-wise light exposure; and
a step of supplying at least one material selected from the group consisting of a printing ink and dampening water to the lithographic printing plate precursor having undergone light exposure to remove the image-recording layer in a non-image area on a printer.

**16.** A lithographic printing method, comprising:

a step of subjecting the lithographic printing plate precursor according to any one of claims 1 to 14 to image-wise light exposure;
a step of supplying at least one material selected from the group consisting of a printing ink and dampening water to the lithographic printing plate precursor having undergone light exposure to remove the image-recording layer in a non-image area on a printer and to prepare a lithographic printing plate; and
a step of performing printing by using the prepared lithographic printing plate.

## Patentansprüche

**1.** Lithographischer Druckplattenvorläufer, umfassend:

einen Aluminiumträger; und
eine Bildaufzeichnungsschicht, die auf dem Aluminiumträger gebildet ist,
wobei die Bildaufzeichnungsschicht Harzpartikel A mit einer ethylenisch ungesättigten Gruppe und eine Verbindung B mit einer ethylenisch ungesättigten Gruppe, die von den Harzpartikeln A verschieden ist, umfasst und eine ethylenisch ungesättigte Bindungsvalenz von 1,5 mmol/g oder mehr aufweist; wobei der Aluminiumträger eine Aluminiumplatte und einen anodischen Oxidfilm von Aluminium, der auf der Aluminiumplatte angeordnet ist, aufweist,
sich der anodische Oxidfilm an einer Position, die näher an einer Seite der Bildaufzeichnungsschicht als die Aluminiumplatte liegt, befindet und Mikroporen, die sich in einer Tiefenrichtung von einer Oberfläche des anodischen Oxidfilms auf der Seite der Bildaufzeichnungsschicht erstrecken, aufweist,
ein durchschnittlicher Durchmesser der Mikroporen innerhalb der Oberfläche des anodischen Oxidfilms mehr als 10 nm und 100 nm oder weniger beträgt, und
in dem L*a*b*-Farbraum ein Wert von Helligkeit L* der Oberfläche des anodischen Oxidfilms auf der Seite der Bildaufzeichnungsschicht 70 bis 100 beträgt.

**2.** Lithographischer Druckplattenvorläufer nach Anspruch 1,

wobei die ethylenisch ungesättigte Bindungsvalenz der Bildaufzeichnungsschicht 2,1 mmol/g oder mehr beträgt.

**3.** Lithographischer Druckplattenvorläufer nach Anspruch 1 oder 2,
wobei ein ethylenisch ungesättigtes Bindungsäquivalent der Verbindung B 300 g/mol oder weniger beträgt.

**4.** Lithographischer Druckplattenvorläufer nach einem der Ansprüche 1 bis 4,
wobei die Verbindung B eine Verbindung mit einer ethylenisch ungesättigten Bindungsvalenz von 5,0 mmol/g oder mehr umfasst.

**5.** Lithographischer Druckplattenvorläufer nach Anspruch 4,
wobei die Verbindung mit einer ethylenisch ungesättigten Bindungsvalenz von 5,0 mmol/g oder mehr mindestens eine Art von Struktur, die aus der Gruppe, die aus einer Adduktstruktur einer polyfunktionellen Alkoholverbindung, einer Biuretstruktur und einer Isocyanuratstruktur besteht, ausgewählt wird, umfasst.

**6.** Lithographischer Druckplattenvorläufer nach einem der Ansprüche 1 bis 5,

wobei die Harzpartikel A Partikel sind, die ein Harz mit einer ethylenisch ungesättigten Gruppe enthalten,
das Harz mit einer ethylenisch ungesättigten Gruppe, die in den Harzpartikeln A enthalten ist, ein Harz ist, das ferner eine hydrophile Struktur aufweist, und
die hydrophile Struktur des Harzes mit einer ethylenisch ungesättigten Gruppe eine Polyalkylenoxid-Struktur umfasst.

**7.** Lithographischer Druckplattenvorläufer nach Anspruch 6,
wobei das Harz mit einer ethylenisch ungesättigten Gruppe, die in den Harzpartikeln A enthalten ist, ein Harz des Additionspolymerisationstyps ist.

**8.** Lithographischer Druckplattenvorläufer nach Anspruch 6,

wobei das Harz mit einer ethylenisch ungesättigten Gruppe in den Harzpartikeln A ein Harz, das eine Struktur, die durch Umsetzen von mindestens Wasser und einer Isocyanatverbindung, die durch die folgende Formel (Iso) dargestellt wird, erhalten wird, aufweist und eine Polyethylenoxidstruktur und eine Polypropylenoxidstruktur als eine Polyoxyalkylstruktur aufweist, umfasst:

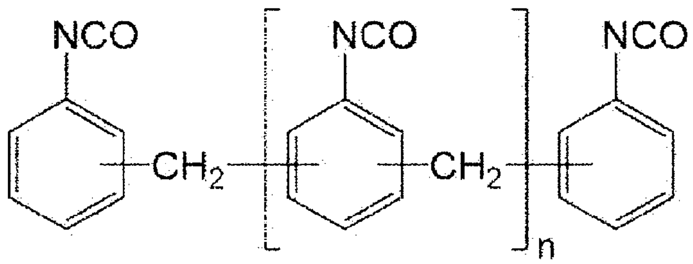

(Iso)

in Formel (Iso) n eine ganze Zahl von 0 bis 10 darstellt.

**9.** Lithographischer Druckplattenvorläufer nach einem der Ansprüche 1 bis 8,

wobei die Bildaufzeichnungsschicht ferner einen elektronenspendenden Polymerisationsinitiator und einen Infrarotabsorber umfasst, und
HOMO des Infrarotabsorbers - HOMO des elektronenspendenden Polymerisationsinitiators 0,70 eV oder weniger beträgt.

**10.** Lithographischer Druckplattenvorläufer nach einem der Ansprüche 1 bis 9,

wobei die Bildaufzeichnungsschicht ferner einen Infrarotabsorber umfasst, und
der Infrarotabsorber ein organisches Anion aufweist, das $\delta d \geq 16$, $\delta p = 16$ bis 32 und $\delta h \leq \delta p \times 0{,}6$ bei den Hansen-Löslichkeitsparametern erfüllt.

**11.** Lithographischer Druckplattenvorläufer nach einem der Ansprüche 1 bis 10,

wobei die Bildaufzeichnungsschicht ferner Polymerisationsinitiator umfasst, und der Polymerisationsinitiator einen elektronenaufnehmenden Polymerisationsinitiator umfasst, und der elektronenaufnehmende Polymerisationsinitiator ein organisches Anion aufweist, das $\delta d \geq 16$, $\delta p = 16$ bis 32 und $\delta h \leq \delta p \times 0{,}6$ bei den Hansen-Löslichkeitsparametern erfüllt.

**12.** Lithographischer Druckplattenvorläufer nach einem der Ansprüche 1 bis 10,

wobei die Bildaufzeichnungsschicht ferner Polymerisationsinitiator umfasst, und die Polymerisation einen elektronenaufnehmenden Polymerisationsinitiator umfasst enthält, und der elektronenannehmende Polymerisationsinitiator eine Verbindung umfasst, die durch Formel (II) dargestellt wird:

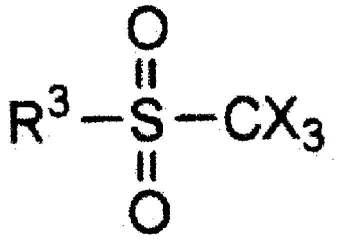
(II)

wobei in Formel (II) X ein Halogenatom darstellt und $R^3$ eine Arylgruppe darstellt.

**13.** Lithographischer Druckplattenvorläufer nach einem der Ansprüche 1 bis 12,

wobei die Bildaufzeichnungsschicht ein saure Farbentwicklungsmittel umfasst, das saure Farbentwicklungsmittel einen Leukofarbstoff mit einer Phthalidstruktur oder einer Fluoranstruktur umfasst, und der Leukofarbstoff mit einer Phthalidstruktur oder einer Fluoranstruktur eine Verbindung ist, die durch eine beliebige von Formel (Le-7) bis Formel (Le-9) dargestellt wird:

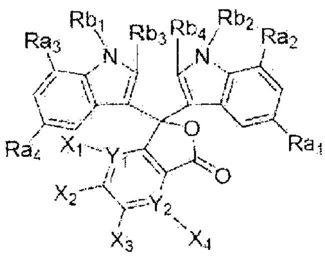
(Le-7)

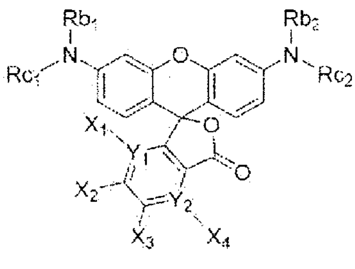
(Le-8)

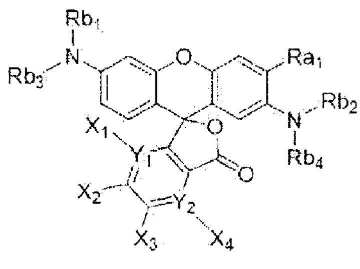
(Le-9)

wobei in Formel (Le-7) bis Formel (Le-9) $X_1$ bis $X_4$ jeweils unabhängig voneinander ein Wasserstoffatom, ein Halogenatom oder eine Dialkylanilino-Gruppe darstellen, $Y_1$ und $Y_2$ jeweils unabhängig voneinander C oder N darstellen, $X_1$ in einem Fall, in dem $Y_1$ N ist, nicht existiert, $X_4$ in einem Fall, in dem $Y_2$ N ist, nicht existiert, $Ra_1$ bis $Ra_4$ jeweils unabhängig voneinander ein Wasserstoffatom, eine Alkylgruppe oder eine Alkoxygruppe darstellen, $Rb_1$ bis $Rb_4$ jeweils unabhängig voneinander eine Alkylgruppe oder eine Arylgruppe darstellen und $Rc_1$ und $Rc_2$ jeweils unabhängig voneinander eine Arylgruppe darstellen.

**14.** Lithographischer Druckplattenvorläufer nach einem der Ansprüche 1 bis 13, wobei die Bildaufzeichnungsschicht ferner Polyvinylacetal als ein Bindemittel umfasst.

**15.** Verfahren zum Herstellen einer lithographischen Druckplatte, umfassend:

einen Schritt des Unterziehens des lithographischen Druckplattenvorläufers nach einem der Ansprüche 1 bis 14 zu bildweiser Belichtung; und

einen Schritt des Zuführens von mindestens einem Material, das aus der Gruppe, die aus einem Druckfarbe und Feuchtwasser besteht, ausgewählt wird, zu dem lithographischen Druckplattenvorläufer, der Belichtung unterzogen wurde, um die Bildaufzeichnungsschicht in einem Nicht-Bildbereich an einem Drucker zu entfernen.

**16.** Lithographisches Druckverfahren, umfassend:

einen Schritt des Unterziehens des lithographischen Druckplattenvorläufers nach einem der Ansprüche 1 bis 14 zu bildweiser Belichtung;
einen Schritt des Zuführens von mindestens einem Material, das aus der Gruppe, die aus einem Druckfarbe und Feuchtwasser besteht, ausgewählt wird, zu dem lithographischen Druckplattenvorläufer, der Belichtung unterzogen wurde, um die Bildaufzeichnungsschicht in einem Nicht-Bildbereich an einem Drucker zu entfernen und um eine lithographische Druckplatte herzustellen; und
einen Schritt des Durchführens von Drucken durch Verwenden der hergestellten lithographischen Druckplatte.

## Revendications

**1.** Précurseur de plaque d'impression lithographique, comprenant :

un support en aluminium ; et
une couche d'enregistrement d'images formée sur le support en aluminium,
dans lequel la couche d'enregistrement d'images comprend des particules de résine A ayant un groupe éthyléniquement insaturé et un composé B ayant un groupe éthyléniquement insaturé autre que les particules de résine A et a une valence de liaison éthyléniquement insaturée de 1,5 mmol/g ou plus ; dans lequel le support en aluminium a une plaque en aluminium et un film d'oxyde anodique d'aluminium disposé sur la plaque en aluminium,
le film d'oxyde anodique est à une position plus proche d'un côté de la couche d'enregistrement d'images que la plaque en aluminium et possède des micropores s'étendant dans une direction de profondeur à partir d'une surface du film d'oxyde anodique sur le côté de la couche d'enregistrement d'images,
un diamètre moyen des micropores à la surface du film d'oxyde anodique est supérieur à 10 nm et 100 nm ou moins, et
dans l'espace colorimétrique L*a*b*, une valeur de luminosité L* de la surface du film d'oxyde anodique sur le côté de la couche d'enregistrement d'images est de 70 à 100.

**2.** Précurseur de plaque d'impression lithographique selon la revendication 1,
dans lequel la valence de liaison éthyléniquement insaturée de la couche d'enregistrement d'images est de 2,1 mmol/g ou plus.

**3.** Précurseur de plaque d'impression lithographique selon la revendication 1 ou la revendication 2,
dans lequel un équivalent de liaison éthyléniquement insaturée du composé B est 300 g/mol ou moins.

**4.** Précurseur de plaque d'impression lithographique selon l'une quelconque des revendications 1 à 4,
dans lequel le composé B comprend un composé ayant une valence de liaison éthyléniquement insaturée de 5,0 mmol/g ou plus.

**5.** Précurseur de plaque d'impression lithographique selon la revendication 4,
dans lequel le composé ayant une valence de liaison éthyléniquement insaturée de 5,0 mmol/g ou plus comprend au moins un type de structure sélectionné parmi le groupe constitué d'une structure d'adduit d'un composé alcool polyfonctionnel, d'une structure de biuret et d'une structure d'isocyanurate.

**6.** Précurseur de plaque d'impression lithographique selon l'une quelconque des revendications 1 à 5,

dans lequel les particules de résine A sont des particules contenant une résine ayant un groupe éthyléniquement insaturé,
la résine ayant un groupe éthyléniquement insaturé contenu dans les particules de résine A est une résine ayant en outre une structure hydrophile, et
la structure hydrophile de la résine ayant un groupe éthyléniquement insaturé comprend une structure d'oxyde de polyalkylène.

**7.** Précurseur de plaque d'impression lithographique selon la revendication 6,
dans lequel la résine ayant un groupe éthyléniquement insaturé contenu dans les particules de résine A est une résine de type polymérisation par addition.

**8.** Précurseur de plaque d'impression lithographique selon la revendication 6,

dans lequel la résine ayant un groupe éthyléniquement insaturé dans les particules de résine A inclut une résine qui a une structure obtenue en réagissant au moins de l'eau et un composé isocyanate représenté par la Formule suivante (Iso) et a une structure d'oxyde de polyéthylène et une structure d'oxyde de polypropylène comme une structure de polyoxyalkylène :

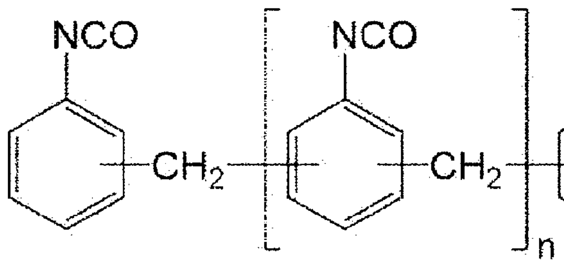

(Iso)

dans Formule (Iso), n représente un entier de 0 à 10.

**9.** Précurseur de plaque d'impression lithographique selon l'une quelconque des revendications 1 à 8,

dans lequel la couche d'enregistrement d'images comprend en outre un initiateur de polymérisation donneur d'électrons et un absorbeur infrarouge, et
HOMO de l'absorbeur infrarouge - HOMO de l'initiateur de polymérisation donneur d'électrons est de 0,70 eV ou moins.

**10.** Précurseur de plaque d'impression lithographique selon l'une quelconque des revendications 1 à 9,

dans lequel la couche d'enregistrement d'images comprend en outre un absorbeur infrarouge, et
l'absorbeur infrarouge a un anion organique qui satisfait $\delta d \geq 16$, $\delta p = 16$ à $32$ et $\delta h \leq \delta p \times 0{,}6$ dans les paramètres de solubilité de Hansen.

**11.** Précurseur de plaque d'impression lithographique selon l'une quelconque des revendications 1 à 10,

dans lequel la couche d'enregistrement d'images comprend en outre un initiateur de polymérisation, et
l'initiateur de polymérisation comprend un initiateur de polymérisation accepteur d'électrons, et
l'initiateur de polymérisation accepteur d'électrons a un anion organique qui satisfait $\delta d \geq 16$, $\delta p = 16$ à $32$ et $\delta h \leq \delta p \times 0{,}6$ dans les paramètres de solubilité de Hansen.

**12.** Précurseur de plaque d'impression lithographique selon l'une quelconque des revendications 1 à 10,

dans lequel la couche d'enregistrement d'images comprend en outre un initiateur de polymérisation, et
la polymérisation comprend inclut un initiateur de polymérisation accepteur d'électrons, et
l'initiateur de polymérisation accepteur d'électrons comprend un composé représenté par Formule (II):

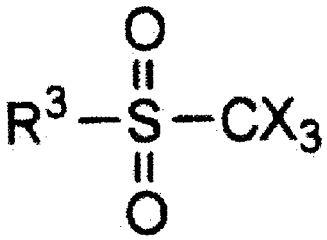

(II)

dans lequel dans Formule (II), X représente un atome d'halogène, et $R^3$ représente un groupe aryle.

**13.** Précurseur de plaque d'impression lithographique selon l'une quelconque des revendications 1 à 12,

dans lequel la couche d'enregistrement d'images comprend un agent de développement de couleur acide, l'agent de développement de couleur acide comprend un colorant leuco ayant une structure de phtalide ou une structure de fluoran, et
le colorant leuco ayant une structure de phtalide ou une structure de fluoran est un composé représenté par l'une quelconque des Formules (Le-7) à (Le-9) :

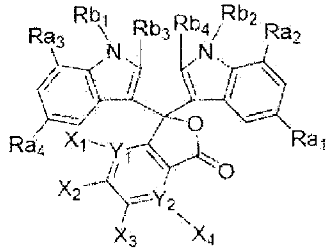
(Le - 7)

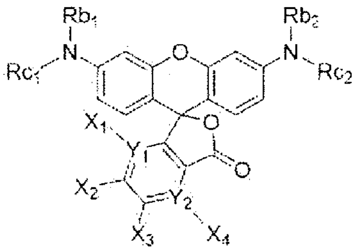
(Le - 8)

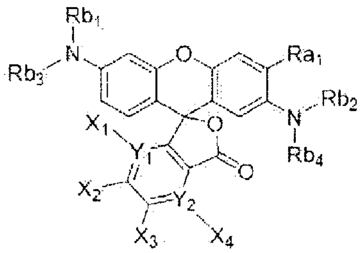
(Le - 9)

dans lequel, dans Formule (Le-7) à Formule (Le-9), $X_1$ à $X_4$ représentent chacun indépendamment un atome d'hydrogène, un atome d'halogène ou un groupe dialkylanilino, $Y_1$ et $Y_2$ représentent chacun indépendamment C ou N, $X_1$ n'existe pas dans un cas où $Y_1$ est N, $X_4$ n'existe pas dans un cas où $Y_2$ est N, $Ra_1$ à $Ra_4$ représentent chacun indépendamment un atome d'hydrogène, un groupe alkyle ou un groupe alkoxy, $Rb_1$ à $Rb_4$ représentent chacun indépendamment un groupe alkyle ou un groupe aryle, et $Rc_1$ et $Rc_2$ représentent chacun indépendamment un groupe aryle.

**14.** Précurseur de plaque d'impression lithographique selon l'une quelconque des revendications 1 à 13, dans lequel la couche d'enregistrement d'images comprend en outre de l'acétal de polyvinyle comme une résine liant.

**15.** Procédé de préparation d'une plaque d'impression lithographique, comprenant :

une étape de soumission du précurseur de plaque d'impression lithographique selon l'une quelconque des revendications 1 à 14 à une exposition lumineuse image par image ; et
une étape de fourniture d'au moins un matériau sélectionné parmi le groupe constitué d'une encre d'impression et d'eau de mouillage au précurseur de plaque d'impression lithographique ayant subi une exposition lumineuse pour enlever la couche d'enregistrement d'images dans une zone sans image sur une imprimante.

**16.** Procédé d'impression lithographique, comprenant :

une étape de soumission du précurseur de plaque d'impression lithographique selon l'une quelconque des revendications 1 à 14 à une exposition lumineuse image par image ;
une étape de fourniture d'au moins un matériau sélectionné parmi le groupe constitué d'une encre d'impression et d'eau de mouillage au précurseur de plaque d'impression lithographique ayant subi une exposition lumineuse pour enlever la couche d'enregistrement d'images dans une zone sans image sur une imprimante et pour préparer une plaque d'impression lithographique ; et
une étape d'exécution d'impression en utilisant la plaque d'impression lithographique préparée.

FIG. 1

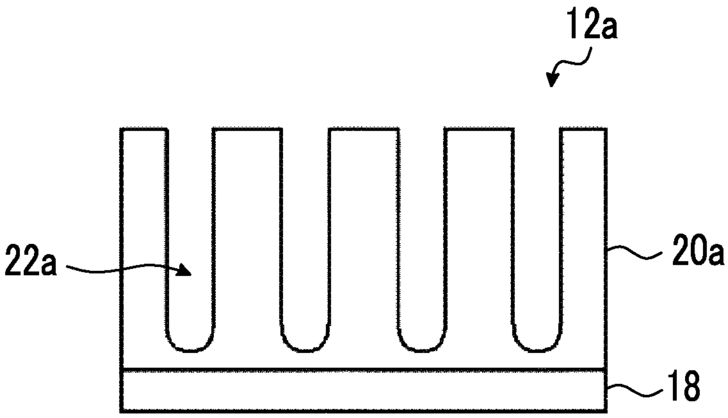


FIG. 2

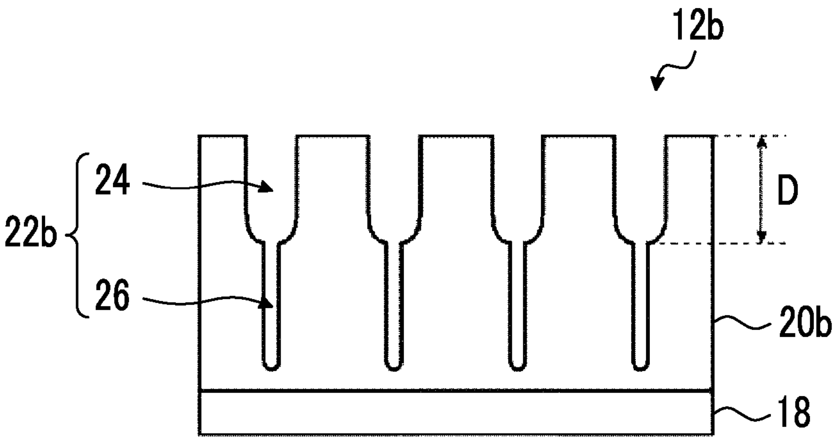

FIG. 3

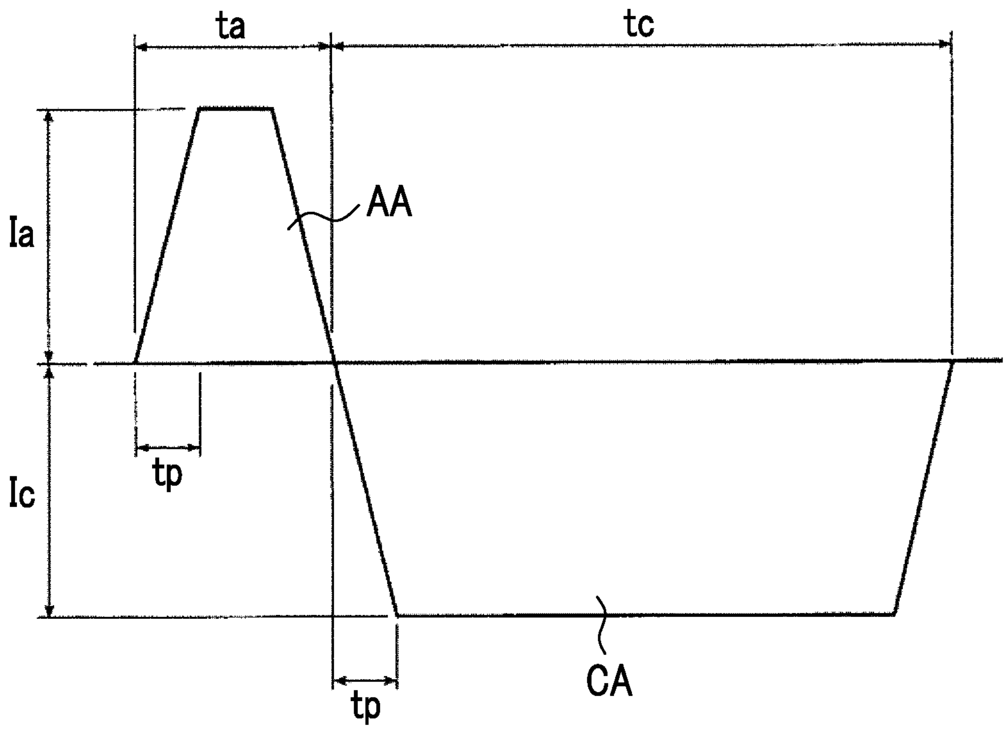


FIG. 4

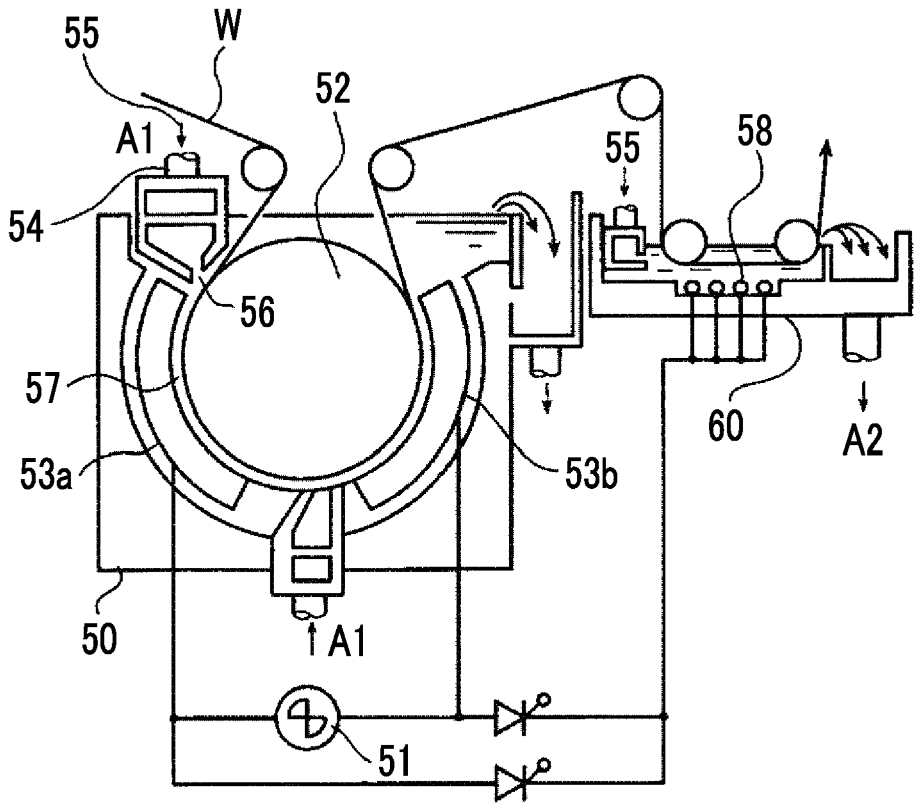

FIG. 5

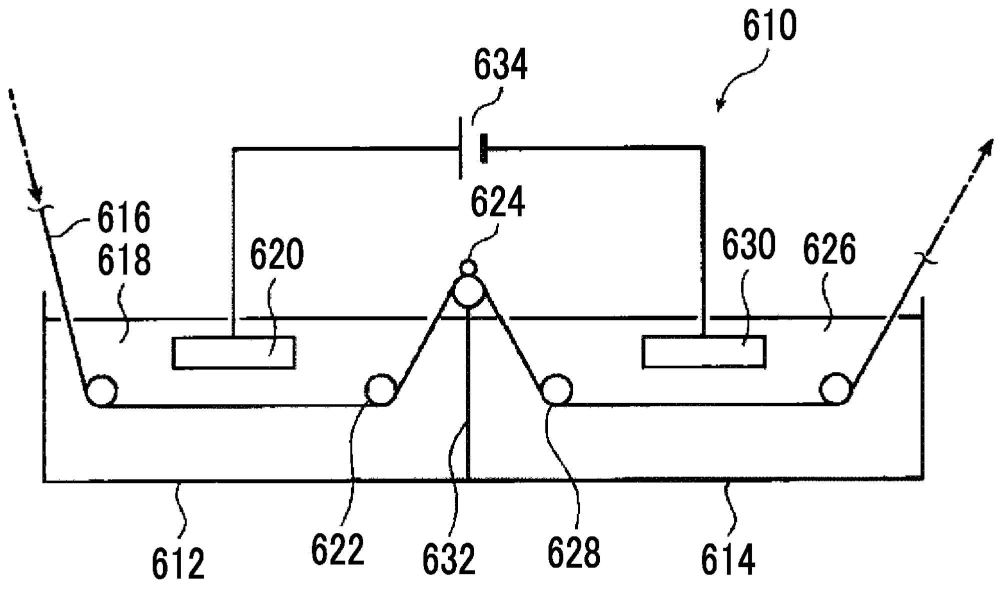

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

### Patent documents cited in the description


- WO 2018159710 A
- JP 2005297305 A
- EP 1470914 A2
- EP 2236291 A1
- WO 2012124177 A1
- EP 2471654 A2
- WO 2018230412 A
- EP 3476616 A
- JP 2012206495 A
- JP 2006508380 A
- JP 2002287344 A
- JP 2008256850 A
- JP 2001342222 A
- JP 9179296 A
- JP H09179296 A
- JP 9179297 A
- JP H09179297 A
- JP 9179298 A
- JP H09179298 A
- JP 2004294935 A
- JP 2006243493 A
- JP 2002275129 A
- JP 2003064130 A
- JP 2003280187 A
- JP 10333321 A
- JP H10333321 A
- JP 48041708 B
- JP S48041708 B
- JP 51037193 A
- JP S5137193 A
- JP 2032293 B
- JP H0232293 B
- JP 2016765 B
- JP H0216765 B
- JP 2003344997 A
- JP 2006065210 A
- JP 58049860 B
- JP S5849860 B
- JP 56017654 B
- JP S5617654 B
- JP 62039417 B
- JP S6239417 B
- JP 62039418 B
- JP S6239418 B
- JP 2000250211 A
- JP 2007094138 A
- US 7153632 B
- JP 8505958 A
- JP H08505958 A
- JP 2007293221 A
- JP 2007293223 A
- JP 2008195018 A
- JP 8108621 A
- JP H08108621 A
- JP 61166544 A
- JP S61166544 A
- JP 2002328465 A
- JP 2001133969 A
- JP 2002023360 A
- JP 2002040638 A
- JP 2002278057 A
- JP 2007090850 A
- JP 5005005 A
- JP H055005 A
- JP 2001222101 A
- JP 9123387 A
- JP H09123387 A
- JP 9131850 A
- JP H09131850 A
- JP 9171249 A
- JP H09171249 A
- JP 9171250 A
- JP H09171250 A
- EP 931647 B
- JP 2001277740 A
- JP 2001277742 A
- JP 2007276454 A
- JP 2009154525 A
- JP 2006297907 A
- JP 2007050660 A
- JP 2008284858 A
- JP 2009090645 A
- JP 2009208458 A
- JP 62293247 A
- JP S62293247 A
- JP 2008284817 A
- JP 50040047 B
- JP S5040047 B
- JP 10282679 A
- JP H10282679 A
- JP 2304441 A
- JP H02304441 A
- JP 2005238816 A
- JP 2005125749 A
- JP 2006239867 A
- JP 2006215263 A
- JP 2006188038 A

- JP 2012158022 A

**Non-patent literature cited in the description**


- **TOSHINAO OKITSU**. *Journal of the Adhesion Society of Japan*, 1993, vol. 29 (5)
- Dye Handbooks. 1970
- **CHARLES M. HANSEN**. Hansen Solubility Parameters; A Users Handbook. CRC Press, 2007
- **IWANAMI**. Dictionary of Physics and Chemistry. Iwanami Shoten, Publishers, 1998